(19) Europäisches Patentamt
European Patent Office
Office européen des brevets

(11) EP 4 742 867 A1

(12) EUROPEAN PATENT APPLICATION

(43) Date of publication:
13.05.2026 Bulletin 2026/20

(21) Application number: 25212276.7

(22) Date of filing: 30.10.2025

(51) International Patent Classification (IPC):
*H10K 50/11* (2023.01) *H10K 85/30* (2023.01)
*H10K 85/60* (2023.01)

(52) Cooperative Patent Classification (CPC):
**H10K 50/11; H10K 85/322; H10K 85/657; H10K 85/658**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.11.2024 KR 20240156459**

(71) Applicant: **Samsung Electronics Co., Ltd.**
**Suwon-si, Gyeonggi-do 16677 (KR)**

(72) Inventors:
- **LEE, Halim**
  **16678 Suwon-si (KR)**
- **KIM, Sangmo**
  **16678 Suwon-si (KR)**
- **KIM, Hwang Suk**
  **16678 Suwon-si (KR)**
- **LEE, Eunkyung**
  **16678 Suwon-si (KR)**
- **KIM, Raesung**
  **16678 Suwon-si (KR)**
- **KIM, Jiwhan**
  **16677 Suwon-si (KR)**
- **NAM, Sungho**
  **16678 Suwon-si (KR)**
- **LEE, Yeonkyung**
  **16678 Suwon-si (KR)**
- **JEONG, Daun**
  **16678 Suwon-si (KR)**
- **CHO, Hwayoung**
  **16678 Suwon-si (KR)**
- **CHWAE, Jun**
  **16678 Suwon-si (KR)**

(74) Representative: **Elkington and Fife LLP**
**Prospect House**
**8 Pembroke Road**
**Sevenoaks, Kent TN13 1XR (GB)**

Remarks:
Amended claims in accordance with Rule 137(2) EPC.

# (54) HETEROCYCLIC COMPOUND, ORGANIC LIGHT-EMITTING DEVICE INCLUDING THE SAME, AND ELECTRONIC APPARATUS

(57) Provided are a heterocyclic compound represented by Formula 1, an organic light-emitting device including the same, and an electronic apparatus:

EP 4 742 867 A1

Formula 1

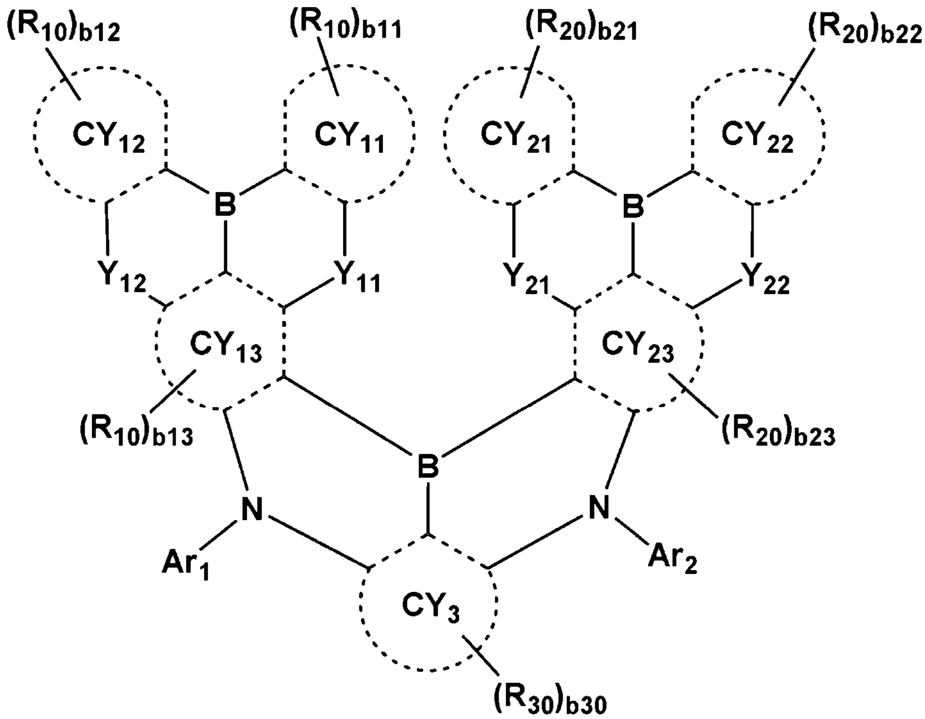

Descriptions of the substituents in Formula 1 are as provided herein.

FIG. 1

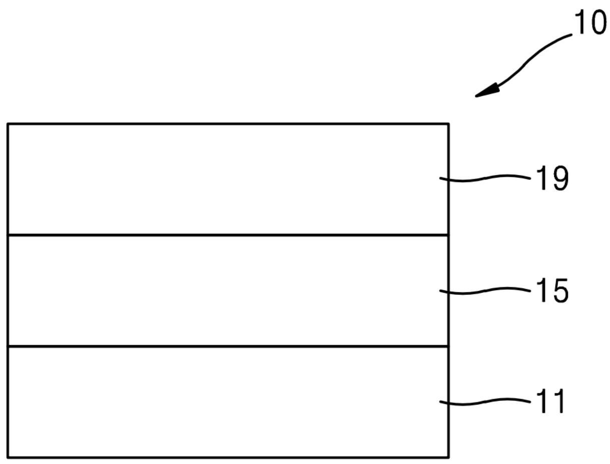

**Description**

FIELD OF THE INVENTION

The disclosure relates to a heterocyclic compound, an organic light-emitting device including the heterocyclic compound, and an electronic apparatus including the organic light-emitting device.

BACKGROUND OF THE INVENTION

Organic light-emitting devices (OLEDs) are self-emissive devices that have excellent characteristics in terms of viewing angles, response time, brightness, driving voltage, response speed, and the like, and produce full-color images.

Organic light-emitting devices include an anode, a cathode, and an organic layer arranged between the anode and the cathode and including an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

SUMMARY OF THE INVENTION

Provided are a heterocyclic compound, an organic light-emitting device including the heterocyclic compound, and an electronic apparatus.

Additional aspects will be set forth in part in the detailed description that follows and, in part, will be apparent from the detailed description, or may be learned by practice of the presented exemplary embodiments described herein.

According to an aspect, provided is a heterocyclic compound represented by Formula 1:

Formula 1

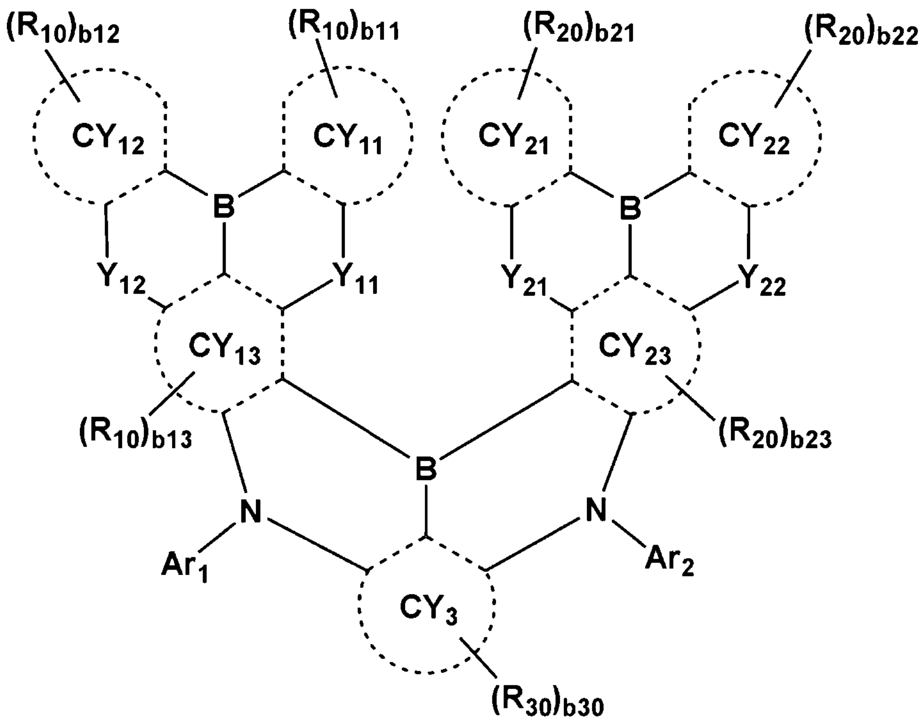

wherein, in Formula 1,

$Y_{11}$ and $Y_{12}$ are each independently a single bond, O, S, Se, $N(Ar_3)$, $N(R_1)$, $C(R_1)(R_2)$, $Si(R_1)(R_2)$, $Ge(R_1)(R_2)$, $B(R_1)$, $P(R_1)$, $P(=O)(R_1)$, $S(=O)_2$, or $C(=O)$,

$Y_{21}$ and $Y_{22}$ are each independently a single bond, O, S, Se, $N(Ar_4)$, $N(R_3)$, $C(R_3)(R_4)$, $Si(R_3)(R_4)$, $Ge(R_3)(R_4)$, $B(R_3)$,

$P(R_3)$, $P(=O)(R_3)$, $S(=O)_2$, or $C(=O)$,

$Ar_1$ to $Ar_4$ are each independently a group represented by Formula 2,

Formula 2

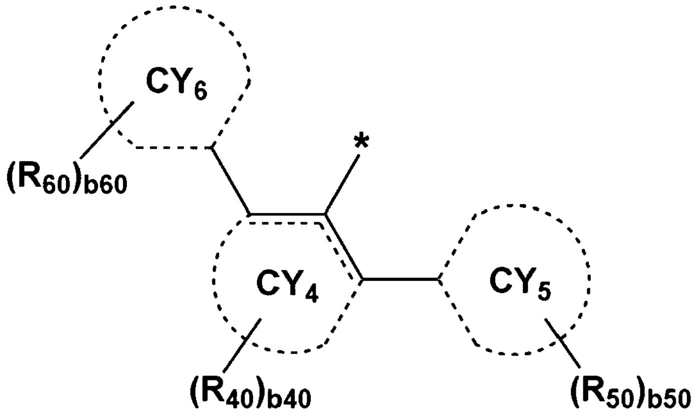

wherein, in Formulae 1 and 2,

$CY_{11}$ to $CY_{13}$, $CY_{21}$ to $CY_{23}$, and $CY_3$ to $CY_6$ are each independently a $C_5$-$C_{30}$ carbocyclic group or a $C_1$-$C_{30}$ heterocyclic group,

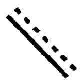

indicates a single bond or a double bond,

* indicates a binding site to a neighboring atom,

$R_1$ to $R_4$, $R_{10}$, $R_{20}$, $R_{30}$, $R_{40}$, $R_{50}$ and $R_{60}$ are each independently hydrogen, deuterium, -F, -Cl, -Br, -I, $-SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_1)(Q_2)(Q_3)$, $-Ge(Q_1)(Q_2)(Q_3)$, $-C(=O)(Q_1)$, $-S(=O)(Q_1)$, $-S(=O)_2(Q_1)$, $-B(Q_1)(Q_2)$, $-P(Q_1)(Q_2)$, $-P(=O)(Q_1)(Q_2)$, or $-P(=S)(Q_1)(Q_2)$,

b11 to b13, b21 to b23, b30, b40, b50, and b60 are each independently 1, 2, 3, 4, 5, 6, 7, 8, 9, 10, 11, 12, 13, or 14,

two or more adjacent of $R_1$ to $R_4$, $R_{10}$, $R_{20}$, $R_{30}$, $R_{40}$, $R_{50}$, and $R_{60}$ are optionally bonded to each other to form a substituted or unsubstituted $C_5$-$C_{30}$ carbocyclic group or a substituted or unsubstituted $C_1$-$C_{30}$ heterocyclic group,

substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group are:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{11})(Q_{12})(Q_{13})$, $-Ge(Q_{11})(Q_{12})(Q_{13})$, $-C(=O)(Q_{11})$, $-S(=O)(Q_{11})$, $-S(=O)_2(Q_{11})$, $-B(Q_{11})(Q_{12})$, $-P(Q_{11})(Q_{12})$, $-P(=O)(Q_{11})(Q_{12})$, $-P(=S)(Q_{11})(Q_{12})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $-Ge(Q_{21})(Q_{22})(Q_{23})$, $-C(=O)(Q_{21})$, $-S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, $-P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, $-S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$ or $-P(=S)(Q_{31})(Q_{32})$; or

a combination thereof, and

$Q_1$ to $Q_3$, $Q_{11}$ to $Q_{13}$, $Q_{21}$ to $Q_{23}$ and $Q_{31}$ to $Q_{33}$ are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, a hydroxyl group, a cyano group, a $C_1$-$C_{60}$ alkyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, or a combination thereof.

According to an aspect, an organic light-emitting device includes at least one of the heterocyclic compounds represented by Formula 1.

According to another aspect, an organic light-emitting device includes a first electrode; a second electrode; and an organic layer arranged between the first electrode and the second electrode, wherein the organic layer comprises an emission layer, and wherein the organic layer further comprises at least one of the heterocyclic compounds represented by Formula 1.

According to an aspect, an electronic apparatus includes at least one heterocyclic compound represented by

Formula 1.

BRIEF DESCRIPTION OF THE DRAWINGS

The above and other aspects, features, and advantages of certain embodiments will be more apparent from the following description taken in conjunction with the accompanying drawings, in which:

FIG. 1 shows a schematic cross-sectional view of an organic light-emitting device according to one or more embodiments; and
FIGS. 2 to 6 show schematic views showing energy transfer of an organic light-emitting device according to one or more embodiments, respectively.

DETAILED DESCRIPTION OF THE EMBODIMENTS

Reference will now be made in further detail to embodiments, examples of which are illustrated in the accompanying drawings, wherein like reference numerals refer to like elements throughout the specification. In this regard, the present exemplary embodiments may have different forms and should not be construed as being limited to the detailed descriptions set forth herein. Accordingly, the embodiments are merely described in further detail below, and by referring to the figures, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10%, 5% of the stated value.

As used herein, an "energy level" (e.g., a highest occupied molecular orbital (HOMO) energy level or a triplet ($T_1$) energy level) is expressed as an absolute value from a vacuum level. In addition, when the energy level is referred to as being "deep," "high," or "large," the energy level has a large absolute value based on "0 electron Volts (eV)" of the vacuum

level, and when the energy level is referred to as being "shallow," "low," or "small," the energy level has a small absolute value based on "0 eV" of the vacuum level.

A heterocyclic compound according to one or more aspects is represented by Formula 1:

Formula 1

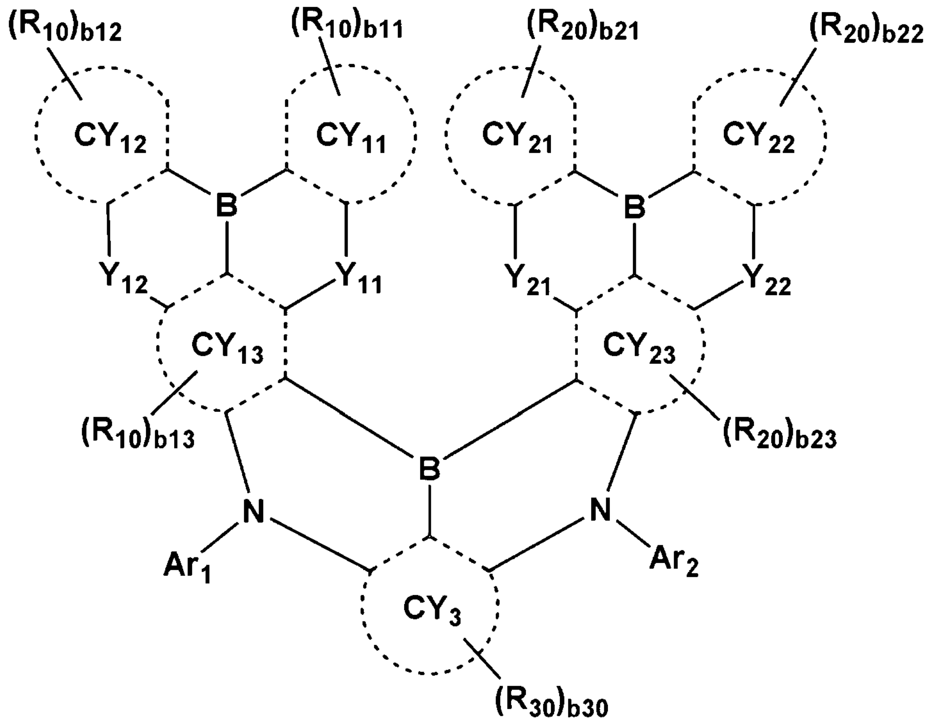

$Y_{11}$ and $Y_{12}$ in Formula 1 are each independently a single bond, O, S, Se, $N(Ar_3)$, $N(R_1)$, $C(R_1)(R_2)$, $Si(R_1)(R_2)$, $Ge(R_1)(R_2)$, $B(R_1)$, $P(R_1)$, $P(=O)(R_1)$, $S(=O)_2$, or C(=O).

$Y_{21}$ and $Y_{22}$ in Formula 1 are each independently a single bond, O, S, Se, $N(Ar_4)$, $N(R_3)$, $C(R_3)(R_4)$, $Si(R_3)(R_4)$, $Ge(R_3)(R_4)$, $B(R_3)$, $P(R_3)$, $P(=O)(R_3)$, $S(=O)_2$, or C(=O).

In one or more embodiments, $Y_{11}$ and $Y_{21}$ are each independently O, S, or Se.

In one or more embodiments, $Y_{12}$ and $Y_{22}$ are each independently O, S, Se, $N(Ar_3)$, $N(R_1)$, $C(R_1)(R_2)$, or $Si(R_1)(R_2)$.

$Ar_1$ to $Ar_4$ in Formula 1 are each independently a group represented by Formula 2.

Formula 2

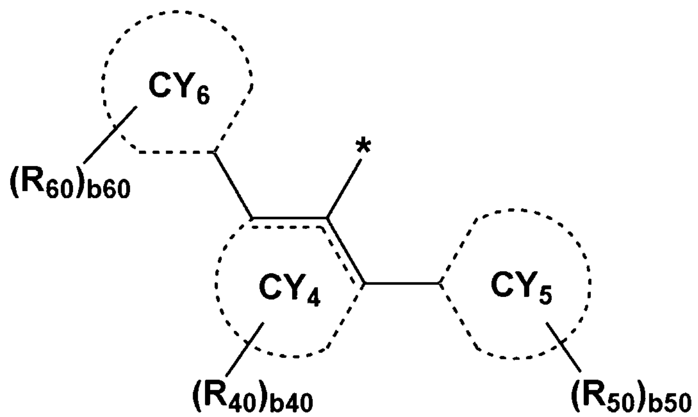

$CY_{11}$ to $CY_{13}$, $CY_{21}$ to $CY_{23}$, and $CY_3$ to $CY_6$ in Formulae 1 and 2 are each independently a $C_5$-$C_{30}$ carbocyclic group or

a $C_1$-$C_{30}$ heterocyclic group.

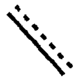

in Formula 2 indicates a single bond or a double bond. The two

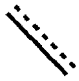

may not be a double bond at the same time.
* in Formula 2 indicates a binding site to a neighboring atom.

In one or more embodiments, $CY_{11}$ to $CY_{13}$, $CY_{21}$ to $CY_{23}$, and $CY_3$ to $CY_6$ may each independently be i) a first ring, ii) a second ring, iii) a condensed ring group in which at least two first rings are condensed, iv) a condensed ring group in which at least two second rings are condensed, or v) a condensed ring group in which at least one first ring is condensed with at least one second ring,

the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, $CY_{11}$ to $CY_{13}$, $CY_{21}$ to $CY_{23}$, and $CY_3$ to $CY_6$ may each independently be a $C_6$-$C_{30}$ aromatic carbocyclic group or a $C_1$-$C_{30}$ aromatic heterocyclic group.

In one or more embodiments, $CY_{11}$ to $CY_{13}$, $CY_{21}$ to $CY_{23}$, and $CY_3$ to $CY_6$ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

In one or more embodiments, $CY_{11}$ to $CY_{13}$, $CY_{21}$ to $CY_{23}$, and $CY_3$ to $CY_6$ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

In one or more embodiments, $CY_{11}$, $CY_{12}$, $CY_{21}$, $CY_{22}$, and $CY_3$ to $CY_6$ may each independently be a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, or a dibenzosilole group.

In one or more embodiments, $CY_{13}$ and $CY_{23}$ may each independently be a benzene group, a naphthalene group, a phenanthrene group, a pyridine group, a pyrimidine group, a quinoline group, an isoquinoline group, a phthalazine group, a naphthyridine group, a quinoxaline group, or a quinazoline group.

In one or more embodiments, the group represented by Formula 2 may be a group represented by Formula 2A:

Formula 2A

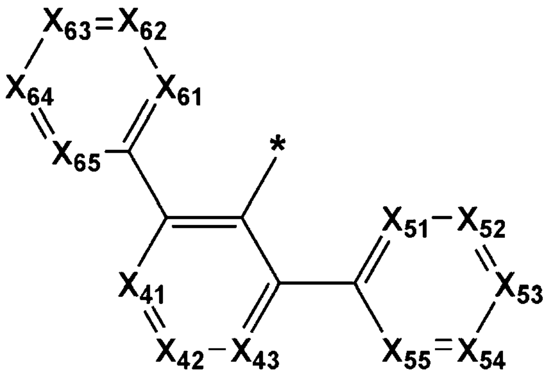

wherein, in Formula 2A,

$X_{41}$ may be $C(R_{41})$ or N, $X_{42}$ may be $C(R_{42})$ or N, and $X_{43}$ may be $C(R_{43})$ or N,
$X_{51}$ may be $C(R_{51})$ or N, $X_{52}$ may be $C(R_{52})$ or N, $X_{53}$ may be $C(R_{53})$ or N, $X_{54}$ may be $C(R_{54})$ or N, $X_{55}$ may be $C(R_{55})$ or N,
$X_{61}$ may be $C(R_{61})$ or N, $X_{62}$ may be $C(R_{62})$ or N, $X_{63}$ may be $C(R_{63})$ or N, $X_{64}$ may be $C(R_{64})$ or N, $X_{65}$ may be $C(R_{65})$ or N,
$R_{41}$ to $R_{43}$ are each independently as described in connection with $R_{40}$,
$R_{51}$ to $R_{55}$ are each independently as described in connection with $R_{50}$,
$R_{61}$ to $R_{65}$ are each independently as described in connection with $R_{60}$, and
* indicates a binding site to a neighboring atom.

In one or more embodiments, the group represented by Formula 2 may be a group represented by Formula 2A-1.

Formula 2A-1

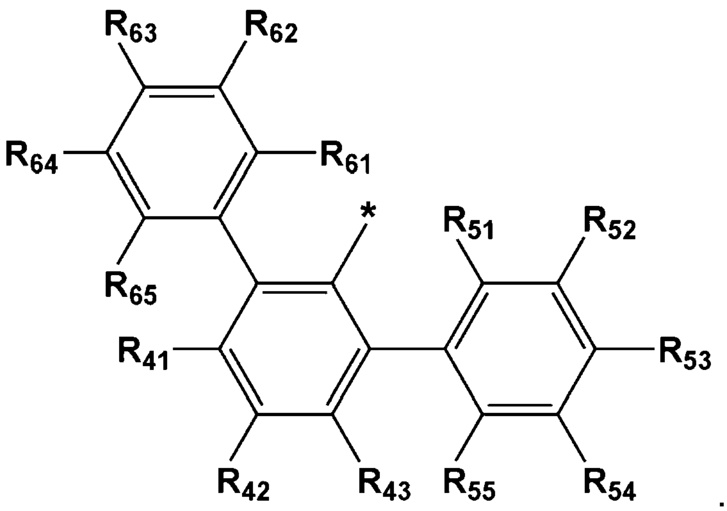

In Formula 2A-1,

$R_{41}$ to $R_{43}$ are each independently as described in connection with $R_{40}$,
$R_{51}$ to $R_{55}$ are each independently as described in connection with $R_{50}$,
$R_{61}$ to $R_{65}$ are each independently as described in connection with $R_{60}$, and

* indicates a binding site to a neighboring atom.

$R_1$ to $R_4$, $R_{10}$, $R_{20}$, $R_{30}$, $R_{40}$, $R_{50}$, and $R_{60}$ in Formulae 1 and 2 are each independently hydrogen, deuterium, -F, -Cl, -Br, -I, -$SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_1)(Q_2)(Q_3)$, - $Ge(Q_1)(Q_2)(Q_3)$, -$C(=O)(Q_1)$, -$S(=O)(Q_1)$, -$S(=O)_2(Q_1)$, -$B(Q_1)(Q_2)$, -$P(Q_1)(Q_2)$, - $P(=O)(Q_1)(Q_2)$, or -$P(=S)(Q_1)(Q_2)$.

In one or more embodiments, $R_1$ to $R_4$, $R_{10}$, $R_{20}$, $R_{30}$, $R_{40}$, $R_{50}$, and $R_{60}$ may each independently be:

hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with deuterium, -F, -Cl, -Br, -I, -$SF_5$, -$CD_3$, -$CD_2H$, -$CDH_2$, - $CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing (e.g. deuterated) $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl) cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1] pentyl group, a bicyclo[2.1.1]hexyl group, a bicyclo[2.2.1]heptyl group, a bicyclo[2.2.2]octyl group, a ($C_1$-$C_{20}$ alkyl)

cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_1)(Q_2)(Q_3)$, $-Ge(Q_1)(Q_2)(Q_3)$, $-C(=O)(Q_1)$, $-S(=O)(Q_1)$, $-S(=O)_2(Q_1)$, $-B(Q_1)(Q_2)$, $-P(Q_1)(Q_2)$, $-P(=O)(Q_1)(Q_2)$, or $-P(=S)(Q_1)(Q_2)$.

In one or more embodiments, $R_1$ to $R_4$, $R_{10}$, $R_{20}$, $R_{30}$, $R_{40}$, $R_{50}$, and $R_{60}$ may each independently be:

hydrogen, deuterium, -F, -Cl, -Br, -I, $-SF_5$, $-CD_3$, $-CD_2H$, $-CDH_2$, $-CF_3$, $-CF_2H$, $-CFH_2$, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group; or

a group represented by one of Formulae 9-1 to 9-61, 9-201 to 9-244, 10-1 to 10-154, or 10-201 to 10-350:

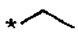
9-1
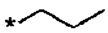
9-2
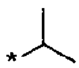
9-3
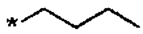
9-4
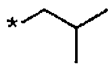
9-5
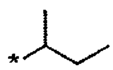
9-6
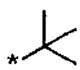
9-7
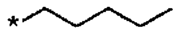
9-8

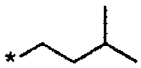
9-9
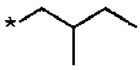
9-10
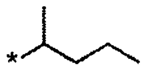
9-11
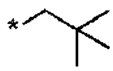
9-12
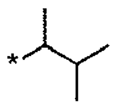
9-13
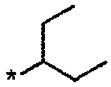
9-14
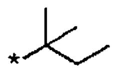
9-15

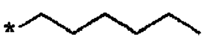
9-16
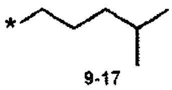
9-17
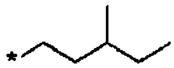
9-18
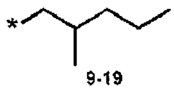
9-19
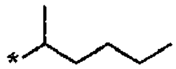
9-20
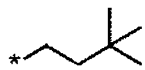
9-21

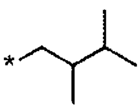
9-22
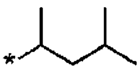
9-23
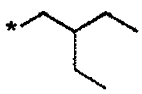
9-24
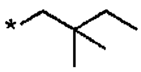
9-25
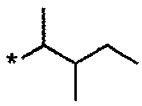
9-26
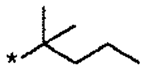
9-27
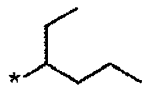
9-28

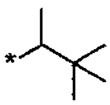
9-29
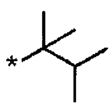
9-30
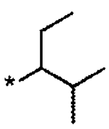
9-31
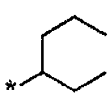
9-32
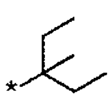
9-33
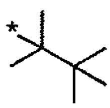
9-34
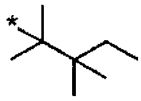
9-35
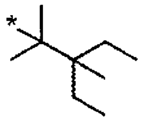
9-36

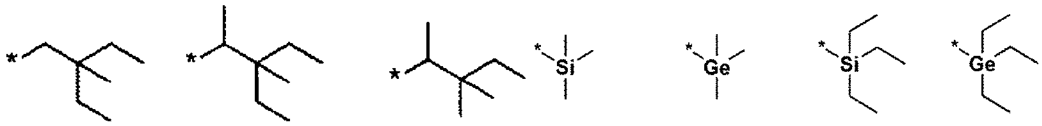

9-37 9-38 9-39 9-40 9-41 9-42 9-43

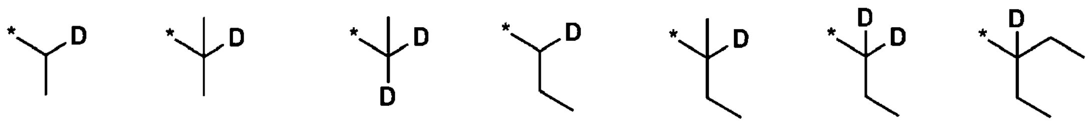

9-44 9-45 9-46 9-47 9-48 9-49 9-50

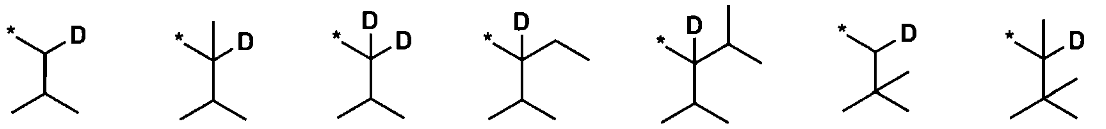

9-51 9-52 9-53 9-54 9-55 9-56 9-57

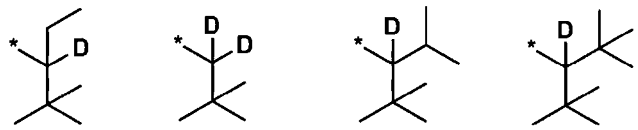

9-58 9-59 9-60 9-61

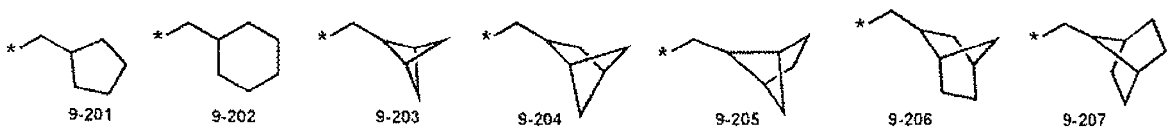

9-201 9-202 9-203 9-204 9-205 9-206 9-207

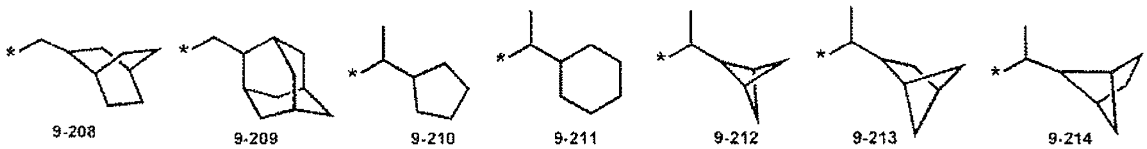

9-208 9-209 9-210 9-211 9-212 9-213 9-214

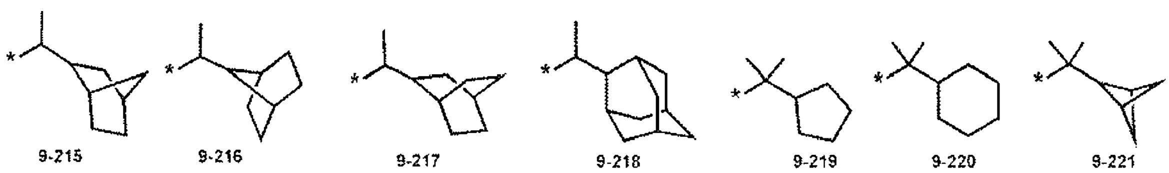

9-215 9-216 9-217 9-218 9-219 9-220 9-221

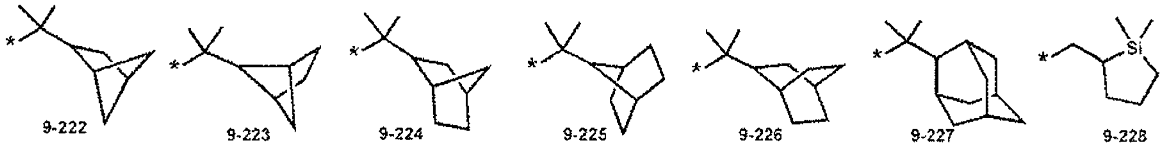

9-222 9-223 9-224 9-225 9-226 9-227 9-228

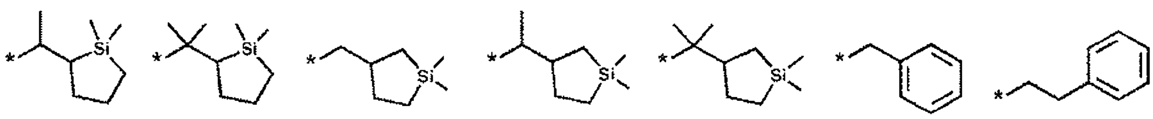

9-229 9-230 9-231 9-232 9-233 9-234 9-235

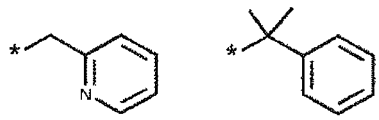

9-236 9-237

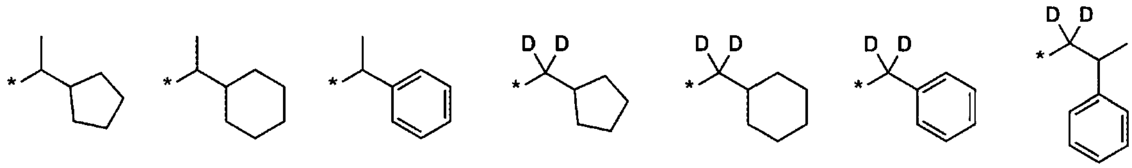

9-238 9-239 9-240 9-241 9-242 9-243 9-244

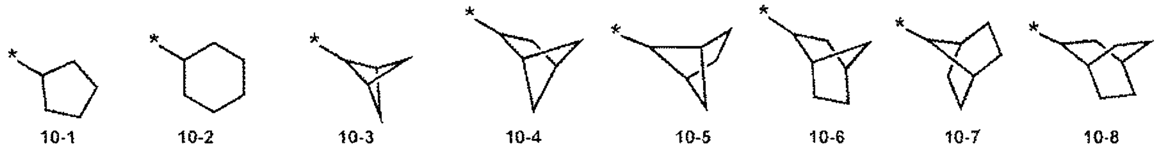

10-1 10-2 10-3 10-4 10-5 10-6 10-7 10-8

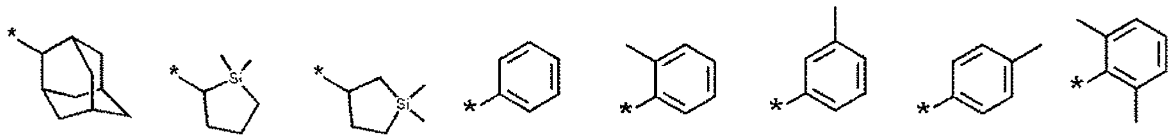

10-9 10-10 10-11 10-12 10-13 10-14 10-15 10-16

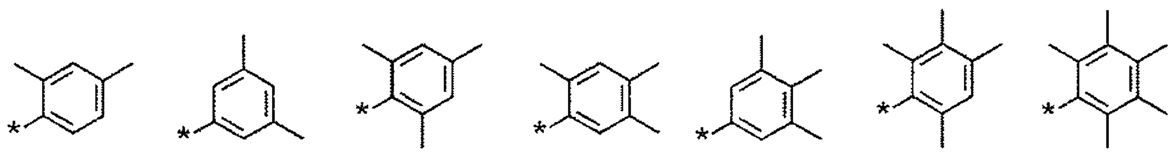

10-17 10-18 10-19 10-20 10-21 10-22 10-23

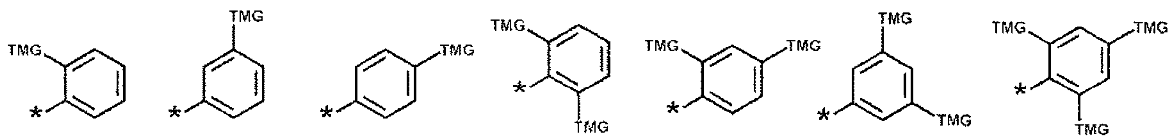

10-24 10-25 10-26 10-27 10-28 10-29 10-30

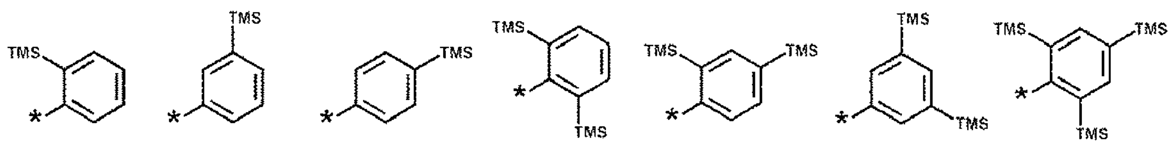

10-31 10-32 10-33 10-34 10-35 10-36 10-37

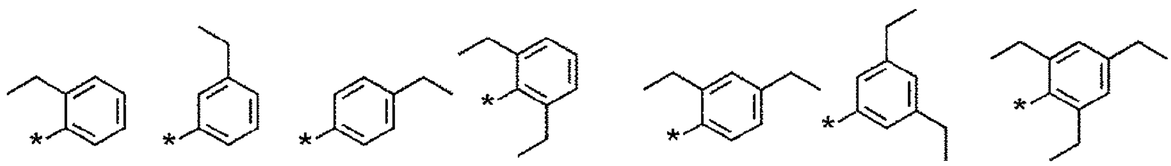

10-38 10-39 10-40 10-41 10-42 10-43 10-44

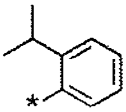
10-45
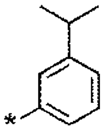
10-46
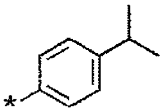
10-47
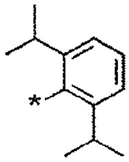
10-48
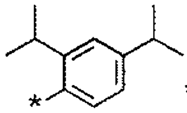
10-49
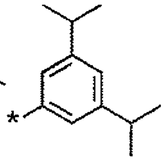
10-50
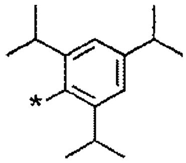
10-51

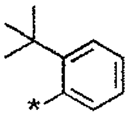
10-52
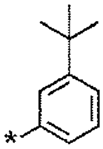
10-53
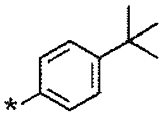
10-54
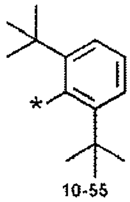
10-55
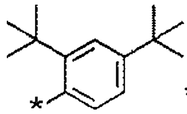
10-56
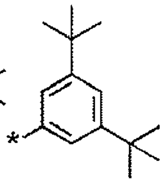
10-57
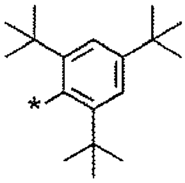
10-58

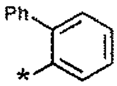
10-59
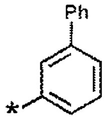
10-60
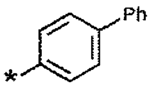
10-61
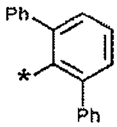
10-62
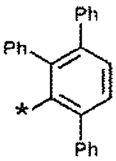
10-63
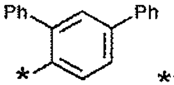
10-64
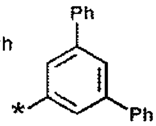
10-65
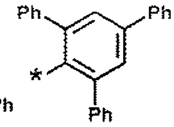
10-66

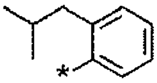
10-67
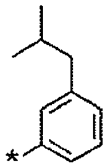
10-68
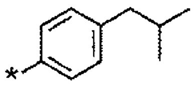
10-69
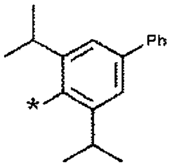
10-70
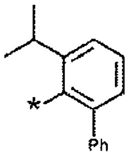
10-71
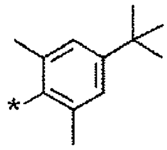
10-72

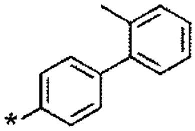
10-73
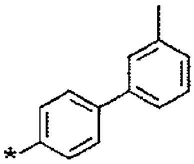
10-74
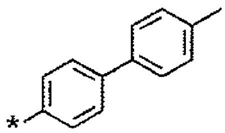
10-75
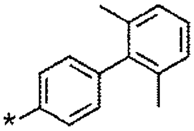
10-76
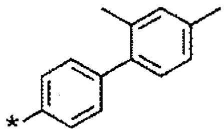
10-77

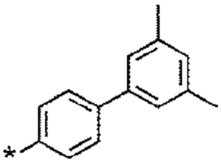
10-78
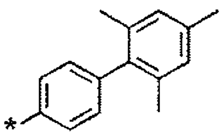
10-79
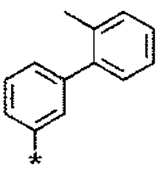
10-80
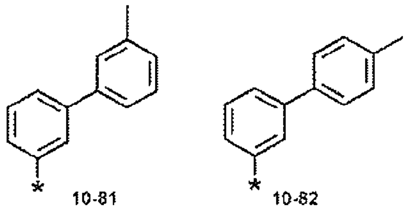
10-81
10-82

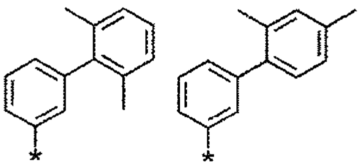
10-83
10-84
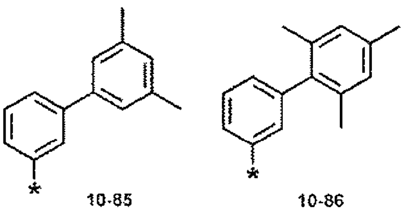
10-85
10-86
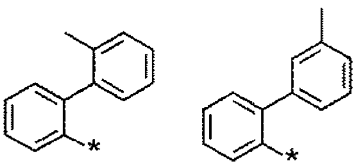
10-87
10-88

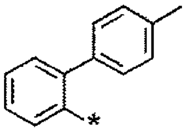
10-89

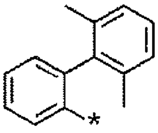
10-90

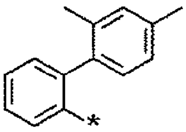
10-91

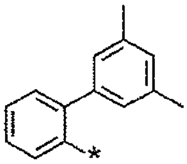
10-92

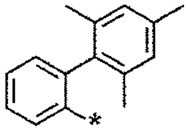
10-93

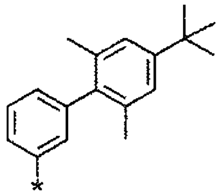
10-94

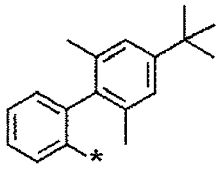
10-95

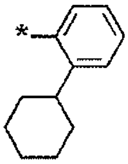
10-96

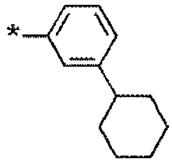
10-97

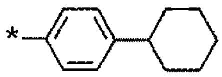
10-98

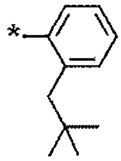
10-99

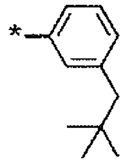
10-100

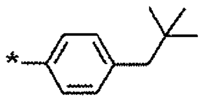
10-101

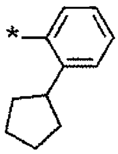
10-102

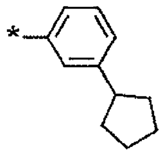
10-103

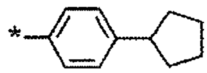
10-104

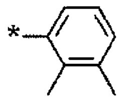
10-105

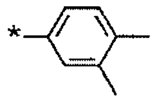
10-106

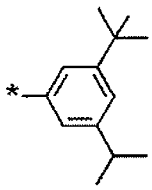
10-107

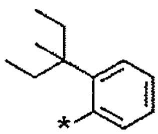
10-108

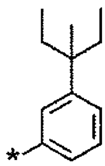
10-109

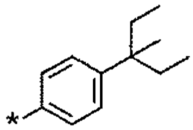
10-110

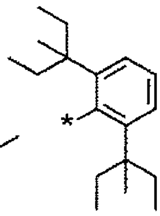
10-111

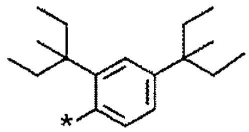
10-112

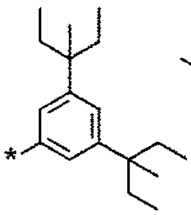
10-113

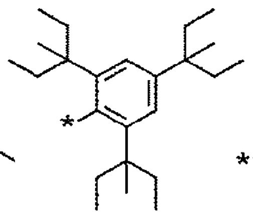
10-114

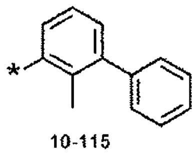
10-115

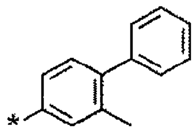
10-116

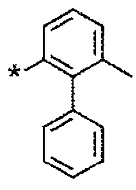
10-117

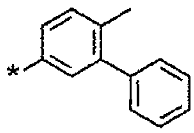
10-118

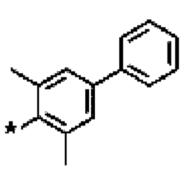
10-119

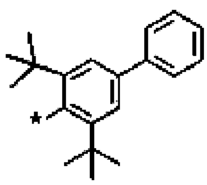
10-120

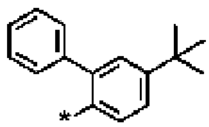
10-121

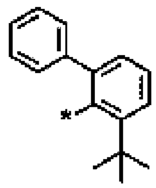
10-122

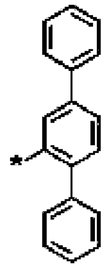
10-123

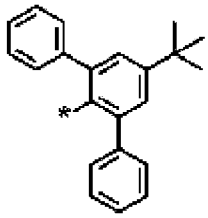 10-124 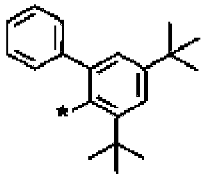 10-125 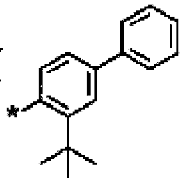 10-126 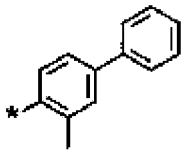 10-127 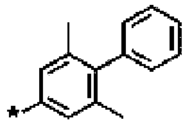 10-128

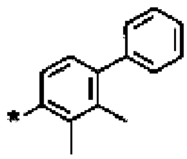 10-129

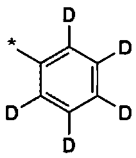 10-130 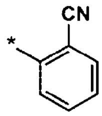 10-131 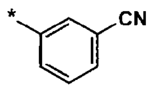 10-132 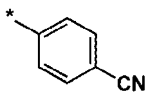 10-133 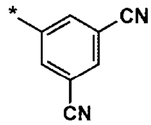 10-134 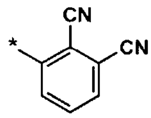 10-135

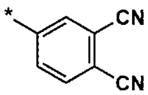 10-136 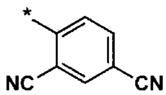 10-137 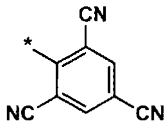 10-138 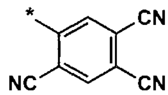 10-139 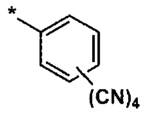 10-140 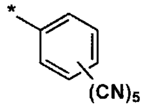 10-141

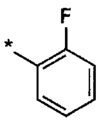 10-142 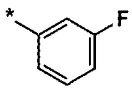 10-143 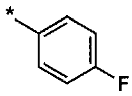 10-144 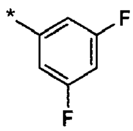 10-145 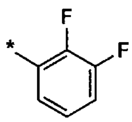 10-146 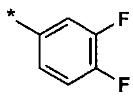 10-147 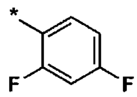 10-148

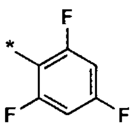 10-149 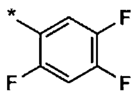 10-150 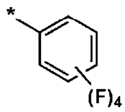 10-151 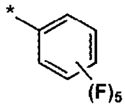 10-152 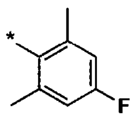 10-153 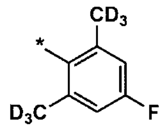 10-154

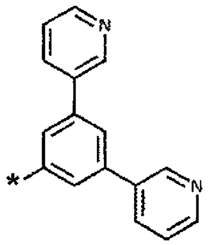 10-201 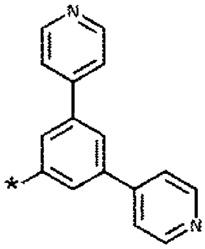 10-202 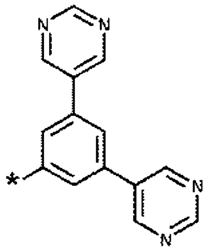 10-203 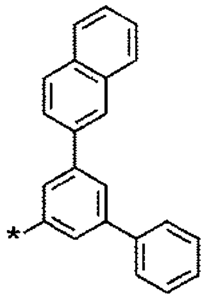 10-204 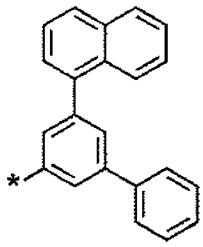 10-205

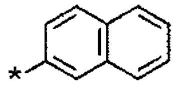
10-206

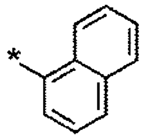
10-207

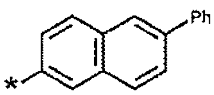
10-208

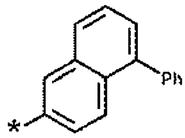
10-209

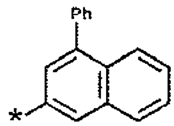
10-210

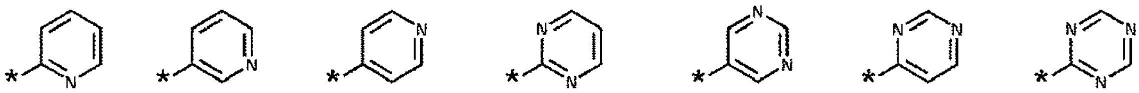
10-211 10-212 10-213 10-214 10-215 10-216 10-217

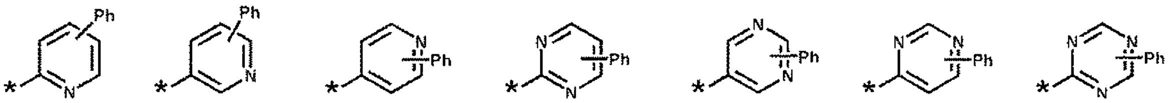
10-218 10-219 10-220 10-221 10-222 10-223 10-224

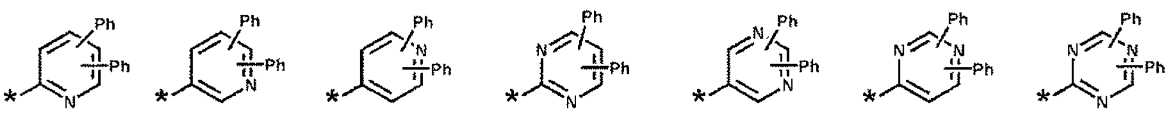
10-225 10-226 10-227 10-228 10-229 10-230 10-231

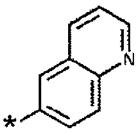
10-232

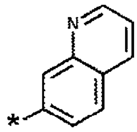
10-233

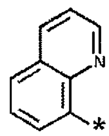
10-234

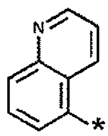
10-235

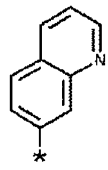
10-236

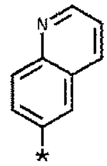
10-237

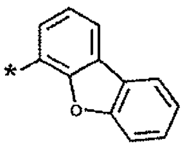
10-238

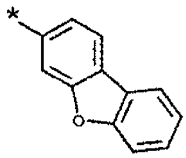
10-239

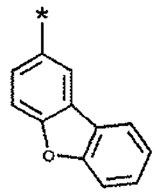
10-240

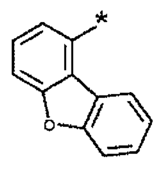
10-241

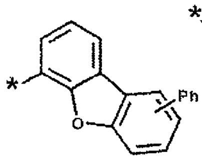
10-242

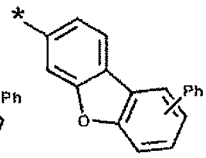
10-243

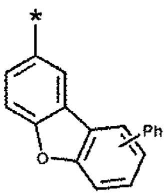
10-244

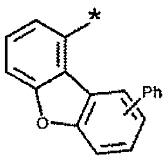
10-245

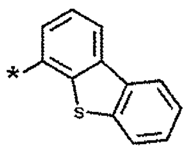
10-246

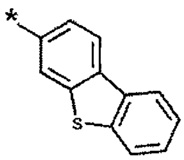
10-247

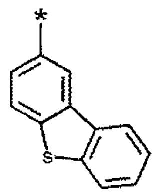
10-248

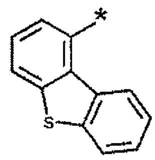
10-249

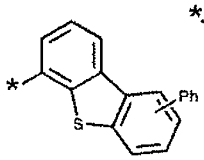
10-250

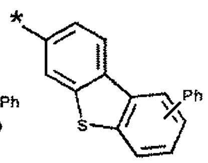
10-251

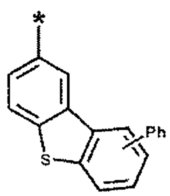
10-252

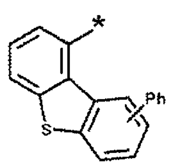
10-253

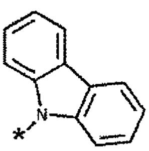
10-254

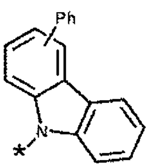
10-255

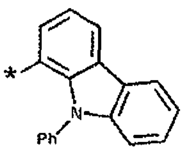
10-256
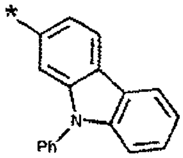
10-257
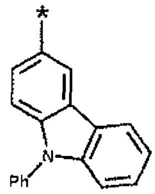
10-258
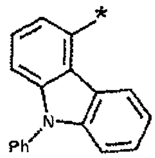
10-259
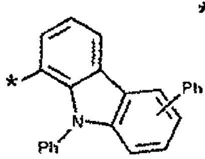
10-260
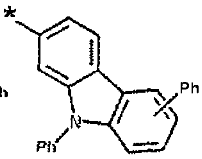
10-261

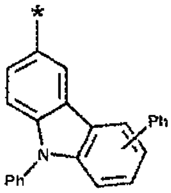
10-262
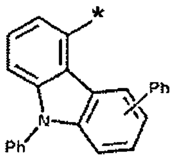
10-263
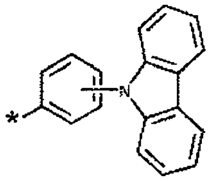
10-264
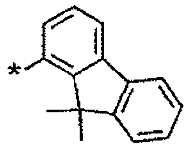
10-265
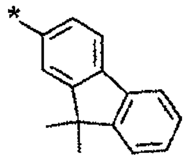
10-266
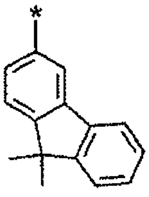
10-267

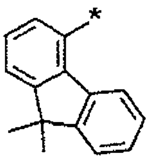
10-268
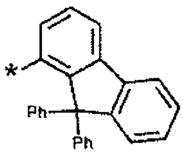
10-269
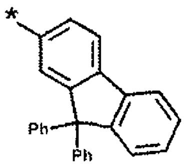
10-270
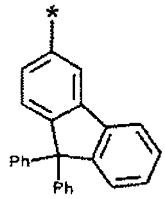
10-271
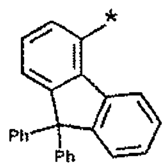
10-272

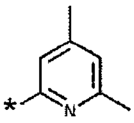
10-273
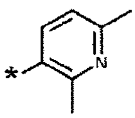
10-274
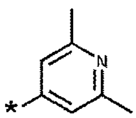
10-275
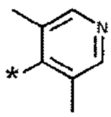
10-276
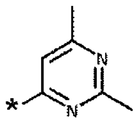
10-277
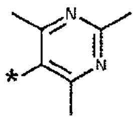
10-278
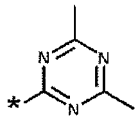
10-279

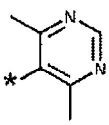
10-280
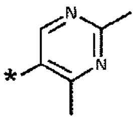
10-281
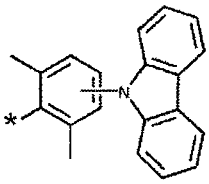
10-282
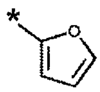
10-283
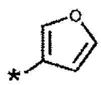
10-284
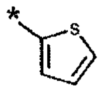
10-285
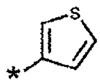
10-286

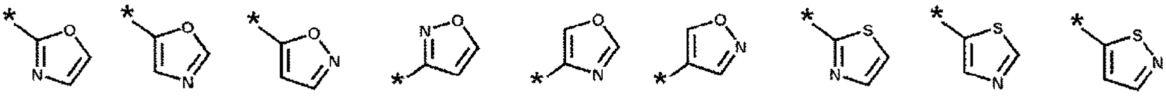
10-287 10-288 10-289 10-290 10-291 10-292 10-293 10-294 10-295

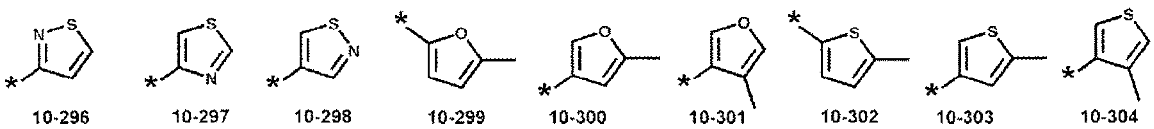
10-296 10-297 10-298 10-299 10-300 10-301 10-302 10-303 10-304

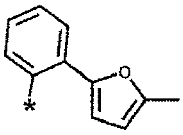
10-305
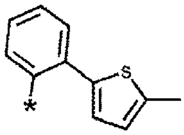
10-306
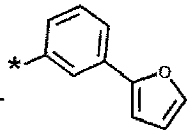
10-307
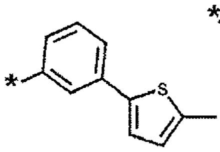
10-308
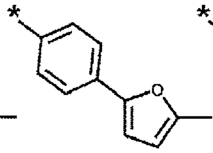
10-309
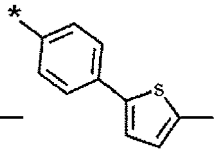
10-310

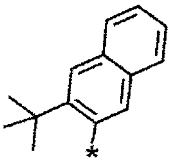
10-311
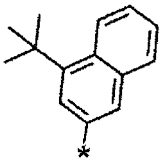
10-312
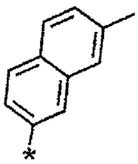
10-313
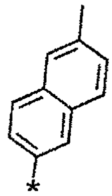
10-314
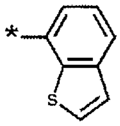
10-315
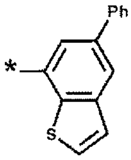
10-316
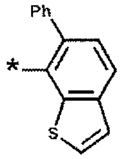
10-317

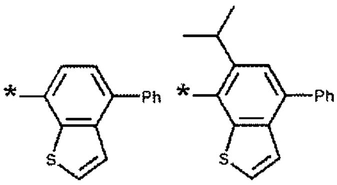
10-318
10-319
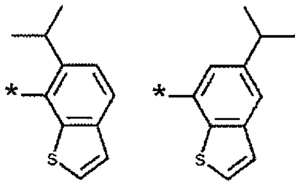
10-320
10-321
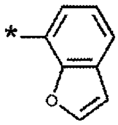
10-322
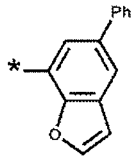
10-323
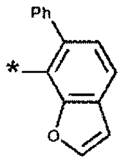
10-324

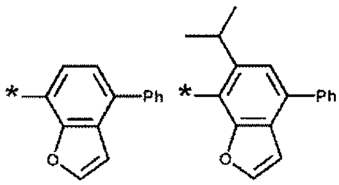
10-325
10-326
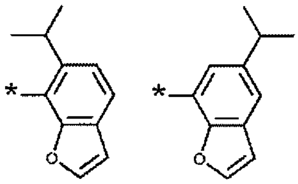
10-327
10-328
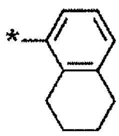
10-329
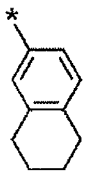
10-330
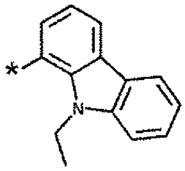
10-331

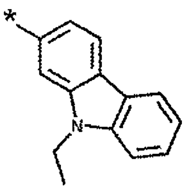
10-332
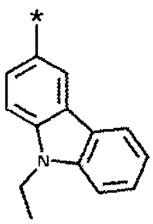
10-333
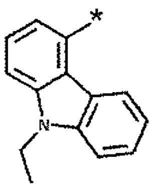
10-334
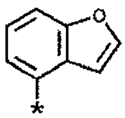
10-335
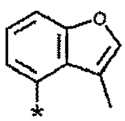
10-336
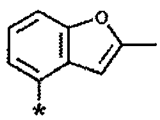
10-337

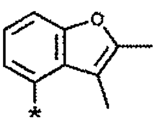
10-338
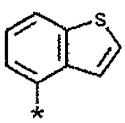
10-339
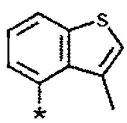
10-340
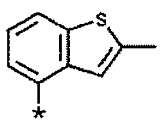
10-341
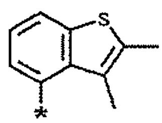
10-342
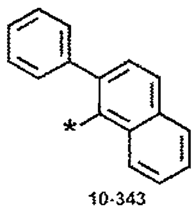
10-343

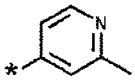
10-344
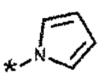
10-345
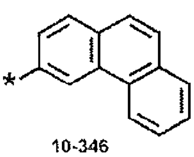
10-346
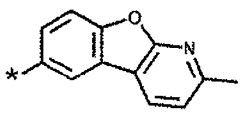
10-347
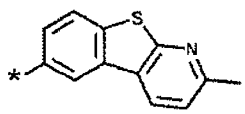
10-348

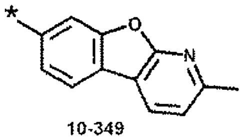

10-349

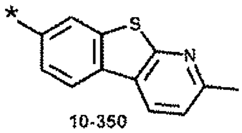

10-350

wherein, in Formulae 9-1 to 9-61, 9-201 to 9-244, 10-1 to 10-154, and 10-201 to 10-350, * represents a binding site to an adjacent atom, "Ph" represents a phenyl group, "TMS" represents a trimethylsilyl group, and "TMG" represents a trimethylgermyl group.

In one or more embodiments, $R_1$ to $R_4$, $R_{10}$, $R_{20}$, $R_{30}$, $R_{40}$, $R_{50}$, and $R_{60}$ may each independently be:

hydrogen, deuterium, -F, -Cl, -Br, -I, $-SF_5$, $-CD_3$, $-CD_2H$, $-CDH_2$, $-CF_3$, $-CF_2H$, $-CFH_2$, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group; or
a group represented by one of Formulae 9-1 to 9-61, 9-201 to 9-244, 10-1 to 10-154, or 10-201 to 10-350.

In one or more embodiments, at least one of $R_{30}$ in the number of b30 may be -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, at least one of $R_{30}$ in the number of b30 may be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, at least one of $R_{30}$ in the number of b30 may be -F, -Cl, -Br, -I, $-SF_5$, a cyano group, a methyl group, an ethyl group, an n-propyl group, an iso-propyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a $C_1$-$C_{20}$ alkylphenyl group, or a naphthyl group.

b11 to b13, b21 to b23, b30, b40, b50, and b60 in Formulae 1 and 2 are each independently 1, 2, 3, 4, 5, 6, 7, 8, 9, 10, 11, 12, 13, or 14.

In one or more embodiments, b11 to b13, b21 to b23, b30, b40, b50 and b60 may each independently be 1, 2, 3, 4, 5, 6, 7, or 8.

In one or more embodiments, b11, b12, b21, and b22 may each independently be 1, 2, 3, or 4.

In one or more embodiments, b13 and b23 may each be 1.

In one or more embodiments, b30 may be 1, 2, or 3.

Two or more of adjacent $R_1$ to $R_4$, $R_{10}$, $R_{20}$, $R_{30}$, $R_{40}$, $R_{50}$, and $R_{60}$ in Formulae 1 and 2 are optionally bonded to each other to form a substituted or unsubstituted $C_5$-$C_{30}$ carbocyclic group or a substituted or unsubstituted $C_1$-$C_{30}$ heterocyclic group.

In one or more embodiments, the heterocyclic compound may be represented by Formula 11:

Formula 11

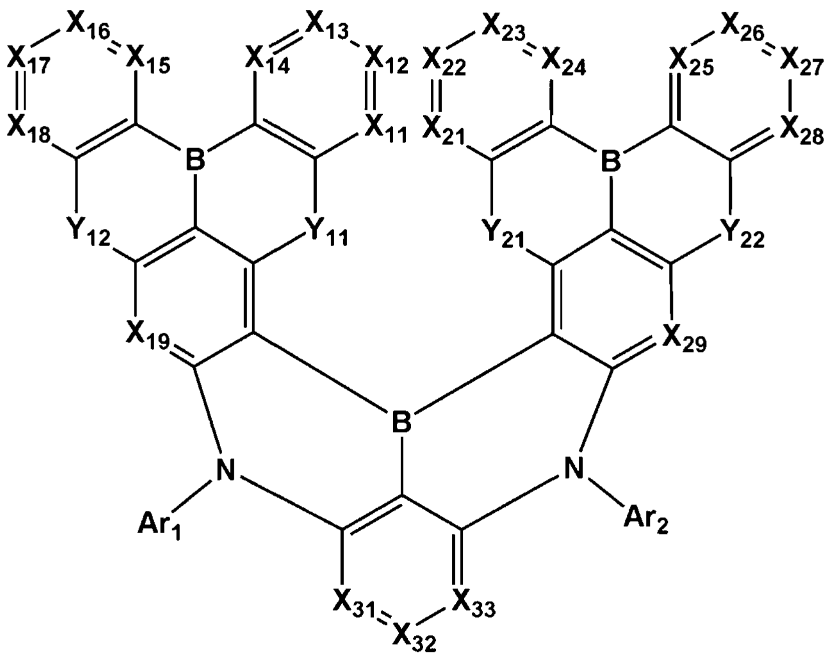

wherein, in Formula 11,

$Y_{11}$, $Y_{12}$, $Y_{21}$, $Y_{22}$, $Ar_1$, and $Ar_2$ are as described above,
$X_{11}$ may be $C(R_{11})$ or N, $X_{12}$ may be $C(R_{12})$ or N, $X_{13}$ may be $C(R_{13})$ or N, $X_{14}$ may be $C(R_{14})$ or N, $X_{15}$ may be $C(R_{15})$ or N, $X_{16}$ may be $C(R_{16})$ or N, $X_{17}$ may be $C(R_{17})$ or N, $X_{18}$ may be $C(R_{18})$ or N, $X_{19}$ may be $C(R_{19})$ or N,
$X_{21}$ may be $C(R_{21})$ or N, $X_{22}$ may be $C(R_{22})$ or N, $X_{23}$ may be $C(R_{23})$ or N, $X_{24}$ may be $C(R_{24})$ or N, $X_{25}$ may be $C(R_{25})$ or N, $X_{26}$ may be $C(R_{26})$ or N, $X_{27}$ may be $C(R_{27})$ or N, $X_{28}$ may be $C(R_{28})$ or N, $X_{29}$ may be $C(R_{29})$ or N,
$X_{31}$ may be $C(R_{31})$ or N, $X_{32}$ may be $C(R_{32})$ or N, $X_{33}$ may be $C(R_{33})$ or N,
$R_{11}$ to $R_{19}$ are each independently as described in connection with $R_{10}$,
$R_{21}$ to $R_{29}$ are each independently as described in connection with $R_{20}$, and
$R_{31}$ to $R_{33}$ are each independently as described in connection with $R_{30}$.

In one or more embodiments, the heterocyclic compound may be represented by Formula 21:

Formula 21

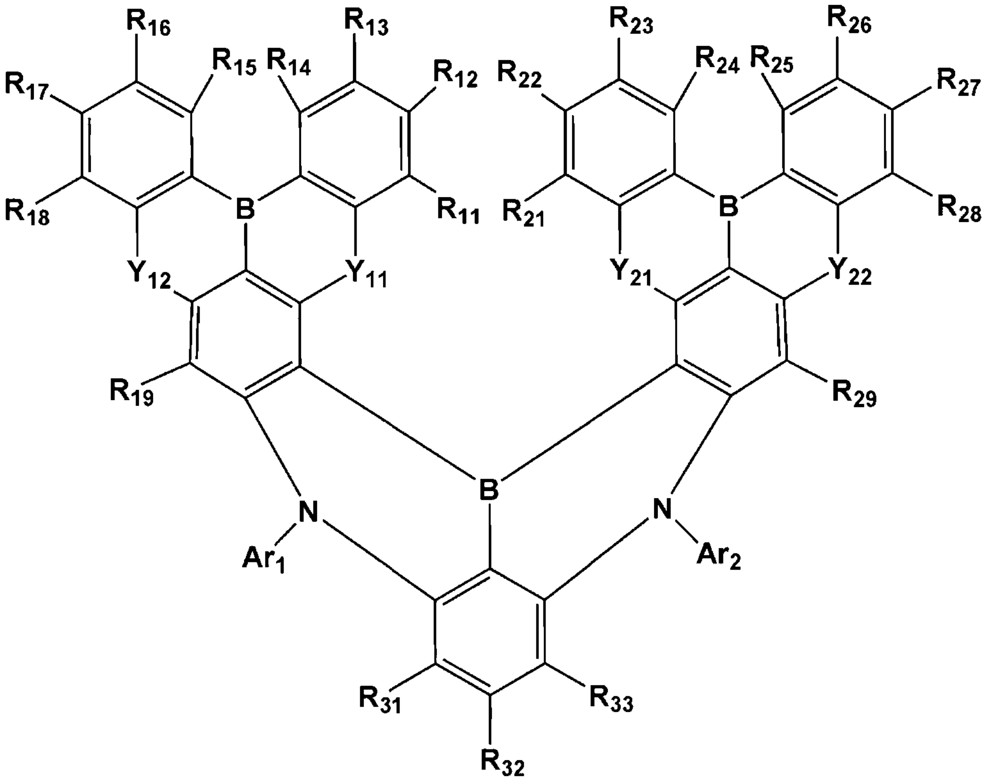

wherein, in Formula 21,

$Y_{11}$, $Y_{12}$, $Y_{21}$, $Y_{22}$, $Ar_1$, and $Ar_2$ are as described above,
$R_{11}$ to $R_{19}$ are each independently as described in connection with $R_{10}$,
$R_{21}$ to $R_{29}$ are each independently as described in connection with $R_{20}$, and
$R_{31}$ to $R_{33}$ are each independently as described in connection with $R_{30}$.

In one or more embodiments, the heterocyclic compound may be represented by Formula 31:

Formula 31

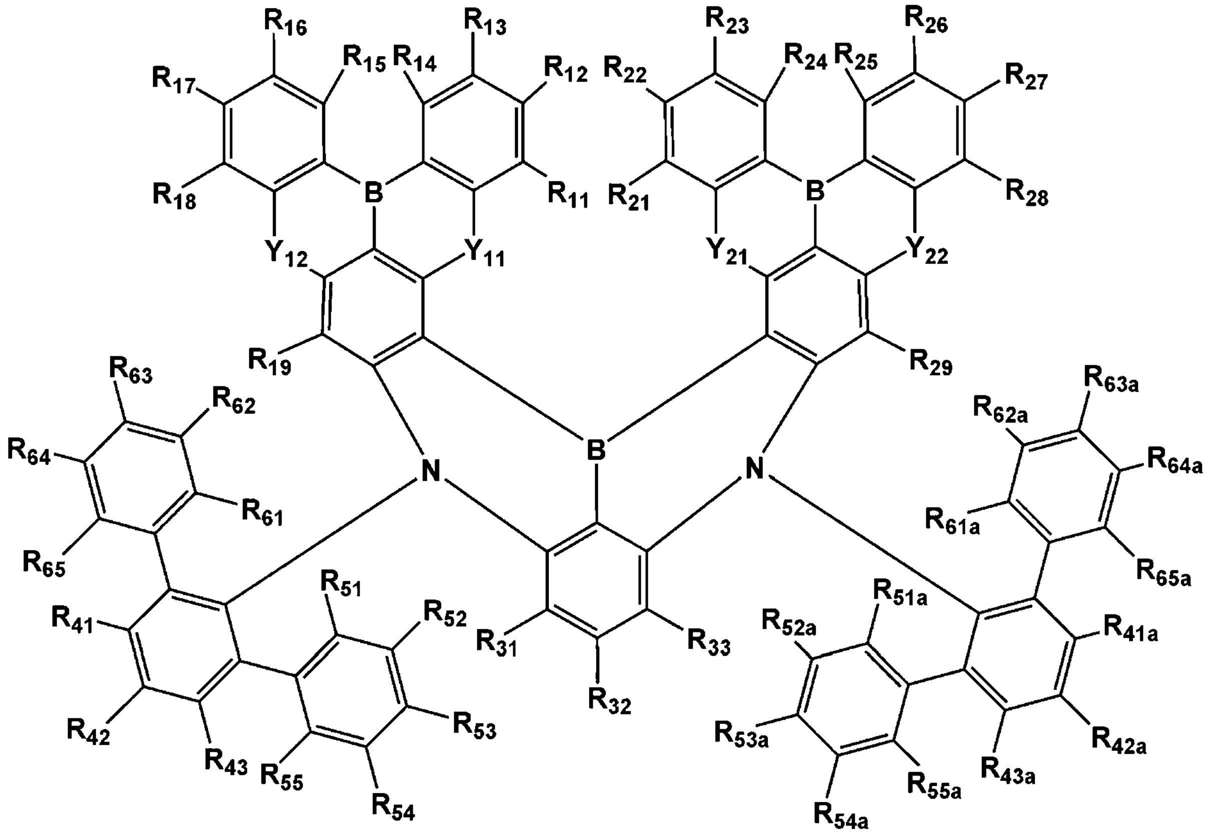

wherein, in Formula 31,

$Y_{11}$, $Y_{12}$, $Y_{21}$, and $Y_{22}$ are as described above,
$R_{11}$ to $R_{19}$ are each independently as described in connection with $R_{10}$,
$R_{21}$ to $R_{29}$ are each independently as described in connection with $R_{20}$,
$R_{31}$ to $R_{33}$ are each independently as described in connection with $R_{30}$,
$R_{41}$ to $R_{43}$ and $R_{41a}$ to $R_{43a}$ are each independently as described in connection with $R_{40}$,
$R_{51}$ to $R_{55}$ and $R_{51a}$ to $R_{55a}$ are each independently as described in connection with $R_{50}$, and
$R_{61}$ to $R_{65}$ and $R_{61a}$ to $R_{65a}$ are each independently as described in connection with $R_{60}$.

In one or more embodiments, at least one of $R_{31}$ to $R_{33}$ in Formulae 11, 21, and 31 may be -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, at least one of $R_{31}$ to $R_{33}$ in Formulae 11, 21, and 31 may be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, $R_{32}$ in Formulae 11, 21, and 31 may be -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In one or more embodiments, $R_{32}$ in Formulae 11, 21, and 31 may be -F, -Cl, -Br, -I, $-SF_5$, a cyano group, a methyl group, an ethyl group, an n-propyl group, an iso-propyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a $C_1$-$C_{20}$ alkylphenyl group, or

a naphthyl group.

In one or more embodiments, $R_{31}$ and $R_{33}$ in Formulae 11, 21, and 31 may each independently be hydrogen or deuterium.

In one or more embodiments, in Formula 31, at least one of $R_{11}$ to $R_{14}$, at least one of $R_{15}$ to $R_{18}$, at least one of $R_{21}$ to $R_{24}$, at least one of $R_{25}$ to $R_{28}$, at least one of $R_{41}$ to $R_{43}$, and/or at least one of $R_{41a}$ to $R_{43a}$ may each independently be as described in connection with the at least one of $R_{31}$ to $R_{33}$ in Formulae 11, 21 and 31.

In one or more embodiments, in Formula 31, at least one of $R_{11}$ to $R_{14}$, at least one of $R_{15}$ to $R_{18}$, at least one of $R_{21}$ to $R_{24}$, at least one of $R_{25}$ to $R_{28}$, at least one of $R_{41}$ to $R_{43}$, and/or at least one of $R_{41a}$ to $R_{43a}$ may each independently be as described in connection with $R_{32}$ in Formulae 11, 21 and 31.

In one or more embodiments, in Formula 31, at least one of $R_{11}$ to $R_{14}$, at least one of $R_{15}$ to $R_{18}$, at least one of $R_{21}$ to $R_{24}$, at least one of $R_{25}$ to $R_{28}$, at least one of $R_{41}$ to $R_{43}$, at least one of $R_{41a}$ to $R_{43a}$, and/or at least one of $R_{31}$ to $R_{33}$ may each independently be a $C_1$-$C_{20}$ alkyl group (e.g., a branched $C_3$-$C_{20}$ alkyl group, or a branched $C_3$-$C_{10}$ alkyl group), a $C_1$-$C_{20}$ alkoxy group, or a $C_1$-$C_{20}$ alkylthio group, each unsubstituted or substituted with deuterium, -F, -Cl, -Br, -I, -$SF_5$, -$CD_3$, -$CD_2H$, -$CDH_2$, -$CF_3$, -$CF_2H$, -$CFH_2$, a cyano group, or a combination thereof.

In one or more embodiments, in Formula 31, $R_{13}$, $R_{16}$, $R_{23}$, $R_{26}$, $R_{42}$, $R_{42a}$ and $R_{32}$ may each independently be a $C_1$-$C_{20}$ alkyl group (e.g., a branched $C_3$-$C_{20}$ alkyl group, or a branched $C_3$-$C_{10}$ alkyl group), a $C_1$-$C_{20}$ alkoxy group, or a $C_1$-$C_{20}$ alkylthio group, each unsubstituted or substituted with deuterium, -F, -Cl, -Br, -I, -$SF_5$, -$CD_3$, - $CD_2H$, -$CDH_2$, -$CF_3$, -$CF_2H$, -$CFH_2$, a cyano group, or a combination thereof.

In one or more embodiments, in Formula 31, $R_{13}$, $R_{16}$, $R_{23}$, $R_{26}$, $R_{42}$, $R_{42a}$ and $R_{32}$ may each independently be a branched $C_3$-$C_{20}$ (e.g., $C_3$-$C_{10}$) alkyl group unsubstituted or substituted with deuterium, -$CD_3$, -$CD_2H$, -$CDH_2$, or a combination thereof.

The above detailed description about the various groups in Formula 31 may also be applicable to the corresponding groups in Formulae 11 and 21.

In one or more embodiments, the heterocyclic compound may have a symmetrical structure or an asymmetrical structure.

For example, the heterocyclic compound may have a symmetrical structure.

In one or more embodiments, the heterocyclic compound may have an asymmetric structure.

Substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group are:

deuterium, -F, -Cl, -Br, -I, -$SF_5$, -$CD_3$, -$CD_2H$, -$CDH_2$, -$CF_3$, -$CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkylthio group, a $C_1$-$C_{60}$ alkoxy group, or a $C_1$-$C_{60}$ alkylthio group, each substituted with deuterium, -F, -Cl, -Br, -I, -$SF_5$, -$CD_3$, -$CD_2H$, -$CDH_2$, -$CF_3$, - $CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{11}$)($Q_{12}$), - Si($Q_{11}$)($Q_{12}$)($Q_{13}$), -Ge($Q_{11}$)($Q_{12}$)($Q_{13}$), -C(=O)($Q_{11}$), -S(=O)($Q_{11}$), -S(=O)$_2$($Q_{11}$), -B($Q_{11}$)($Q_{12}$), -P($Q_{11}$)($Q_{12}$), -P(=O)($Q_{11}$)($Q_{12}$), -P(=S)($Q_{11}$)($Q_{12}$), or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_2$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, -$SF_5$, - $CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid

group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $-Ge(Q_{21})(Q_{22})(Q_{23})$, $-C(=O)(Q_{21})$, - $S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, - $P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, - $S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$, or - $P(Q_{31})(Q_{32})$; or

a combination thereof.

$Q_1$ to $Q_3$, $Q_{11}$ to $Q_{13}$, $Q_{21}$ to $Q_{23}$ and $Q_{31}$ to $Q_{33}$ as used herein may each independently be:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, a hydroxyl group, a cyano group, a $C_1$-$C_{60}$ alkyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, or a combination thereof.

For example, $Q_1$ to $Q_3$, $Q_{11}$ to $Q_{13}$, $Q_{21}$ to $Q_{23}$ and $Q_{31}$ to $Q_{33}$ as used herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or

an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or a combination thereof.

In one or more embodiments, the heterocyclic compound may be at least one of Compounds 1 to 510:

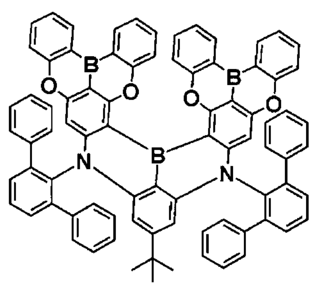

**1**

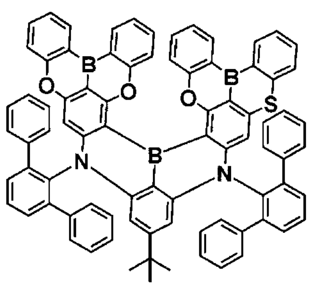

**2**

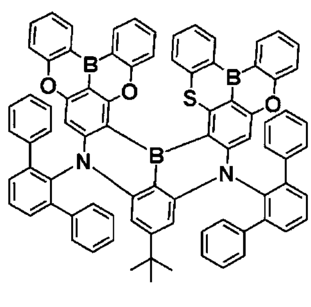

**3**

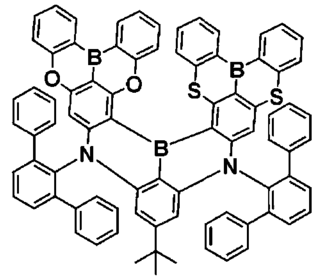

**4**

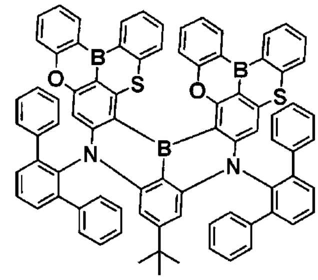

**5**

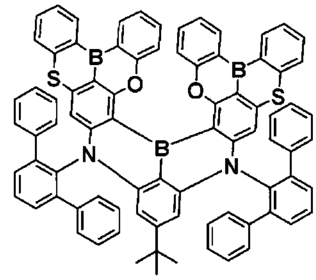

**6**

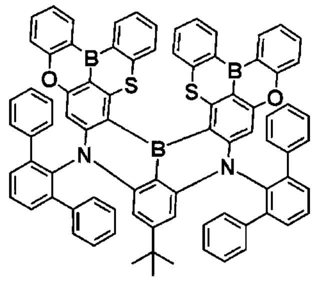

**7**

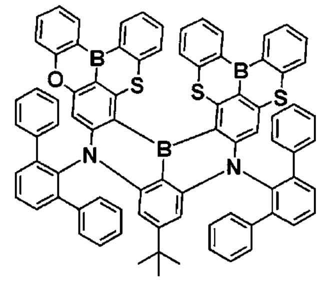

**8**

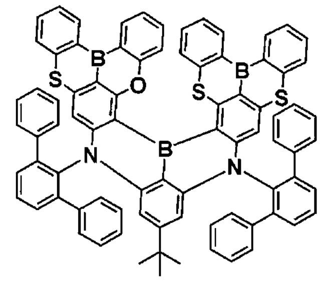

**9**

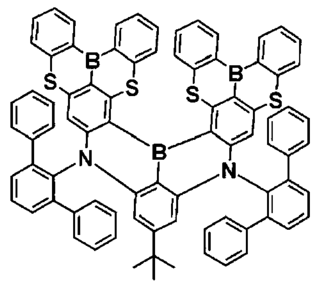

**10**

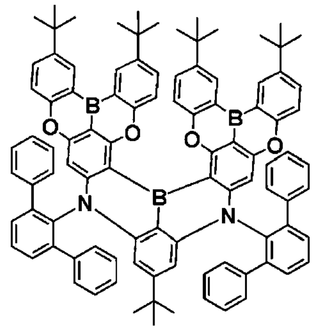

**11**

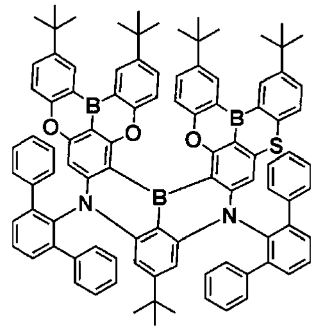

**12**

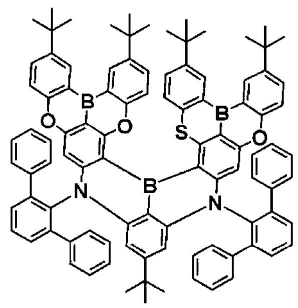

**13**

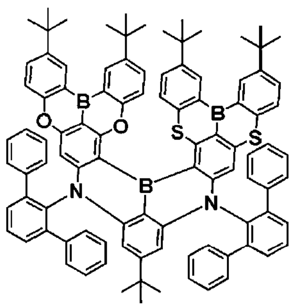

**14**

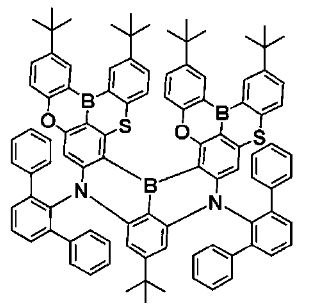

**15**

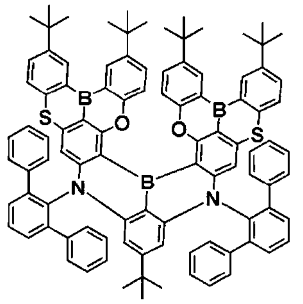

16

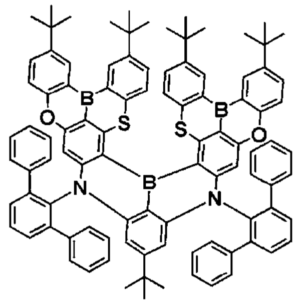

17

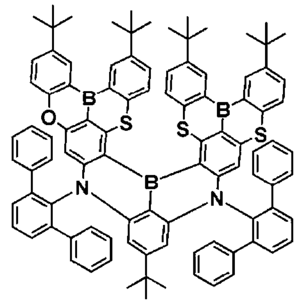

18

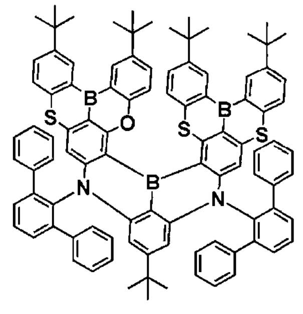

19

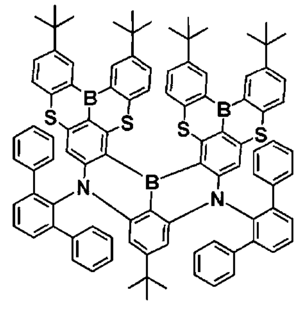

20

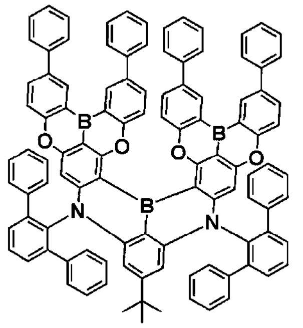

21

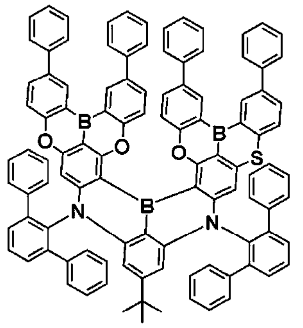

22

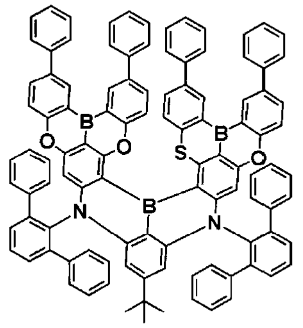

23

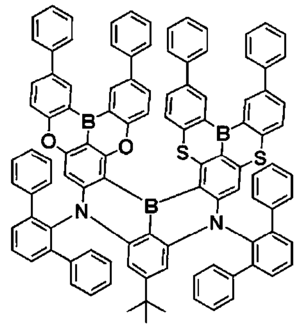

24

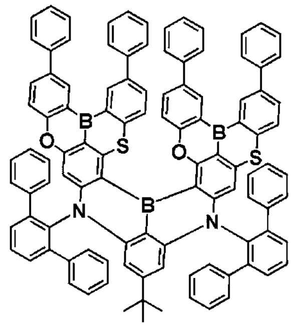

25

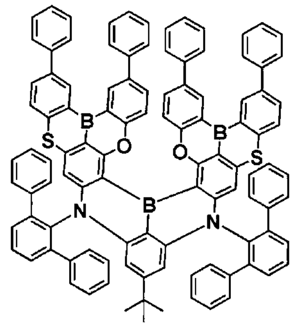

26

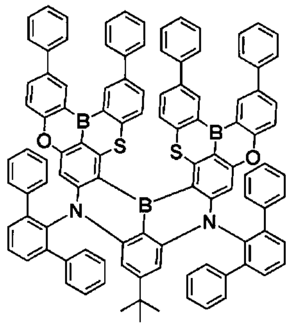

27

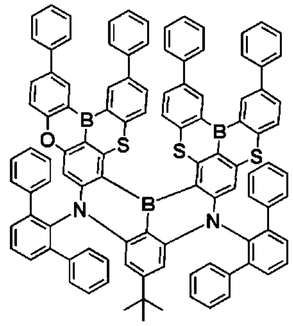

**28**

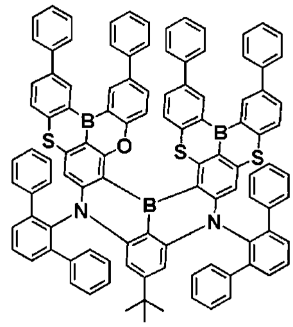

**29**

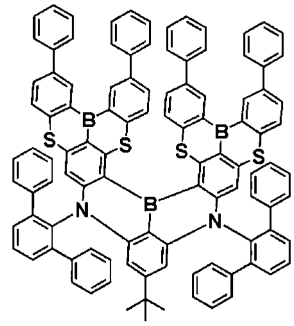

**30**

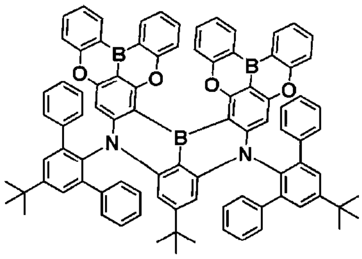

**31**

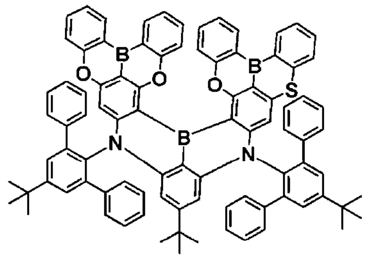

**32**

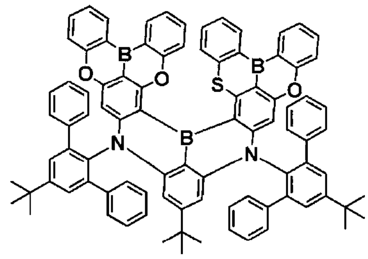

**33**

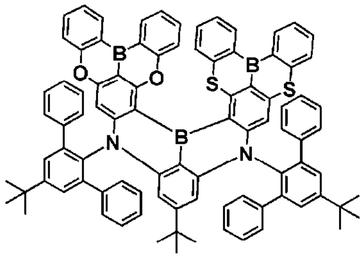

**34**

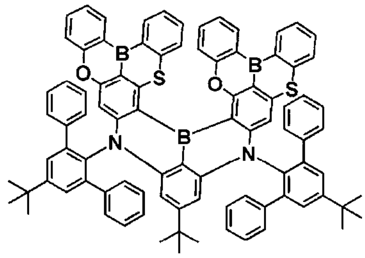

**35**

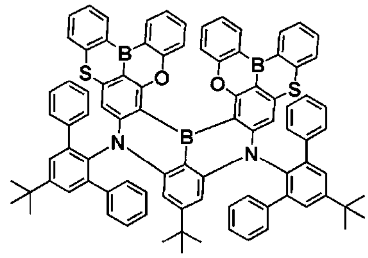

**36**

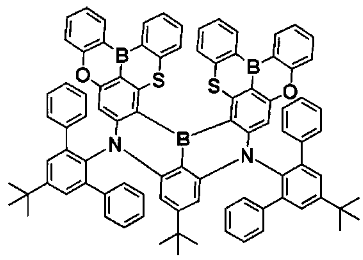

**37**

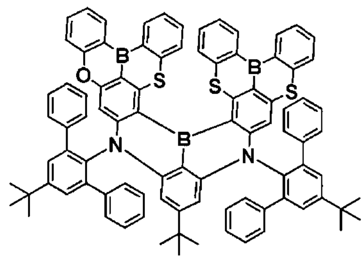

**38**

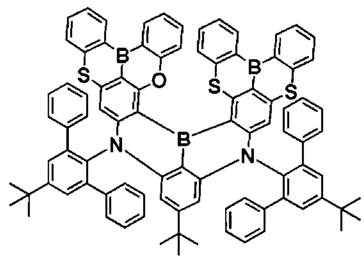

**39**

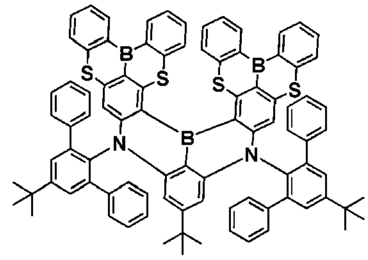

40

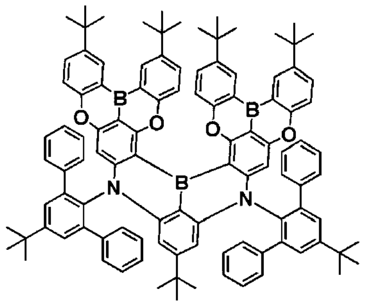

41

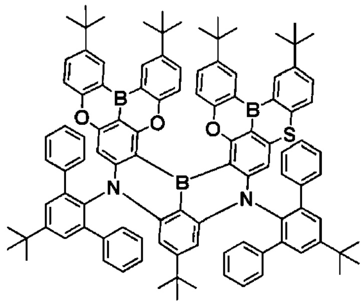

42

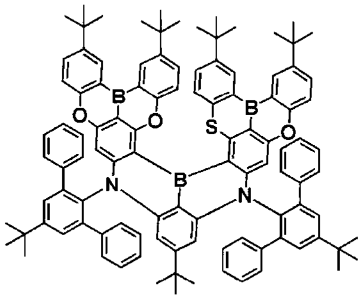

43

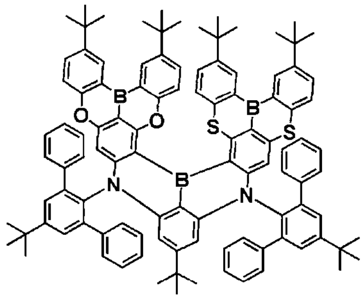

44

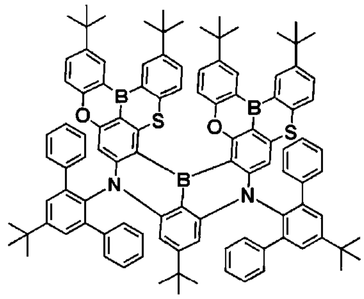

45

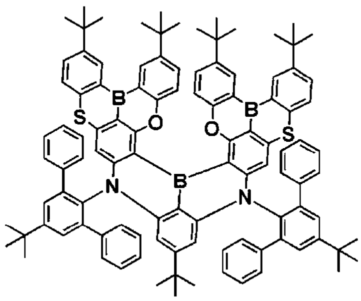

46

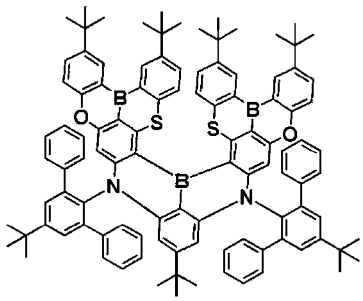

47

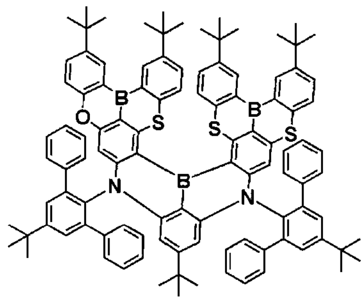

48

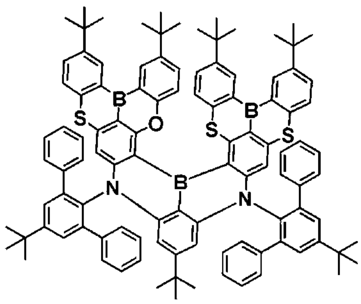

49

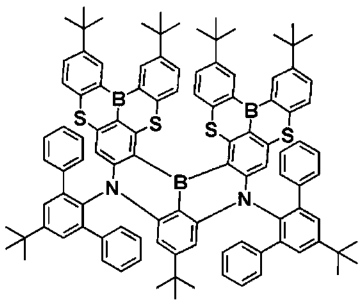

50

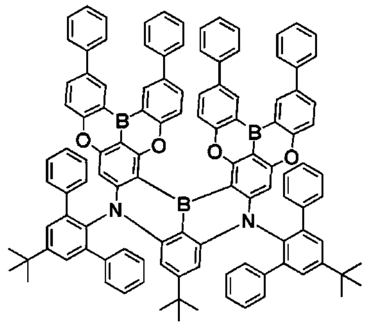

51

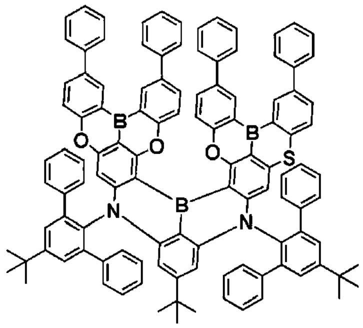

52

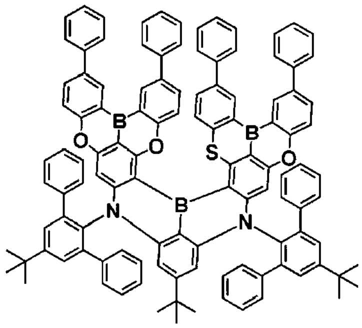

53

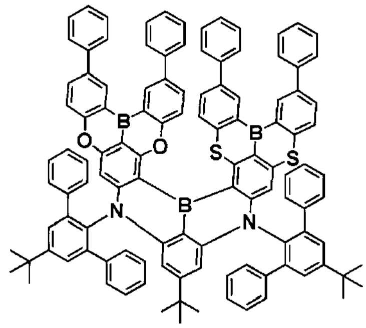

54

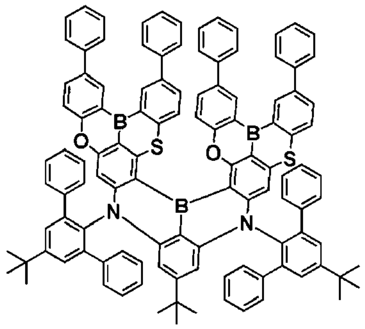

55

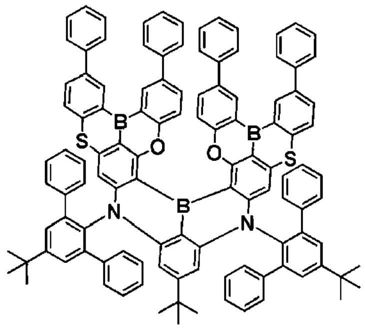

56

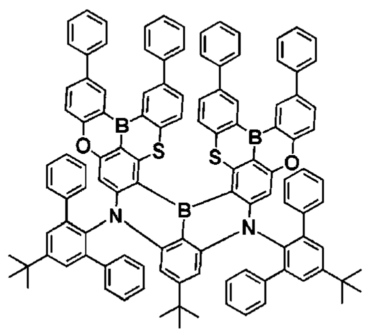

57

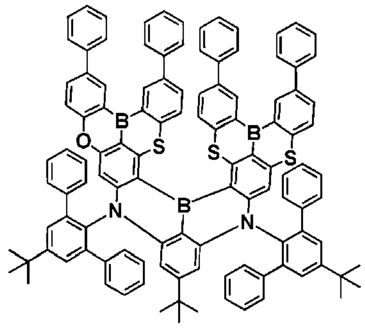

58

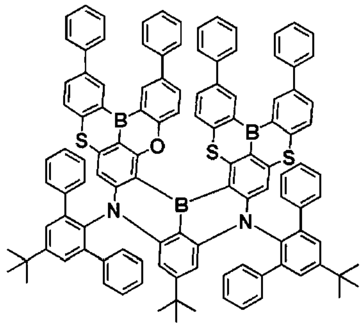

59

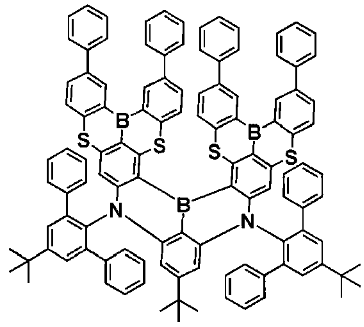

60

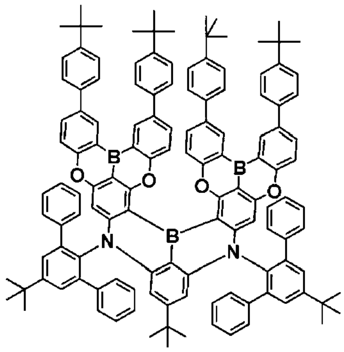

61

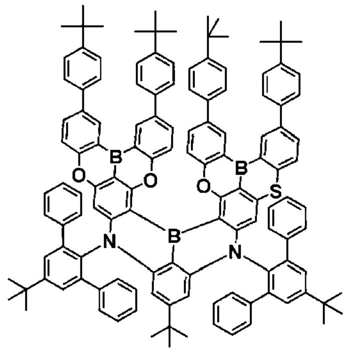

62

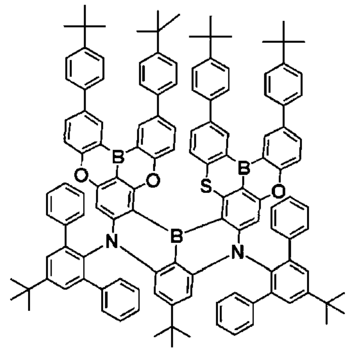

63

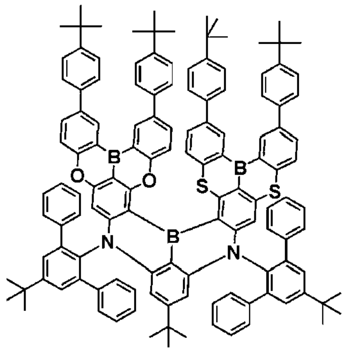

64

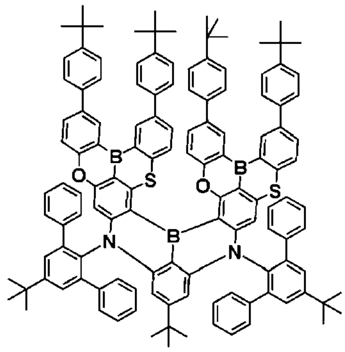

65

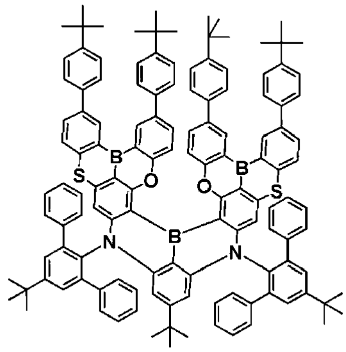

66

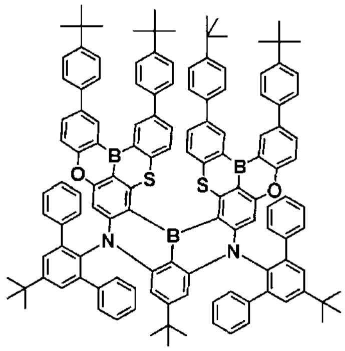

67

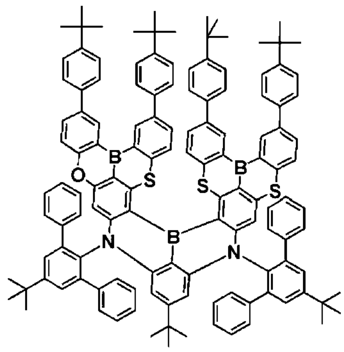

68

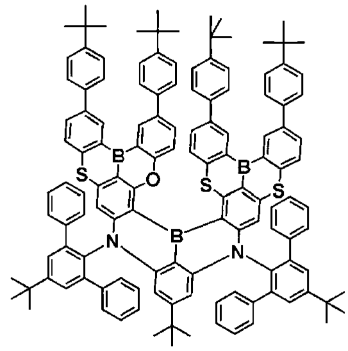

69

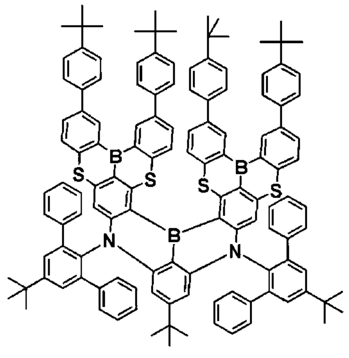

70

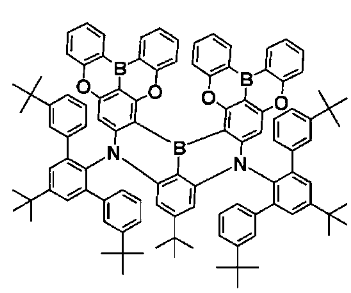

71

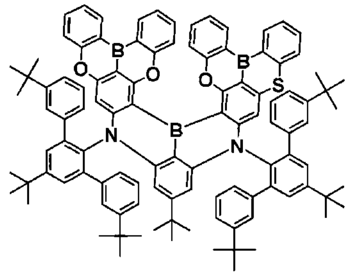

72

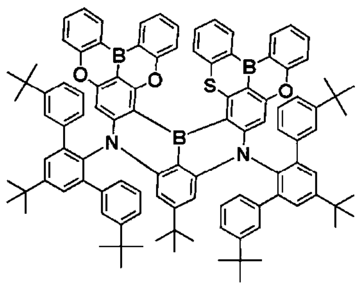

73

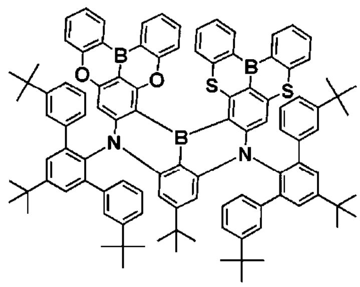

74

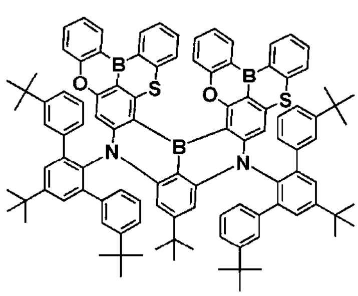

75

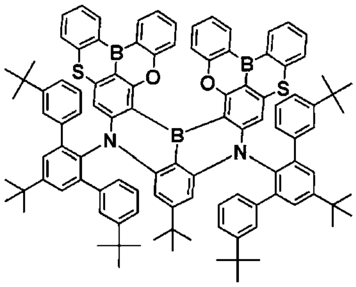
76

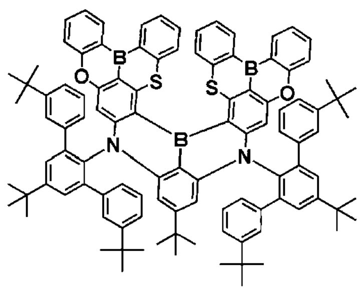
77

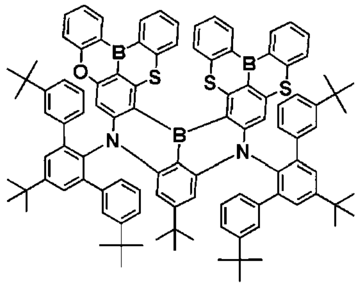
78

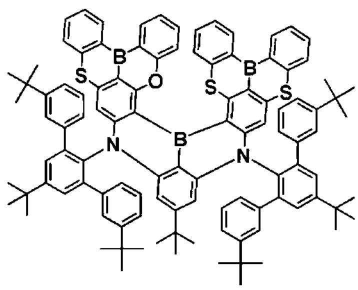
79

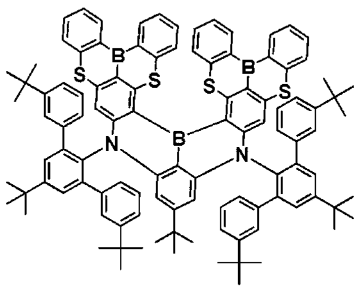
80

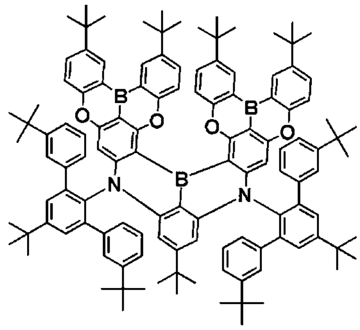
81

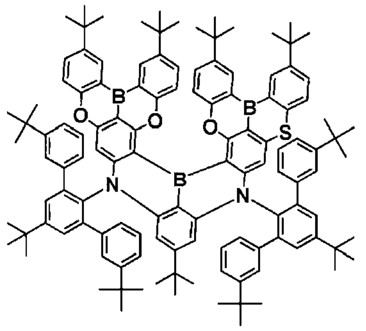
82

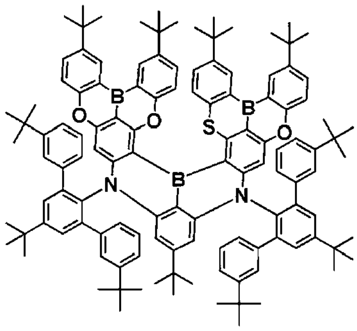
83

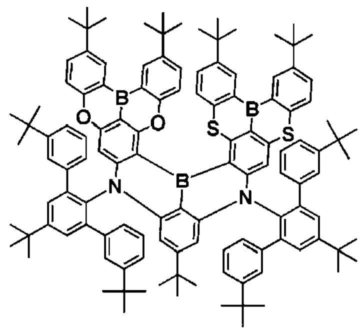
84

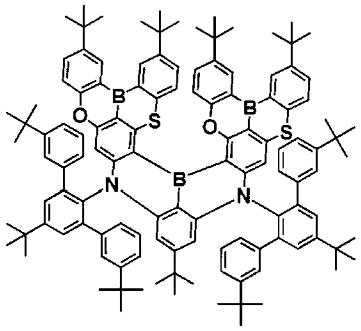
85

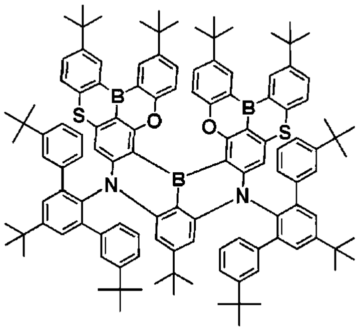
86

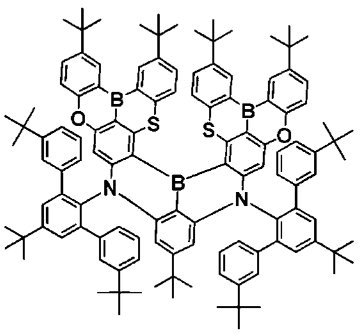
87

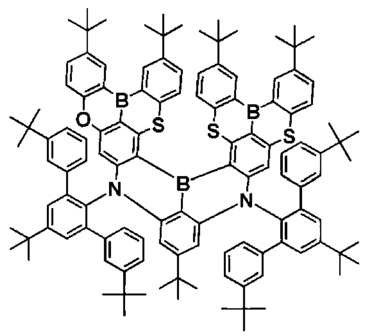

88

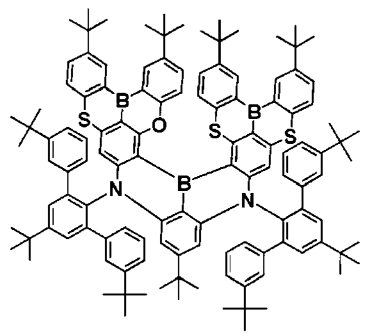

89

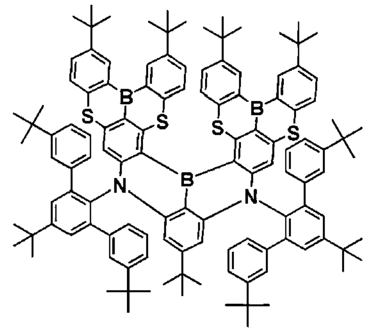

90

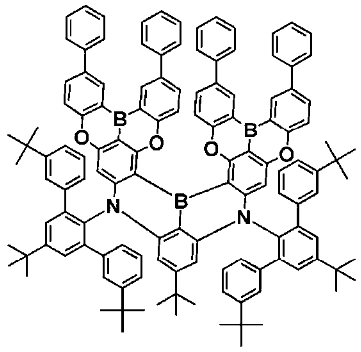

91

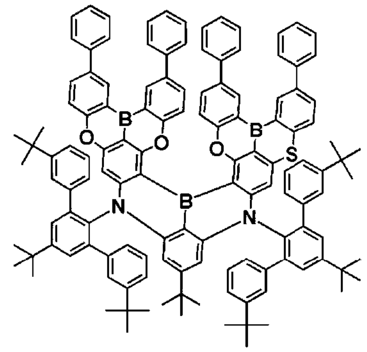

92

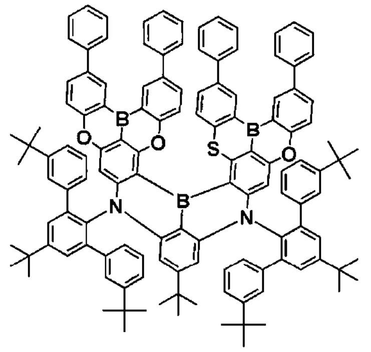

93

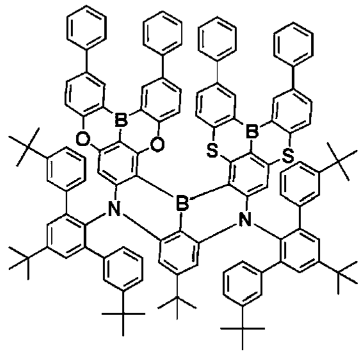

94

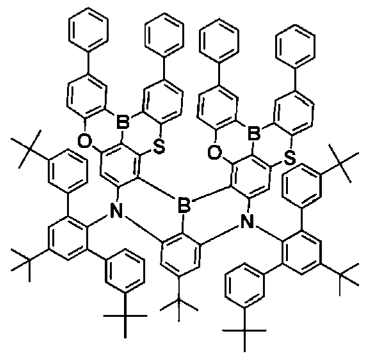

95

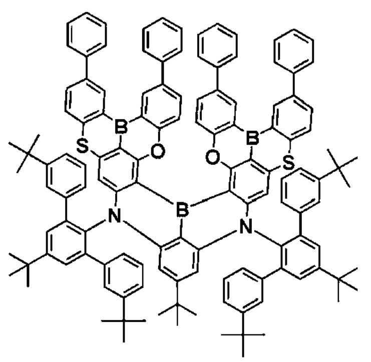

96

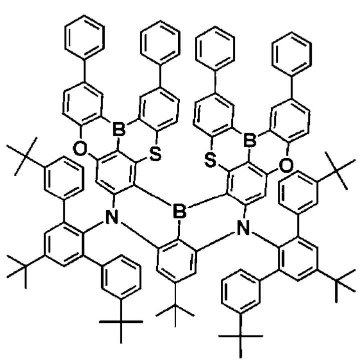

97

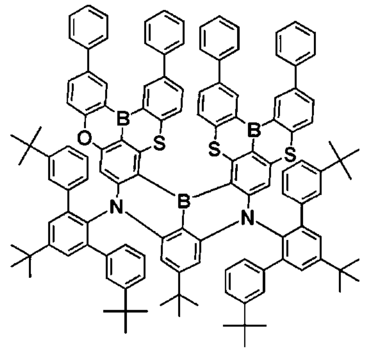

98

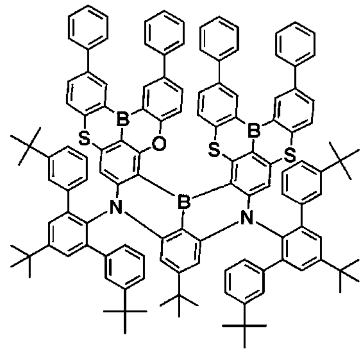

99

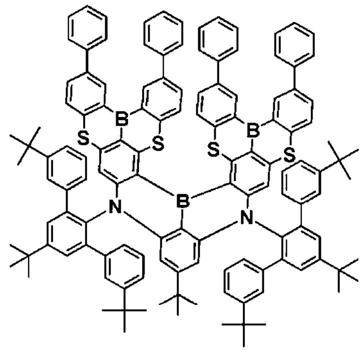

**100**

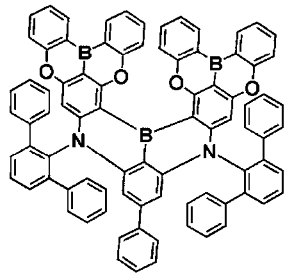

**101**

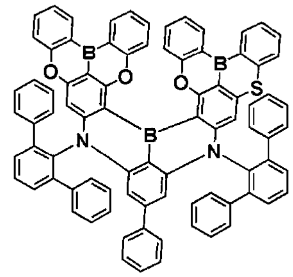

**102**

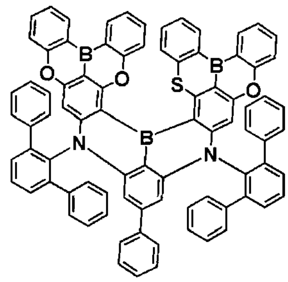

**103**

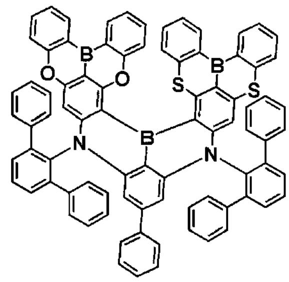

**104**

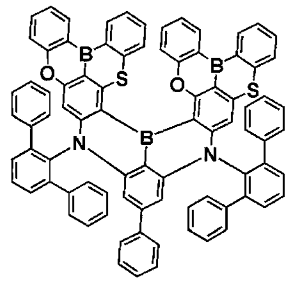

**105**

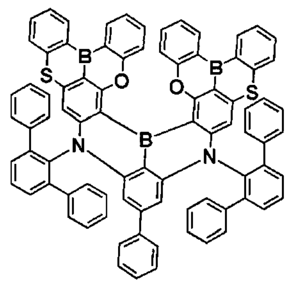

**106**

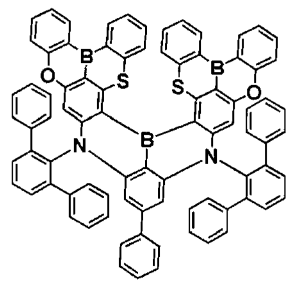

**107**

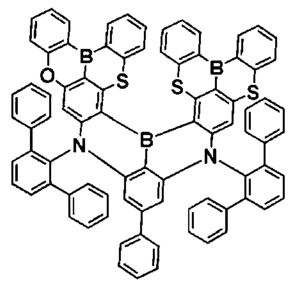

**108**

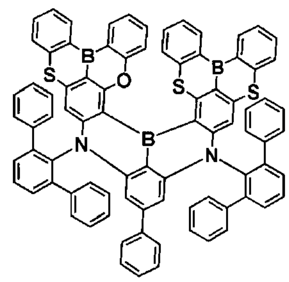

**109**

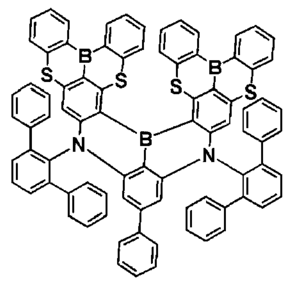

**110**

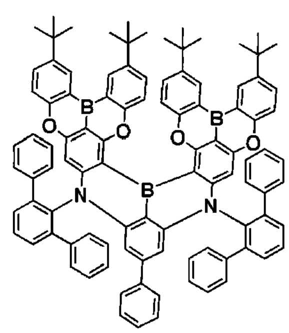

**111**

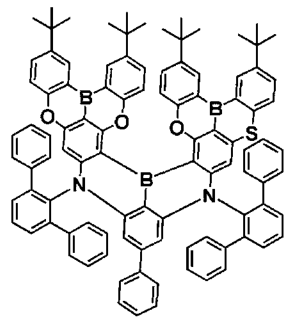

112

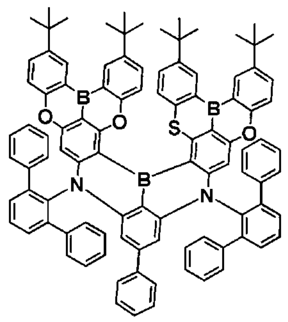

113

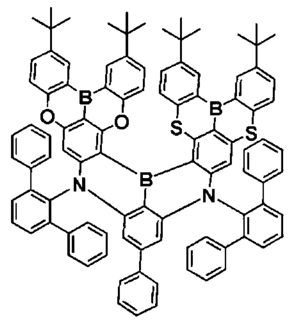

114

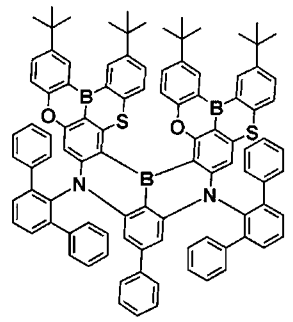

115

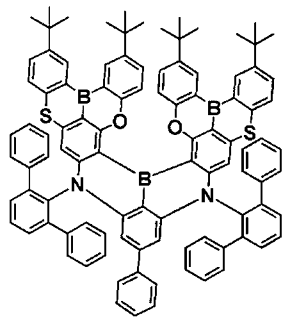

116

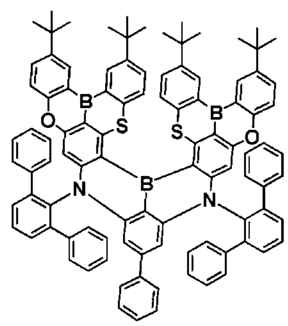

117

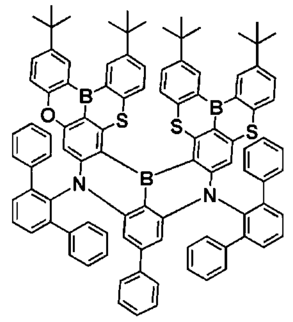

118

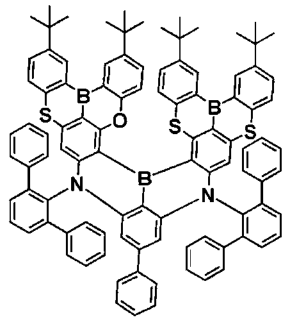

119

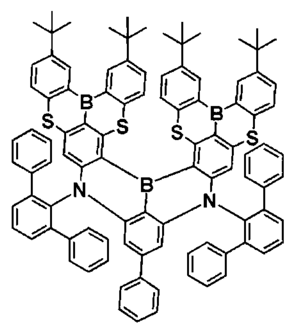

120

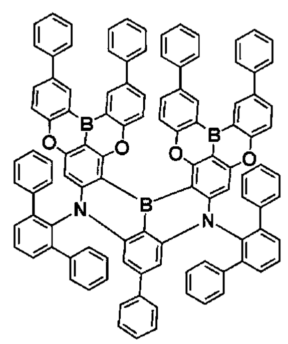

121

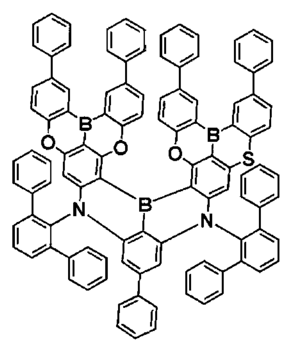

122

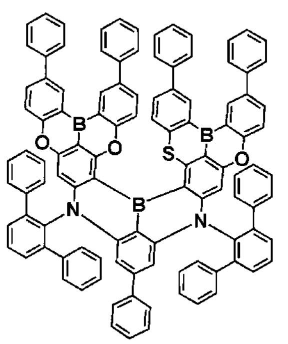

123

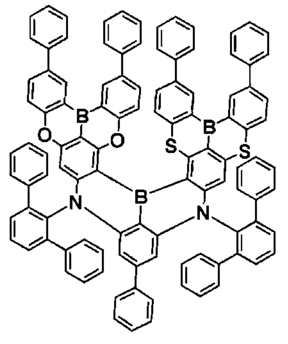

124

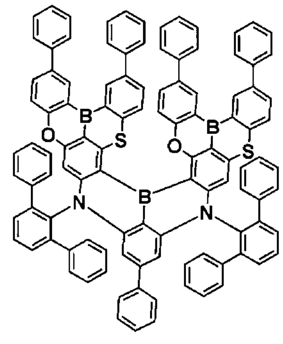

125

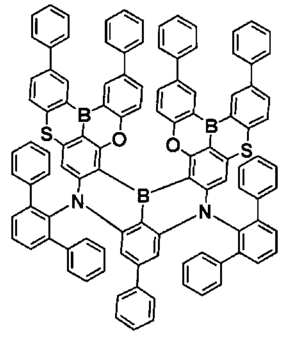

126

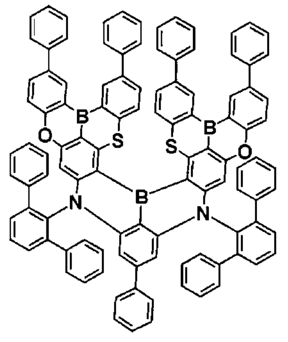

127

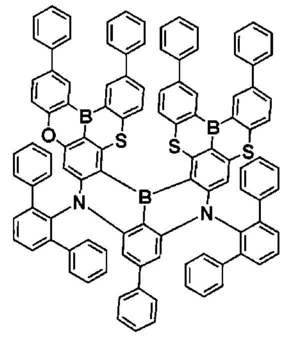

128

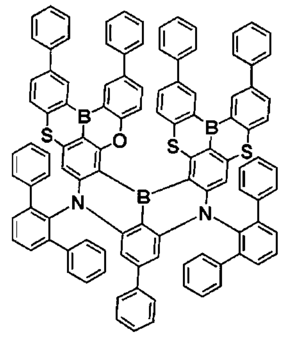

129

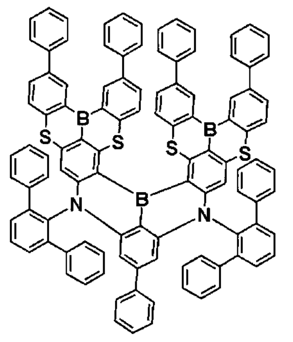

130

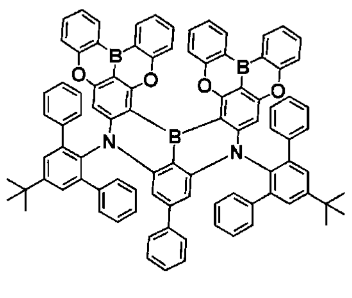

131

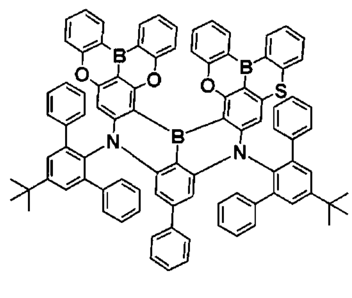

132

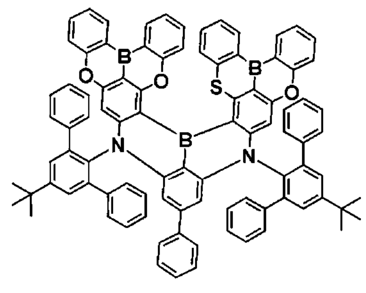

133

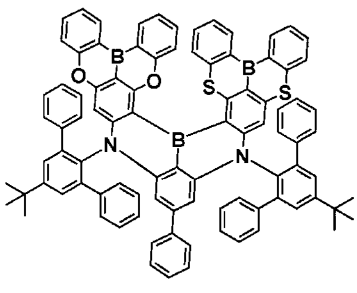

134

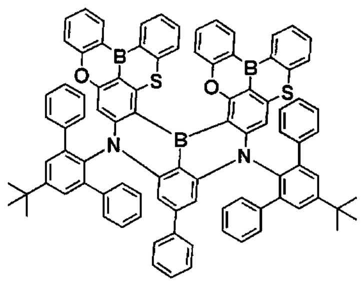

135

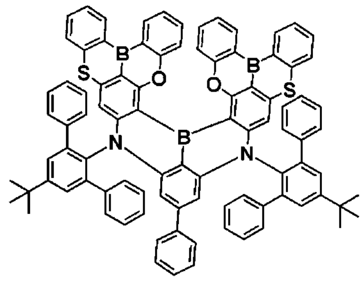

136

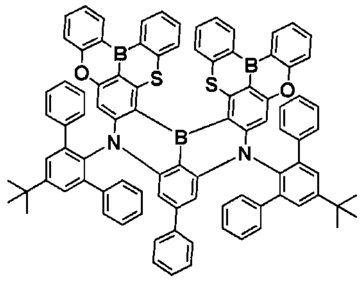

137

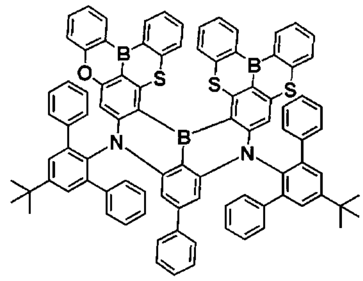

138

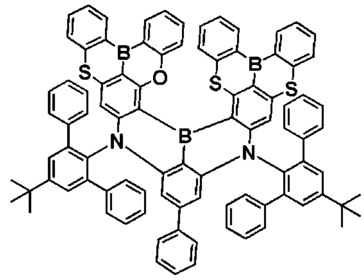

139

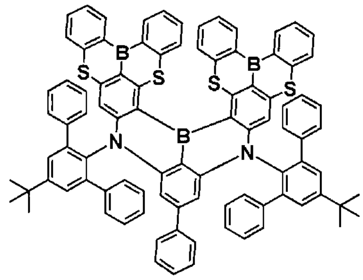

140

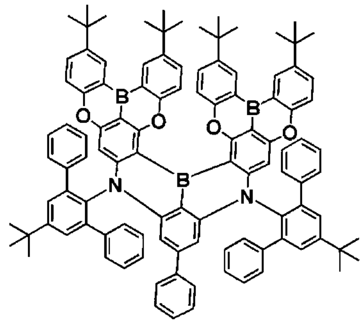

141

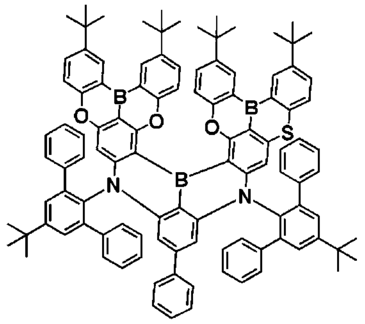

142

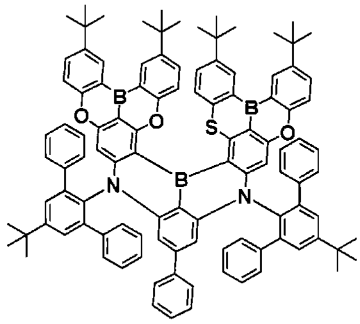

143

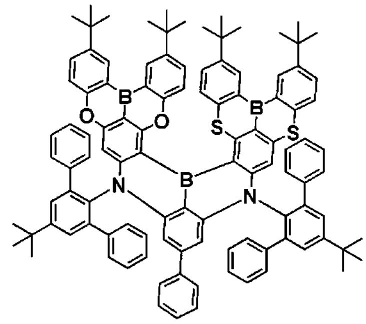

144

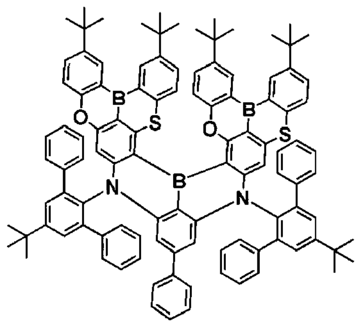

145

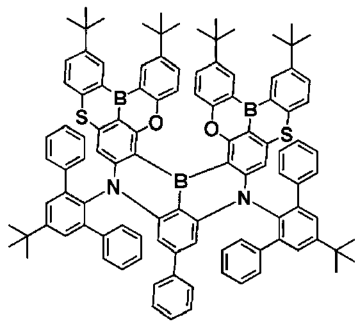

146

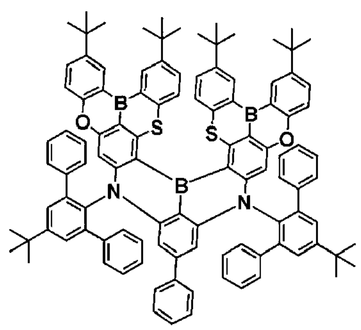

147

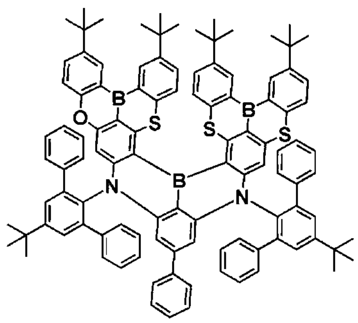

**148**

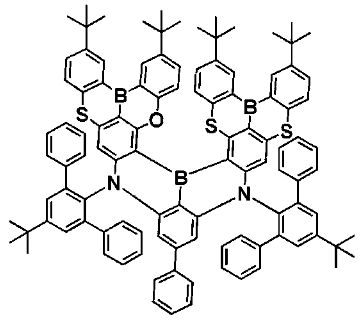

**149**

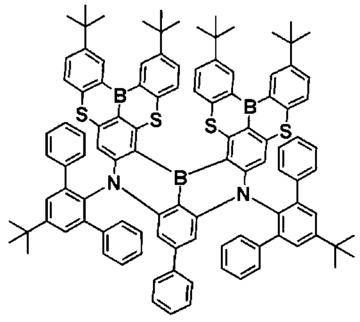

**150**

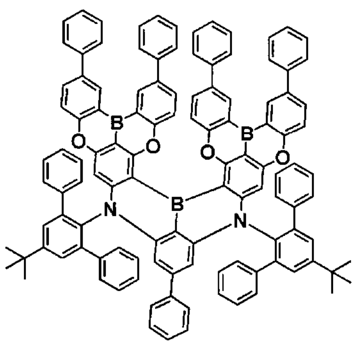

**151**

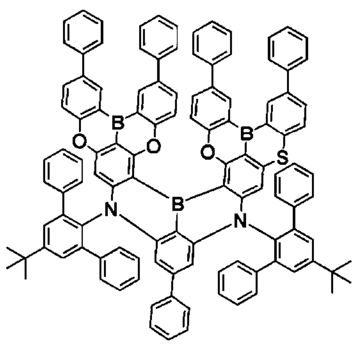

**152**

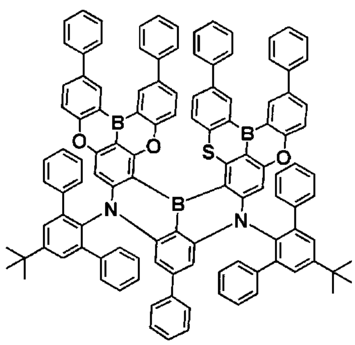

**153**

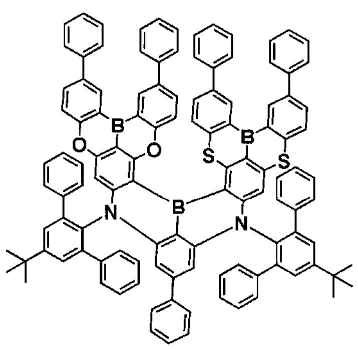

**154**

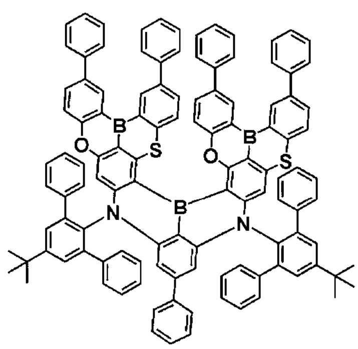

**155**

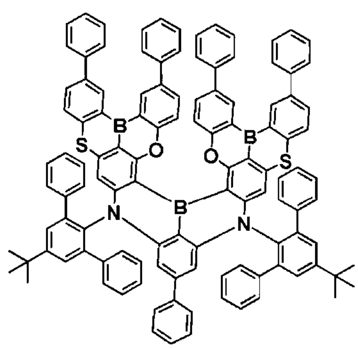

**156**

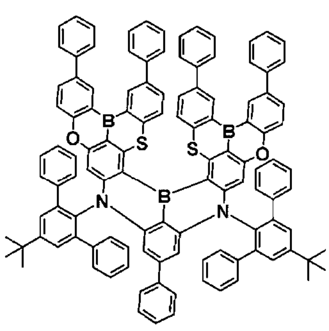

**157**

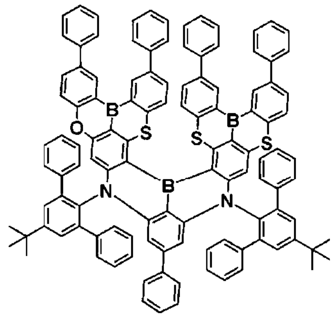

**158**

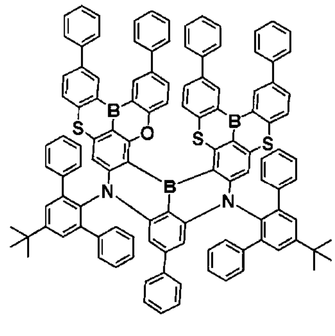

**159**

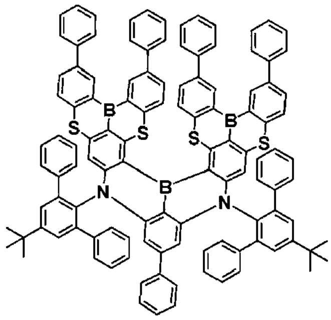

160

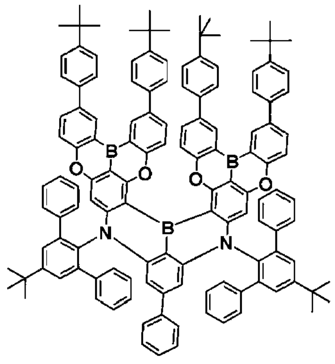

161

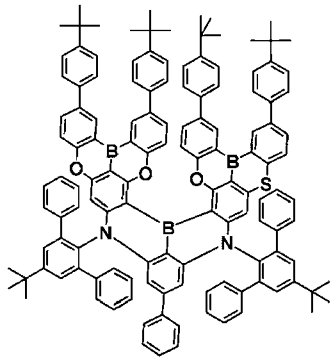

162

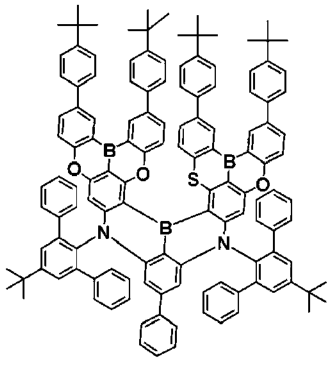

163

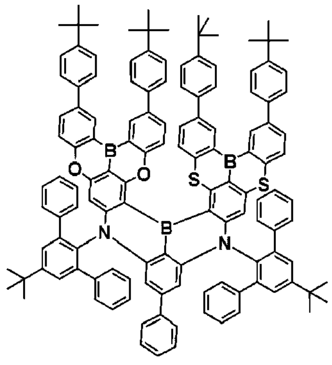

164

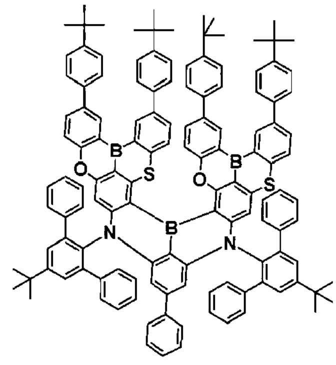

165

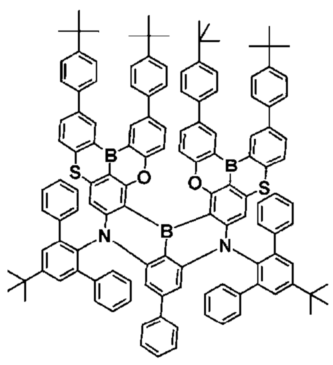

166

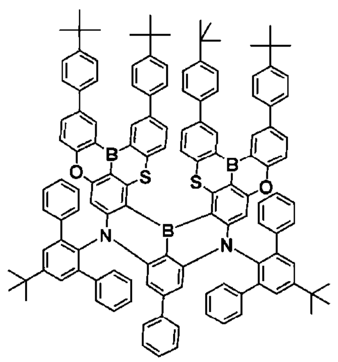

167

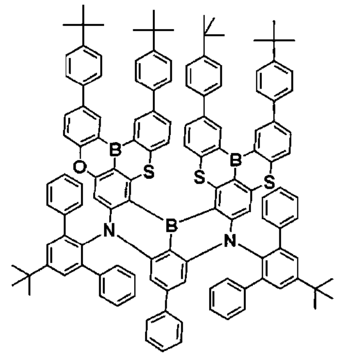

168

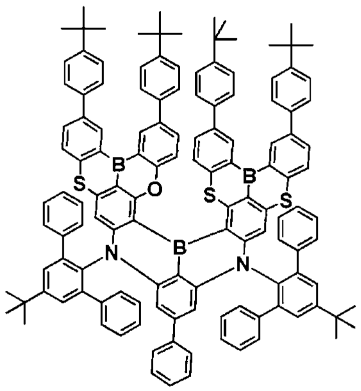

169

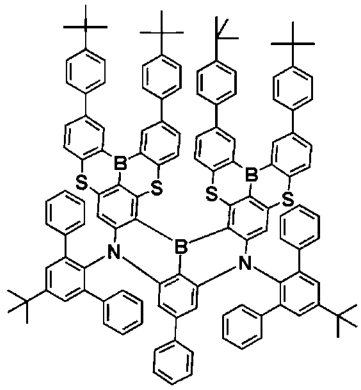

170

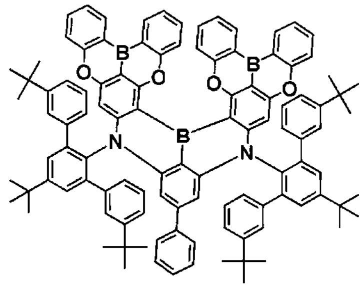

171

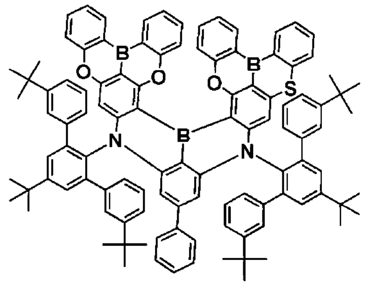

**172**

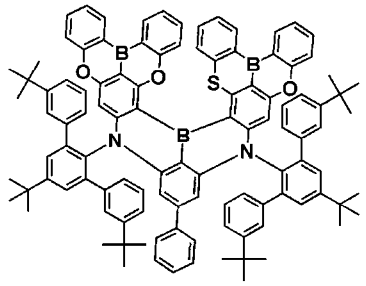

**173**

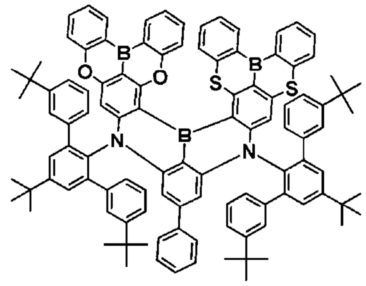

**174**

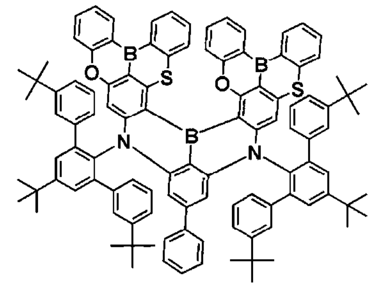

**175**

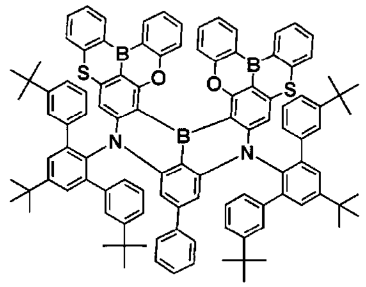

**176**

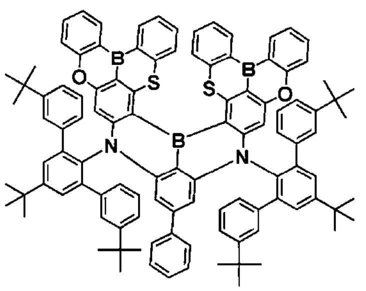

**177**

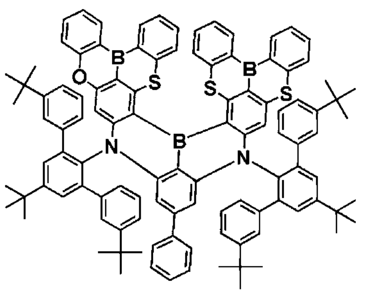

**178**

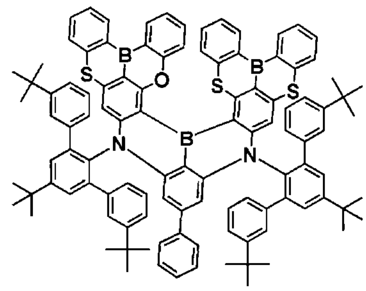

**179**

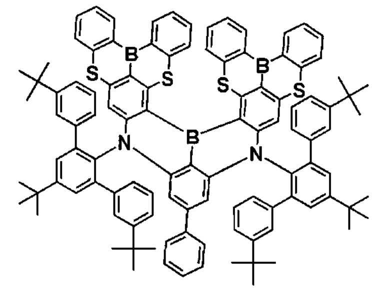

**180**

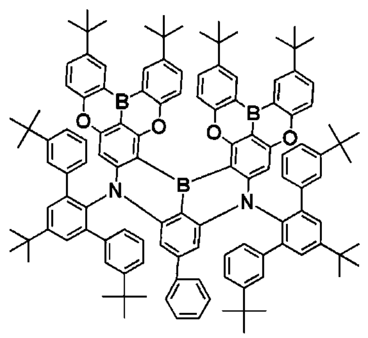

**181**

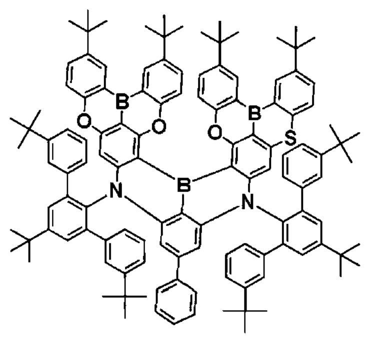

**182**

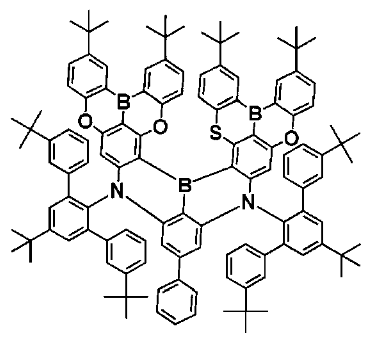

**183**

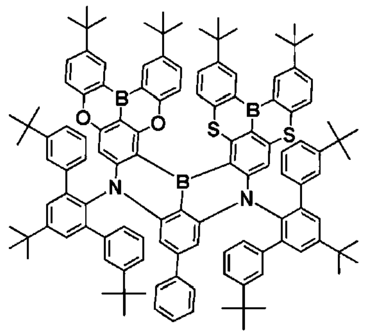

**184**

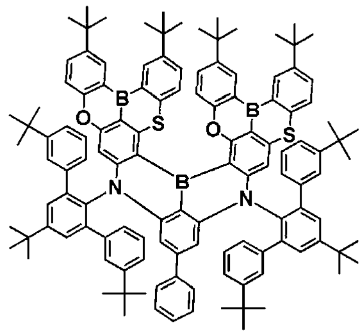

**185**

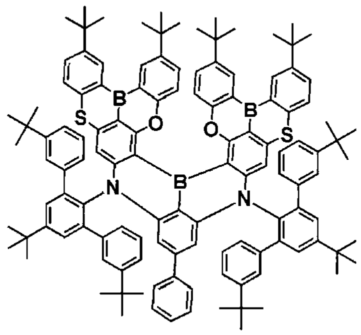

**186**

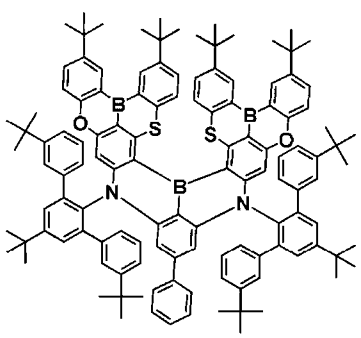

**187**

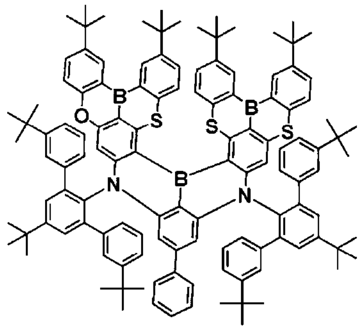

**188**

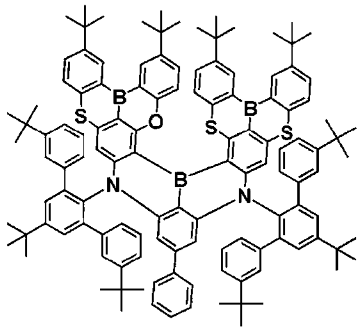

**189**

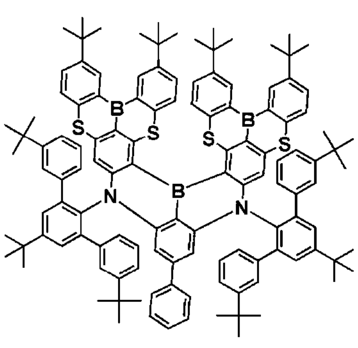

**190**

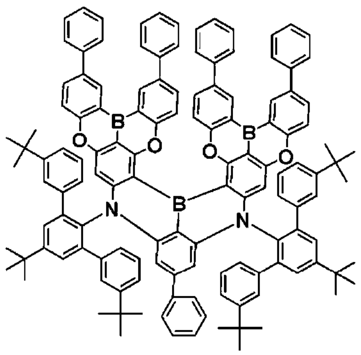

**191**

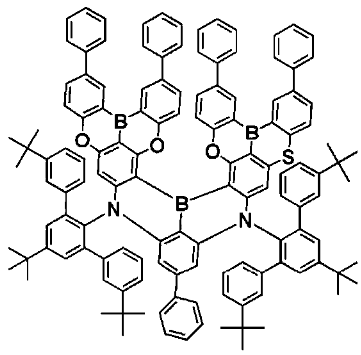

**192**

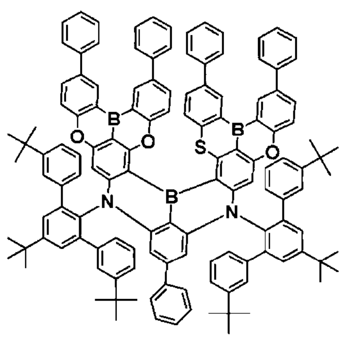

**193**

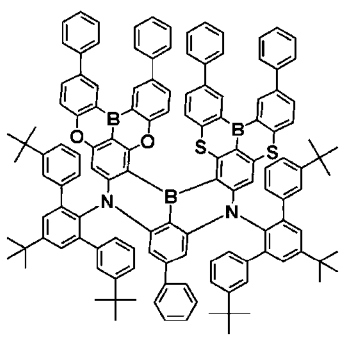

**194**

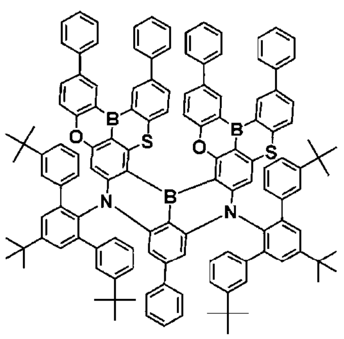

**195**

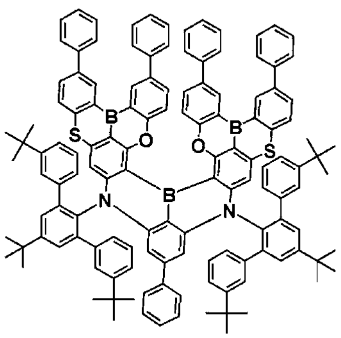

196

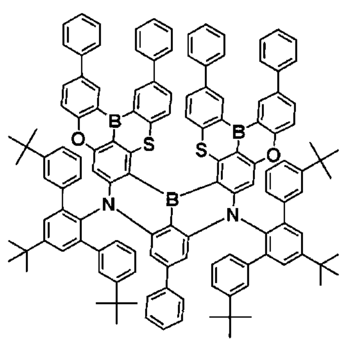

197

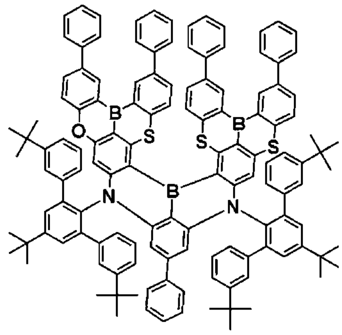

198

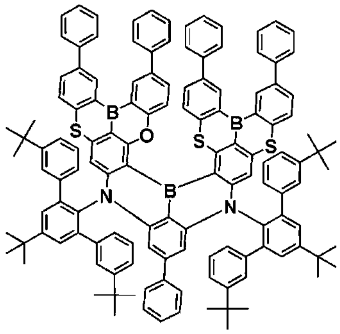

199

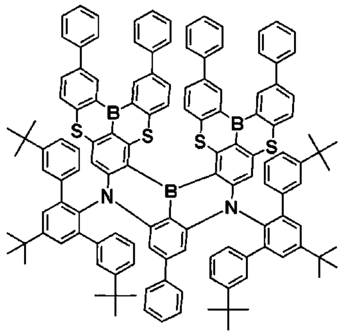

200

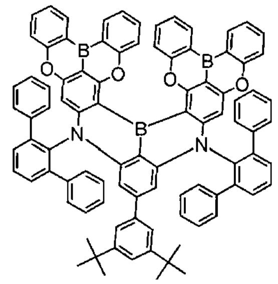

201

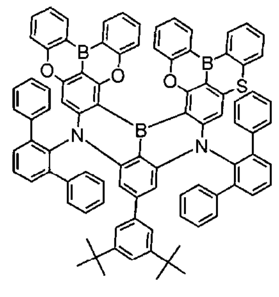

202

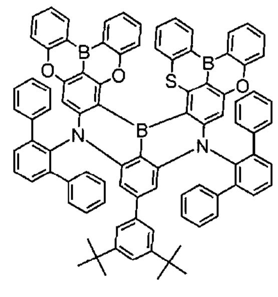

203

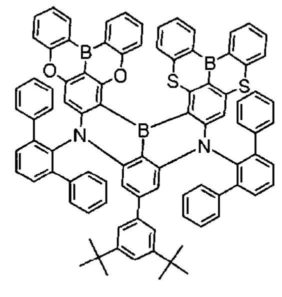

204

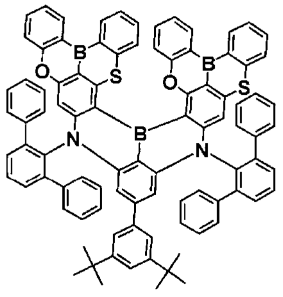

205

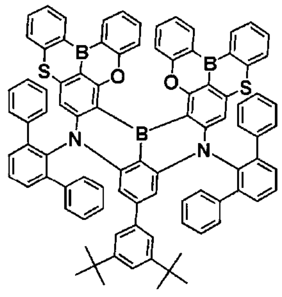

206

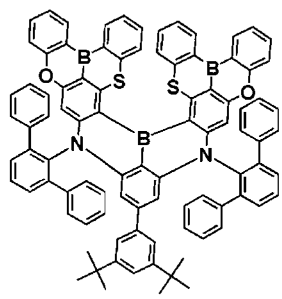

207

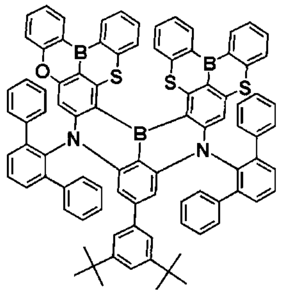

208

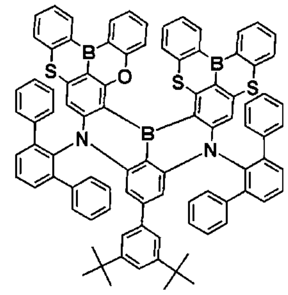

209

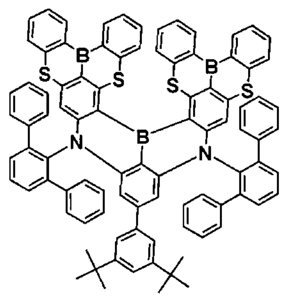

210

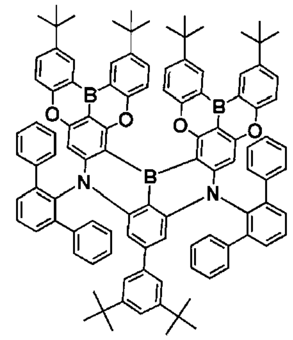

211

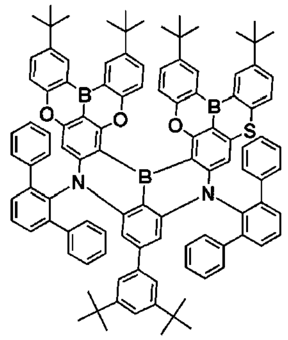

212

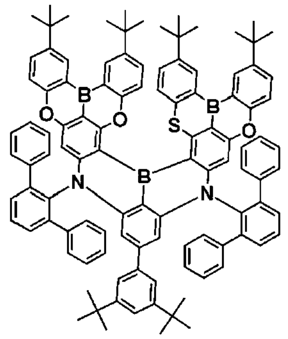

213

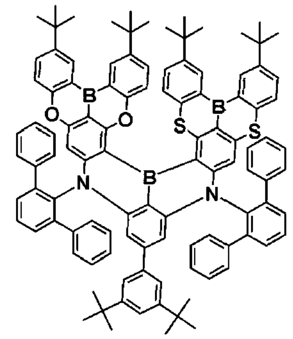

214

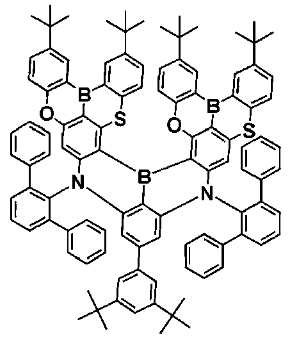

215

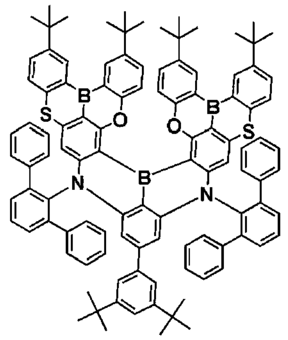

216

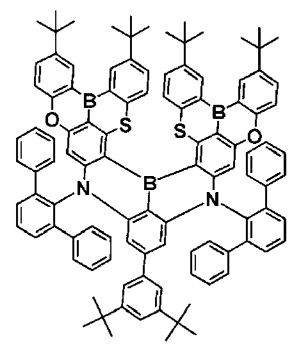

217

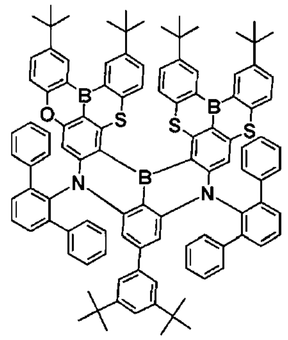

218

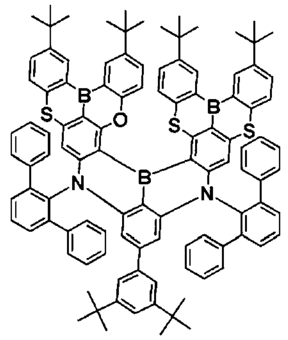

219

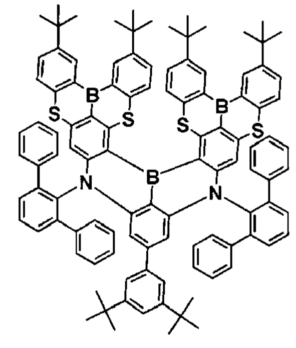

220

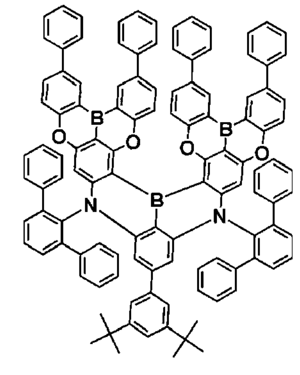

221

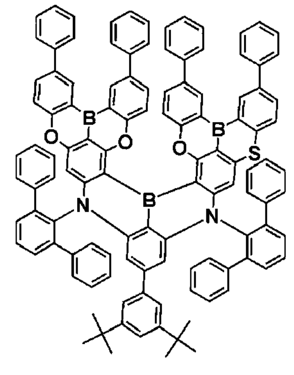

222

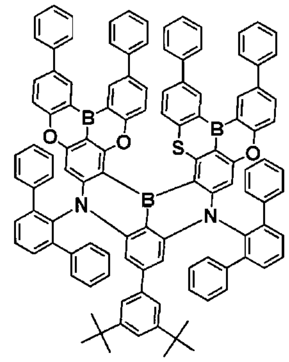

223

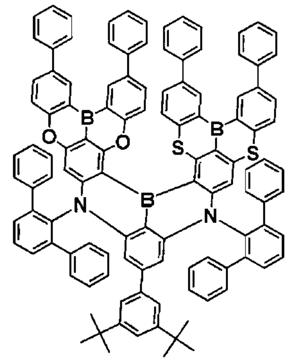

224

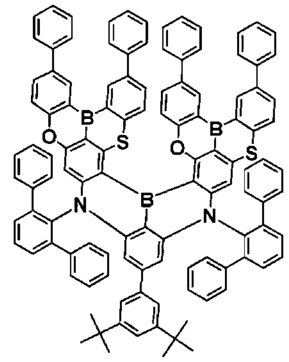

225

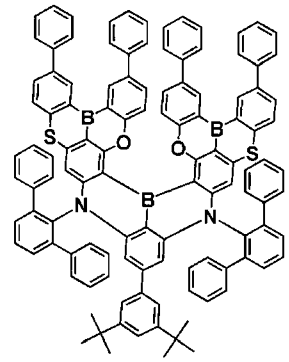

226

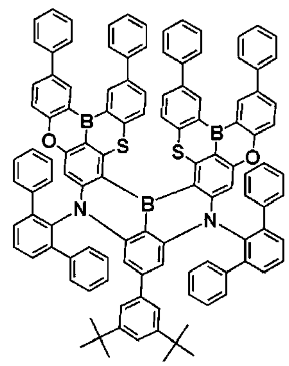

227

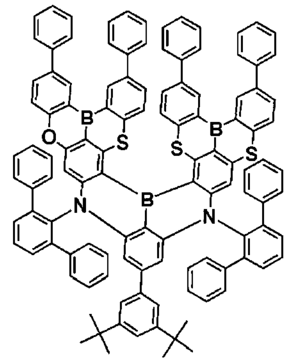

228

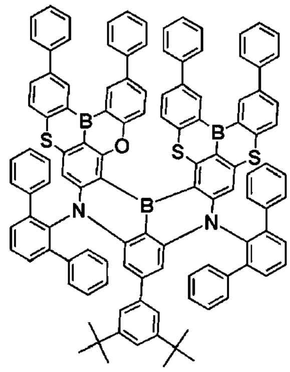

229

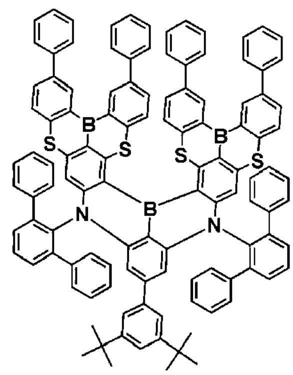

230

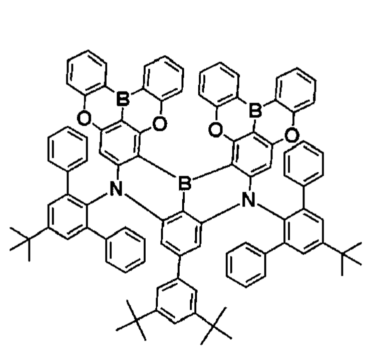

231

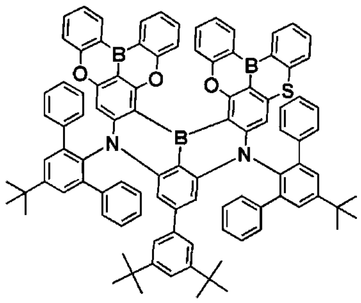

**232**

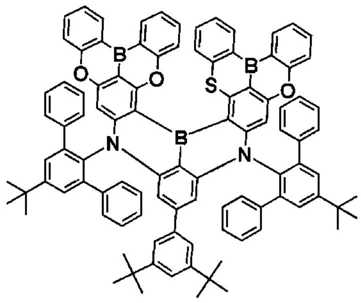

**233**

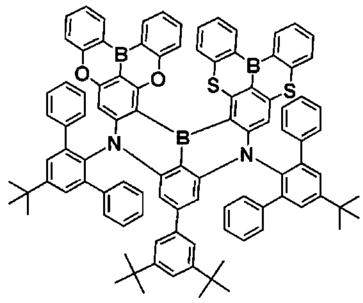

**234**

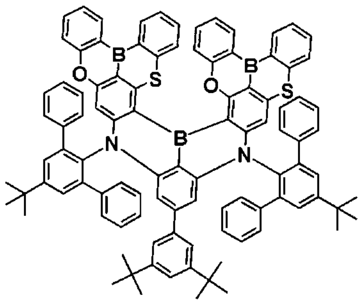

**235**

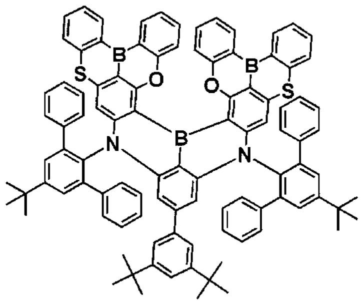

**236**

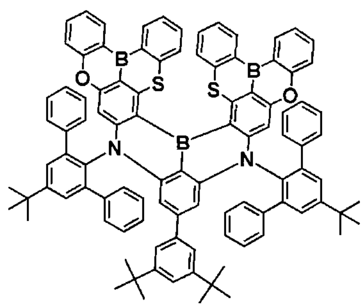

**237**

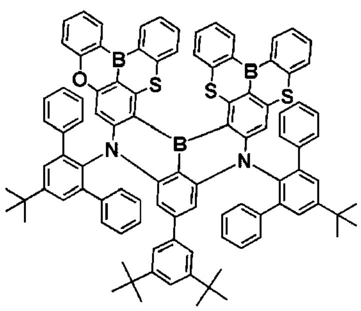

**238**

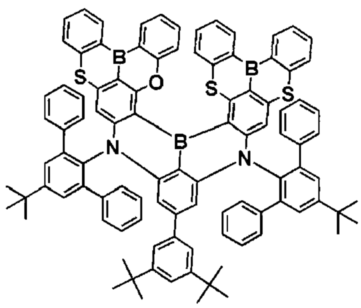

**239**

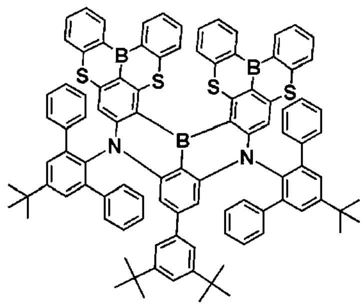

**240**

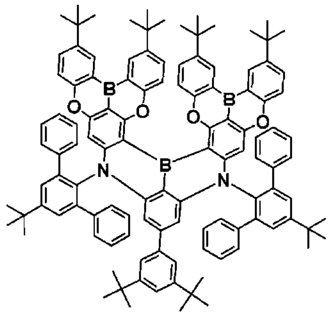

**241**

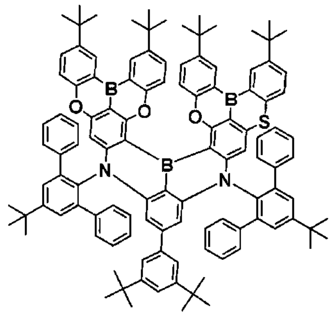

**242**

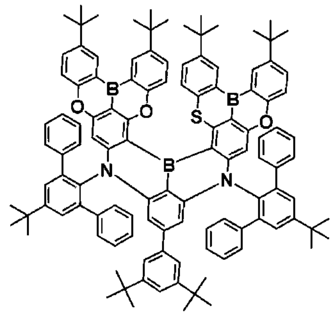

**243**

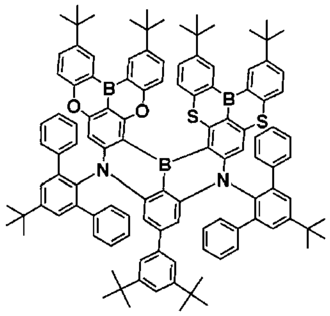

244

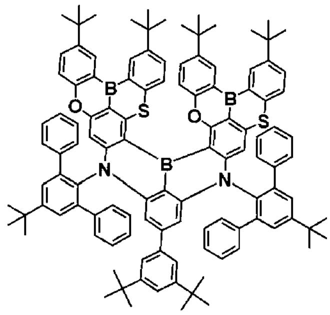

245

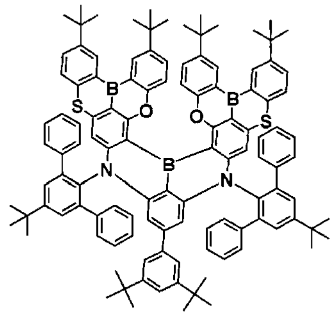

246

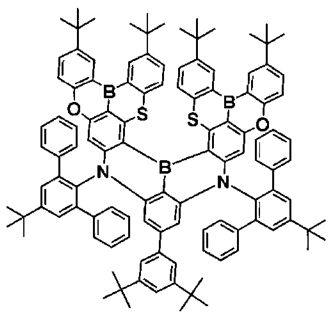

247

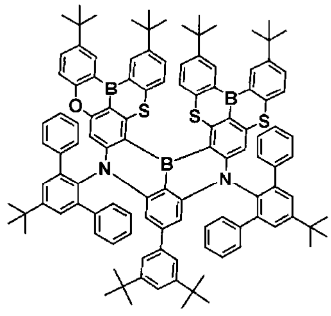

248

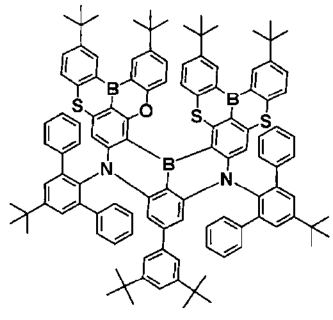

249

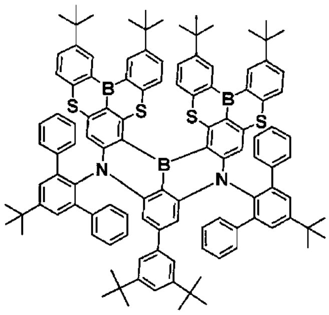

250

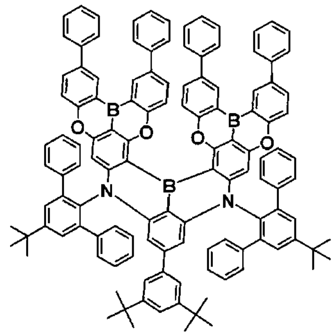

251

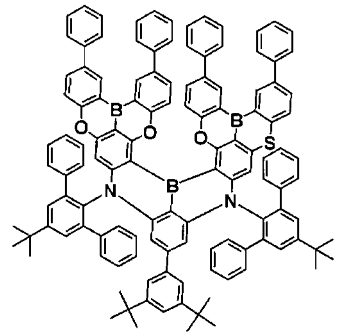

252

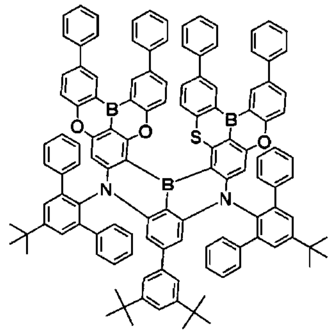

253

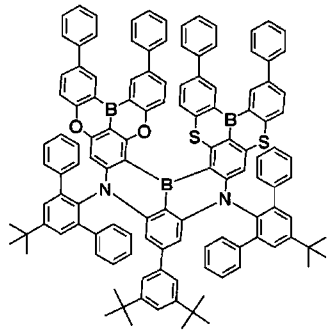

254

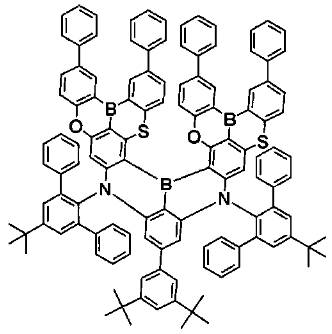

255

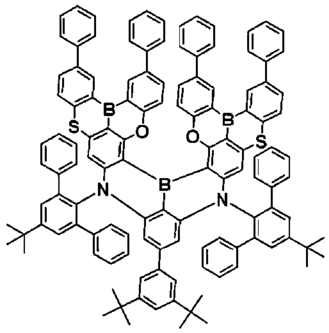
256
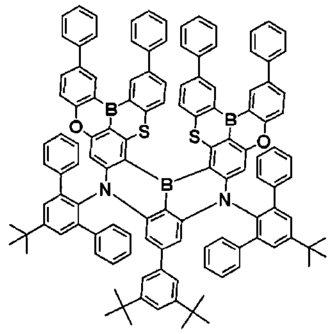
257
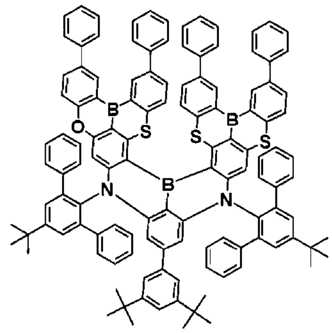
258

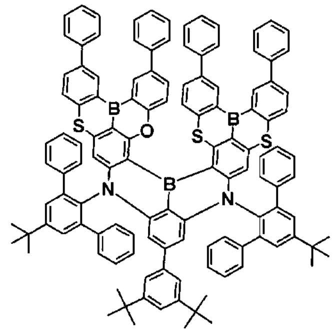
259
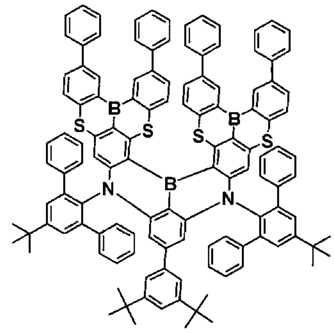
260
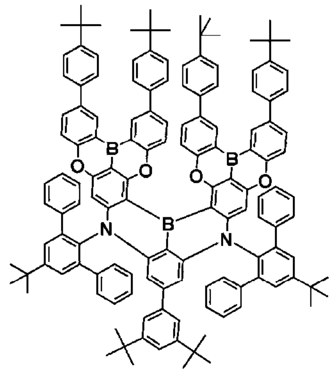
261

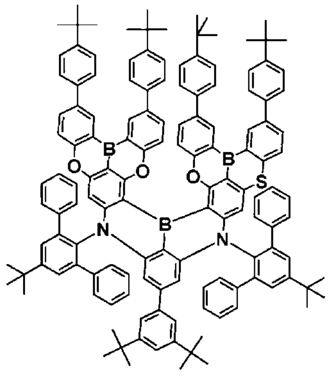
262
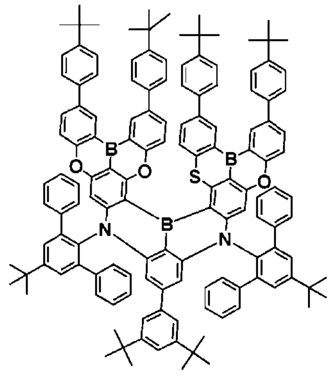
263
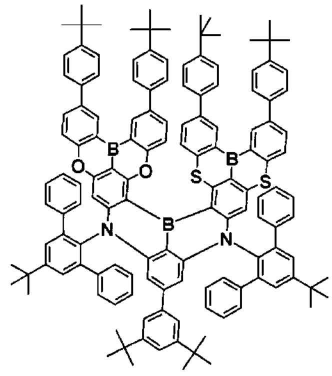
264

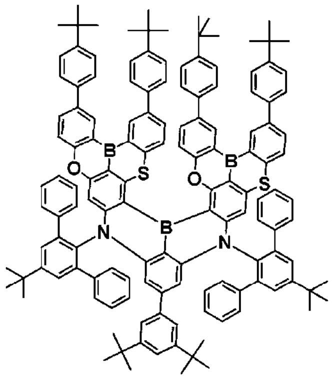
265
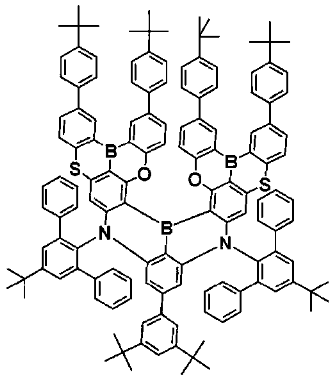
266
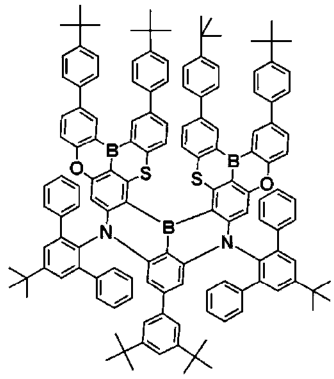
267

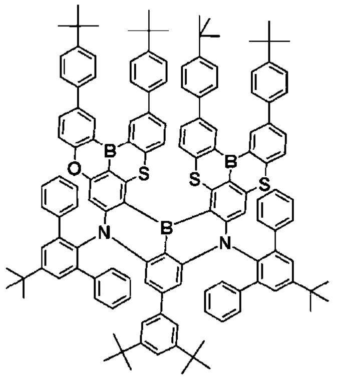

268

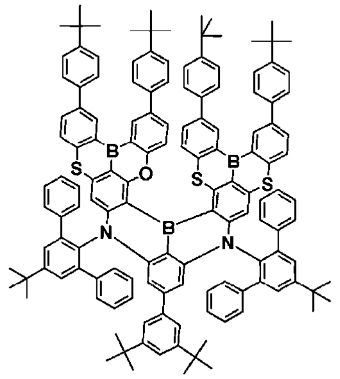

269

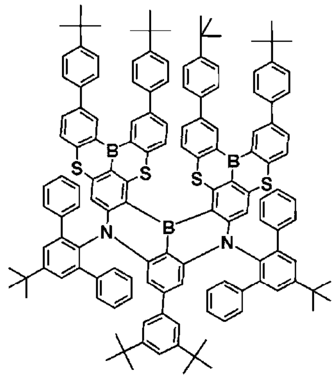

270

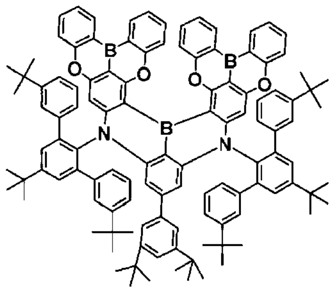

271

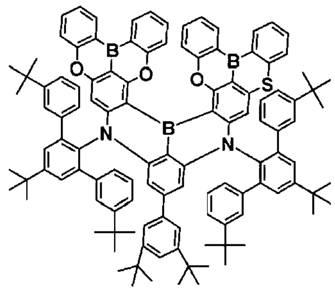

272

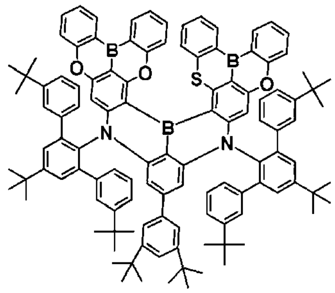

273

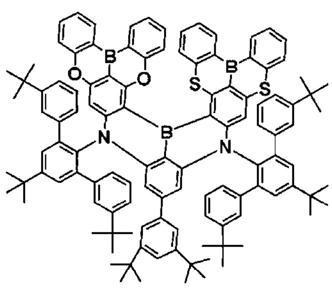

274

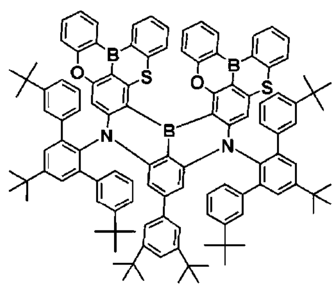

275

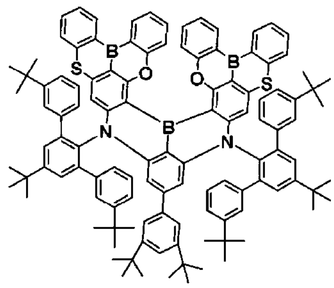

276

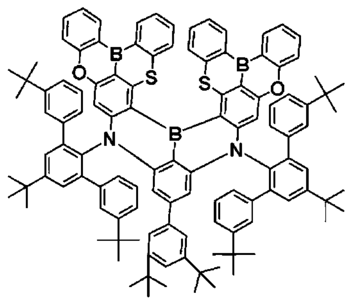

277

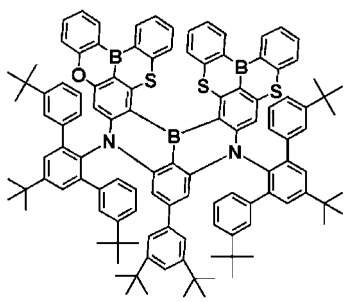

278

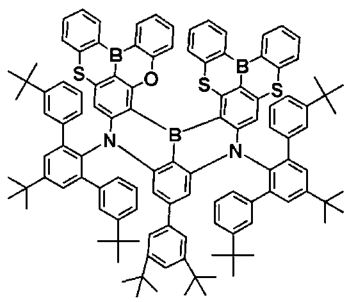

279

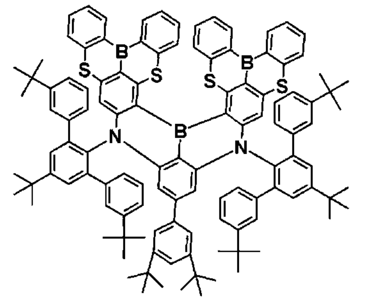

280

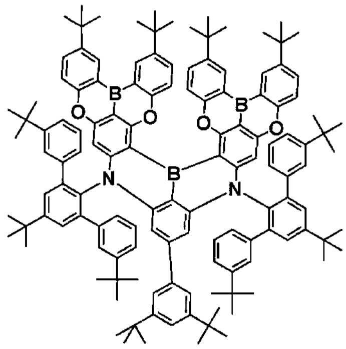

281

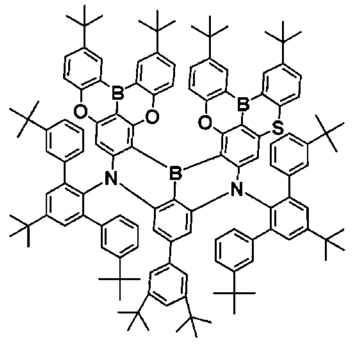

282

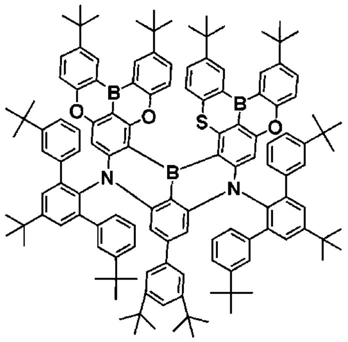

283

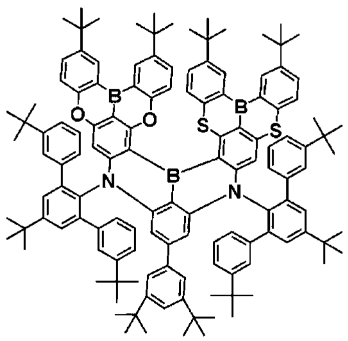

284

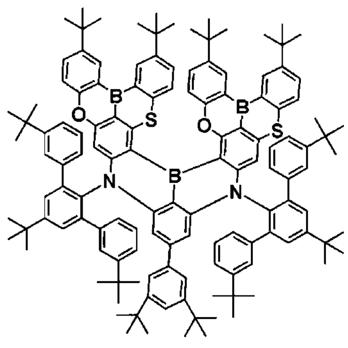

285

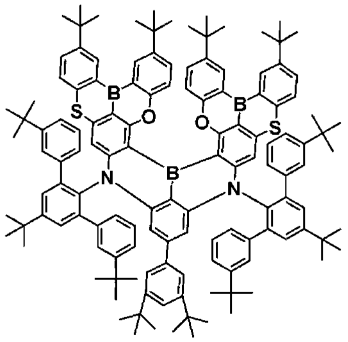

286

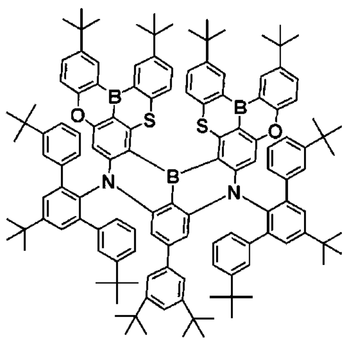

287

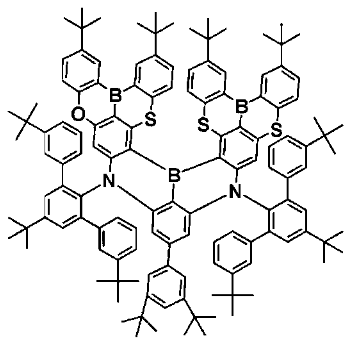

288

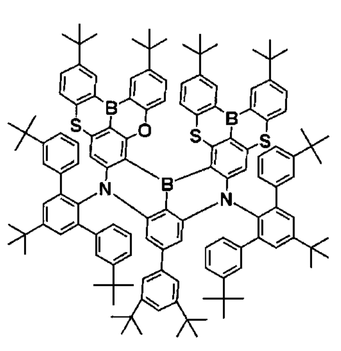

289

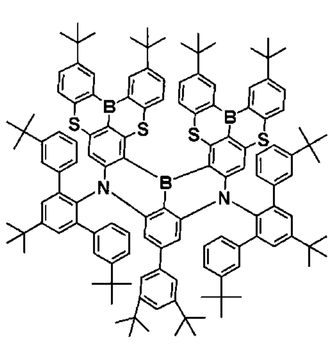

290

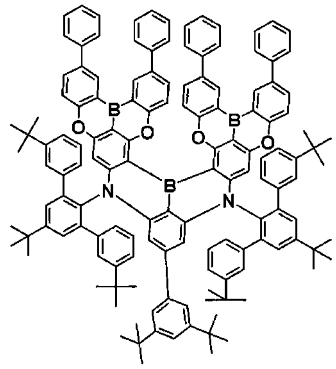

291

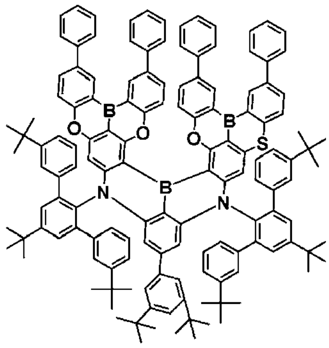

**292**

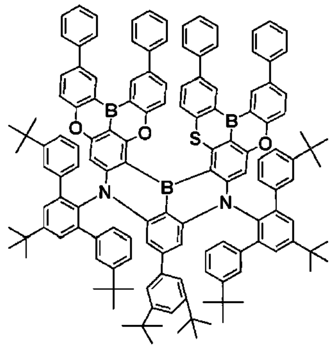

**293**

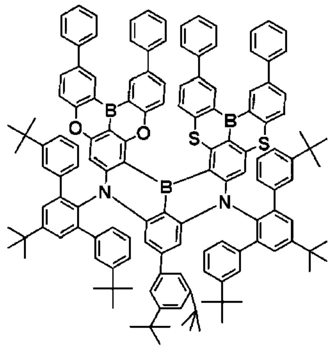

**294**

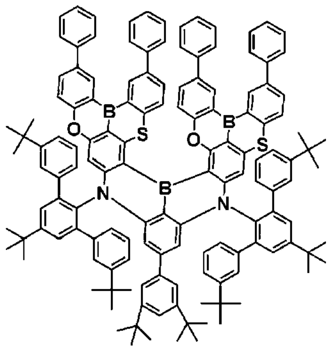

**295**

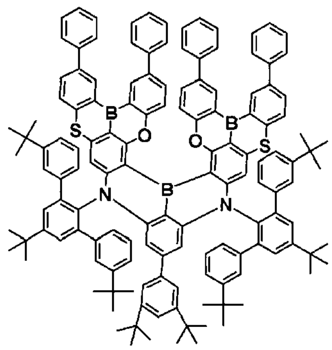

**296**

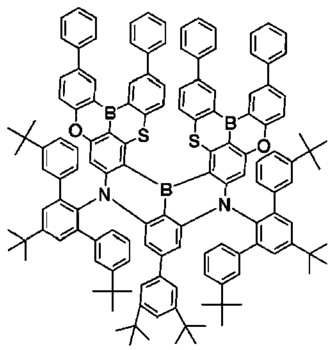

**297**

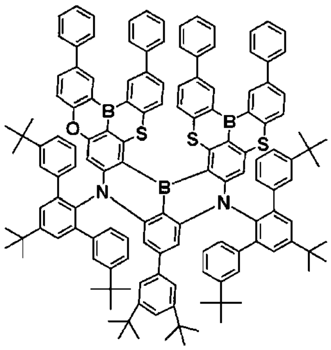

**298**

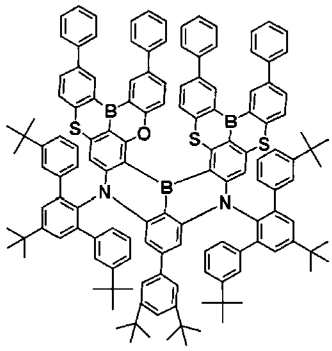

**299**

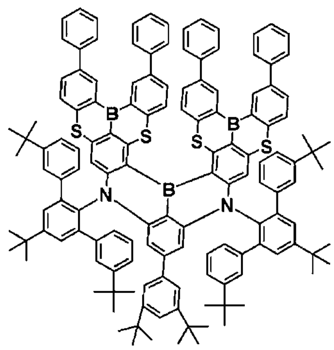

**300**

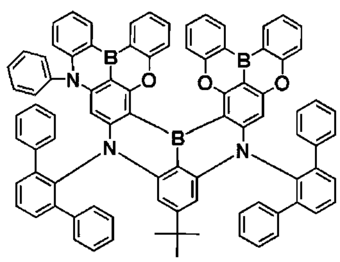

**301**

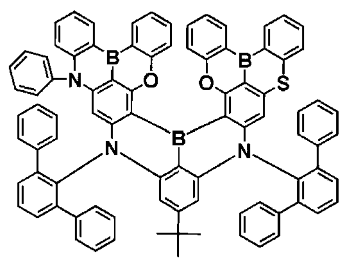

**302**

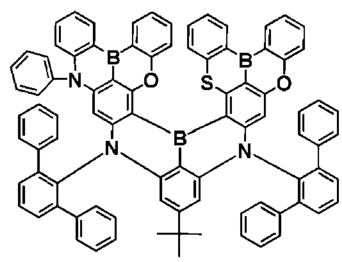

**303**

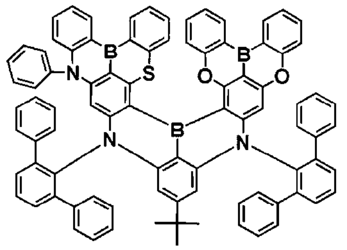

**304**

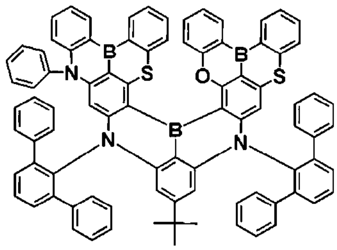

**305**

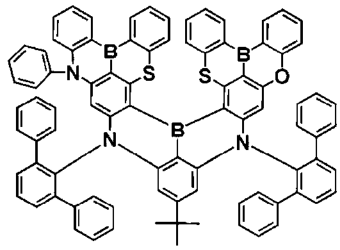

**306**

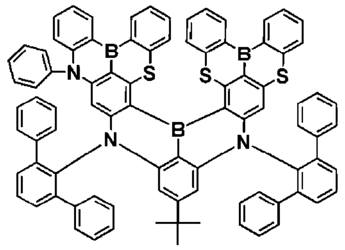

**307**

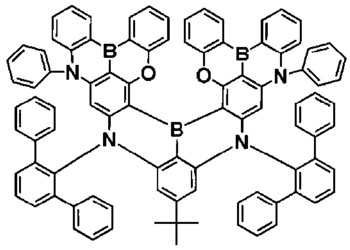

**308**

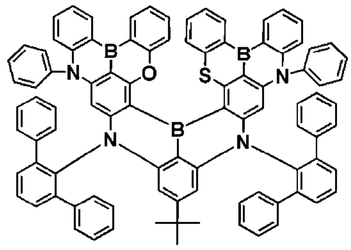

**309**

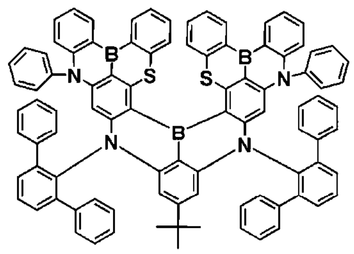

**310**

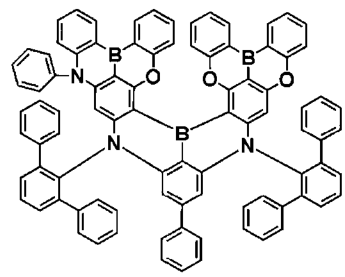

**311**

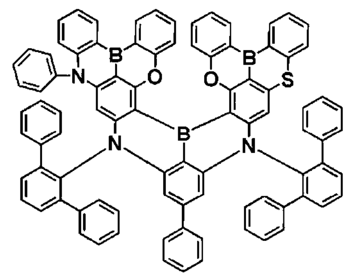

**312**

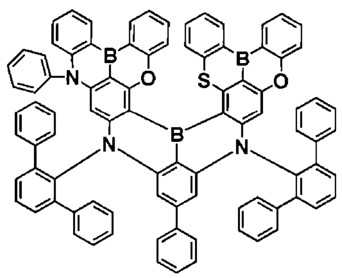

**313**

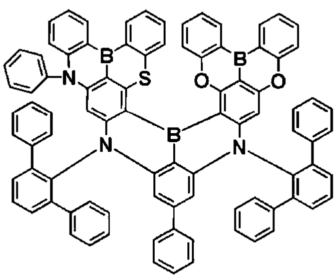

**314**

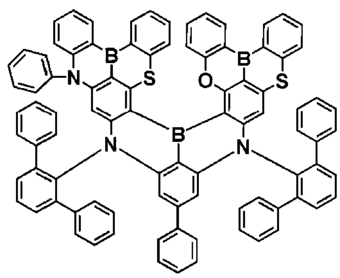

**315**

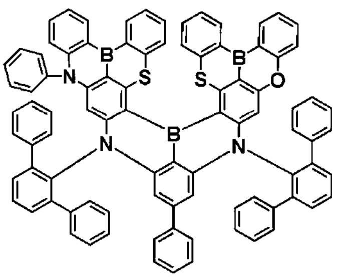

**316**

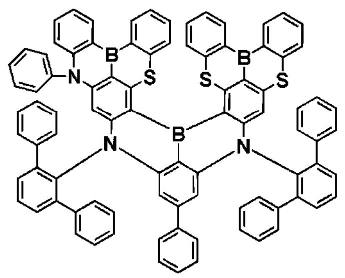

**317**

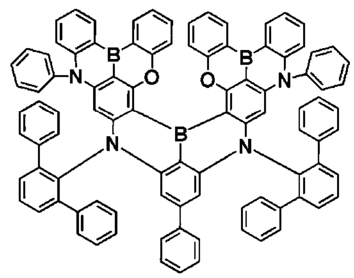

**318**

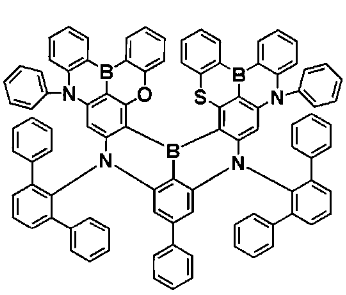

**319**

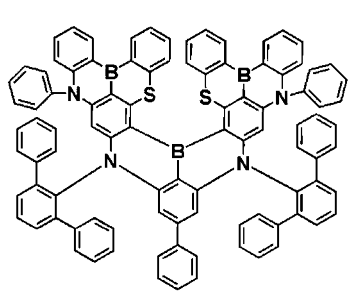

**320**

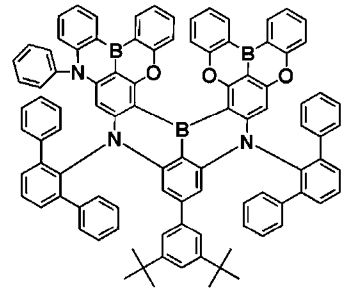

**321**

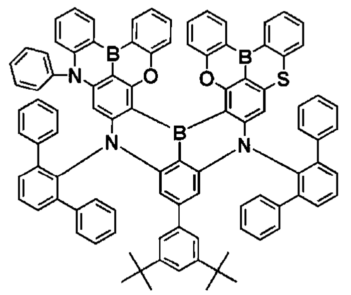

**322**

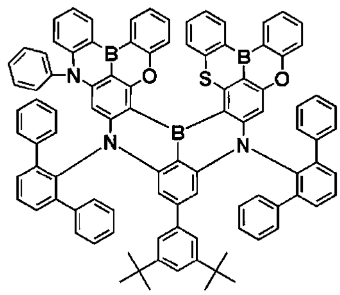

**323**

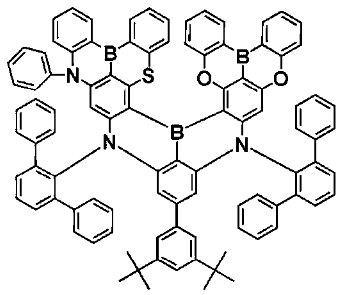

**324**

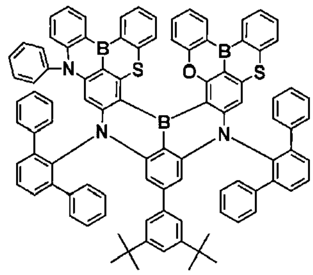

**325**

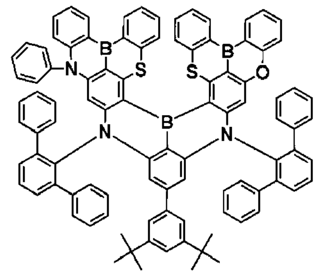

**326**

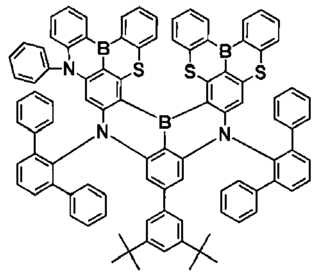

**327**

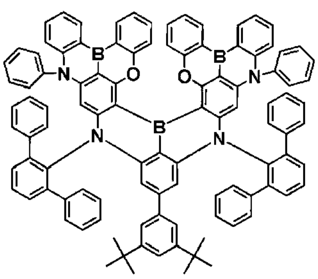

**328**

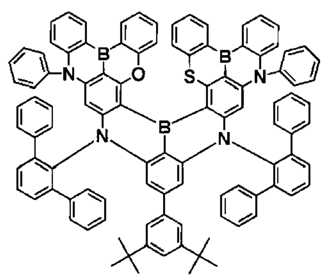

**329**

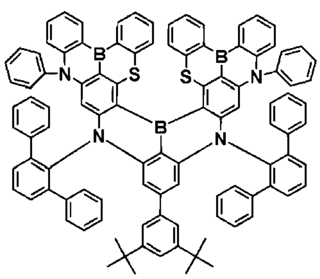

**330**

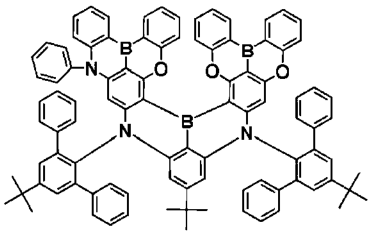

**331**

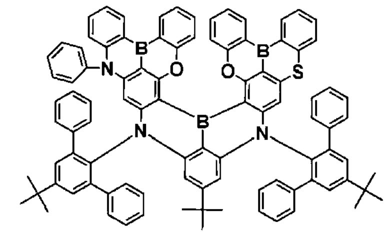

**332**

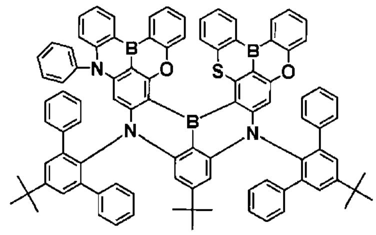

**333**

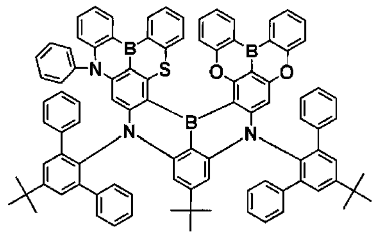

334

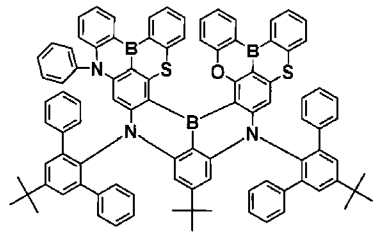

335

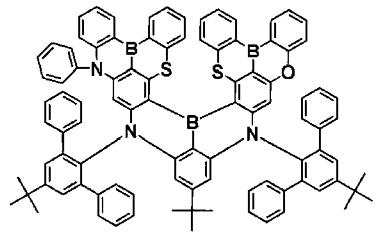

336

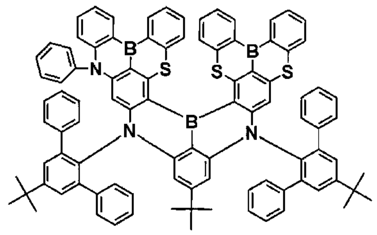

337

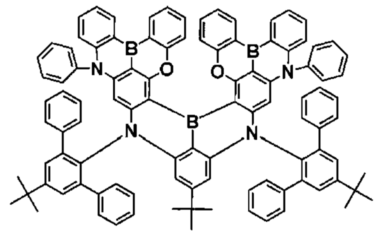

338

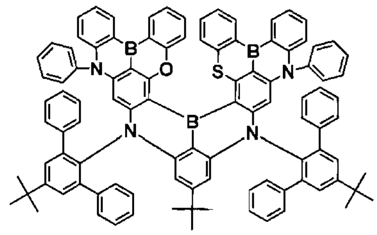

339

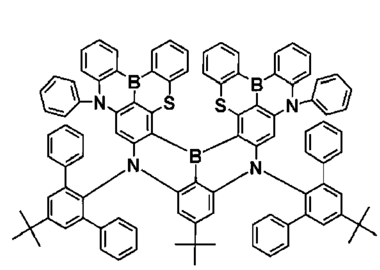

340

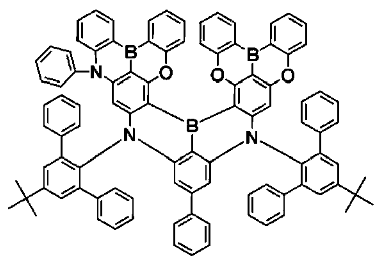

341

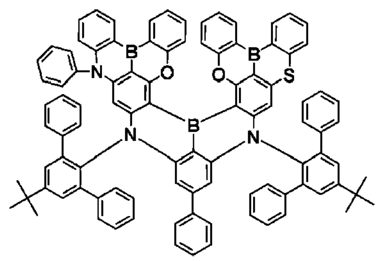

342

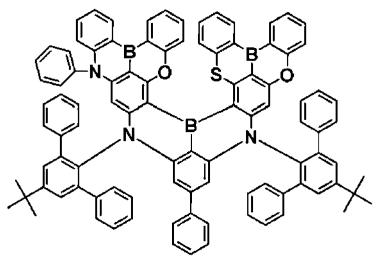

343

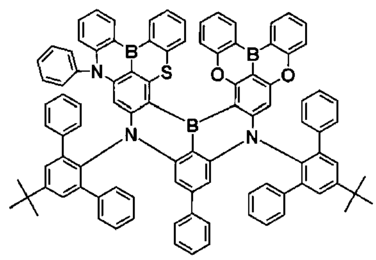

344

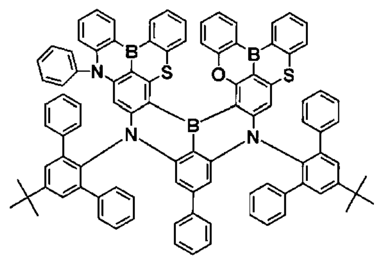

345

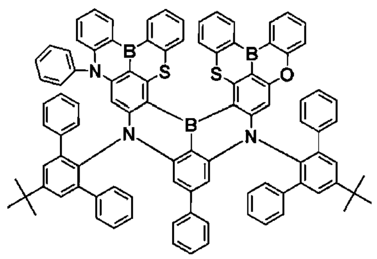

346

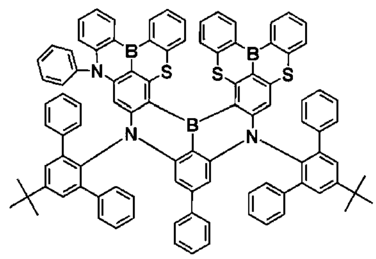

347

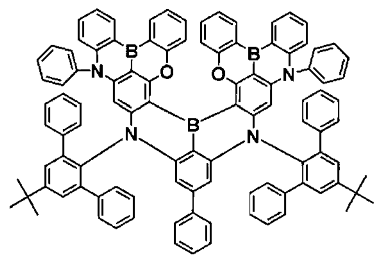

348

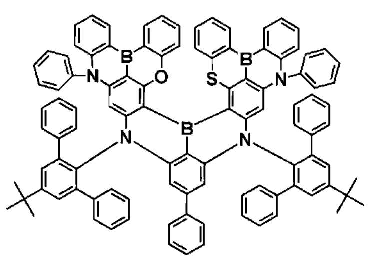

349

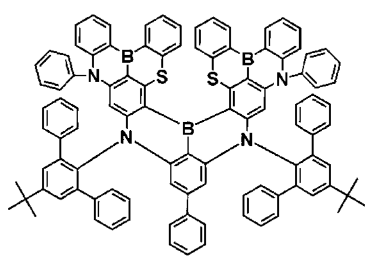

350

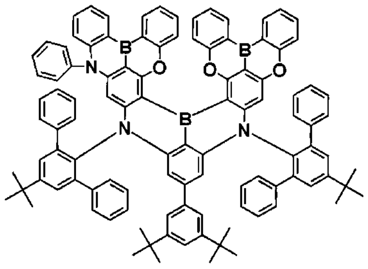

351

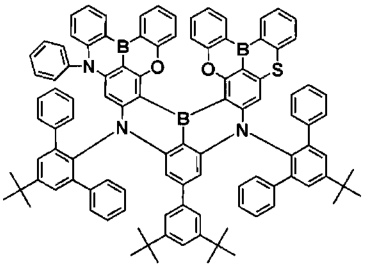

352

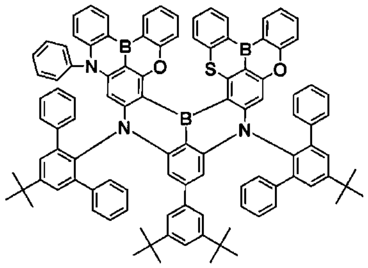

353

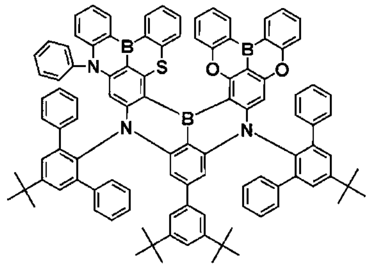

354

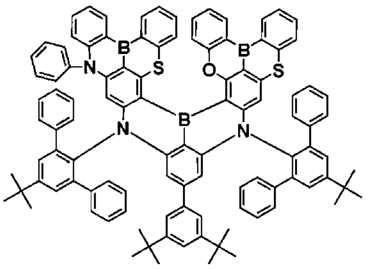

355

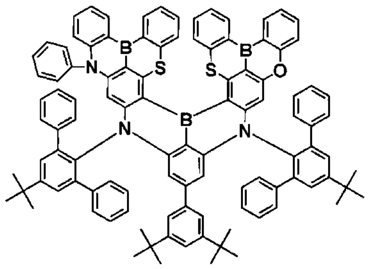

356

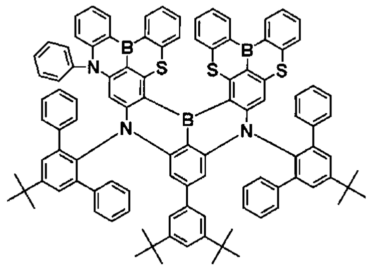

357

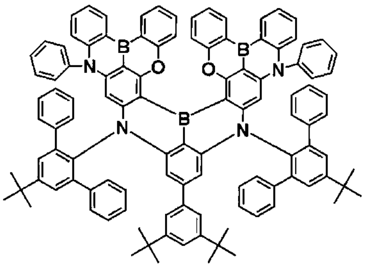

358

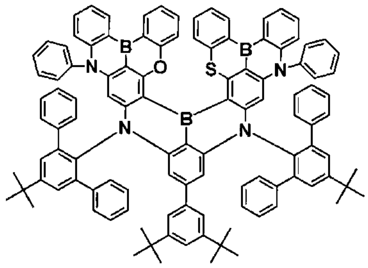

359

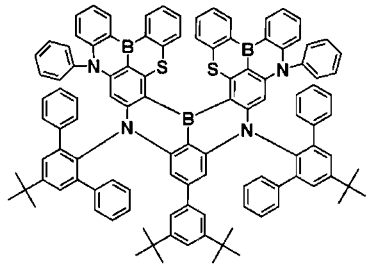

360

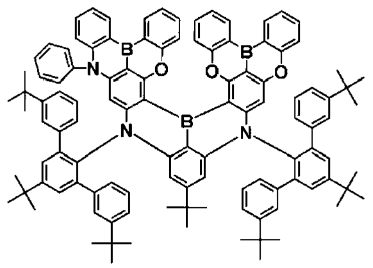

361

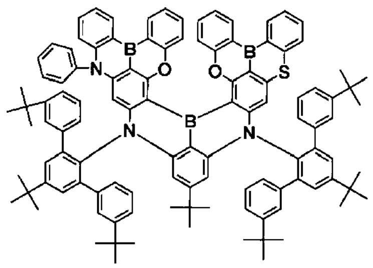

362

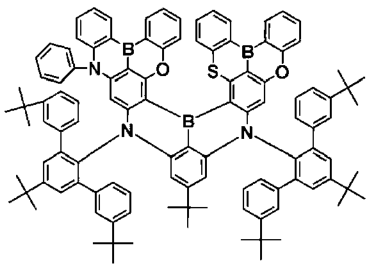

363

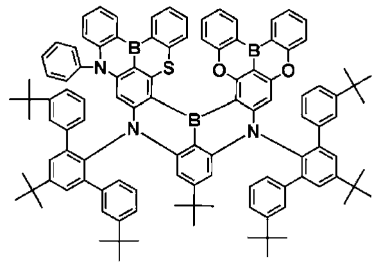

364

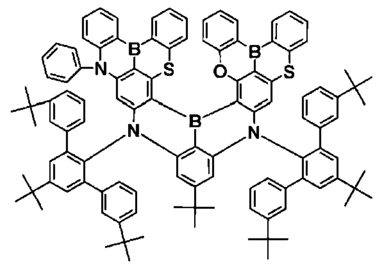

365

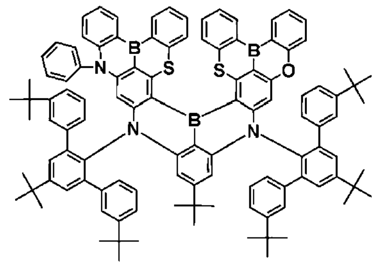

366

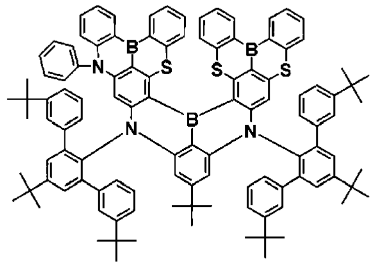

367

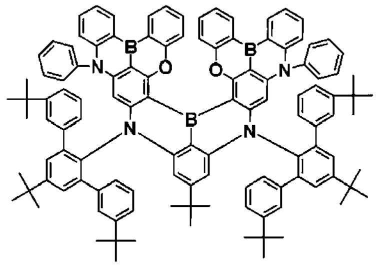

368

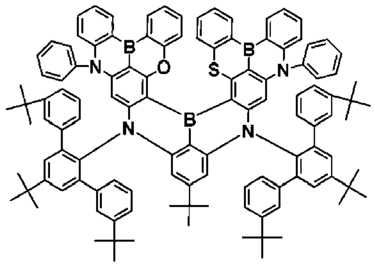

369

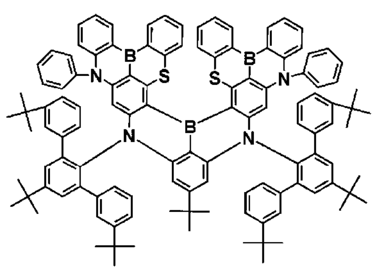

370

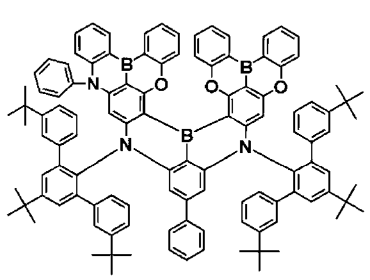

371

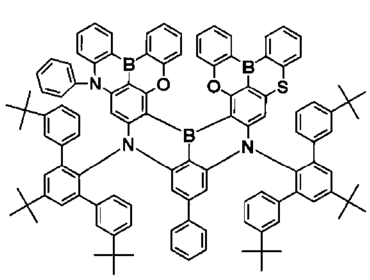

372

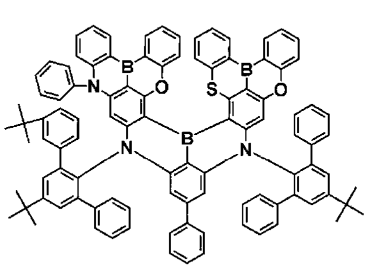

373

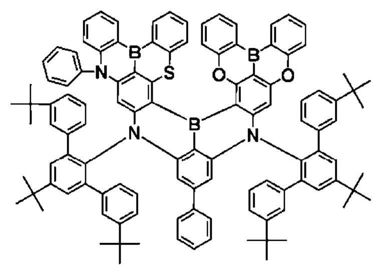

374

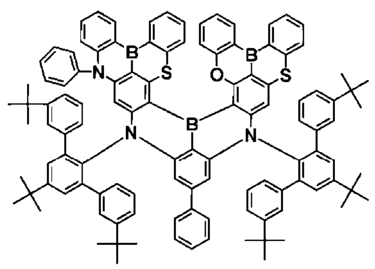

375

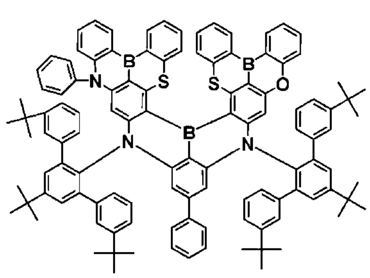

376

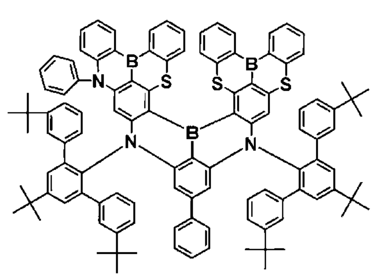

377

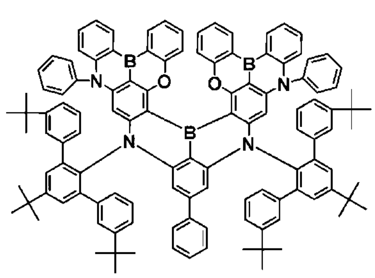

378

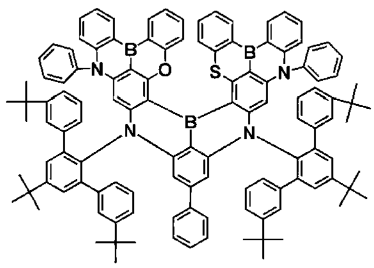

**379**

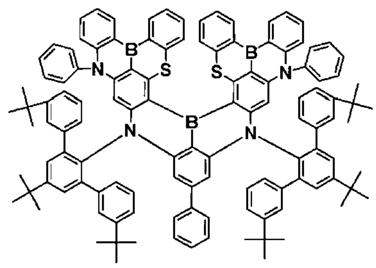

**380**

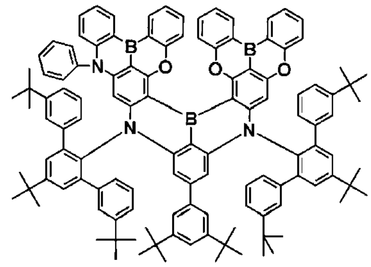

**381**

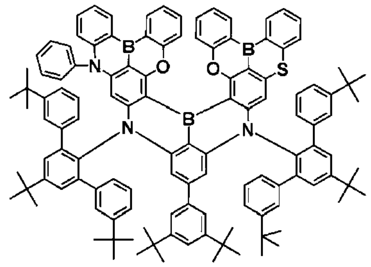

**382**

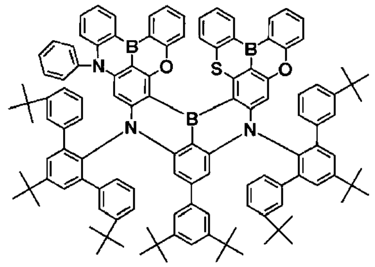

**383**

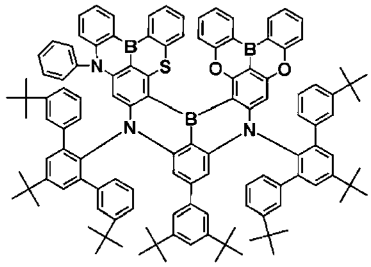

**384**

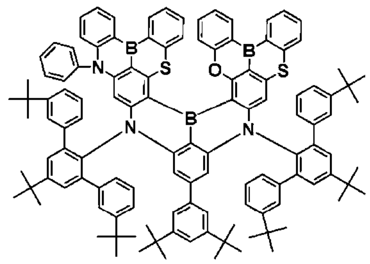

**385**

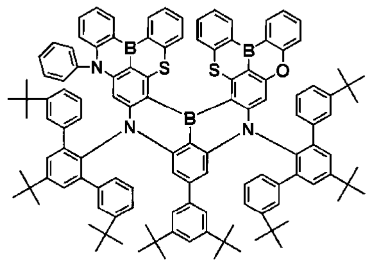

**386**

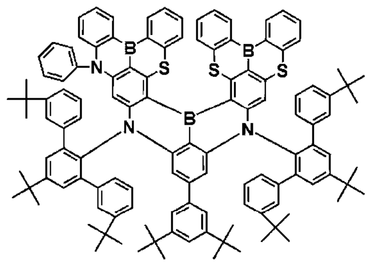

**387**

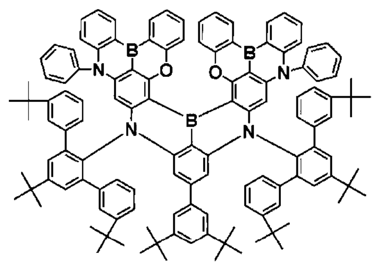

**388**

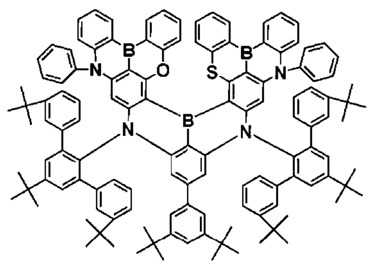

**389**

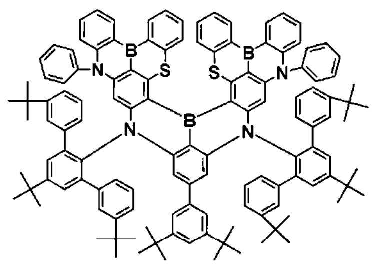

**390**

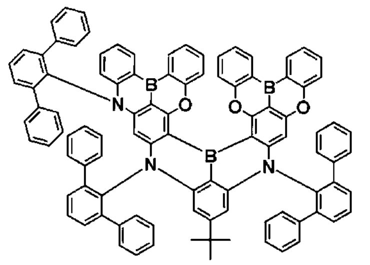

**391**

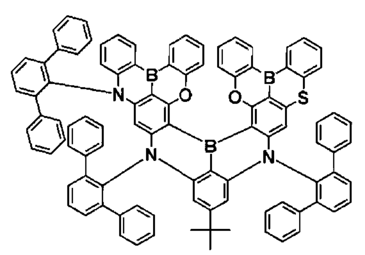

**392**

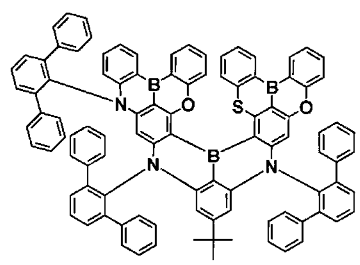

**393**

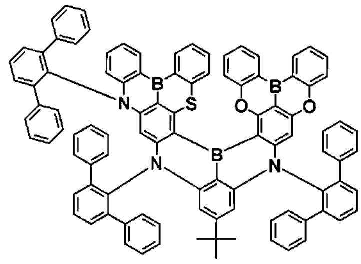

394

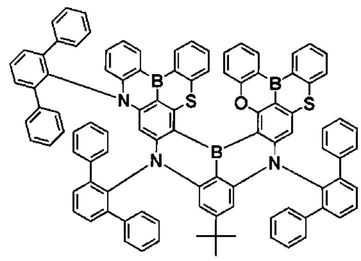

395

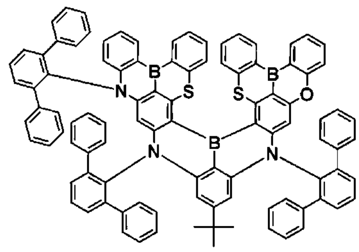

396

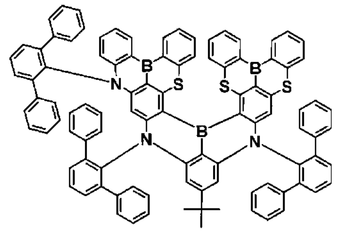

397

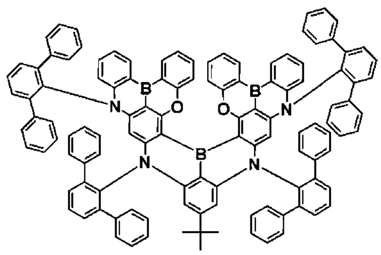

398

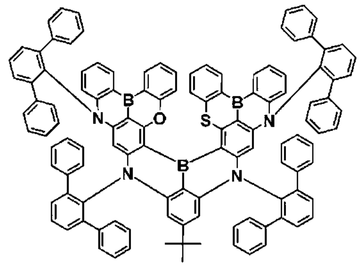

399

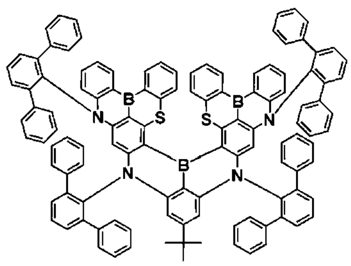

400

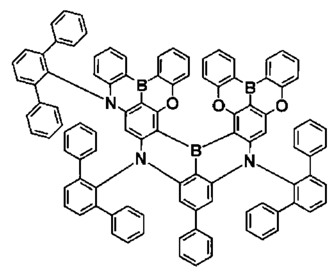

401

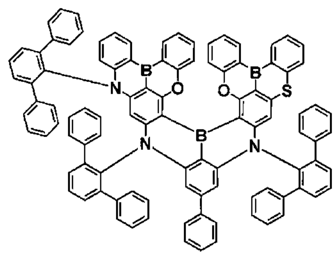

402

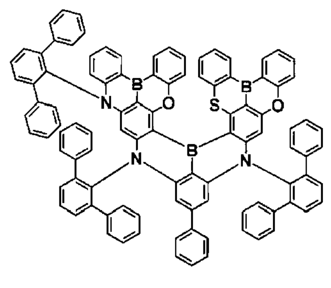

403

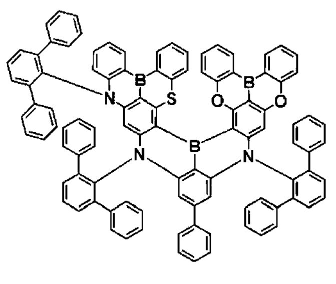

404

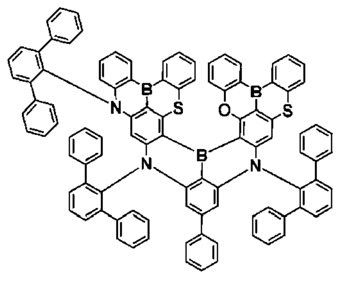

405

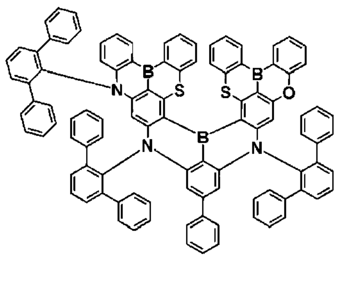

406

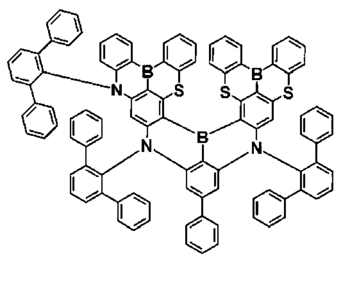

407

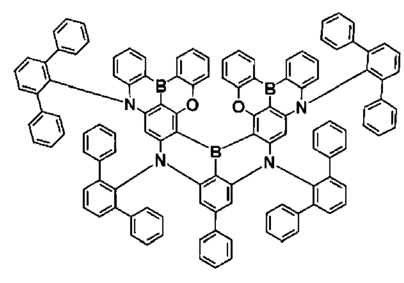

408

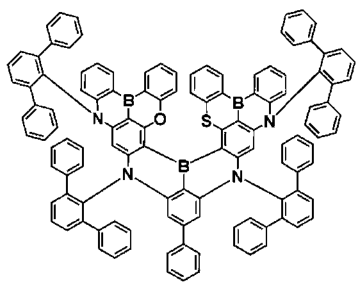

409

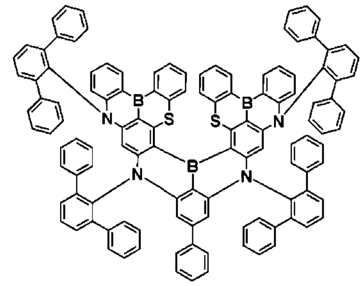

410

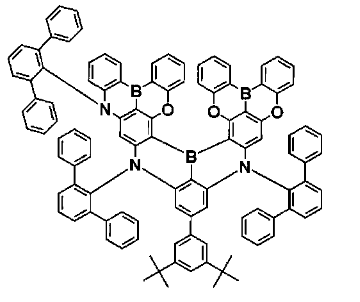

411

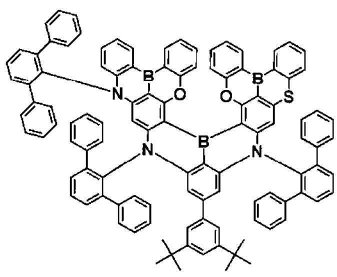

412

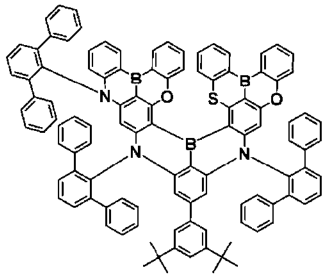

413

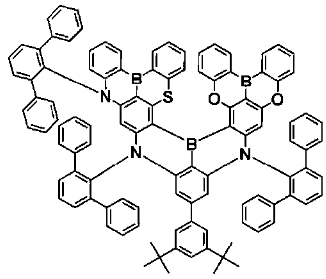

414

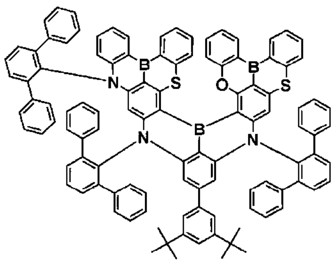

415

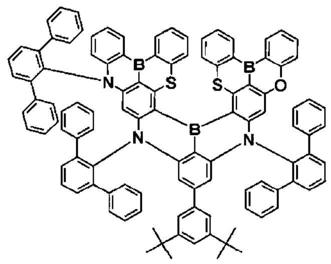

416

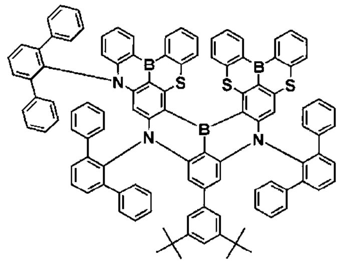

417

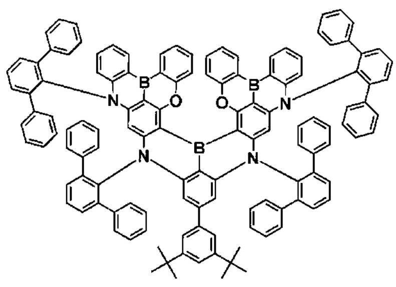

418

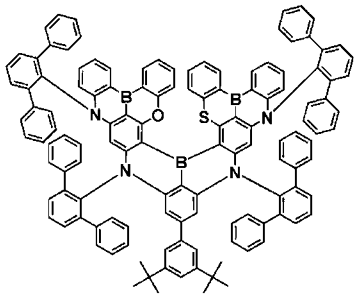

419

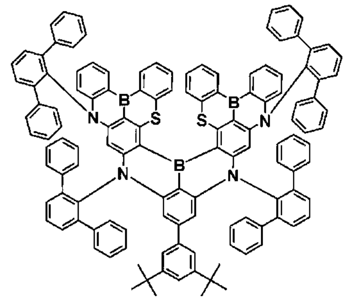

420

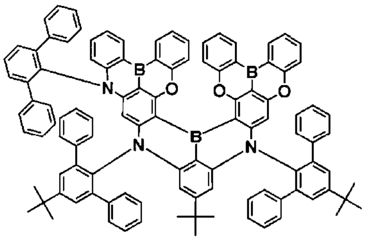

421

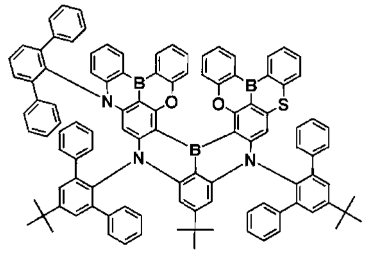

422

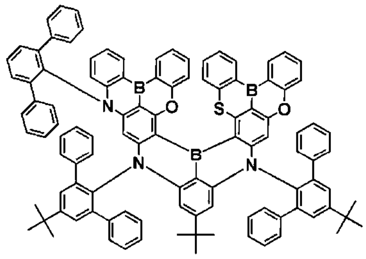

423

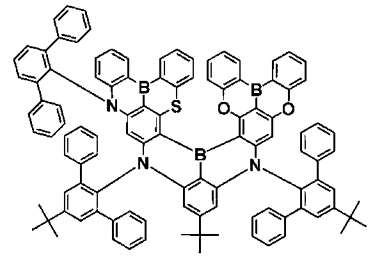

424

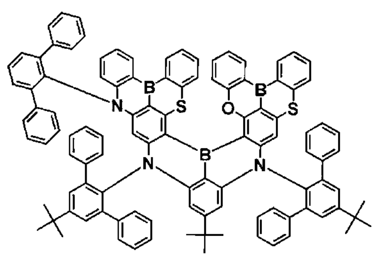

425

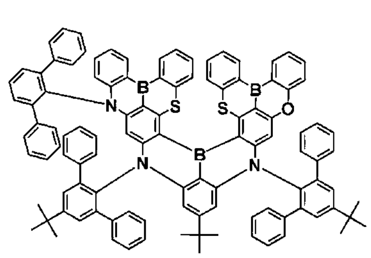

426

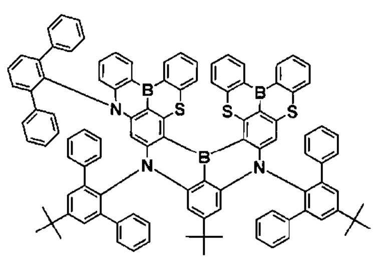

427

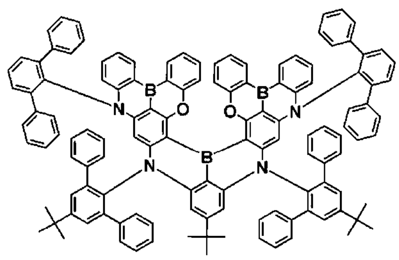

428

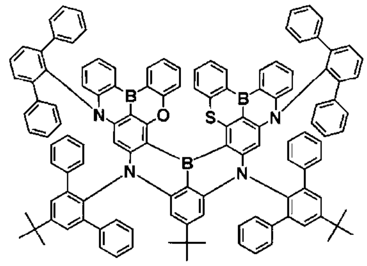

429

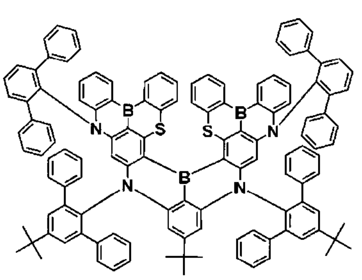

430

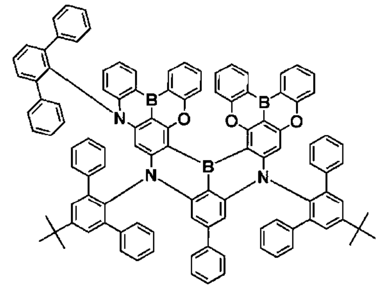

431

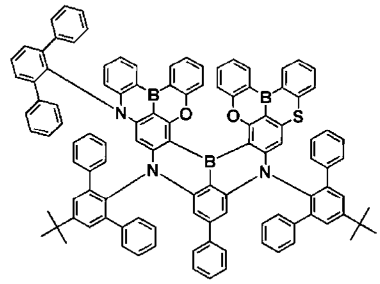

432

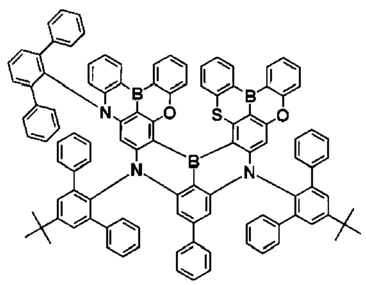

433

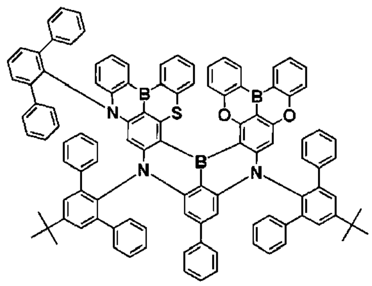

434

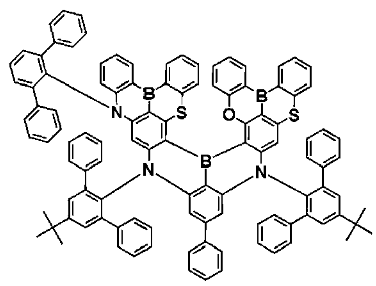

435

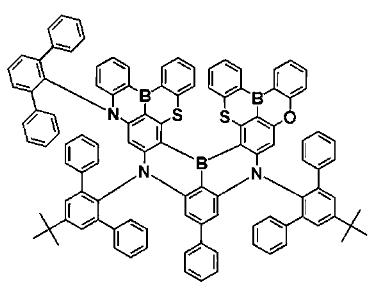

436

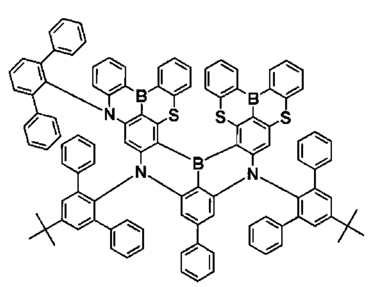

437

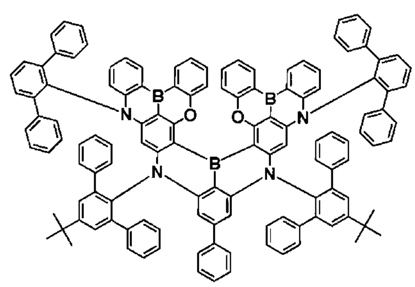

438

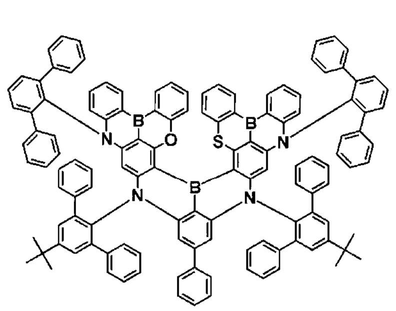

439

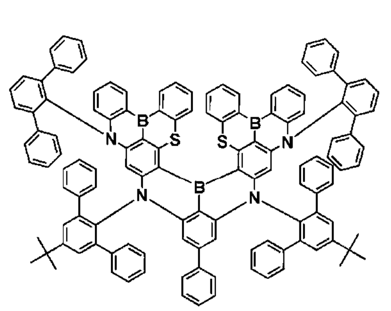

440

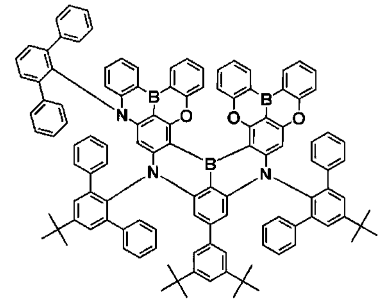

441

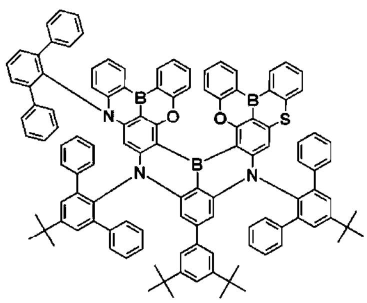

442

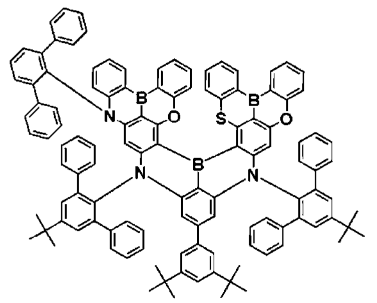

443

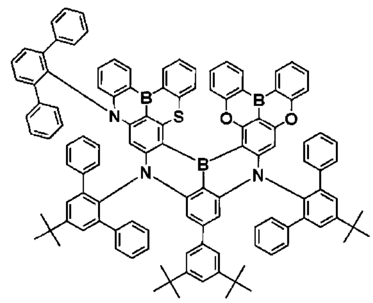

444

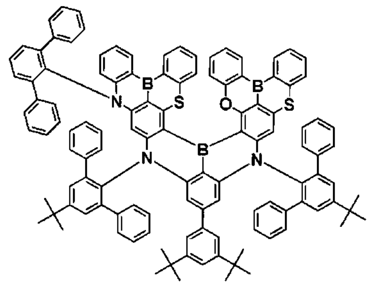

445

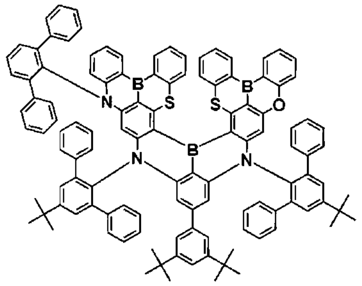

446

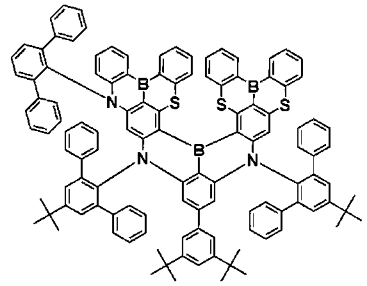

447

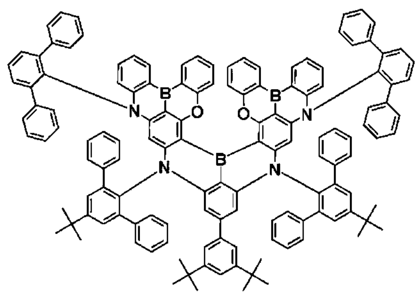

448

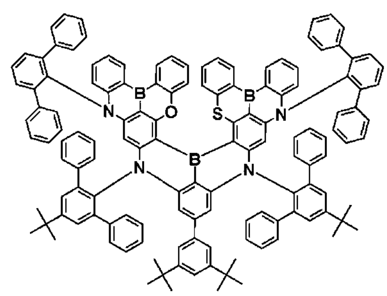

449

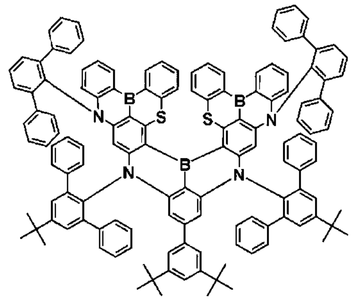

450

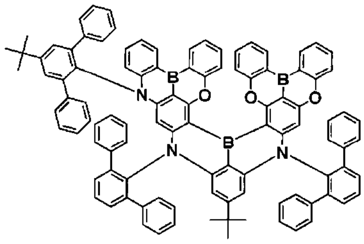

451

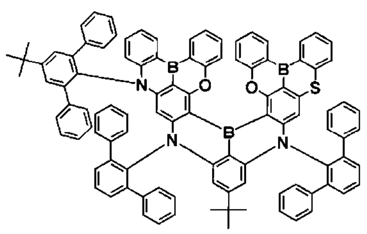

452

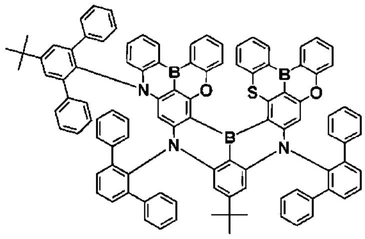

453

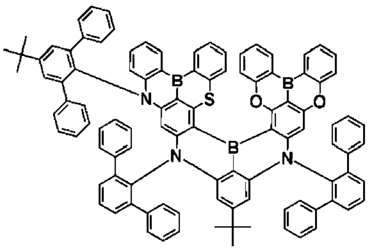

454

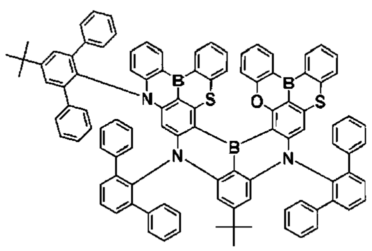

455

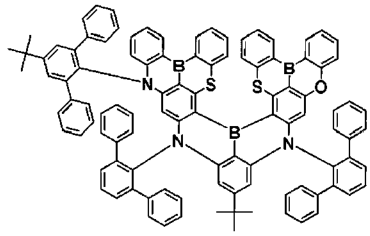

456

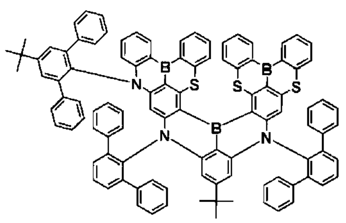

457

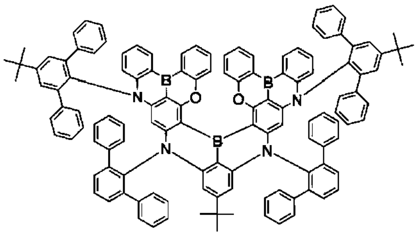

458

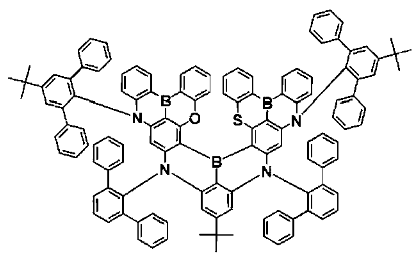

459

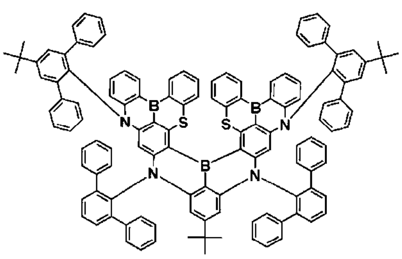

460

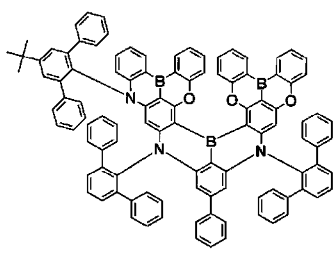

461

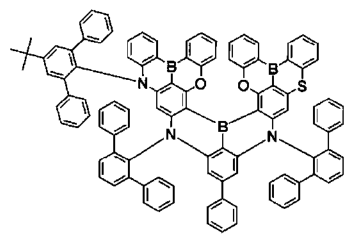

462

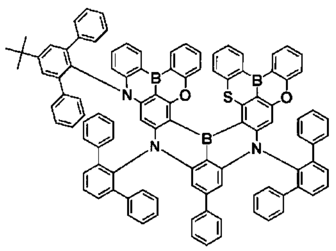

463

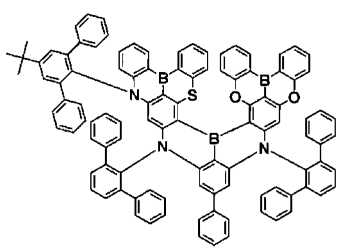

464

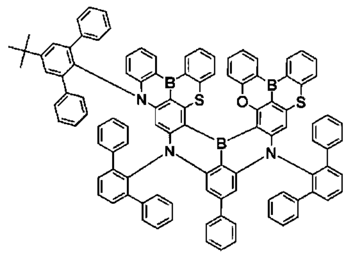

465

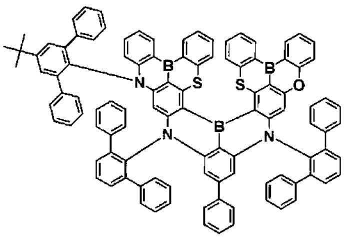
466

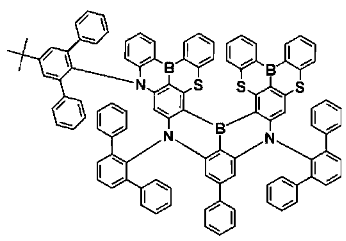
467

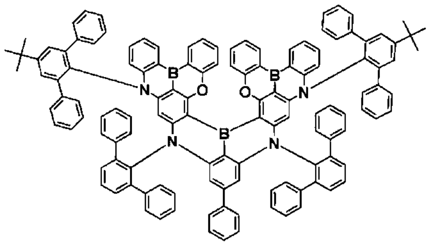
468

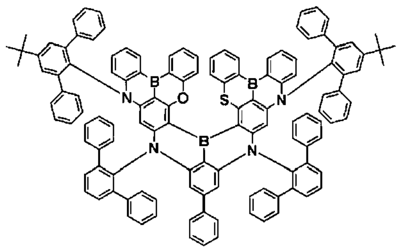
469

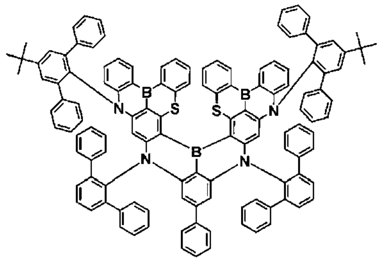
470

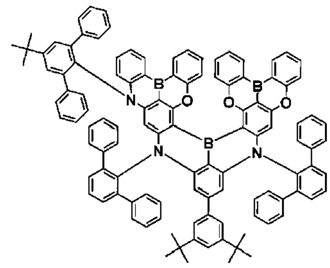
471

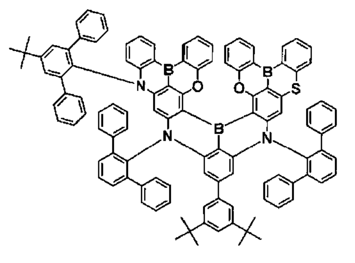
472

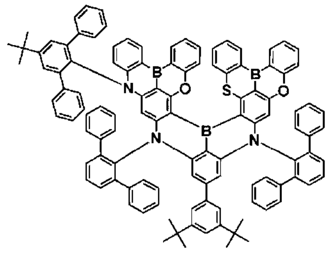
473

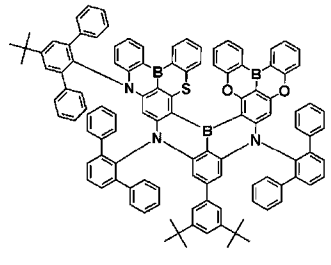
474

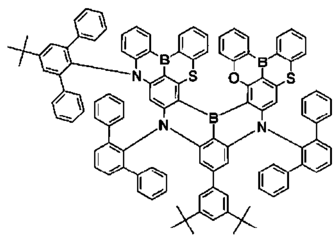
475

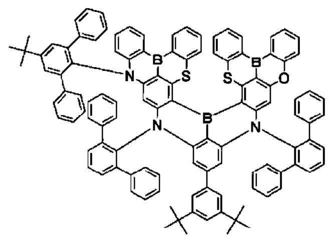
476

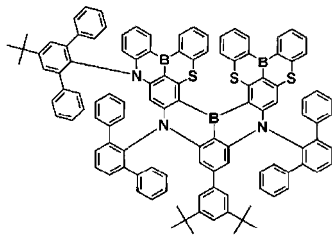
477

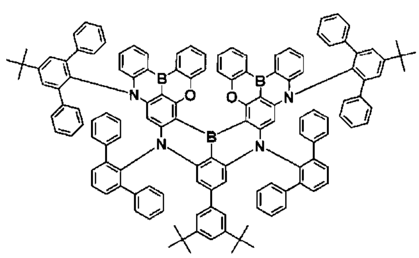
478

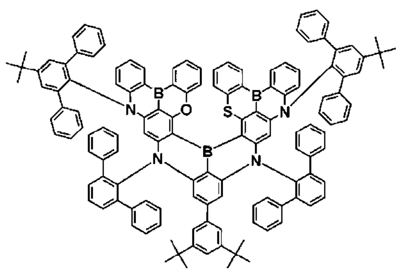
479

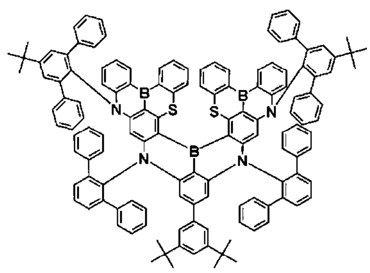
480

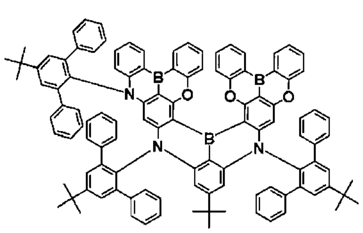

481

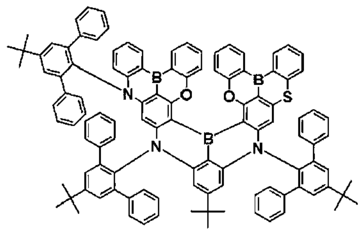

482

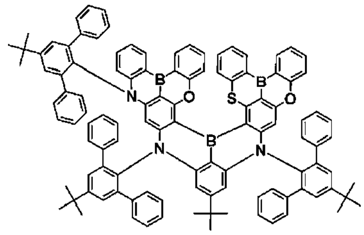

483

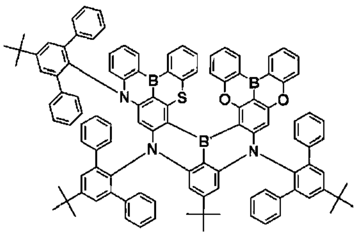

484

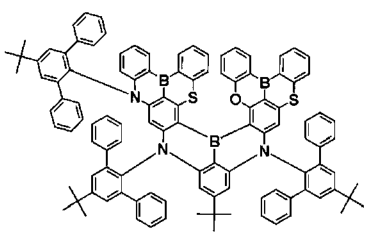

485

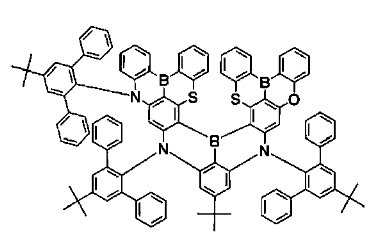

486

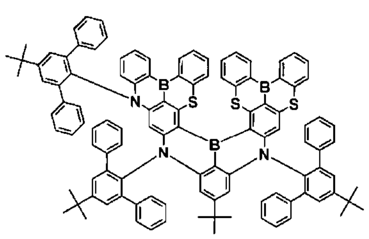

487

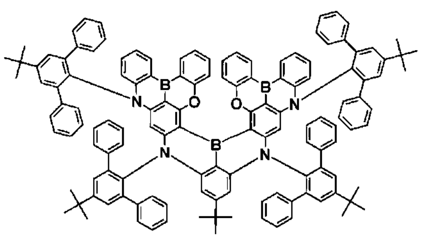

488

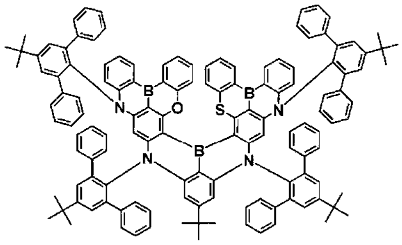

489

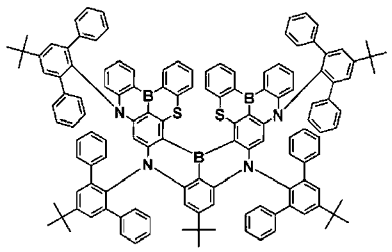

490

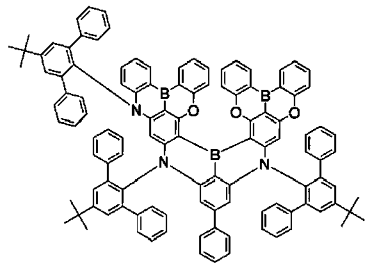

491

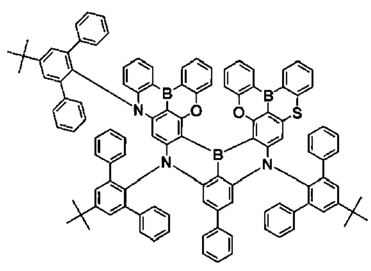

492

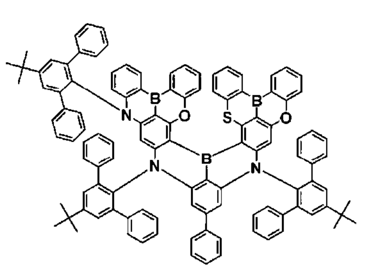

493

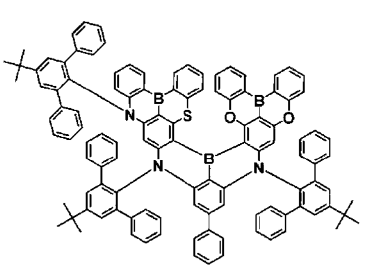

494

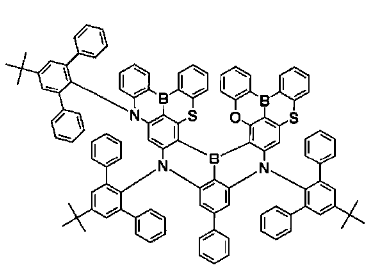

495

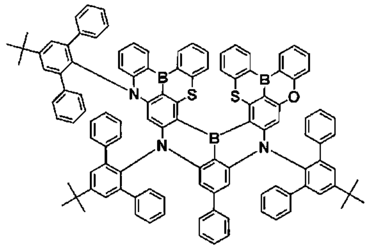

496

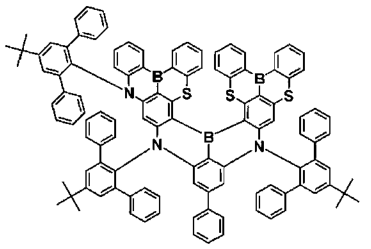

497

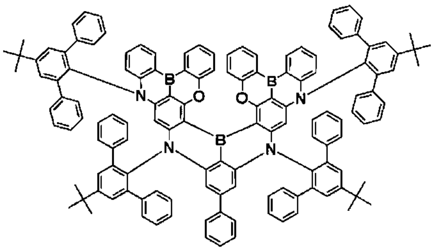

498

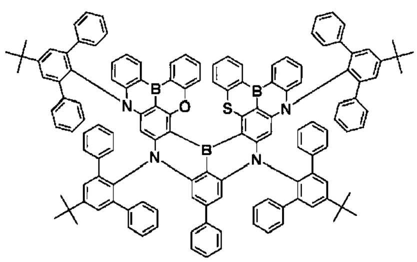

499

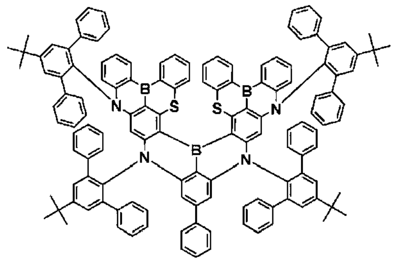

500

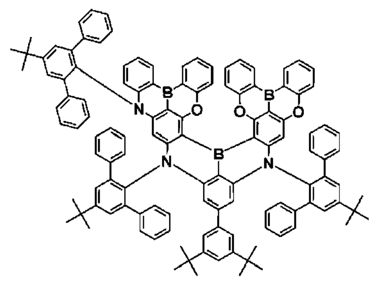

501

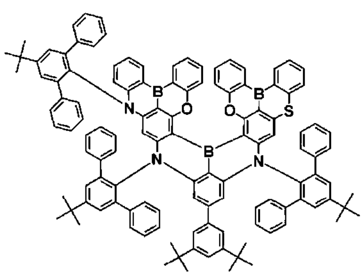

502

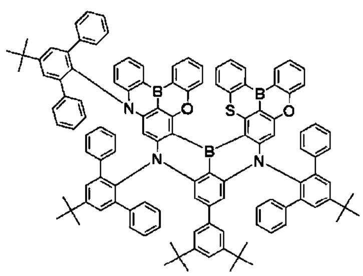

503

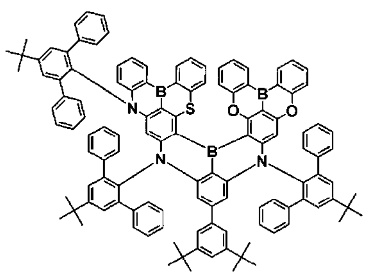

504

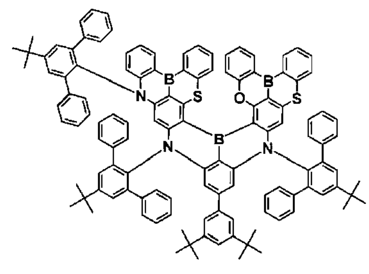

505

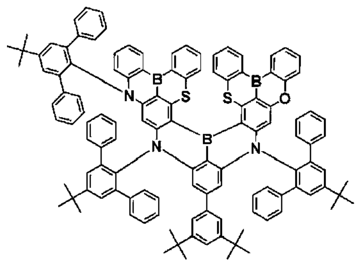

506

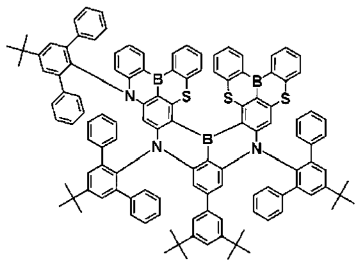

507

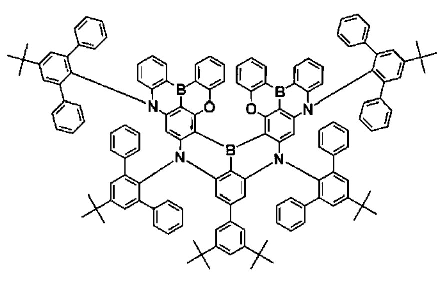

508

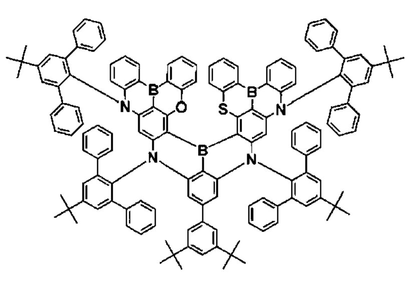

509

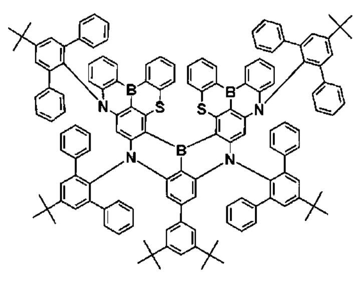

510

.

The heterocyclic compound represented by Formula 1 satisfies the structure of Formula 1 described above in which $Ar_1$ and $Ar_2$ are each independently a group represented by Formula 2. Due to this structure, the heterocyclic compound represented by Formula 1 may have excellent luminescence properties, and in particular, can realize a deep blue color with a short wavelength.

While not being limited to any particular theory, the heterocyclic compound represented by Formula 1 may exhibit increased molecular rigidity due to the structure represented by Formula 1 therein, resulting in a small singlet-triplet energy gap, and accordingly may exhibit advantageous characteristics such as narrow full width at half maximum (FWHM), small Stokes shift, and/or fast (i.e. short) delayed fluorescence excitation time (tau). Furthermore, as described above, by including the group represented by Formula 2, that is, a bulky substituent structure in which $CY_5$ and $CY_6$ are connected at the ortho positions of $CY_4$, a $S_1$ energy level may be high, and intermolecular interactions may be suppressed to achieve a high color purity, and light orientation may be high, and accordingly, when at least one of the heterocyclic compounds represented by Formula 1 is used as a light-emitting material, Dexter energy transfer may be suppressed, thereby exhibiting excellent lifespan characteristics.

Therefore, electronic devices, for example, an organic light-emitting device, including at least one of the heterocyclic compounds represented by Formula 1 may exhibit high efficiency and/or long lifespan.

The highest occupied molecular orbital (HOMO) energy level, lowest unoccupied molecular orbital (LUMO) energy level, singlet ($S_1$) energy level, and triplet ($T_1$) energy level of some compounds among the heterocyclic compounds represented by Formula 1 were evaluated using the Gaussian 09 program, which involves molecular structure optimization based on B3LYP-based density functional theory (DFT). The results thereof are shown in Table 1.

Table 1

| | HOMO (eV) | LUMO (eV) | $S_1$ (eV) | $T_1$ (eV) |
|---|---|---|---|---|
| Compound 41 | -4.86 | -1.34 | 2.814 | 2.812 |
| Compound A | -4.75 | -1.09 | 2.739 | 2.656 |

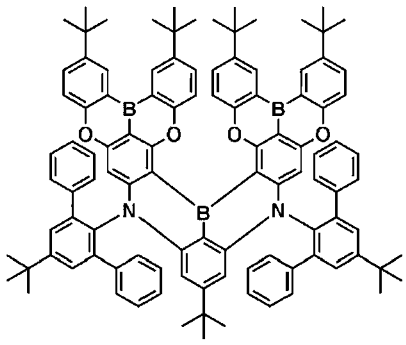

**41**

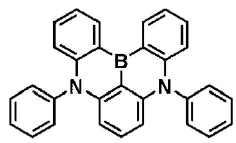

**A**

From Table 1, it was seen that the heterocyclic compound represented by Formula 1 has electrical characteristics suitable for use as a dopant (for example, an emitter or a sensitizer) in an electronic device, for example, an organic light-emitting device.

According to one or more embodiments, the full width at half maximum (FWHM) of an emission peak of an emission spectrum (e.g. a photoluminescence spectrum) or an electroluminescence spectrum of the heterocyclic compound represented by Formula 1 may be about 60 nm or less. For example, the FWHM of an emission peak of an emission spectrum (e.g. a photoluminescence spectrum) or an electroluminescence spectrum of the heterocyclic compound represented by Formula 1 may be about 5 nm to about 50 nm, about 7 nm to about 40 nm, about 10 nm to about 30 nm, about 15 nm to about 25 nm, or about 18 nm to about 21 nm.

Synthesis methods of the heterocyclic compound represented by Formula 1 may be recognizable by one of ordinary skill in the art and by referring to Synthesis Examples provided herein.

There are no particular limitations to the method for determining the structure of a heterocyclic compound represented by Formula 1. In one or more embodiments, the structure of the heterocyclic compound may be identified by a known method (for example, NMR, LC-MS, or the like).

Organic light-emitting device

According to an aspect, an organic light-emitting device includes at least one of the heterocyclic compounds

represented by Formula 1.

In one or more embodiments, the organic light-emitting device includes: a first electrode; a second electrode; and an organic layer arranged between the first electrode and the second electrode, wherein the organic layer includes an emission layer, and wherein the organic layer further includes at least one heterocyclic compound represented by Formula 1.

In one or more embodiments, the emission layer may include the at least one heterocyclic compound represented by Formula 1.

In one or more embodiments, the emission layer may include a host and an emitter, and the emitter may include the at least one heterocyclic compound represented by Formula 1.

In one or more embodiments, the amount of the host in the emission layer may be greater than the amount of the at least one heterocyclic compound represented by Formula 1, based on weight.

In one or more embodiments, the emission layer may further include a sensitizer.

In one or more embodiments, the sensitizer may include a phosphorescent compound, a delayed fluorescence compound, or a combination thereof.

Details on the host, the emitter and the sensitizer described above will be described below.

The organic light-emitting device may have a relatively narrow electroluminescent (EL) spectrum emission peak FWHM, excellent efficiency, and/or lifespan characteristics due to the inclusion of an emission layer including a heterocyclic compound represented by Formula 1 as described above.

In one or more embodiments, the heterocyclic compound represented by Formula 1 may act as a dopant (for example, an emitter or a sensitizer) in the emission layer, and the emission layer may further include a host (i.e., the amount of the at least one heterocyclic compound represented by Formula 1 in the emission layer may be less than the amount of the host, based on weight).

In one or more embodiments, the emission layer may emit a blue light. For example, the emission layer may emit a blue light having a maximum emission wavelength of about 410 nm to about 490 nm.

In one or more embodiments, the emission layer may emit a deep blue light having a maximum emission wavelength of about 410 nm to about 450 nm. For example, the emission layer may emit deep blue light having a maximum emission wavelength of about 410 nm to about 445 nm.

The expression that an "(emission layer) includes at least one heterocyclic compound represented by Formula 1" as used herein may be construed as meaning that the "(emission layer) may include one heterocyclic compound of Formula 1 or two or more different heterocyclic compounds of Formula 1."

In one or more embodiments, the emission layer may include only Compound 1 as the at least one heterocyclic compound represented by Formula 1. In this regard, Compound 1 may be included in the emission layer of the organic light-emitting device. In one or more embodiments, the emission layer may include, as the at least one heterocyclic compound represented by Formula 1, both Compound 1 and Compound 2.

## Description of FIG. 1

FIG. 1 is a schematic cross-sectional view of an organic light-emitting device 10 according to one or more embodiments. Hereinafter, the structure and manufacturing method of the organic light-emitting device 10 according to one or more embodiments will be described with reference to FIG. 1.

In FIG. 1, an organic light-emitting device 10 includes a first electrode 11, a second electrode 19 facing the first electrode 11, and an organic layer 15 that is arranged between the first electrode 11 and the second electrode 19.

The organic layer 15 may include an emission layer, and may further include a hole transport region arranged between the first electrode 11 and the emission layer, and an electron transport region arranged between the emission layer and the second electrode 19.

A substrate may be further disposed under the first electrode 11 or on the second electrode 19. The substrate may be any suitable substrate commonly used in organic light-emitting devices, e.g., a glass substrate or a transparent plastic substrate, which have excellent mechanical strength, thermal stability, transparency, surface smoothness, ease of handling, and/or water repellency.

## First electrode 11

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a transflective electrode, or a transmissive electrode. In case that the first electrode 11 is a transmissive electrode, a material for forming the first electrode 11 may be indium tin oxide (ITO), indium zinc oxide (IZO), tin oxide ($SnO_2$), zinc oxide (ZnO), or a combination thereof, but embodiments are not

limited thereto. In some embodiments, in case that the first electrode 110 is a transflective electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), or a combination thereof may be used, but embodiments are not limited thereto.

The first electrode 11 may have a single-layered structure or a multi-layered structure including two or more layers.

Emission layer

The emission layer may include the at least one heterocyclic compound represented by Formula 1.

A thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

Description of FIG. 2

According to one or more embodiments, the heterocyclic compound represented by Formula 1 may be a fluorescent emitter.

In one or more embodiments, the emission layer may further include a host (hereinafter referred to as 'host A', and the host A is not identical to the heterocyclic compound represented by Formula 1). Host A may be any one of the host materials provided herein, but embodiments are not limited thereto. The host A may be a fluorescent host.

FIG. 2 illustrates the energy transfer according to one or more embodiments.

For example, a singlet exciton is formed in host A in the emission layer, and the singlet exciton formed in host A is transferred to the fluorescent emitter through a Förster energy transfer or a Förster resonance energy transfer (FRET).

Because the singlet exciton formed in host A is only 25%, the efficiency of the organic light-emitting device can be further improved by allowing the triplet excitons occupying 75% and formed in host A to fuse with each other to convert into singlet excitons. That is, the efficiency of the organic light-emitting device can be further improved by using a triplet-triplet fusion (TTF) mechanism.

In some embodiments, among the total emission components emitted from the emission layer, the ratio of emission components emitted from the heterocyclic compound represented by Formula 1 may be about 80% or more, for example, about 90% or more. For example, among the total emission components emitted from the emission layer, the ratio of emission components emitted from the heterocyclic compound represented by Formula 1 may be about 95% or more based on the total emission components emitted from the emission layer.

In this regard, the heterocyclic compound represented by Formula 1 may emit fluorescent light, and the host may not emit light.

In one or more embodiments, when the emission layer further includes host A in addition to the at least one heterocyclic compound represented by Formula 1, the amount of the heterocyclic compound represented by Formula 1 may be 50 parts by weight or less, for example, 30 parts by weight or less, based on 100 parts by weight of the emission layer, and the amount of host A in the emission layer may be 50 parts by weight or more, for example, 70 parts by weight or more, based on 100 parts by weight of the emission layer, but is not limited thereto.

In some embodiments, the emission layer may further include host A in addition to the at least one heterocyclic compound represented by Formula 1, and host A and the heterocyclic compound represented by Formula 1 may satisfy condition A:

Condition A

$$E(H_A)_{S1} > E_{S1}$$

wherein, in condition A,

$E(H_A)_{S1}$ indicates a lowest excited singlet energy level of host A, and
$E_{S1}$ indicates a lowest excited singlet energy level of the heterocyclic compound represented by Formula 1.

In this regard, $E(H_A)_{S1}$ and $E_{S1}$ may be evaluated by using the Gaussian program which involves molecular structure optimization by DFT based on B3LYP and 6-31G(d,p).

Description For FIG. 3

According to one or more embodiments, the heterocyclic compound represented by Formula 1 may be a delayed fluorescence emitter.
According to some embodiments, the emission layer may further include a host (hereinafter referred to as 'host B', and host B is not identical to the heterocyclic compound represented by Formula 1). Host B may be any one or more of the host materials provided herein, and is not limited thereto.
FIG. 3 shows the energy transfer according to one or more embodiments
For example, singlet excitons produced in host B in the emission layer, which occupies 25 %, may be transferred to a delayed fluorescence emitter through FRET. In some embodiments, triplet excitons formed in host B in the emission layer, which occupies 75%, may be transferred to the delayed fluorescence emitter via Dexter energy transfer. At least part of the energy of the singlet in a delayed fluorescence emitter may be transferred to the triplet by intersystem crossing (ISC). The energy of the triplet of a delayed fluorescence emitter may be transferred to the singlet through reverse intersystem crossing (RISC). When the singlet excitons and triplet excitons generated in the emission layer are transferred to the heterocyclic compound represented by Formula 1, an organic light-emitting device having improved efficiency can be obtained.
In one or more embodiments, among the total emission components emitted from the emission layer, the emission components emitted from the heterocyclic compound represented by Formula 1 may be about 80% or more, for example, about 90% or more. In some embodiments, the emission components emitted from the heterocyclic compound represented by Formula 1 may be about 95 % or greater based on the total emission components emitted from the emission layer.
In this regard, the heterocyclic compound represented by Formula 1 may emit fluorescent light and/or delayed fluorescent light, and the emission component of the heterocyclic compound represented by Formula 1 may be the sum of the prompt emission component of the heterocyclic compound represented by Formula 1 and the delayed fluorescence component by RISC of the heterocyclic compound represented by Formula 1. In addition, host B may not emit a light.
one or more embodiments, in case that the emission layer further includes host B in addition to the at least one heterocyclic compound represented by Formula 1, the amount of the heterocyclic compound represented by Formula 1 may be about 50 parts by weight or less, for example, about 30 parts by weight or less, based on 100 parts by weight of the emission layer, and the amount of host B in the emission layer may be about 50 parts by weight or more, for example, about 70 parts by weight or more, based on 100 parts by weight of the emission layer, but embodiments are not limited thereto.
one or more embodiments, when the emission layer further includes host B in addition to the at least one heterocyclic compound represented by Formula 1, host B and the heterocyclic compound represented by Formula 1 may satisfy condition B:

Condition B

$$E(H_B)_{S1} > E_{S1}$$

wherein, in condition B,

$E(H_B)_{S1}$ indicates a lowest excited singlet energy level of host B, and
$E_{S1}$ indicates a lowest excited singlet energy level of the heterocyclic compound represented by Formula 1.

In this regard, $E(H_B)_{S1}$ and $E_{S1}$ may be evaluated by using the Gaussian program which involves molecular structure optimization by DFT based on B3LYP and 6-31G(d,p).

Description of FIG. 4

In some embodiments, the heterocyclic compound represented by Formula 1 is used as a fluorescence emitter, and the emission layer includes a sensitizer, for example, a delayed fluorescent sensitizer. According to one or more embodiments, the emission layer may further include a host (hereinafter referred to as 'host C', and host C is not identical to the heterocyclic compound represented by Formula 1 or the sensitizer) and a sensitizer (hereinafter referred to as 'sensitizer A', and sensitizer A is not identical to host C or the heterocyclic compound represented by Formula 1). Host C and sensitizer A may respectively be any one of the host material and the sensitizer material provided herein, but embodiments are not limited thereto.
In one or more embodiments, among the total emission components emitted from the emission layer, the amount of the emission component of the heterocyclic compound represented by Formula 1 may be about 80% or more, for example, about 90% or more (for example, about 95% or more). For example, the heterocyclic compound represented by

Formula 1 may emit fluorescent light. In some embodiments, each of host C and sensitizer A may not emit a light.

FIG. 4 shows the energy transfer, according to one or more embodiments.

For example, singlet and triplet excitons may be produced in host C in the emission layer, and singlet and triplet excitons produced in host C may be transferred to the sensitizer A and then transferred to the heterocyclic compound represented by Formula 1 through FRET. The energy of the singlet excitons formed in host C, which occupy 25%, is transferred to sensitizer A via FRET, and the energy of the triplet excitons formed in host C, which occupy 75%, is transferred to the singlet and triplet excitons of sensitizer A. At least part of the energy of the singlet of sensitizer A may be transferred to the triplet by ISC. The energy transferred to the triplet of sensitizer A may be transferred by RISC to the singlet, and then the singlet energy of sensitizer A may be transferred to the heterocyclic compound represented by Formula 1 through FRET.

An organic light-emitting device with improved efficiency can be obtained by transferring both singlet excitons and triplet excitons generated in the emission layer to a dopant (e.g., an emitter). In addition, since the obtained organic light-emitting device may have significantly reduced energy loss, the lifespan characteristics of the organic light-emitting device can be improved.

When the example in FIG. 4 includes an emission layer that further includes host C and sensitizer A in addition to the heterocyclic compound represented by Formula 1, host C, sensitizer A, and the heterocyclic compound represented by Formula 1 may satisfy condition C-1 and/or condition C-2:

Condition C-1

$$S_1(H_C) \geq S_1(S_A)$$

Condition C-2

$$S_1(S_A) \geq S_1(HC)$$

wherein, in conditions C-1 and C-2,

$S_1(H_C)$ indicates a lowest excited singlet energy level of host C,
$S_1(S_A)$ indicates a lowest excited singlet energy level of sensitizer A, and
$S_1(HC)$ indicates a lowest excited singlet energy level of the heterocyclic compound represented by Formula 1.

$S_1(H_C)$, $S_1(S_A)$, and $S_1(HC)$ are evaluated by using the Gaussian program which involves molecular structure optimization by DFT based on B3LYP and 6-31G(d,p).

When host C, sensitizer A, and the heterocyclic compound represented by Formula 1 satisfy Condition C-1 and/or Condition C-2, FRET from sensitizer A to the heterocyclic compound represented by Formula 1 may be facilitated, and accordingly, the organic light-emitting device may have improved luminescence efficiency.

Description of FIG. 5

In one or more embodiments, the heterocyclic compound represented by Formula 1 may be used as a fluorescent emitter, and the emission layer may include a sensitizer, specifically a phosphorescent sensitizer.

one or more embodiments, the emission layer may further include a host (hereinafter referred to as 'host D', and host D is not identical to the heterocyclic compound represented by Formula 1 or the sensitizer) and a sensitizer (hereinafter referred to as 'sensitizer B', and sensitizer B is not identical to host D or the heterocyclic compound represented by Formula 1). Host D and sensitizer B may respectively be any one or more of the host materials and the sensitizer materials provided herein, but embodiments are not limited thereto.

In one or more embodiments, among the total emission components emitted from the emission layer, the proportion of the emission component of the heterocyclic compound represented by Formula 1 may be about 80% or more, for example, about 90% or more (for example, about 95% or more). For example, the heterocyclic compound represented by Formula 1 may emit fluorescent light. In some embodiments, each of the host and the sensitizer may not emit a light.

FIG. 5 illustrates the energy transfer according to one or more embodiments.

The energy of the triplet excitons formed in host D in the emission layer, which occupy the ratio of 75%, are transferred to sensitizer B through Dexter energy transfer, and singlet excitons formed in host D in the emission layer, which occupy the ratio of 25%, are transferred to the singlet and triplet excitons of sensitizer B. Among these, the energy transferred to the singlet of sensitizer B is transferred by ISC to a triplet, and then the triplet energy of sensitizer B is transferred to the heterocyclic compound represented by Formula 1 through FRET.

Accordingly, an organic light-emitting device with improved efficiency can be obtained by transferring both singlet excitons and triplet excitons generated in the emission layer to a dopant (e.g., an emitter). In addition, since an organic light-emitting device with significantly reduced energy loss can be obtained, the lifespan characteristics of the organic light-emitting device can be improved.

In one or more embodiments, when the emission layer further includes host D and a sensitizer B in addition to the at least one heterocyclic compound represented by Formula 1, host D, sensitizer B, and the heterocyclic compound represented by Formula 1 may satisfy Conditions D-1 and/or D-2:

Condition D-1

$$T_1(H_D) \geq T_1(S_B)$$

Condition D-2

$$T_1(S_B) \geq S_1(HC)$$

wherein, in conditions D-1 and D-2,

$T_1(H_D)$ indicates a lowest excited triplet energy level of Host D,
$T_1(S_B)$ indicates a lowest excited triplet energy level of Sensitizer B, and
$S_1(HC)$ indicates a lowest excited singlet energy level of the heterocyclic compound represented by Formula 1.

$T_1(H_D)$, $T_1(S_B)$, and $S_1(HC)$ may be evaluated according to the Gaussian program which involves molecular structure optimization by DFT based on B3LYP and 6-31G(d,p).

When Host D, Sensitizer B, and the heterocyclic compound represented by Formula 1 satisfy Condition D-1 and/or Condition D-2, FRET from Sensitizer B to the heterocyclic compound represented by Formula 1 may be facilitated, and accordingly, the organic light-emitting device may have improved luminescence efficiency.

According to one or more embodiments, the amount of the sensitizer in the emission layer may be about 5 wt% to about 50 wt%, for example, about 10 wt% to about 30 wt%, based on total weight of the emission layer. When the amount is within these ranges, energy transfer in the emission layer may be effectively made. Thus, the organic light-emitting device may have high efficiency and long lifespan.

In one or more embodiments, the amount of the heterocyclic compound represented by Formula 1 in the emission layer may be about 0.01 wt% to about 15 wt% based on the total weight of the emission layer, for example, about 0.05 wt% to about 3 wt% based on the total weight of the emission layer, but embodiments are not limited thereto.

In one or more embodiments, the heterocyclic compound represented by Formula 1 may further satisfy Condition 5:

Condition 5

$$0\ \mu s < T_{decay}(HC) < 5\ \mu s$$

In condition 5,
$T_{decay}(HC)$ indicates a decay time of the heterocyclic compound represented by Formula 1.

The decay time of the heterocyclic compound represented by Formula 1 corresponds to a value calculated from the time-resolved photoluminescence (TRPL) spectrum at room temperature for a 40 nm thick film (hereinafter referred to as "film (HC)") obtained by vacuum co-depositing the host and the heterocyclic compound included in the emission layer on a quartz substrate at a weight ratio of 90:10 at a vacuum of $10^{-7}$ torr.

Description of FIG. 6

According to one or more embodiments, the heterocyclic compound represented by Formula 1 may be used as a delayed fluorescence emitter, and the emission layer may include a sensitizer, for example, a delayed fluorescence sensitizer.

In one or more embodiments, the emission layer may further include a host (hereinafter referred to as 'host E', and the host E is not identical to the heterocyclic compound represented by Formula 1 or the sensitizer) and a sensitizer (hereinafter referred to as 'sensitizer C', and the sensitizer C is not identical to host E or the heterocyclic compound represented by Formula 1). Host E and sensitizer C may respectively include any one or more of the host materials and the

sensitizer materials provided herein, but embodiments are not limited thereto.

In one or more embodiments, among the total emission components emitted from the emission layer, the proportion of the emission component of the heterocyclic compound represented by Formula 1 may be about 80% or more, for example, about 90% or more (for example, about 95% or more) based on total emission components. In some embodiments, the heterocyclic compound represented by Formula 1 may emit fluorescence and/or delayed fluorescence. In addition, host E and sensitizer C may not each emit a light.

In this regard, the heterocyclic compound represented by Formula 1 emits fluorescent light and/or delayed fluorescent light, and the emission component of the heterocyclic compound represented by Formula 1 is the sum of the prompt emission component of the heterocyclic compound represented by Formula 1 and the delayed fluorescence component due to the RISC of the heterocyclic compound represented by Formula 1.

FIG. 6 shows the energy transfer according to one or more embodiments.

The energy of singlet excitons produced in host E in the emission layer, which occupy 25%, may be transferred to a singlet state of sensitizer C through FRET, and the energy of triplet excitons produced in host E in the emission layer may be transferred to a triplet state of sensitizer C, and then singlet energy of sensitizer C may be transferred to the heterocyclic compound represented by Formula 1 through FRET. Subsequently, the triplet energy of sensitizer C may be transferred to the heterocyclic compound represented by Formula 1 through Dexter energy transfer. Among these, the energy transferred to the triplet of sensitizer C may also be transferred by RISC to the singlet. The energy of the triplet formed in sensitizer C may be transferred backward to host E (triplet exciton distributing, TED), and then transferred back to the heterocyclic compound represented by Formula 1 to emit light through RISC.

An organic light-emitting device with improved efficiency may be obtained by transferring both singlet excitons and triplet excitons generated in the emission layer to a dopant (e.g., an emitter). In addition, since an organic light-emitting device with significantly reduced energy loss can be obtained, the lifespan characteristics of the organic light-emitting device can be improved.

In one or more embodiments, when the emission layer may further include host E and sensitizer C in addition to the heterocyclic compound represented by Formula 1, host E, sensitizer C, and the heterocyclic compound represented by Formula 1 may satisfy Conditions E-1, E-2, and/or E-3:

Condition E-1

$$S_1(H_E) \geq S_1(S_C)$$

Condition E-2

$$S_1(S_C) \geq S_1(HC)$$

Condition E-3

$$T_1(S_C) \geq T_1(HC)$$

wherein, in conditions E-1, E-2, and E-3,

$S_1(H_E)$ indicates a lowest excited singlet energy level of host E,
$S_1(S_C)$ indicates a lowest excited singlet energy level of sensitizer C,
$S_1(HC)$ indicates a lowest excited singlet energy level of the heterocyclic compound represented by Formula 1,
$T_1(S_C)$ indicates a lowest excited triplet energy level of sensitizer C, and
$T_1(HC)$ indicates a lowest excited triplet energy level of the heterocyclic compound represented by Formula 1.

$S_1(H_E)$, $S_1(S_C)$, $S_1(HC)$, $T_1(S_C)$, and $T_1(HC)$ may be evaluated by using the Gaussian program which involves molecular structure optimization by DFT based on B3LYP and 6-31G(d,p).

In case that host E, sensitizer C, and the heterocyclic compound represented by Formula 1 satisfy Conditions E-1, E-2, and/or E-3, Dexter transfer and FRET from Sensitizer C to the heterocyclic compound represented by Formula 1 may be facilitated, and accordingly, the organic light-emitting device may have improved luminescence efficiency.

According to one or more embodiments, the amount of the sensitizer in the emission layer may be about 5 wt% to about 50 wt%, for example, about 10 wt% to about 30 wt% based on the total weight of the emission layer. When the amount is within these ranges, energy transfer in the emission layer may be effectively made. Thus, the organic light-emitting device may have high efficiency and long lifespan.

According to one or more embodiments, the amount of the heterocyclic compound represented by Formula 1 in

the emission layer may be about 0.01 wt% to about 15 wt%, for example, about 0.05 wt% to about 3 wt%, based on total weight of the emission layer, but embodiments are not limited thereto.

Host in emission layer

According to one or more embodiments, the host may not include metal atoms.

In one or more embodiments, the host may include at least one compound that is a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, or a sulfonyl-containing compound.

For example, the host may be a compound including at least one carbazole ring and at least one cyano group, or a phosphine oxide-containing compound.

According to one or more embodiments, the host may consist of one type of host. In case that the host includes one type of host, the one type of host may be a bipolar host, an electron-transporting host, or a hole-transporting host, which will be described later.

According to one or more embodiments, the host may be a mixture of two or more different types of hosts. For example, the host may be a mixture of an electron-transporting host and a hole-transporting host, a mixture of two types of electron-transporting hosts different from each other, or a mixture of two types of hole-transporting hosts different from each other. The electron-transporting host and the hole-transporting host may be understood by referring to the related description to be presented later.

According to one or more embodiments, the host may include an electron-transporting host including at least one electron-transporting moiety and a hole-transporting host not including an electron-transporting moiety.

The electron-transporting moiety used herein may be a cyano group, a π electron-deficient nitrogen-containing cyclic group, or a group represented by one of the following formulae:

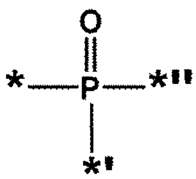
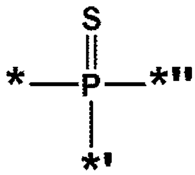
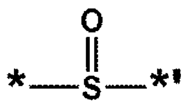
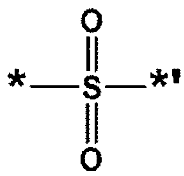

wherein, in these formulae, *, *', and *" each indicate a binding site to a neighboring atom.

In one or more embodiments, the electron-transporting host in the emission layer may include at least one of a cyano group or a π-electron deficient nitrogen-containing cyclic group.

According to one or more embodiments, the electron-transporting host in the emission layer may include at least one cyano group.

According to one or more embodiments, the electron-transporting host in the emission layer may include at least one cyano group and at least one π-electron deficient nitrogen-containing cyclic group.

According to one or more embodiments, the host may include an electron-transporting host and a hole-transporting host, the electron-transporting host may include at least one π electron-deficient nitrogen-free cyclic group and at least one electron-transporting moiety, and the hole-transporting host may include at least one π electron-deficient nitrogen-free cyclic group and may not include an electron-transporting moiety.

The term "π electron deficient nitrogen-containing cyclic group" as used herein refers to a cyclic group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group; or a condensed ring of two or more of the π electron deficient nitrogen-containing cyclic groups, but embodiments are not limited thereto.

Meanwhile, the π electron-deficient nitrogen-free cyclic group may be a benzene group, a heptalene group, an indene group, a naphthalene group, an azulene group, an indacene group, an acenaphthylene group, a fluorene group, a

spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, or a condensed cyclic group of two or more π electron-deficient nitrogen-free cyclic groups, but embodiments are not limited thereto.

According to one or more embodiments, in case that the host is a mixture of an electron-transporting host and a hole-transporting host, the weight ratio of the electron-transporting host to the hole-transporting host may be about 1:9 to about 9:1, for example, about 2:8 to about 8:2, for example, about 3:7 to about 7:3, for example, about 4:6 to about 6:4, or about 5:5. When the weight ratio of the electron transport host and the hole transport host satisfies the above-described ranges, the hole-and-electron transport balance in the emission layer may be made.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphth-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl) benzene (TCP), 1,3-bis(N-carbazolyl)benzene (mCP), Compound H50, or Compound H51, but embodiments are not limited thereto:

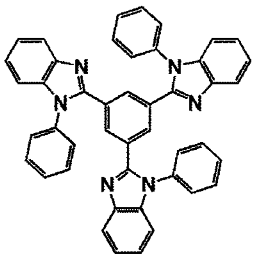
TPBi

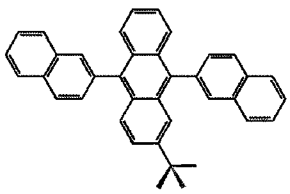
TBADN

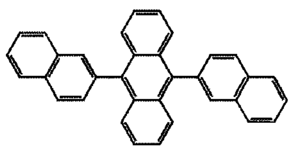
ADN

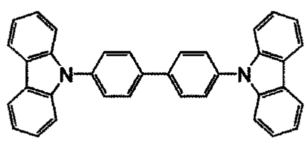
CBP

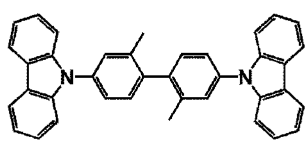
CDBP

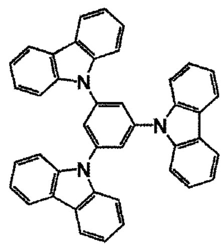
TCP

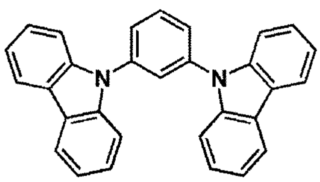
mCP

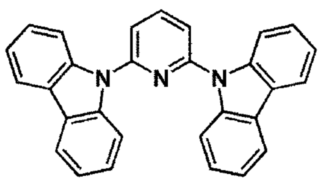
H50

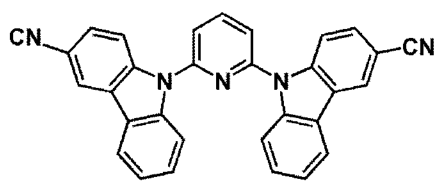
H51

.

In one or more embodiments, the host may further include a compound represented by Formula 301:

Formula 301

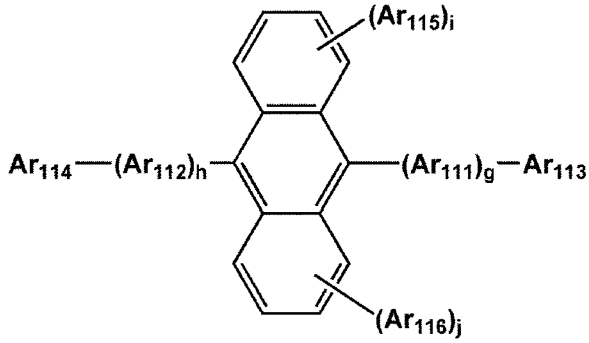

wherein $Ar_{111}$ and $Ar_{112}$ in Formula 301 may each independently be:

a phenylene group, a naphthylene group, a phenanthrenylene group, or a pyrenylene group; and
a phenylene group, a naphthylene group, a phenanthrenylene group, or a pyrenylene group, each substituted with at least one of a phenyl group, a naphthyl group, or an anthracenyl group.

$Ar_{113}$ to $Ar_{116}$ in Formula 301 may each independently be:

a $C_1$-$C_{10}$ alkyl group, a phenyl group, a naphthyl group, a phenanthrenyl group, or a pyrenyl group; and
a phenyl group, a naphthyl group, a phenanthrenyl group, or a pyrenyl group, each substituted with at least one of a phenyl group, a naphthyl group, or an anthracenyl group.

g, h, i, and j in Formula 301 may each independently be an integer from 0 to 4, and may be, for example, 0, 1, or 2.
$Ar_{113}$ to $Ar_{116}$ in Formula 301 may each independently be:

a $C_1$-$C_{10}$ alkyl group, substituted with at least one of a phenyl group, a naphthyl group, or an anthracenyl group;
a phenyl group, a naphthyl group, an anthracenyl group, a pyrenyl, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a phenyl group, a naphthyl group, an anthracenyl group, a pyrenyl group, a phenanthrenyl group, or a fluorenyl group; or

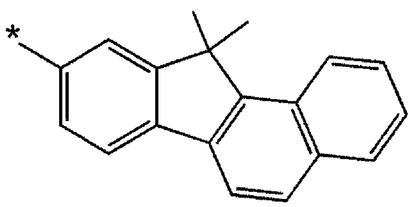
,

but embodiments are not limited thereto.

In one or more embodiments, the host may include a compound represented by Formula 302:

Formula 302

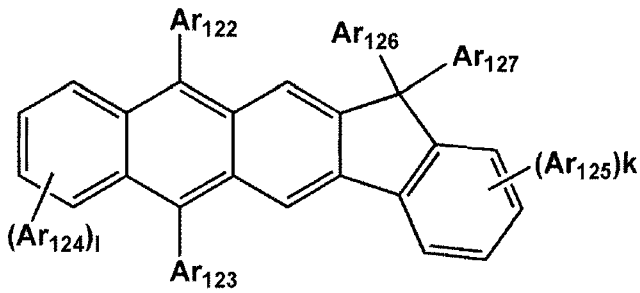

wherein $Ar_{122}$ to $Ar_{125}$ in Formula 302 are defined the same as $Ar_{113}$ in Formula 301.

$Ar_{126}$ and $Ar_{127}$ in Formula 302 may each independently be a $C_1$-$C_{10}$ alkyl group (for example, a methyl group, an ethyl group, a propyl group, or the like).

k and l in Formula 302 may each independently be an integer from 0 to 4. For example, k and l may each independently be 0, 1, or 2.

According to one or more embodiments, the host may include at least one of compounds H1 to H26, but embodiments are not limited thereto:

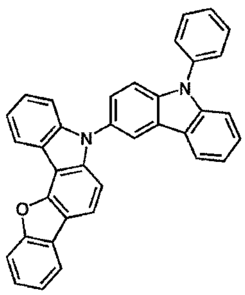

H1

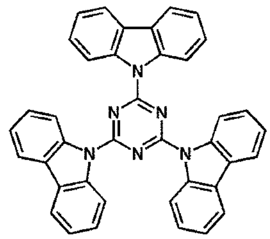

H2

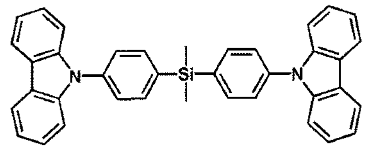

H3

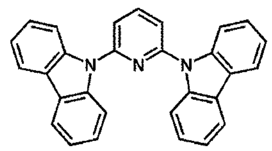

H4

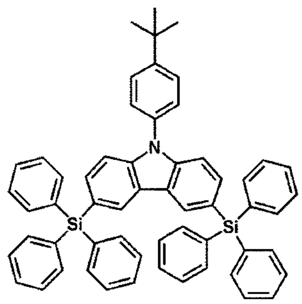

H5

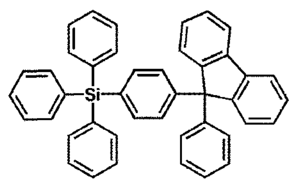

H6

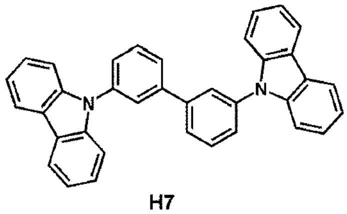

H7

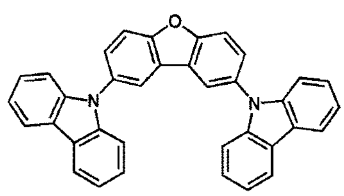

H8

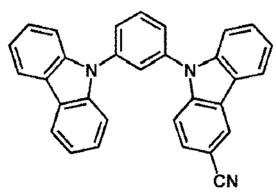

H9

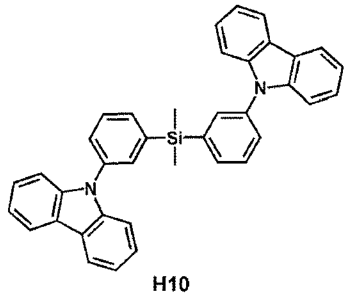

H10

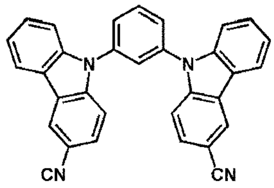

H11

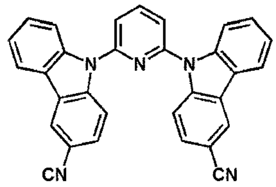

H12

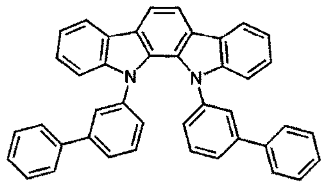

H13

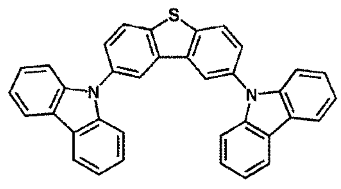

H14

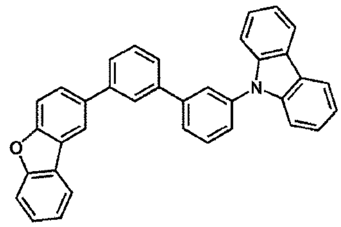

H15

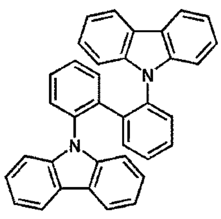

H16

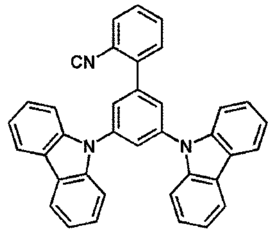

H17

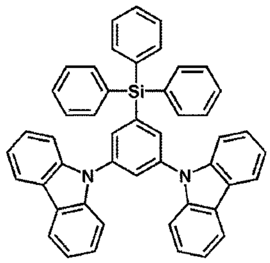

H18

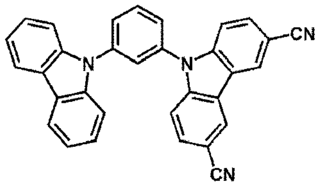

H19

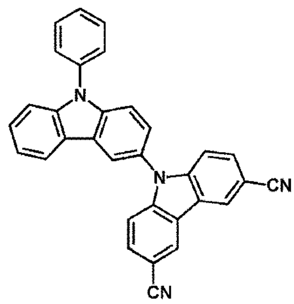

H20

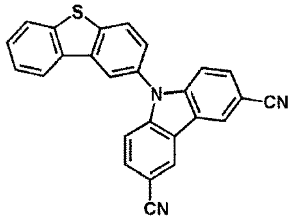

H21

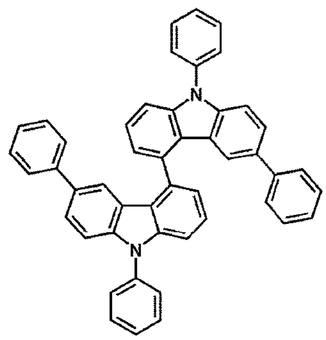

H22

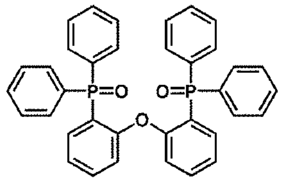

H23

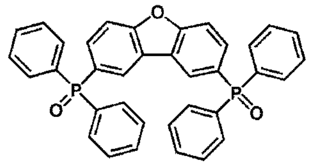

H24

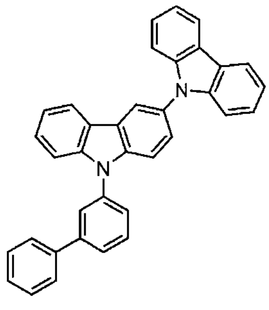

H25

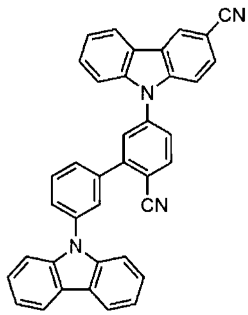

H26

.

According to one or more embodiments, the host may consist of one type of compound. For example, the one type of compound may be arbitrarily selected from a first material (a hole-transporting host) or a second material (electron-transporting host) described above.

According to one or more embodiments, the host may include two or more types of compounds. For example, the host may include two or more different types of hole-transporting hosts, two or more different types of electron-transporting hosts, or a combination of one or more types of hole-transporting hosts and one or more types of electron-transporting hosts.

Emitter in the emission layer

The emitter may include at least one of the heterocyclic compounds represented by Formula 1.

Sensitizer in emission layer

According to one or more embodiments, the sensitizer may include a phosphorescent compound.

According to one or more embodiments, the phosphorescent compound may include an organometallic compound comprising one or more types of metals.

According to one or more embodiments, the organometallic compound may include one or more types of metal ($M_{11}$) and an organic ligand ($L_{11}$), and $L_{11}$ and $M_{11}$ may form one, two, three, or four cyclometallated rings.

According to one or more embodiments, the organometallic compound may be represented by Formula 101.

Formula 101 M11(L11)n11(L12)n12

wherein, in Formula 101,

$M_{11}$ may be a transition metal,
$L_{11}$ may be a ligand represented by any one of Formulae 1-1 to 1-4,
$L_{12}$ may be a monodentate ligand or a bidentate ligand,
n11 may be 1, and
n12 may be 0, 1, or 2,

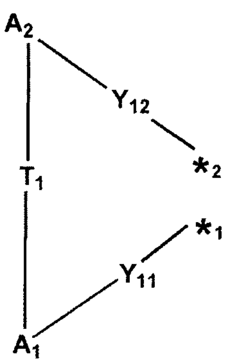

1-1

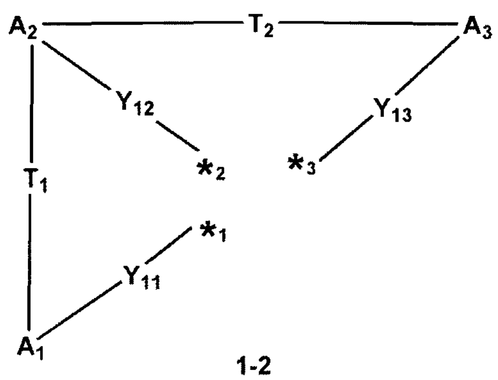

1-2

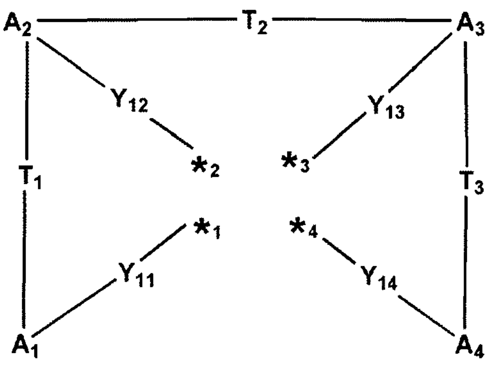

1-3

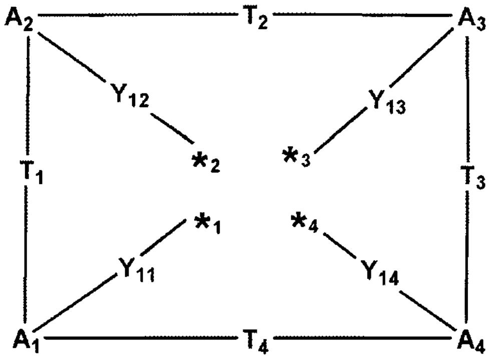

1-4

wherein, in Formulae 1-1 to 1-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a non-cyclic group,

$Y_{11}$ to $Y_{14}$ may each independently be a chemical bond, O, S, $N(R_{91})$, $B(R_{91})$, $P(R_{91})$, or $C(R_{91})(R_{92})$,

$T_1$ to $T_4$ may each independently be a single bond, a double bond, *-$N(R_{93})$-*', *-$B(R_{93})$-*', *-$P(R_{93})$-*', *-$C(R_{93})(R_{94})$-*', *-$Si(R_{93})(R_{94})$-*', *-$Ge(R_{93})(R_{94})$-*', *-S-*', *-Se-*', *-O-*', *-C(=O)-*', *-S(=O)-*', *-$S(=O)_2$-*', *-$C(R_{93})$=*', *=$C(R_{93})$-*', *-$C(R_{93})=C(R_{94})$-*', *-C(=S)-*', or *-C≡C-*',

a substituent of the substituted $C_5$-$C_{30}$ carbocyclic group, a substituent of the substituted $C_1$-$C_{30}$ heterocyclic group, and $R_{91}$ to $R_{94}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_2$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -$Si(Q_1)(Q_2)(Q_3)$, -$Ge(Q_1)(Q_2)(Q_3)$, -$C(Q_1)(Q_2)(Q_3)$, -$B(Q_1)(Q_2)$, -$N(Q_1)(Q_2)$, -$P(Q_1)(Q_2)$, - $C(=O)(Q_1)$, -$S(=O)(Q_1)$, -$S(=O)_2(Q_1)$, -$P(=O)(Q_1)(Q_2)$, or -$P(=S)(Q_1)(Q_2)$, wherein each of the substituents of the substituted $C_5$-$C_{30}$ carbocyclic group and the substituent of the substituted $C_1$-$C_{30}$ heterocyclic group are not hydrogen,

$*_1$, $*_2$, $*_3$, and $*_4$ each indicate a binding site to $M_{11}$, and

$Q_1$ to $Q_3$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a

monovalent non-aromatic condensed heteropolycyclic group, each substituted with deuterium, -F, -Cl, -Br, -I, $-SF_5$, a hydroxyl group, a cyano group, a $C_1$-$C_{60}$ alkyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, or a combination thereof.

According to one or more embodiments, the transition metal may be platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

According to one or more embodiments, the sensitizer may include a delayed fluorescence compound.

According to one or more embodiments, the delayed fluorescence compound may be represented by Formula 101 or 102.

Formula 101

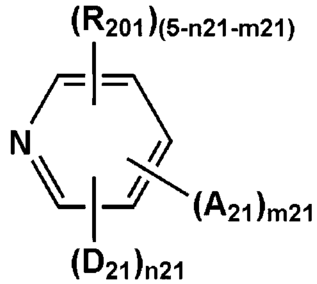

Formula 102

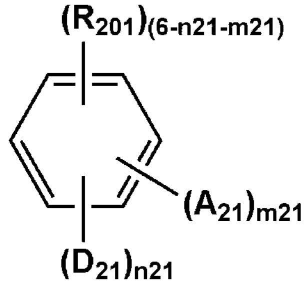

wherein, in Formulae 101 and 102,

$A_{21}$ is an acceptor group,
$D_{21}$ is a donor group,
m21 may be 1, 2, or 3, and n21 may be 1, 2, or 3,
a sum of n21 and m21 in Formula 101 may be 5 or less, and a sum of n21 and m21 in Formula 102 may be 6 or less,

$R_{201}$ may be hydrogen, deuterium, -F, -Cl, -Br, -I, $-SF_5$, a hydroxyl group, a cyano group, a nitro group, an amino group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$, and a plurality of $R_{201}$ may optionally be bonded with each other to form a substituted or unsubstituted $C_5$-$C_{30}$ carbocyclic group or a substituted or unsubstituted $C_1$-$C_{30}$ heterocyclic group, and

$Q_1$ to $Q_3$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group that is substituted with at least one of deuterium, -F, a cyano group, a $C_1$-$C_{60}$ alkyl group, or a $C_6$-$C_{60}$ aryl group, or a $C_6$-$C_{60}$ aryl group that is substituted with at least one of deuterium, -F, a cyano group, a $C_1$-$C_{60}$ alkyl group, or a $C_6$-$C_{60}$ aryl group.

According to one or more embodiments, $D_{21}$ in Formulae 101 and 102 may be a substituted or unsubstituted $\pi$ electron deficient nitrogen-free cyclic group.

In some embodiments, the π electron-deficient nitrogen-free cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a triindolobenzene group, or a condensed cyclic group of two or more π electron-deficient nitrogen-free cyclic groups, but embodiments are not limited thereto.

For example, $A_{21}$ in in Formulae 101 and 102 may be -F, a cyano group, or a π electron deficient nitrogen-containing cyclic group;

a $C_1$-$C_{60}$ alkyl group, an π-electron deficient nitrogen-containing cyclic group, or an π electron-deficient nitrogen-free cyclic group, each substituted with at least one of -F or a cyano group; or

an π-electron deficient nitrogen-containing cyclic group, substituted with at least one of deuterium, a $C_1$-$C_{60}$ alkyl group, an π -electron deficient nitrogen-containing cyclic group, or an π electron-deficient nitrogen-free cyclic group.

In one or more embodiments, the π electron-deficient nitrogen-free cyclic group is as described above.

The term "π electron deficient nitrogen-containing cyclic group" as used herein refers to a cyclic group having at least one *-N=*' moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, a benzimidazolobenzimidazole group; or a condensed cyclic group of two or more of these π electron-deficient nitrogen-containing cyclic groups.

According to one or more embodiments, the amount of the sensitizer in the organic layer (e.g. the emission layer) may be greater than the amount of the emitter, based on volume and/or weight. For example, the volume ratio of the sensitizer to the emitter in the organic layer (e.g. the emission layer) may be about 30:0.1 to about 10:3, or about 10:0.1 to about 20:5. In another example, the weight ratio of the sensitizer to the emitter may be about 10:0.1 to about 20:5. Meanwhile, the volume ratio of the host to the sensitizer in the organic layer (e.g. the emission layer) may be about 60:40 to about 95:5 or about 70:30 to about 90:10. Alternatively, the weight ratio of the host to the sensitizer may be about 60:40 to about 95:5. Within the ranges as described above, the organic light-emitting device may have improved luminescence efficiency and/or lifespan characteristics.

FIG. 1 is a schematic cross-sectional view of an organic light-emitting device 10 according to one or more embodiments. Hereinafter, the structure and manufacturing method of the organic light-emitting device 10 according to one or more embodiments will be described in further detail with reference to FIG. 1. The organic light-emitting device 10 may have a structure in which a first electrode 11, an organic layer 15, and a second electrode 19 are sequentially stacked in the stated order.

A substrate may be further disposed under the first electrode 11 or on the second electrode 19. The substrate may be a substrate commonly used in organic light-emitting devices, e.g., a glass substrate or a transparent plastic substrate, which have excellent mechanical strength, thermal stability, transparency, surface smoothness, ease of handling, and/or water repellency.

The first electrode 11 may be formed by, for example, depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a transflective electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The organic layer 15 may be arranged on the first electrode 11.

The organic layer 15 may include an emission layer, and may further include a hole transport region and an

electron transport region.

The hole transport region may be arranged between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure, a hole injection layer/hole transport layer/electron-blocking layer structure, or a hole injection layer/a first hole transport layer/a second hole transport layer/electron-blocking layer structure, in which respective layers of each structure are sequentially stacked in the stated order from the first electrode 11.

In case that the hole transport region includes a hole injection layer, the hole injection layer may be formed on the first electrode 11 by using various methods, for example, vacuum deposition, spin coating, casting, and/or Langmuir-Blodgett (LB) deposition, but embodiments are not limited thereto.

In case that the hole injection layer is formed by vacuum deposition, the deposition conditions may vary depending on a compound that is used as a material for forming the hole injection layer, and the structure and thermal characteristics of an hole injection layer to be formed, and may include a deposition temperature of about 100 °C to about 500 °C, a vacuum degree of about $10^{-8}$ torr to about $10^{-3}$ torr, and a deposition rate of about 0.01 angstroms per second (Å/sec) to about 100 Å/sec. However, the deposition conditions are not limited thereto.

In case that the hole injection layer is formed by spin coating, the coating conditions may vary according to a compound that is used as a material for forming the hole injection layer, and the structure and thermal characteristics of the hole injection layer, and may include a coating speed of about 2,000 revolutions per minute (rpm) to about 5,000 rpm and a heat treatment temperature for removing a solvent after coating of about 80 °C to about 200 °C. However, the coating conditions are not limited thereto.

The conditions for forming the hole transport layer and the electron-blocking layer may be referred to the description provided for the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, or a compound represented by Formula 202, but embodiments are not limited thereto:

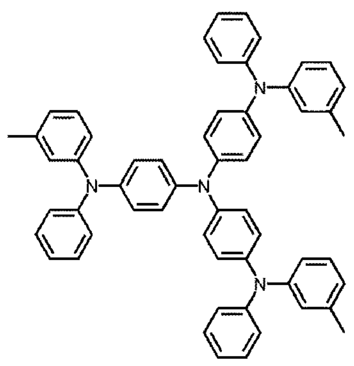

m-MTDATA

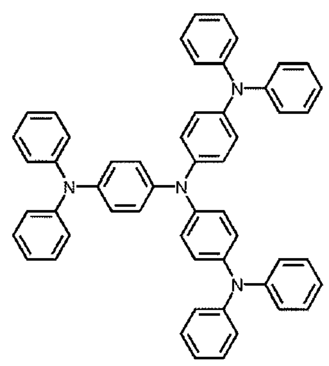

TDATA

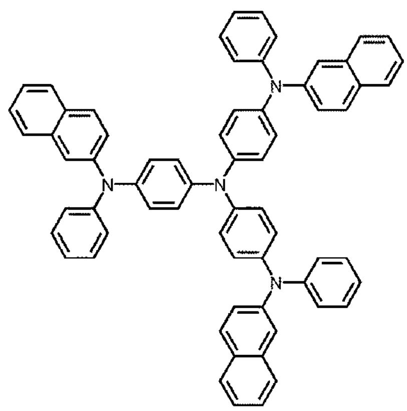

2-TNATA

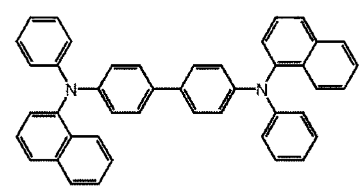

NPB

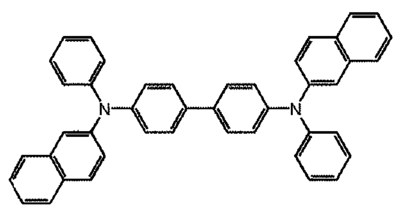

β-NPB

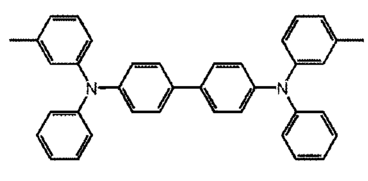

TPD

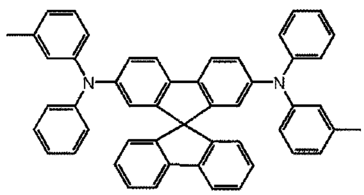

Spiro-TPD

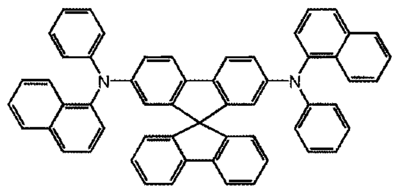

Spiro-NPB

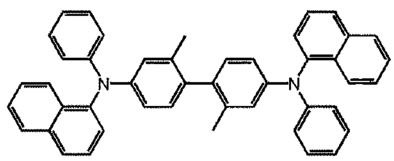

methylated NPB

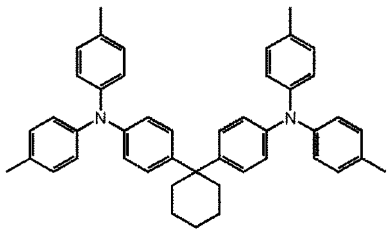

TAPC

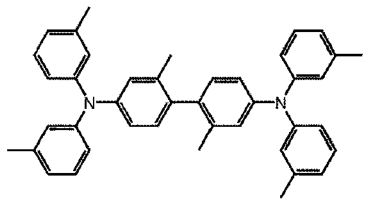

HMTPD

Formula 201

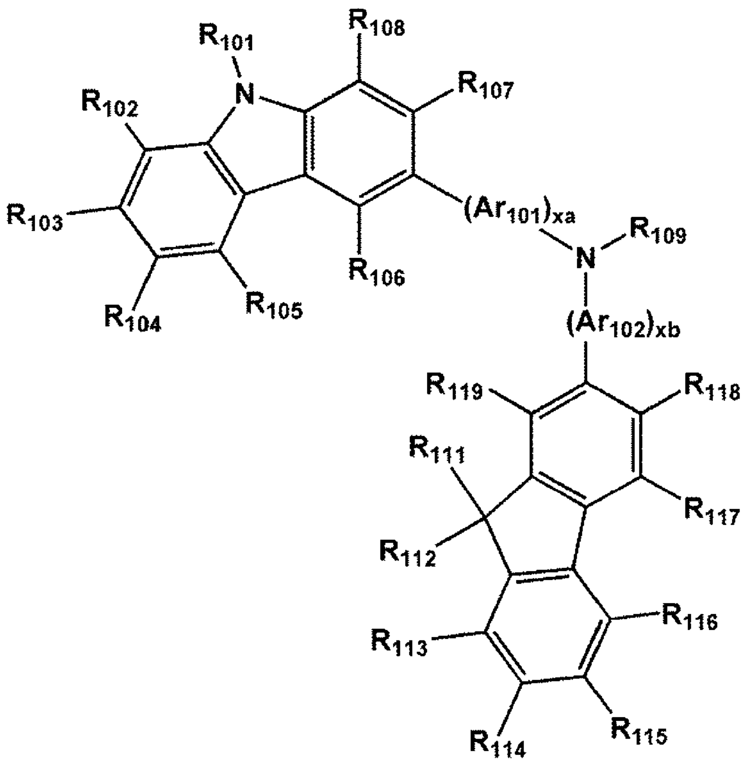

Formula 202

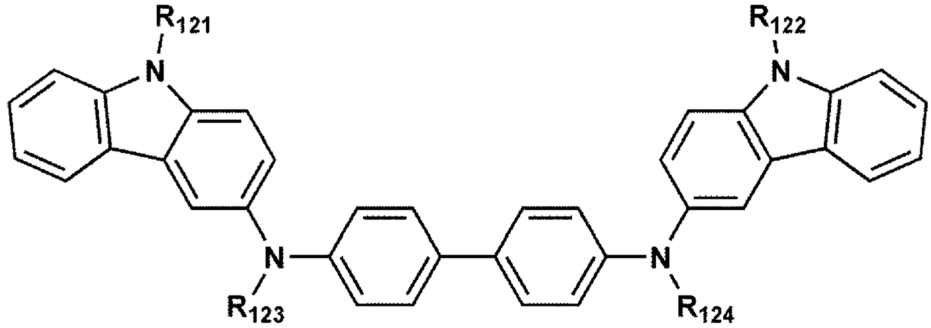

.

$Ar_{101}$ and $Ar_{102}$ in Formula 201 may each independently be:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1, and xb may be 0, but xa and xb are not limited thereto.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, a hexyl group, or the like), a $C_1$-$C_{10}$ alkylthio group, or a $C_1$-$C_{10}$ alkoxy group (e.g., a methoxy group, an ethoxy group, a propoxy group, a butoxy group, a pentoxy group, or the like);

a $C_1$-$C_{10}$ alkyl group, a $C_1$-$C_{10}$ alkylthio group, or a $C_1$-$C_{10}$ alkoxy group, each substituted with deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;

a phenyl group, a naphthyl group, an anthracenyl group, a fluorenyl group, or a pyrenyl group; or

a phenyl group, a naphthyl group, an anthracenyl group, a fluorenyl group, or a pyrenyl group, each substituted with deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkylthio group, a $C_1$-$C_{10}$ alkoxy group, or a combination thereof, but embodiments are not limited thereto. $R_{109}$ in Formula 201 may be:

a phenyl group, a naphthyl group, an anthracenyl group, or a pyridinyl group; or

a phenyl group, a naphthyl group, an anthracenyl group, or a pyridinyl group, each substituted with deuterium, -F, -Cl, -Br, -I, $-SF_5$, a hydroxyl group, a cyano group, a nitro group, an amino group, an amidino group, a hydrazine group

group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one or more embodiments, the compound represented by Formula 201 may be represented by Formula 201A, but embodiments are not limited thereto:

Formula 201A

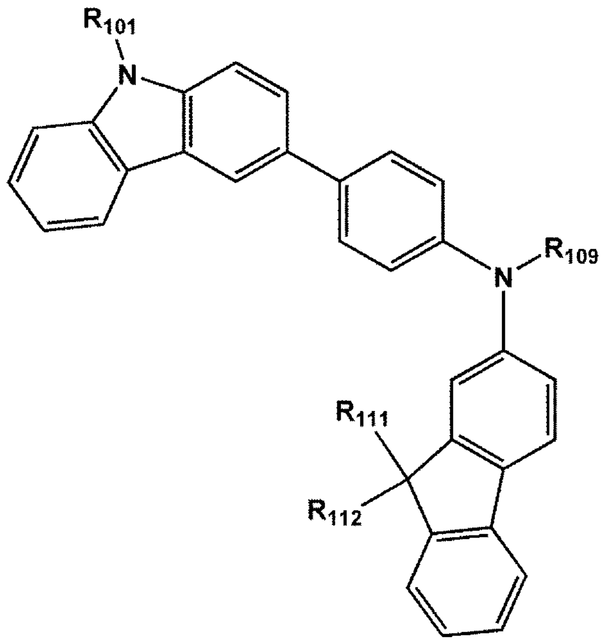

$R_{101}$, $R_{111}$, $R_{112}$, and $R_{109}$ in Formula 201A may each be as described herein.

For example, the compound represented by Formula 201 and the compound represented by Formula 202 may include, but are not limited to, compounds HT1 to HT20:

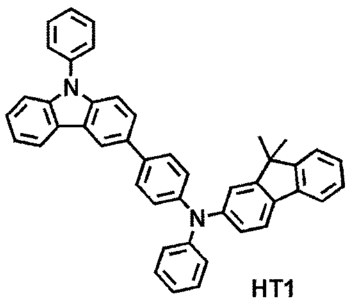

HT1

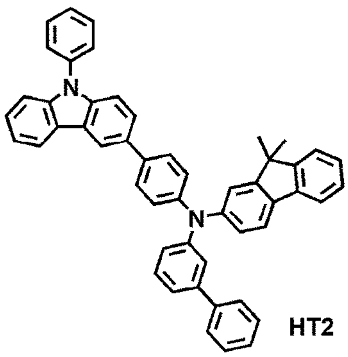

HT2

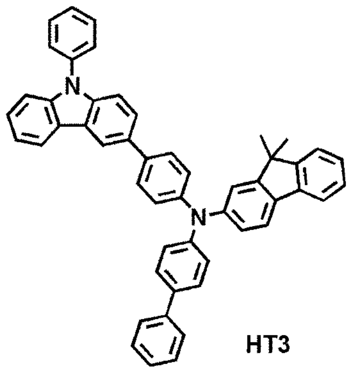

HT3

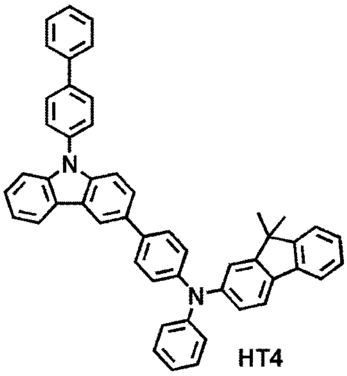

HT4

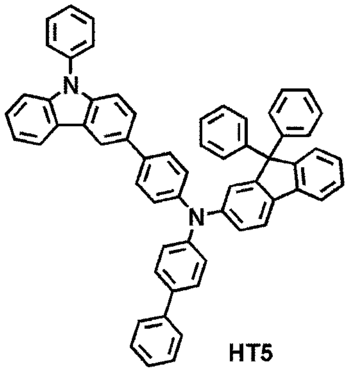

HT5

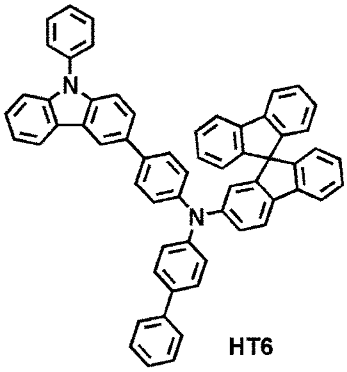

HT6

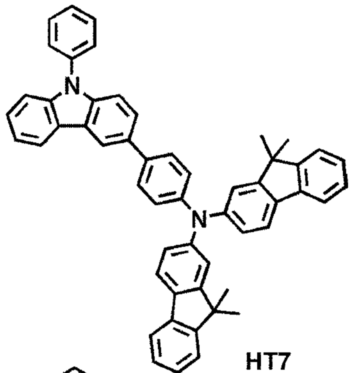

HT7

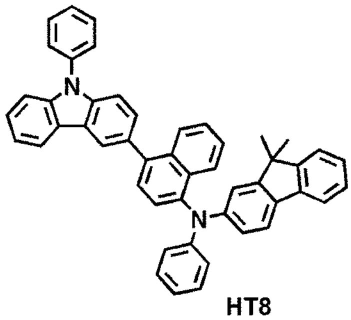

HT8

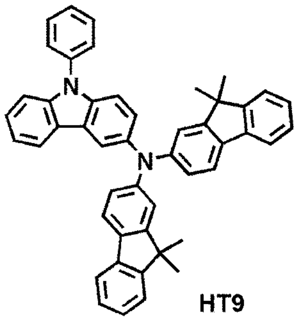

HT9

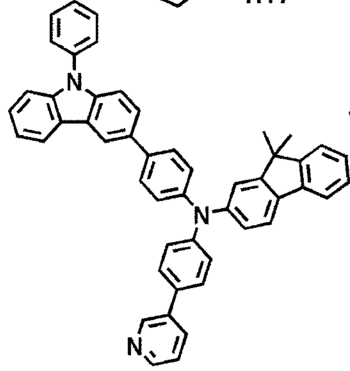

HT10

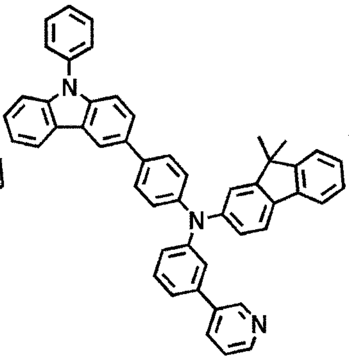

HT11

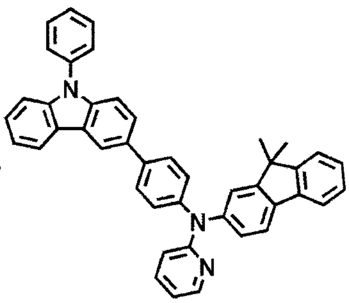

HT12

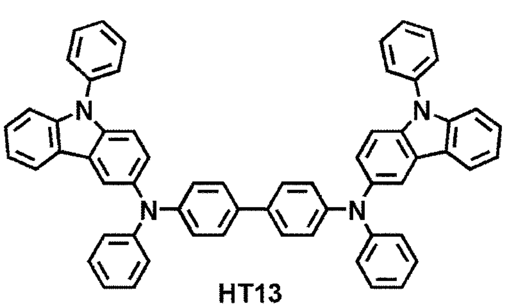

HT13

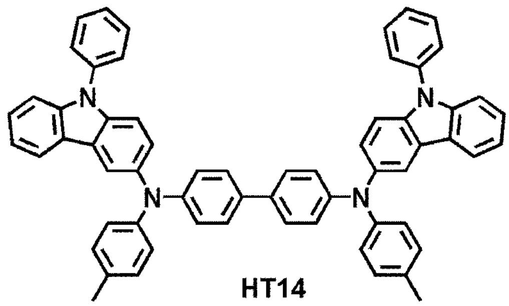

HT14

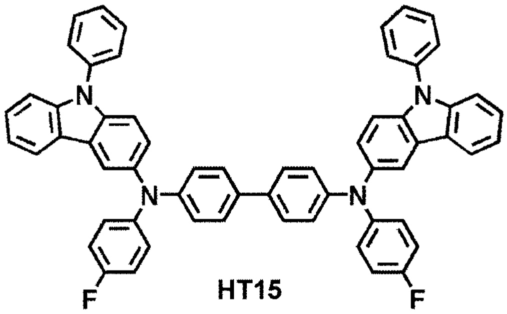

HT15

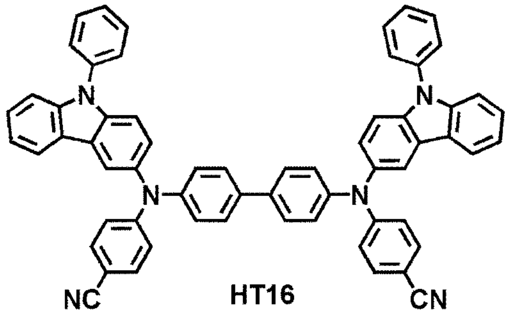

HT16

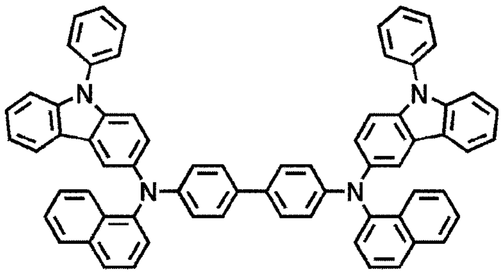

HT17

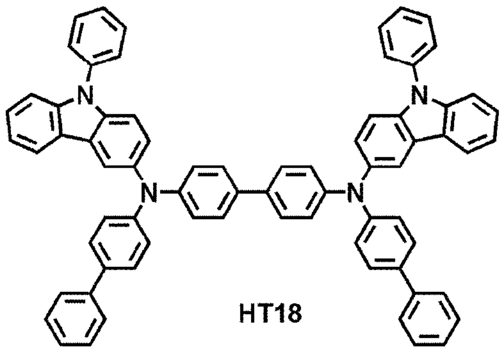

HT18

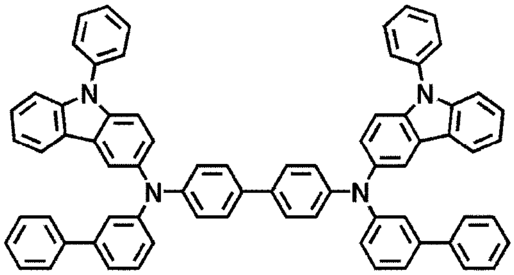

HT19

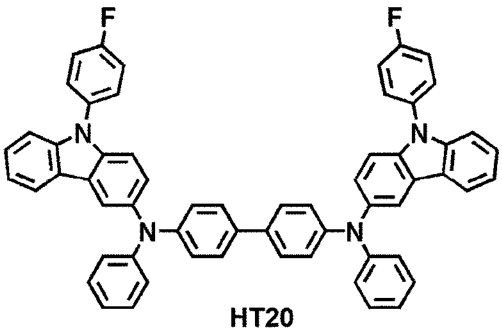

HT20

.

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 50 Å to about 10,000 Å, for example, about 100 Å to about 1,000 Å, and a thickness of the hole transport layer may be about 50 Å to about 2,000 Å, for example, about 100 Å to about 1,500 Å. In case that the thicknesses of the hole transport region, the hole injection layer, and the hole transport layer are within these ranges, satisfactory hole transporting characteristics may be obtained without a substantial increase in driving voltage.

The hole transport region may further include, in addition to the above-described materials, a charge-generation material for improving conductivity. The charge-generation material may be homogeneously or non-homogeneously dispersed in the hole transport region.

The charge-generation material may be, for example, a p-dopant. The p-dopant may be, but is not limited to, one of a quinone derivative, a metal oxide, or a cyano group-containing compound. Non-limiting examples of the p-dopant include a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; or a cyano group-containing compound, such as Compound HT-D1 or F12, but embodiments are not limited thereto:

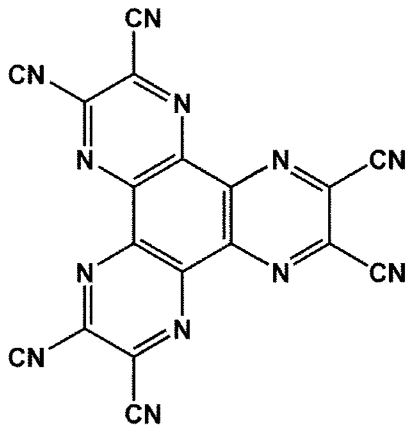

HT-D1

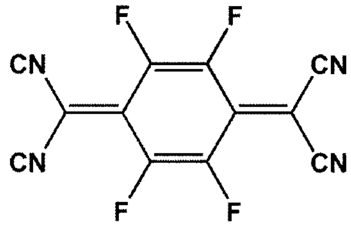

F4-TCNQ

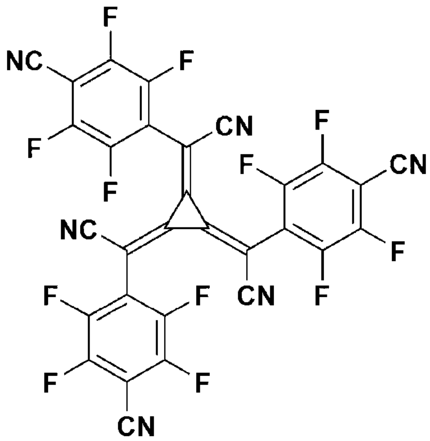

F12

.

The hole transport region may include a buffer layer.

The buffer layer may compensate for an optical resonance distance according to a wavelength of light emitted from the emission layer, and thus, efficiency of a formed organic light-emitting device may be improved.

The emission layer (EML) may be formed on the hole transport region by vacuum deposition, spin coating, casting, LB deposition, or the like. In case that the emission layer is formed by vacuum deposition or spin coating, the deposition or coating conditions may generally be similar to those applied in forming the hole injection layer although the deposition or coating conditions may vary according to a material that is used to form the emission layer.

In some embodiments, when the hole transport region includes an electron-blocking layer, a material for forming the electron-blocking layer may be selected from, but is not limited to, the above-described materials that may be used in the hole transport region and a host material described below. For example, when the hole transport region includes an electron-blocking layer, a material for forming the electron-blocking layer may be mCP, which will be described below.

When the organic light-emitting device is a full-color organic light-emitting device, the emission layer may be patterned into a red emission layer, a green emission layer, and/or a blue emission layer. In one or more embodiments, the emission layer may have a structure in which a red emission layer, a green emission layer, and/or a blue emission layer are stacked, and thus, various modifications such as emission of white light are possible.

When the emission layer includes a host and a dopant, the amount of the dopant in the emission layer may generally be about 0.01 parts by weight to about 15 parts by weight, for example, about 0.5 parts by weight to about 5 parts by weight, or about 1 part by weight to about 3 parts by weight, with respect to 100 parts by weight of the host, but embodiments are not limited thereto.

A thickness of the emission layer may be about 100 Å to about 1,000 Å, for example, about 200 Å to about 600 Å. When the thickness of the emission layer is within the range described above, excellent luminescence characteristics may be obtained without a substantial increase in driving voltage.

Next, an electron transport region may be located on the emission layer.

The electron transport region may include a hole-blocking layer, an electron transport layer, an electron injection

layer (EIL), or a combination thereof.

For example, the electron transport region may have a hole-blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole-blocking layer, the electron transport layer, and the electron injection layer which constitute the electron transport region may be referred to the description provided for the conditions for forming the hole injection layer.

When the electron transport region includes a hole-blocking layer, the hole-blocking layer may include, for example, at least one of 2,9-dimethyl-4,7-diphenyl-1,10-phenanthroline (BCP), 4,7-diphenyl-1,10-phenanthroline (Bphen), DBFPO, or bis(2-methyl-8-quinolinolato-N1,O8)-(1,1'-biphenyl-4-olato)aluminum (BAlq), but embodiments are not limited thereto:

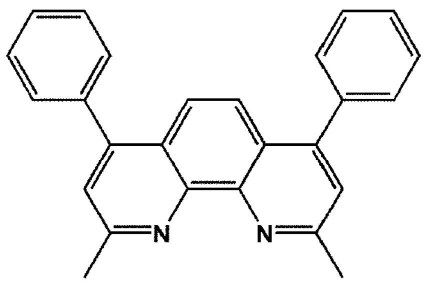

BCP

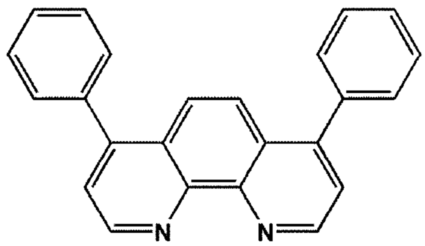

Bphen .

A thickness of the hole-blocking layer may be about 20 Å to about 1,000 Å, for example, about 30 Å to about 300 Å. When the thickness of the hole-blocking layer is within these ranges, excellent hole-blocking characteristics may be obtained without a substantial increase in driving voltage.

The electron transporting layer may further include at least one of DBFPO, BCP, Bphen, tris(8-hydroxyquinolinato)aluminum ($Alq_3$), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

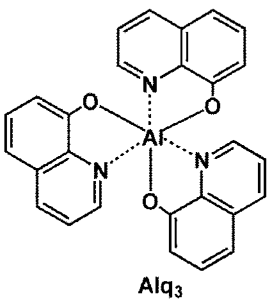

$Alq_3$

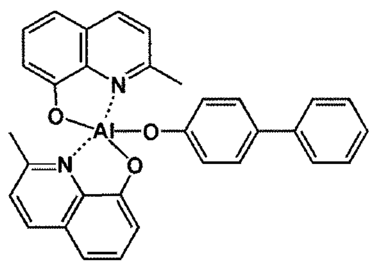

BAlq

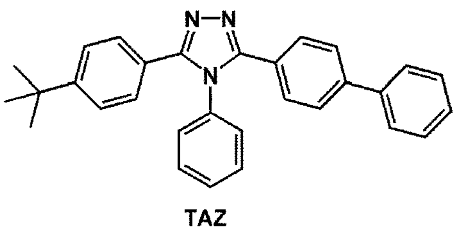

TAZ

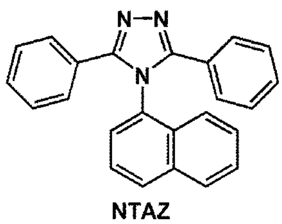

NTAZ .

In one or more embodiments, the electron transport layer may include at least one of compounds ET1 to ET25, but embodiments are not limited thereto:

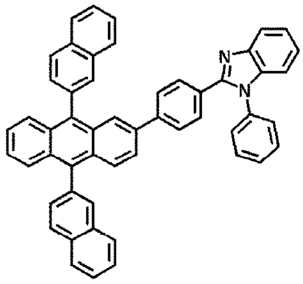

ET1

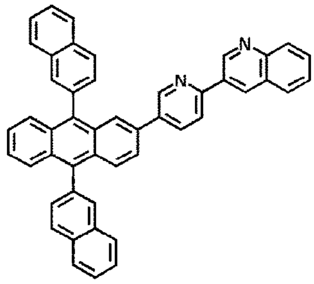

ET2

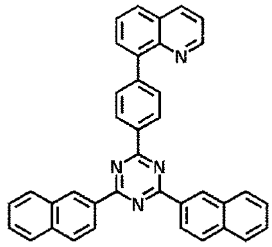

ET3

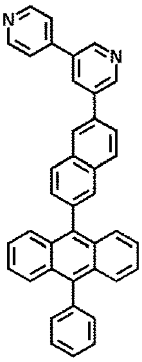

ET4

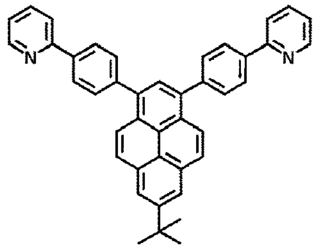

ET5

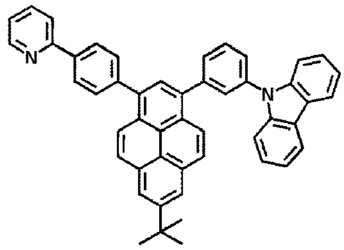

ET6

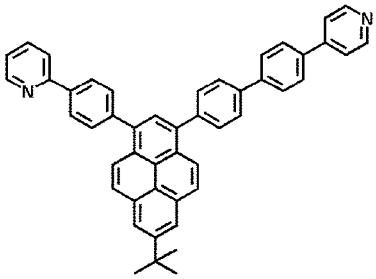

ET7

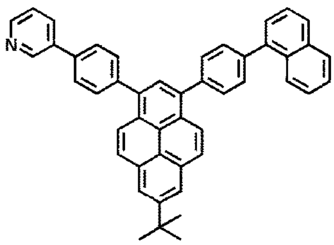

ET8

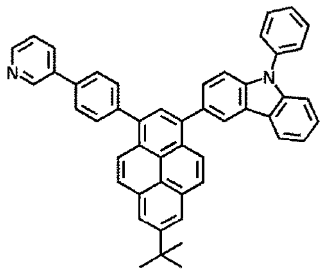

ET9

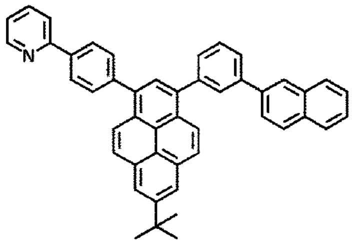

ET10

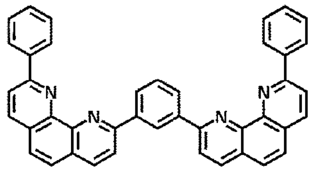

ET11

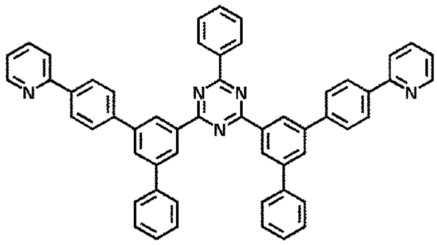

ET12

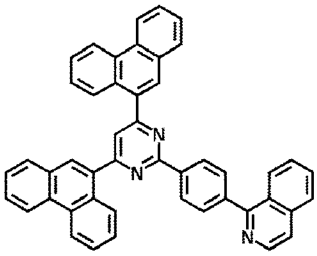
ET13

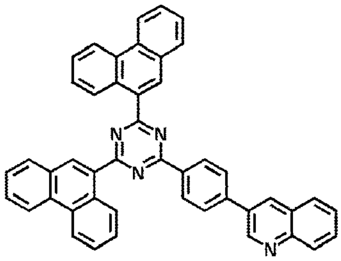
ET14

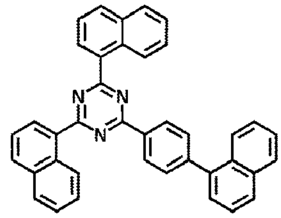
ET15

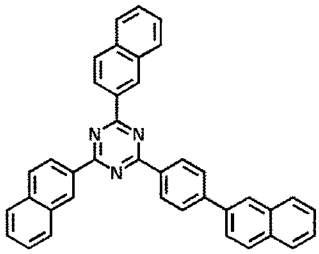
ET16

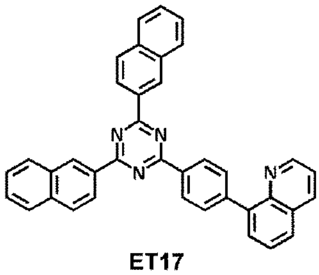
ET17

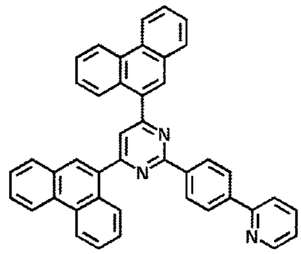
ET18

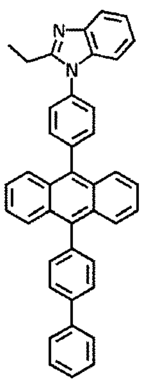
ET19

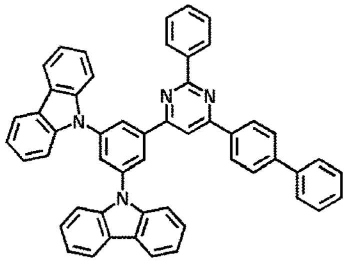
ET20

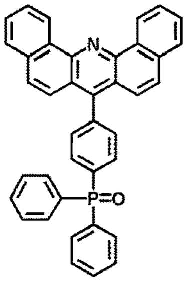
ET21

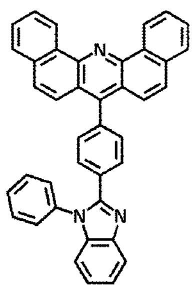
ET22

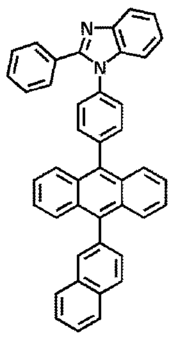
ET23

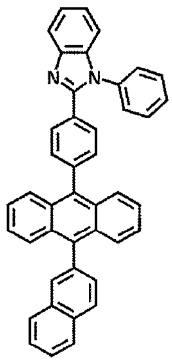
ET24

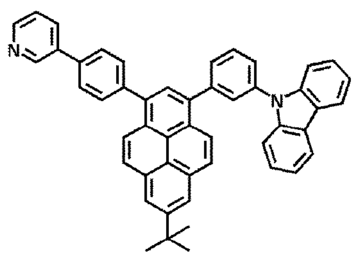
ET25

.

The thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described above.

The metal-containing material may include a Li complex. The Li complex may include, for example, Compound

ET-D1 (lithium quinolate, LiQ) or ET-D2, but embodiments are not limited thereto:

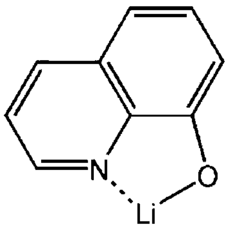

ET-D1

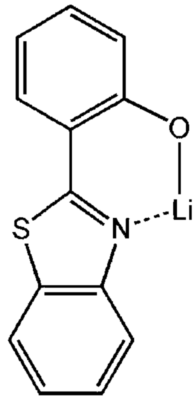

ET-D2 .

The electron transport region may include an electron injection layer that facilitates the injection of electrons from the second electrode 19.

The electron injection layer may include LiQ, LiF, NaCl, CsF, $Li_2O$, BaO, or a combination thereof.

The thickness of the electron injection layer may be about 1 Å to about 100 Å, for example, about 3 Å to about 90 Å. When the thickness of the electron injection layer is within the range as described above, satisfactory electron injection characteristics may be obtained without a substantial increase in driving voltage.

The second electrode 19 may be disposed on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, various modifications, such as formation of a transmissive second electrode using ITO or IZO, is possible.

The organic light-emitting device has been described with reference to FIG. 1, but embodiments are not limited thereto.

According to another aspect, an electronic apparatus includes the organic light-emitting device.

The electronic apparatus may further include a thin-film transistor in addition to the organic light-emitting device as described above. The thin-film transistor may include a source electrode, a drain electrode, and an active layer, wherein any one of the source electrode and the drain electrode may be electrically connected to any one of the first electrode and the second electrode of the organic light-emitting device.

According to another aspect, a diagnostic composition is provided, including at least one of the heterocyclic compounds represented by Formula 1.

The diagnostic composition may include one or more heterocyclic compounds represented by Formula 1.

Since the heterocyclic compound represented by Formula 1 can provide high luminescence efficiency, a diagnostic composition including at least one of the heterocyclic compounds represented by Formula 1 may have high diagnostic efficiency.

The diagnostic composition may be used in various applications including a diagnosis kit, a diagnosis reagent, a biosensor, or a biomarker, but embodiments are not limited thereto. The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, a hexyl group, or the like. The term "$C_1$-$C_{60}$ alkylene group" as used herein refers to a divalent group having the same structure as the $C_1$-$C_{60}$ alkyl group.

Non-limiting examples of the $C_1$-$C_{60}$ alkyl group, the $C_1$-$C_{20}$ alkyl group, and/or the $C_1$-$C_{10}$ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, an n-propoxy group, an isopropyloxy group, a butoxy group, a pentoxy group, or the like.

The term "$C_1$-$C_{60}$ alkylthio group" as used herein refers to a monovalent group represented by -$SA_{101'}$ (wherein $A_{101'}$ is the $C_1$-$C_{60}$ alkyl group).

Non-limiting examples of the $C_1$-$C_{60}$ alkylthio group, a $C_1$-$C_{20}$ alkylthio group or $C_1$-$C_{10}$ alkylthio group include a methylthio group, an ethylthio group, or the like.

The term "$C_2$-$C_{60}$ alkenyl group" as used herein refers to a structure containing at least one carbon-carbon double bond in the middle or at the end of the $C_2$-$C_{60}$ alkyl group, and non-limiting examples thereof include an ethenyl group, a propenyl group, a butenyl group, or the like. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and non-limiting examples thereof include an ethynyl group, a propynyl group, or the like. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon ring group having 3 to 10 carbon atoms, and non-limiting examples thereof include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like. The term "$C_3$-$C_{10}$ cycloalkylene group" as used herein refers to a divalent group having the same structure as the $C_3$-$C_{10}$ cycloalkyl group.

The term "$C_3$-$C_{10}$ cycloalkyl group" as used herein may include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1]hexyl group, a bicyclo[2.2.1]heptyl(norbornanyl) group, a bicyclo[2.2.2]octyl group, or the like.

The term "$C_1$-$C_{10}$ heterocycloalkyl group" as used herein refers to a monovalent saturated heterocyclic group having at least one heteroatom selected from B, N, O, P, Si, S, Se, and Ge as a ring-forming atom and 1 to 10 carbon atoms as ring-forming atom(s), and non-limiting examples thereof include a tetrahydrofuranyl group, a tetrahydrothiophenyl group, a silolanyl group, a silinanyl group, a tetrahydro-2H-pyranyl group, or the like. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent ring group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent heterocyclic group that has at least one heteroatom selected from B, N, O, P, Si, S, Se, and Ge as a ring-forming atom, 1 to 10 carbon atoms as ring-forming atom(s), and at least one double bond in its ring. Non-limiting examples of the $C_1$-$C_{10}$ heterocycloalkenyl group include a 2,3-dihydrofuranyl group, a 2,3-dihydrothiophenyl group, or the like. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic ring system having 6 to 60 carbon atoms, and the term "$C_6$-$C_{60}$ arylene group" as used herein refers to a divalent group having a carbocyclic aromatic ring system having 6 to 60 carbon atoms. Non-limiting examples of the $C_6$-$C_{60}$ aryl group include a phenyl group, a naphthyl group, an anthracenyl group, a phenanthrenyl group, a pyrenyl group, a chrysenyl group, or the like. When the $C_6$-$C_{60}$ aryl group and the $C_6$-$C_{60}$ arylene group each include two or more rings, the rings may be fused with each other.

The term "$C_7$-$C_{60}$ alkyl aryl group" as used herein refers to a $C_6$-$C_{60}$ aryl group substituted with at least one $C_1$-$C_{60}$ alkyl group. The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group having a heterocyclic aromatic system that has at least one heteroatom selected from B, N, O, P, Si, S, Se, and Ge as a ring-forming atom, and 1 to 60 carbon atoms as ring-forming atom(s). The term "$C_1$-$C_{60}$ heteroarylene group" as used herein refers to a divalent group having a heterocyclic aromatic system that has at least one heteroatom selected from B, N, O, P, Si, S, Se, and Ge as a ring-forming atom, and 1 to 60 carbon atoms as ring-forming atom(s). Non-limiting examples of the $C_1$-$C_{60}$ heteroaryl group include a pyridinyl group, a pyrimidinyl group, a pyrazinyl group, a pyridazinyl group, a triazinyl group, a quinolinyl group, an isoquinolinyl group, or the like. When the $C_1$-$C_{60}$ heteroaryl group and the $C_1$-$C_{60}$ heteroarylene group each include two or more rings, the rings may be fused with each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein refers to -$OA_{102}$ (wherein $A_{102}$ is the $C_6$-$C_{60}$ aryl group), and the term "$C_6$-$C_{60}$ arylthio group" as used herein refers to -$SA_{103}$ (wherein $A_{103}$ is the $C_6$-$C_{60}$ aryl group).

The term "$C_1$-$C_{60}$ heteroaryloxy group" as used herein indicates -$OA_{104}$ (wherein $A_{104}$ is a $C_1$-$C_{60}$ heteroaryl group), and the term "$C_1$-$C_{60}$ heteroarylthio group" as used herein indicates -$SA_{105}$ (wherein $A_{105}$ is the $C_1$-$C_{60}$ heteroaryl group).

The term "monovalent non-aromatic condensed polycyclic group" as used herein refers to a monovalent group (for example, having 8 to 60 carbon atoms) having two or more rings condensed with each other, only carbon atoms as ring-forming atoms, and no aromaticity in its entire structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed with each other, a heteroatom selected from B, N, O, P, Si, S, Se, and Ge other than carbon atoms, as a ring-forming atom, and no aromaticity in its entire structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated carbocyclic ring group having, as a ring-forming atom, 5 to 30 carbon atoms only. The $C_5$-$C_{30}$ carbocyclic group may be a monocyclic group or a polycyclic group. Non-limiting examples of the "$C_5$-$C_{30}$ carbocyclic group (unsubstituted or substituted with at least one $R_{1a}$)" as used herein include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, an indene group, a fluorene group, or the like (each unsubstituted or substituted with at least one $R_{1a}$).

The term "$C_1$-$C_{30}$ heterocyclic group" as used herein refers to a saturated or unsaturated heterocyclic ring group having, as a ring-forming atom, at least one heteroatom selected from B, N, O, P, Si, S, Se, and Ge other than 1 to 30 carbon atoms as ring-forming atom(s). The $C_1$-$C_{30}$ heterocyclic group may be a monocyclic group or a polycyclic group. Non-limiting examples of the "$C_1$-$C_{30}$ heterocyclic group (unsubstituted or substituted with at least one $R_{1a}$)" as used herein include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5, 5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5, 5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5, 6, 7, 8-tetrahydroisoquinoline group, a 5, 6, 7, 8-tetrahydroquinoline group, or the like (each unsubstituted or substituted with at least one $R_{1a}$).

In the present specification, "TMS" represents * -$Si(CH_3)_3$, and "TMG" represents * -$Ge(CH_3)_3$.

A term "($C_1$-$C_{20}$ alkyl) X group" (e.g., ($C_1$-$C_{20}$ alkyl) phenyl group) used herein refers to an X group (e.g., a phenyl group) substituted with at least one $C_1$-$C_{20}$ alkyl.

Substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted

$C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group,

a $C_1$-$C_{60}$ alkyl group, a $C_2$-$C_{60}$ alkenyl group, a $C_2$-$C_{60}$ alkynyl group, a $C_1$-$C_{60}$ alkylthio group, or a $C_1$-$C_{60}$ alkoxy group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{11})(Q_{12})(Q_{13})$, $-Ge(Q_{11})(Q_{12})(Q_{13})$, $-C(=O)(Q_{11})$, $-S(=O)(Q_{11})$, $-S(=O)_2(Q_{11})$, $-B(Q_{11})(Q_{12})$, $-P(Q_{11})(Q_{12})$, $-P(=O)(Q_{11})(Q_{12})$, $-P(=S)(Q_{11})(Q_{12})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $-Ge(Q_{21})(Q_{22})(Q_{23})$, $-C(=O)(Q_{21})$, $-S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, $-P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, $-S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$, or $-P(Q_{31})(Q_{32})$; or

a combination thereof, and

$Q_1$ to $Q_3$, $Q_{11}$ to $Q_{13}$, $Q_{21}$ to $Q_{23}$ and $Q_{31}$ to $Q_{33}$ may each independently be:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, -F, -Cl, -Br, -I, $-SF_5$, a hydroxyl group, a cyano group, a $C_1$-$C_{60}$ alkyl group, a $C_6$-$C_{60}$ aryl group, a

$C_1$-$C_{60}$ heteroaryl group, a monovalent non-aromatic condensed polycyclic group, a monovalent non-aromatic condensed heteropolycyclic group, or a combination thereof.

Hereinafter, compounds and organic light-emitting devices, according to one or more embodiments, will be described in further detail with reference to Synthesis Example and Examples. However, the following examples are not intended to limit the scope. The wording "'B' was used instead of 'A'" used in describing Synthesis Examples means that an amount of 'A' used was identical to an amount of 'B' used, in terms of a molar equivalent.

EXAMPLES

Synthesis Examples

Synthesis Example 1: Synthesis of Compound 41

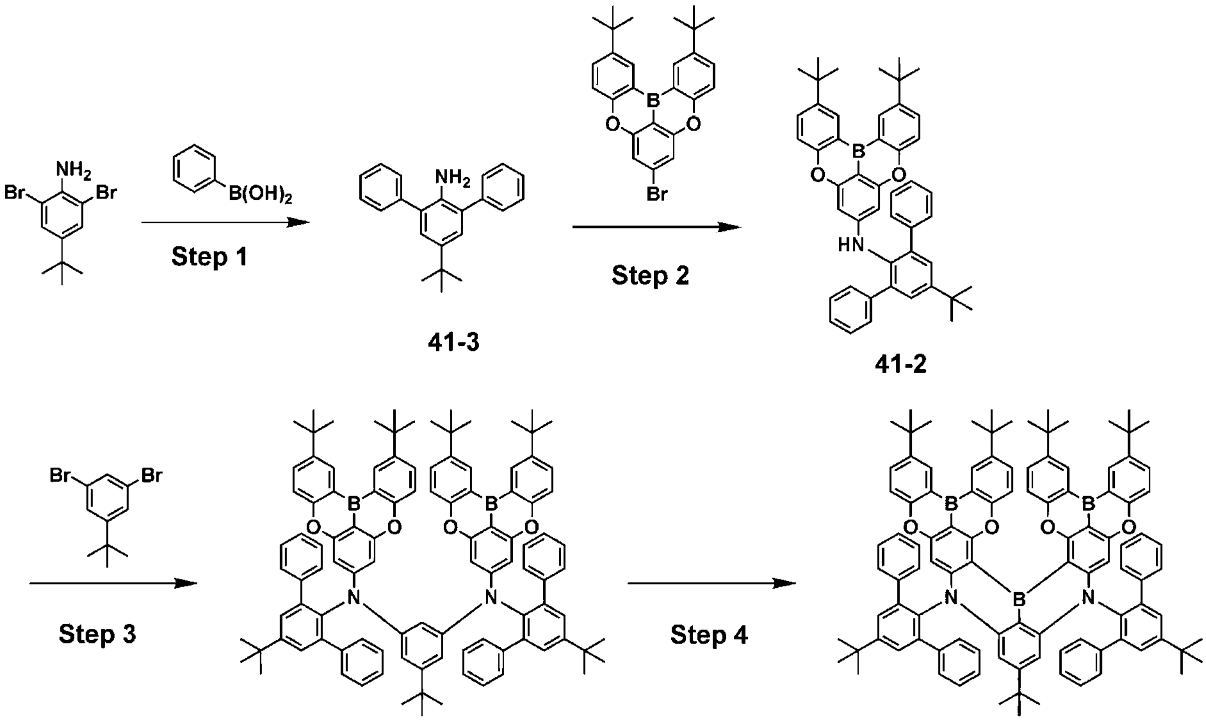


41-3

41-2

41-1

41

(1) Synthesis of compound 41-3

Under nitrogen, 2,6-dibromo-4-(tert-butyl)aniline (20.00 grams (g), 65.24 millimoles (mmol)), phenylboronic acid (17.50 g, 143.5 mmol), $Na_2CO_3$ (20.74 g, 195.7 mmol), $Pd(PPh_3)_4$ (7.54 g, 6.52 mmol), toluene/ethanol(EtOH)/deionized water (DI water) (200 milliliters (mL), 2:1:1) were added and heated at 100°C for 24 hours, and the reaction was terminated with addition of an ammonium chloride aqueous solution. After extraction with dichloromethane, drying with $MgSO_4$, and removing the solvent, purification was performed by column chromatography with methylene chloride (MC):hexane (1:4) as eluents to obtain 17.21 g of a white solid.

Liquid chromatography mass spectrometry (LCMS) (m/z) Calculated: 301.183 g/mol, Found: [M+] 302.194 g/mol.

(2) Synthesis of compound 41-2

Under nitrogen, 7-bromo-2,12-di-tert-butyl-5,9-dioxa-13b-boranaphtho[3,2,1-de]anthracene (7.00 g, 15.21 mmol), compound 41-3 (5.50 g, 18.25 mmol), sodium tertiary butoxide (NaOtBu) (2.19 g, 22.81 mmol), tris(dibenzylideneacetone)dipalladium(0) ($Pd_2(dba)_3$) (0.696 g, 0.760 mmol), 2-dicyclohexylphosphino-2',6'-dimethoxybiphenyl

(SPhos) (0.624 g, 1.52 mmol) were stirred at 150°C with xylene (76 mL) for 24 hours. After cooling to room temperature, the mixture was extracted with MC and dried with $MgSO_4$, and the solvent was removed therefrom. The mixture was purified by column chromatography with MC:hexane (1:7) as eluents to obtain 7.52 g of a white solid.

LCMS (m/z) Calculated: 681.378 g/mol, Found: [M+] 682.423 g/mol.

(3) Synthesis of compound 41-1

Under nitrogen, 1,3-dibromo-5-(tert-butyl)benzene (1.50 g, 5.24 mmol), compound 41-2 (7.50 g, 11.00 mmol), NaOtBu (1.76 g, 18.34 mmol), $Pd_2(dba)_3$ (0.480 g, 0.524 mmol), and SPhos (0.430 g, 1.05 mmol) were stirred at 150°C with xylene (26 mL) for 24 hours. The reaction was terminated with an ammonium chloride aqueous solution. The organic layer was extracted and dried over $MgSO_4$, the solvent was removed therefrom, and the product was purified by column chromatography with MC:hexane (1:5) to obtain 4.30 g of a white solid.

LCMS (m/z) Calculated: 1492.834 g/mol, Found: [M+] 1493.943 g/mol.

(4) Synthesis of compound 41

Under nitrogen, compound 41-1 (5.00 g, 3.35 mmol), $BI_3$ (1.44 g, 3.68 mmol) were stirred with 1,2,4-trichlorobenzene (67 ml) at 190°C for 18 hours. After lowering the temperature to room temperature, the reaction was terminated with the addition of a $Na_2CO_3$ aqueous solution. The organic layer was extracted and dried over $MgSO_4$, and the solvent was removed therefrom. The resultant was purified by column chromatography with MC:hexane (1:9) to obtain 0.85 g of compound 41, which was a solid.

LCMS (m/z) Calculated: 1500.820 g/mol, Found: [M+] 1501.830 g/mol.

Evaluation Example 1: Evaluation of Photoluminescence Characteristics

For compound 41 and compound A, each was dissolved in MC together with polymethyl methacrylate (PMMA) to 1 wt%, and a thin film was formed on a quartz substrate (20 mm x 20 mm) by spin coating. Photoluminescence (PL) spectrum was measured after exciting with an excitation wavelength of 330 nm at room temperature, and the emission peak wavelength ($\lambda_{PL}$) and FWHM were obtained from the PL spectrum. Additionally, delayed fluorescence lifespan (Tau(DF)) and rate constant of reverse intersystem crossing ($k_{RISC}$) were measured at room temperature using a fluorescence lifetime measuring device. For compound B, comparison was made with the published results (Nat. Commun., 2024, 15, 2361). Results are shown in Table 2.

Table 2

| Compound No. | $\lambda_{PL}$ (nm) | FWHM (nm) | Tau(DF) ($\mu$s) | $k_{RISC}$ ($10^5 s^{-1}$) |
|---|---|---|---|---|
| Compound 41 | 442 | 20 | 0.94 | 58.1 |
| Compound A | 461 | 22 | 28.8 | 1.03 |
| Compound B | 451 | 27 | 1.55 | 11.0 |

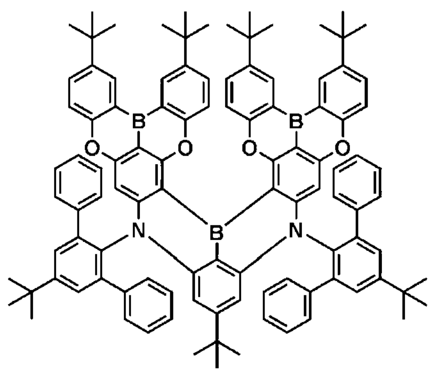

41

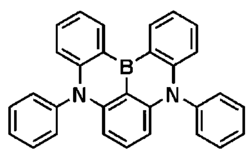

A

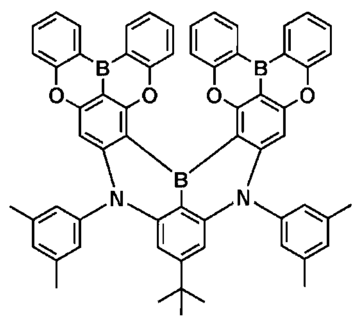

B

From Table 2, it can be seen that the heterocyclic compound represented by Formula 1 according to one or more embodiments had excellent optical luminescence characteristics. In addition, it can be seen that the heterocyclic

compound represented by Formula 1 according to one or more embodiments was more suitable for deep blue emission and had a narrower half-width compared to compounds A and B. In addition, the heterocyclic compound represented by Formula 1 according to one or more embodiments had shorter delayed fluorescence lifespan (Tau(DF)) and much higher rate constant of reverse intersystem crossing ($K_{RISC}$) compared to compounds A and B. A higher $K_{RISC}$ is advantageous for increasing efficiency of an organic light-emitting device.

Example 1

An ITO glass substrate was cut to a size of 50 mm x 50 mm x 0.5 mm and then, sonicated in acetone, isopropyl alcohol, and DI water, each for 15 minutes, and then, washed by exposure to ultraviolet (UV) ozone for 30 minutes.

Next, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron-blocking layer having a thickness of 50 Å.

A first host (H25), a second host (H26), and an emitter (compound 41) were co-deposited on the electron-blocking layer to form an emission layer with a thickness of 400 Å. In this regard, the first host and the second host were mixed at a weight ratio of 65:35, and the emitter was adjusted to be 2 wt% of the total weight of the first host, the second host, and the emitter.

DBFPO was deposited on the emission layer to form a hole-blocking layer having a thickness of 100 Å, and DBFPO and LiQ were co-deposited on the hole-blocking layer at a weight ratio of 5:5 to form an electron transport layer having a thickness of 300 Å, LiQ was deposited on the electron transport layer to form an electron injection layer having a thickness of 10 Å, and aluminum (Al) was deposited on the electron injection layer to form a cathode having a thickness of 1,000 Å, thereby completing the manufacture of an organic light-emitting device.

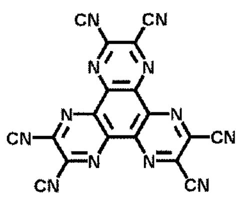
HT-D1(HAT-CN)

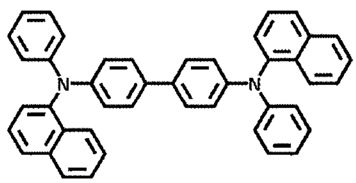
NPB

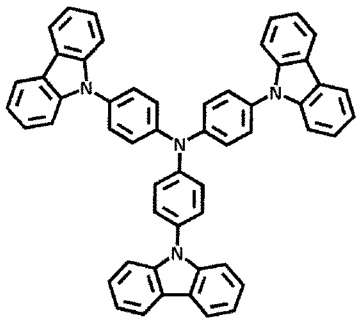
TCTA

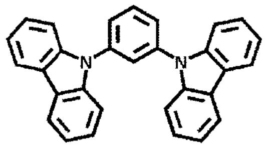
mCP

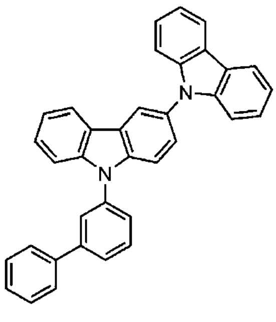
H25

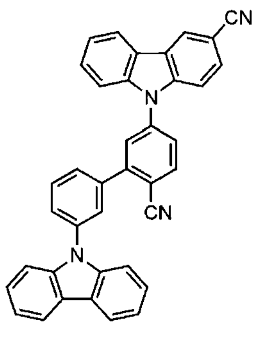
H26

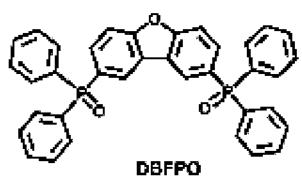
DBFPO

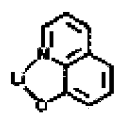
LiQ

Comparative Example 1

An organic light-emitting device was manufactured using the same method as Example 1, except that the compound listed in Table 3 was used as an emitter when forming the emission layer.

Evaluation Example 2: Evaluation of characteristics of organic light-emitting device

The color coordinates (CIEy), emission wavelength ($\lambda_{EL}$), relative efficiency (at 1,000 cd/$m^2$), and roll-off characteristics of the organic light-emitting devices manufactured according to Example 1 and Comparative Example 1 were measured and evaluated using a current-voltage meter (Keithley 2400) and a luminance meter (Minolta Cs-1000A). Results are shown in Table 3. The roll-off ratio was calculated according to Equation 1:

Roll-off ratio = {1- (luminescence efficiency / maximum luminescence efficiency)} x 100 % Equation 1

Table 3

| | Emitter in emission layer | CIEy | Emission wavelength (nm) | Relative efficiency (relative %) | Roll-off ratio (%) |
|---|---|---|---|---|---|
| Example 1 | Compound 41 | 0.040 | 443 | 327 | 25 |
| Comparative Example 1 | Compound A | 0.082 | 458 | 100 | 77 |

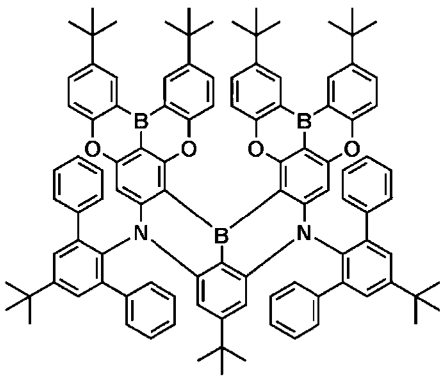

41

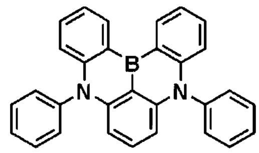

A

The results recorded in Table 3 indicated that the organic light-emitting device of one or more embodiments had excellent luminescence efficiency, and low roll-off characteristics. In addition, the organic light-emitting device of Example 1 had superior color coordinates, shorter emission wavelengths, higher efficiency, and lower roll-off characteristics than those of the organic light-emitting device of Comparative Example 1.

Since the heterocyclic compound represented by Formula 1 has excellent luminescence characteristics and charge mobility characteristics, electronic devices, such as organic light-emitting devices, employing at least one of the heterocyclic compounds represented by Formula 1 can have the characteristics of short emission wavelength, low driving voltage, high efficiency, low roll-off ratio and/or long lifespan. Therefore, high-quality organic light-emitting devices can be realized by using at least one of the heterocyclic compounds represented by Formula 1. Additionally, high-quality electronic apparatus can be implemented by using the organic light-emitting device.

The embodiments described herein should be considered in a descriptive sense only and not for purposes of limitation. Descriptions of features or aspects within each exemplary embodiment should typically be considered as available for other similar features or aspects in other embodiments. While one or more exemplary embodiments have been described with reference to the figures, it will be understood by those of ordinary skill in the art that various changes in form and details may be made therein without departing from the scope as defined by the following claims.

## Claims

**1.** A heterocyclic compound represented by Formula 1:

Formula 1

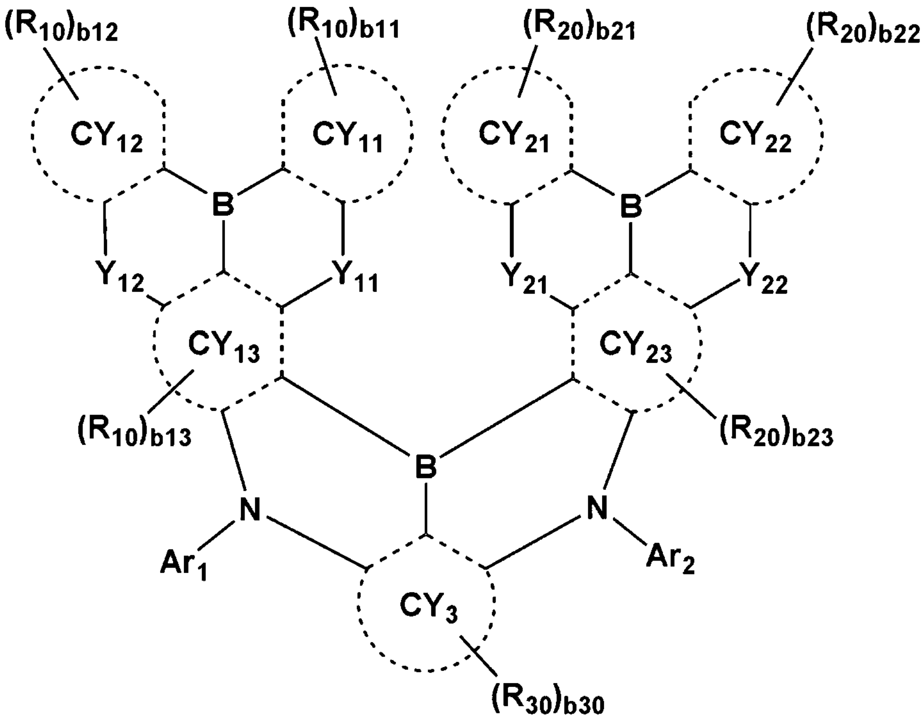

wherein, in Formula 1,

$Y_{11}$ and $Y_{12}$ are each independently a single bond, O, S, Se, $N(Ar_3)$, $N(R_1)$, $C(R_1)(R_2)$, $Si(R_1)(R_2)$, $Ge(R_1)(R_2)$, $B(R_1)$, $P(R_1)$, $P(=O)(R_1)$, $S(=O)_2$, or C(=O),
$Y_{21}$ and $Y_{22}$ are each independently a single bond, O, S, Se, $N(Ar_4)$, $N(R_3)$, $C(R_3)(R_4)$, $Si(R_3)(R_4)$, $Ge(R_3)(R_4)$, $B(R_3)$, $P(R_3)$, $P(=O)(R_3)$, $S(=O)_2$, or C(=O),
$Ar_1$ to $Ar_4$ are each independently a group represented by Formula 2,

Formula 2

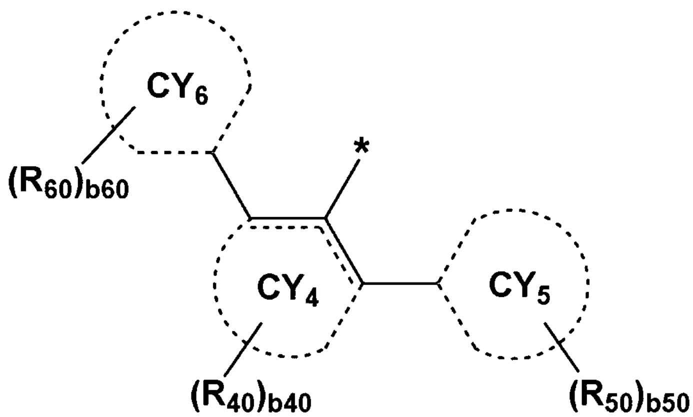

wherein, in Formulae 1 and 2,

$CY_{11}$ to $CY_{13}$, $CY_{21}$ to $CY_{23}$, and $CY_3$ to $CY_6$ are each independently a $C_5$-$C_{30}$ carbocyclic group or a $C_1$-$C_{30}$ heterocyclic group,

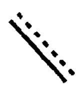

indicates a single bond or a double bond,

* indicates a binding site to a neighboring atom,

$R_1$ to $R_4$, $R_{10}$, $R_{20}$, $R_{30}$, $R_{40}$, $R_{50}$ and $R_{60}$ are each independently hydrogen, deuterium, -F, -Cl, -Br, -I, $-SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_1)(Q_2)(Q_3)$, $-Ge(Q_1)(Q_2)(Q_3)$, $-C(=O)(Q_1)$, $-S(=O)(Q_1)$, - $S(=O)_2(Q_1)$, $-B(Q_1)(Q_2)$, $-P(Q_1)(Q_2)$, $-P(=O)(Q_1)(Q_2)$, or $-P(=S)(Q_1)(Q_2)$,

b11 to b13, b21 to b23, b30, b40, b50, and b60 are each independently 1, 2, 3, 4, 5, 6, 7, 8, 9, 10, 11, 12, 13, or 14,

two or more of adjacent $R_1$ to $R_4$, $R_{10}$, $R_{20}$, $R_{30}$, $R_{40}$, $R_{50}$, and $R_{60}$ are optionally bonded to each other to form a substituted or unsubstituted $C_5$-$C_{30}$ carbocyclic group or a substituted or unsubstituted $C_1$-$C_{30}$ heterocyclic group,

substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group are:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, $C_1$-$C_{60}$ alkylthio group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, $C_1$-$C_{60}$ alkylthio group, or a $C_1$-$C_{60}$ alkoxy group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{11})(Q_{12})(Q_{13})$, $-Ge(Q_{11})(Q_{12})(Q_{13})$, $-C(=O)(Q_{11})$, $-S(=O)(Q_{11})$, $-S(=O)_2(Q_{11})$, $-B(Q_{11})(Q_{12})$, $-P(Q_{11})(Q_{12})$, $-P(=O)(Q_{11})(Q_{12})$, $-P(=S)(Q_{11})(Q_{12})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-SF_5$, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a

carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $-Ge(Q_{21})(Q_{22})(Q_{23})$, $-C(=O)(Q_{21})$, $-S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, $-P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, $-S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$, or $-P(=S)(Q_{31})(Q_{32})$; or

a combination thereof, and

$Q_1$ to $Q_3$, $Q_{11}$ to $Q_{13}$, $Q_{21}$ to $Q_{23}$ and $Q_{31}$ to $Q_{33}$ are each independently:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, a $C_1$-$C_{60}$ alkyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, or a combination thereof.

**2.** The heterocyclic compound of claim 1, wherein

$Y_{11}$ and $Y_{21}$ are each independently O, S, or Se, and
$Y_{12}$ and $Y_{22}$ are each independently O, S, Se, $N(Ar_3)$, $N(R_1)$, $C(R_1)(R_2)$, or $Si(R_1)(R_2)$.

**3.** The heterocyclic compound of claims 1 or 2, wherein
$CY_{11}$ to $CY_{13}$, $CY_{21}$ to $CY_{23}$, and $CY_3$ to $CY_6$ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

**4.** The heterocyclic compound of any of claims 1-3, wherein
the group represented by Formula 2 is a group represented by Formula 2A:

Formula 2A

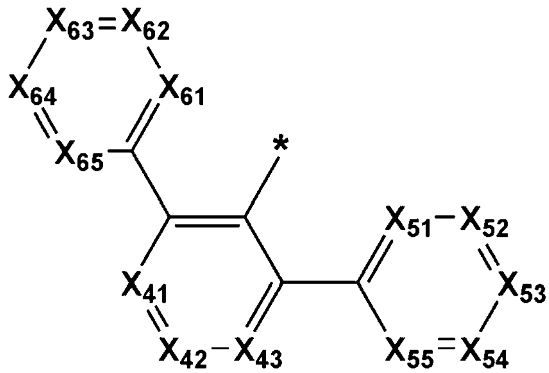

wherein, in Formula 2A,

$X_{41}$ is $C(R_{41})$ or N, $X_{42}$ is $C(R_{42})$ or N, and $X_{43}$ is $C(R_{43})$ or N,
$X_{51}$ is $C(R_{51})$ or N, $X_{52}$ is $C(R_{52})$ or N, $X_{53}$ is $C(R_{53})$ or N, $X_{54}$ is $C(R_{54})$ or N, $X_{55}$ is $C(R_{55})$ or N,
$X_{61}$ is $C(R_{61})$ or N, $X_{62}$ is $C(R_{62})$ or N, $X_{63}$ is $C(R_{63})$ or N, $X_{64}$ is $C(R_{64})$ or N, $X_{65}$ is $C(R_{65})$ or N,
$R_{41}$ to $R_{43}$ are each independently as described in connection with $R_{40}$ in claim 1,
$R_{51}$ to $R_{55}$ are each independently as described in connection with $R_{50}$ in claim 1,
$R_{61}$ to $R_{65}$ are each independently as described in connection with $R_{60}$ in claim 1, and
* indicates a binding site to a neighboring atom;
preferably wherein the group represented by Formula 2 is a group represented by Formula 2A-1:

Formula 2A-1

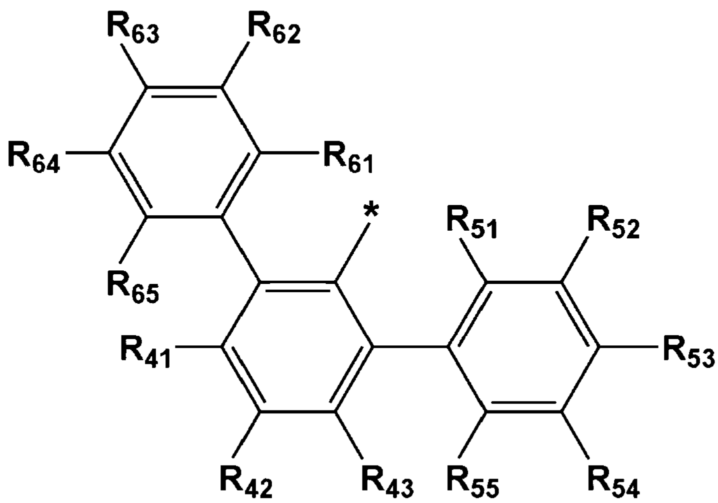

wherein, in Formula 2A-1,

$R_{41}$ to $R_{43}$ are each independently as described in connection with $R_{40}$ in claim 1,
$R_{51}$ to $R_{55}$ are each independently as described in connection with $R_{50}$ in claim 1,
$R_{61}$ to $R_{65}$ are each independently as described in connection with $R_{60}$ in claim 1, and
* indicates a binding site to a neighboring atom.

**5.** The heterocyclic compound of any of claims 1-4, wherein
$R_1$ to $R_4$, $R_{10}$, $R_{20}$, $R_{30}$, $R_{40}$, $R_{50}$, and $R_{60}$ are each independently:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, $C_1$-$C_{20}$ alkylthio group, or a

$C_1$-$C_{20}$ alkoxy group;

a $C_1$-$C_{20}$ alkyl group, $C_1$-$C_{20}$ alkylthio group, or a $C_1$-$C_{20}$ alkoxy group, each substituted with deuterium, -F, -Cl, -Br, -I, -$SF_5$, -$CD_3$, -$CD_2H$, -$CDH_2$, -$CF_3$, -$CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo [2.2.1]heptyl group (a norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2] octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorine-containing $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1] hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2] octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or -N($Q_1$)($Q_2$), -Si($Q_1$ )($Q_2$)($Q_3$), -Ge($Q_1$)($Q_2$)($Q_3$), -C(=O)($Q_1$), -S(=O)($Q_1$), - $S(=O)_2$($Q_1$), -B($Q_1$)($Q_2$), -P($Q_1$)($Q_2$), -P(=O)($Q_1$)($Q_2$), or -P(=S)($Q_1$)($Q_2$).

**6.** The heterocyclic compound of any of claims 1-5, wherein

at least one of $R_{30}$ in the number of b30 is -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

**7.** The heterocyclic compound of any of claims 1-6, wherein the heterocyclic compound is a compound represented by Formula 11:

Formula 11

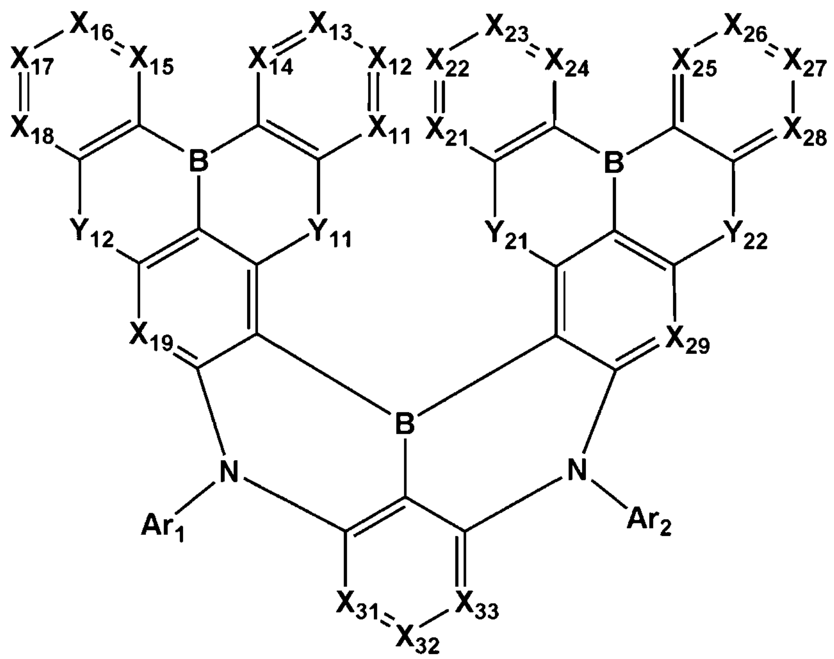

wherein, in Formula 11,

$Y_{11}$, $Y_{12}$, $Y_{21}$, $Y_{22}$, $Ar_1$, and $Ar_2$ are as in claim 1,
$X_{11}$ is $C(R_{11})$ or N, $X_{12}$ is $C(R_{12})$ or N, $X_{13}$ is $C(R_{13})$ or N, $X_{14}$ is $C(R_{14})$ or N, $X_{15}$ is $C(R_{15})$ or N, $X_{16}$ is $C(R_{16})$ or N, $X_{17}$ is $C(R_{17})$ or N, $X_{18}$ is $C(R_{18})$ or N, $X_{19}$ is $C(R_{19})$ or N,
$X_{21}$ is $C(R_{21})$ or N, $X_{22}$ is $C(R_{22})$ or N, $X_{23}$ is $C(R_{23})$ or N, $X_{24}$ is $C(R_{24})$ or N, $X_{25}$ is $C(R_{25})$ or N, $X_{26}$ is $C(R_{26})$ or N, $X_{27}$ is $C(R_{27})$ or N, $X_{28}$ is $C(R_{28})$ or N, $X_{29}$ is $C(R_{29})$ or N,
$X_{31}$ is $C(R_{31})$ or N, $X_{32}$ is $C(R_{32})$ or N, $X_{33}$ is $C(R_{33})$ or N,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1;
preferably wherein
$R_{32}$ is -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group, and
$R_{31}$ and $R_{33}$ are each independently hydrogen or deuterium.

**8.** The heterocyclic compound of any of claims 1-7, wherein the heterocyclic compound is a compound represented by Formula 21:

Formula 21

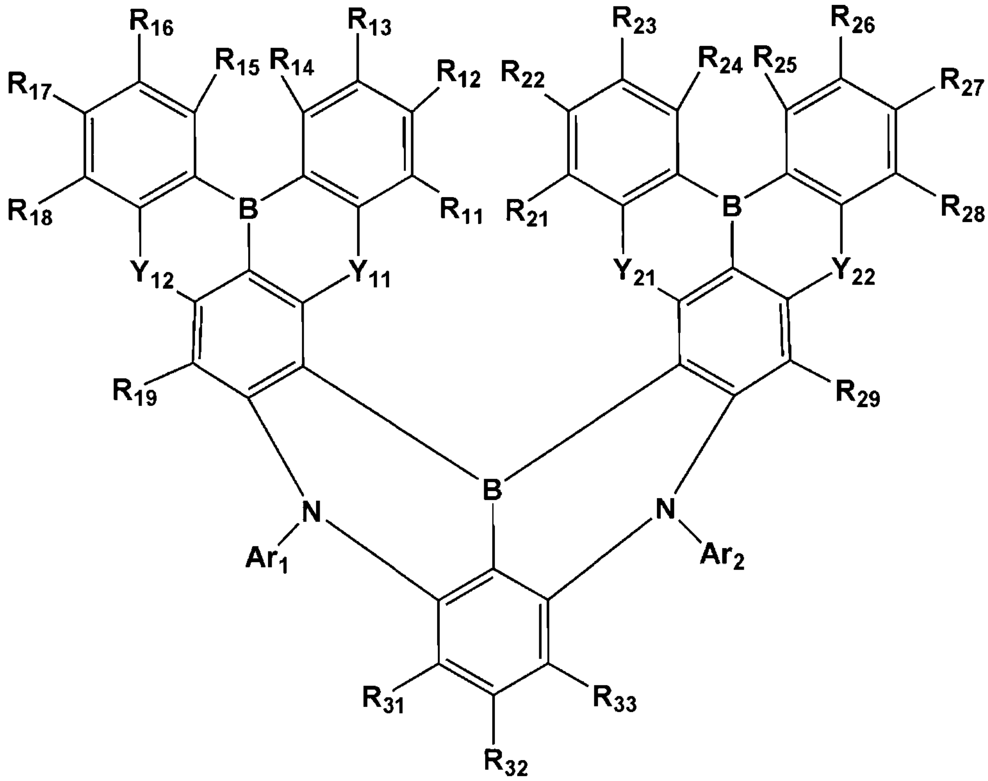

wherein, in Formula 21,

$Y_{11}$, $Y_{12}$, $Y_{21}$, $Y_{22}$, $Ar_1$, and $Ar_2$ are as in claim 1,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1.

**9.** The heterocyclic compound of any of claims 1-8, wherein the heterocyclic compound is a compound represented by Formula 31:

Formula 31

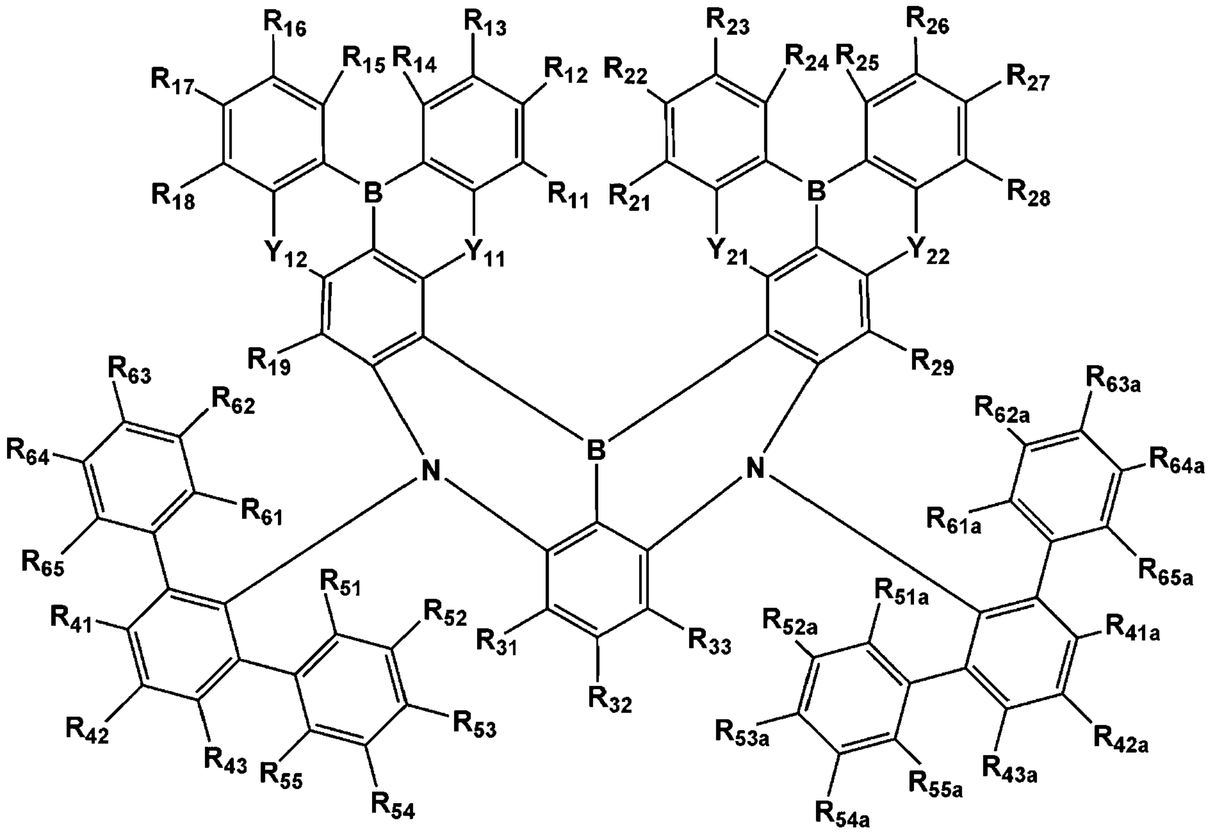

wherein, in Formula 31,

$Y_{11}$, $Y_{12}$, $Y_{21}$, and $Y_{22}$ are as in claim 1,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1,
$R_{41}$ to $R_{43}$ and $R_{41a}$ to $R_{43a}$ are each independently as described in connection with $R_{40}$ in claim 1,
$R_{51}$ to $R_{55}$ and $R_{51a}$ to $R_{55a}$ are each independently as described in connection with $R_{50}$ in claim 1, and
$R_{61}$ to $R_{65}$ and $R_{61a}$ to $R_{65a}$ are each independently as described in connection with $R_{60}$ in claim 1.

**10.** The heterocyclic compound of claim 1, wherein
the heterocyclic compound is any one of compounds 1 to 510:

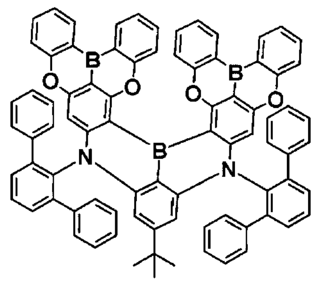

1

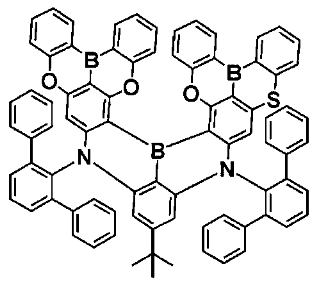

2

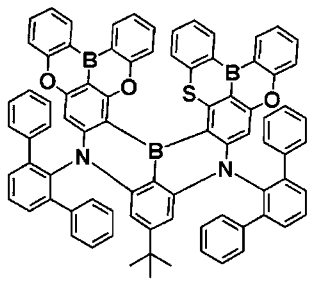

3

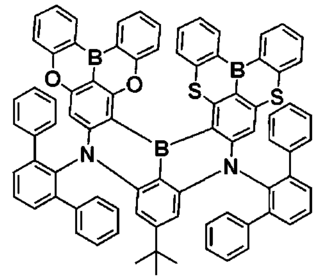
4

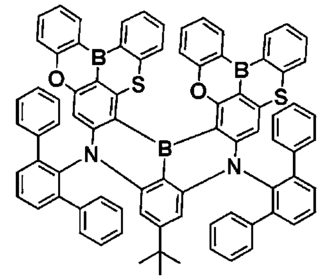
5

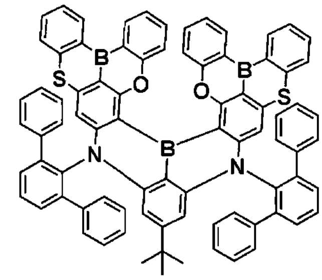
6

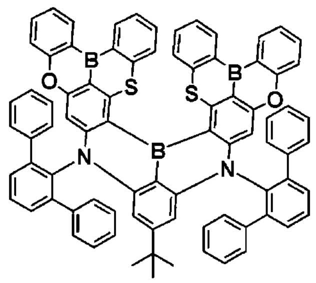
7

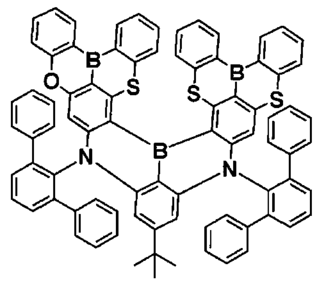
8

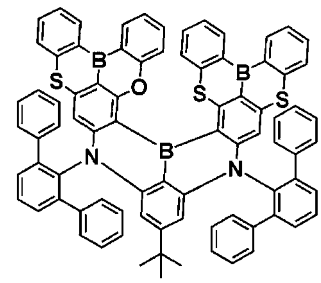
9

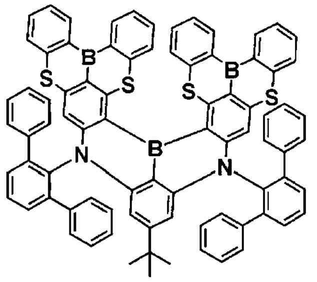
10

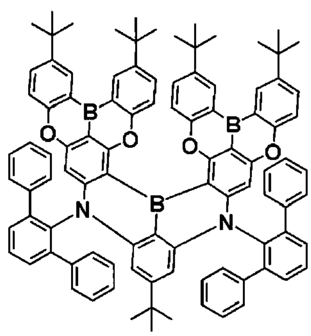
11

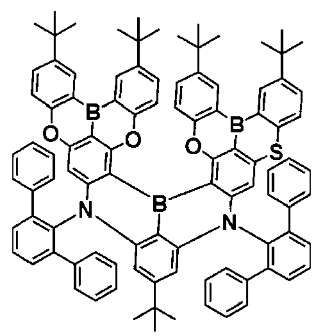
12

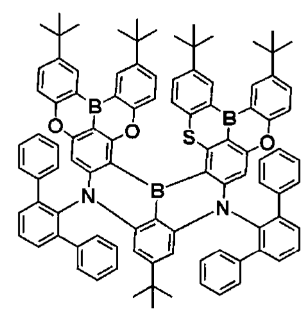
13

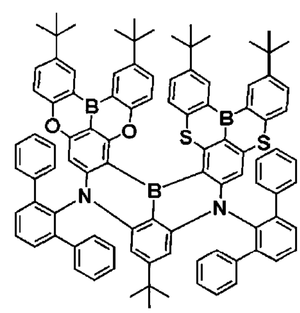
14

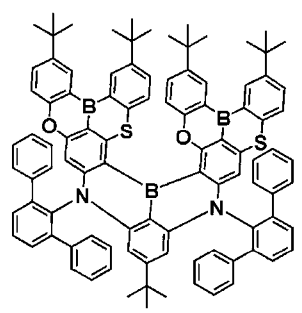
15

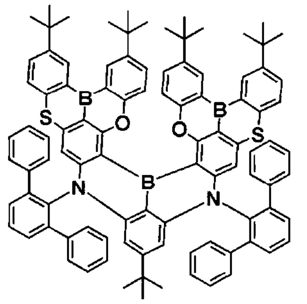

16

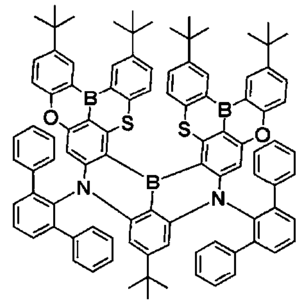

17

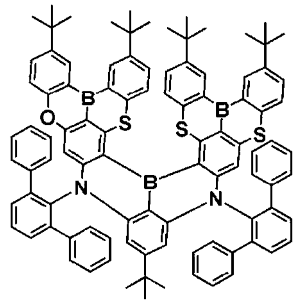

18

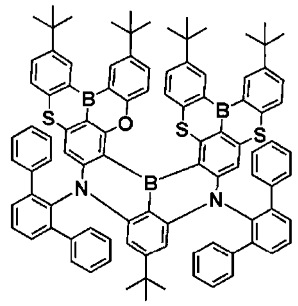

19

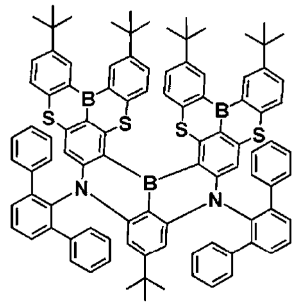

20

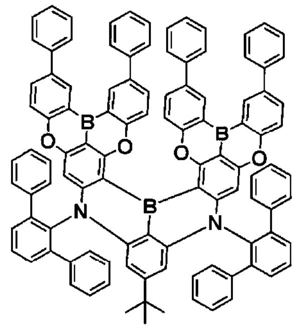

21

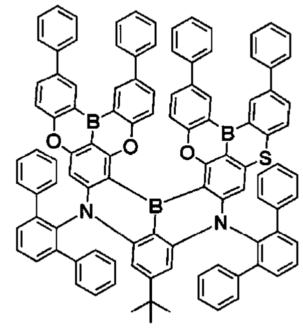

22

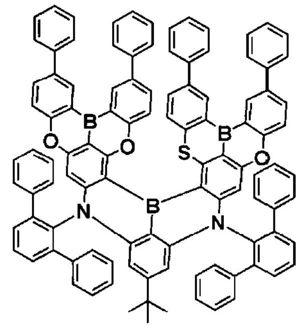

23

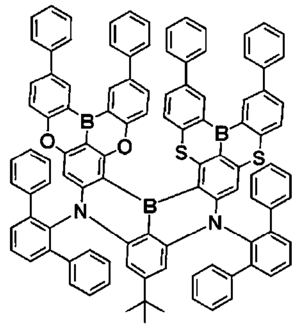

24

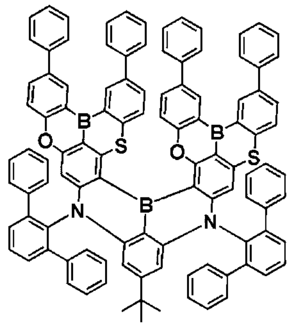

25

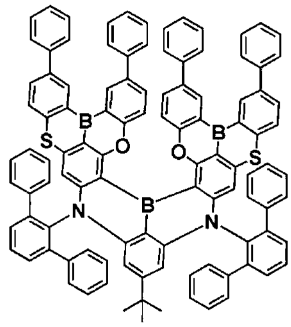

26

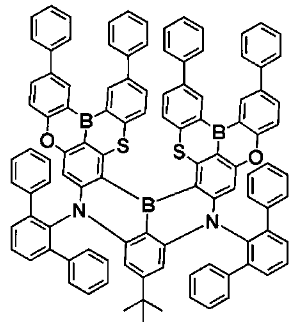

27

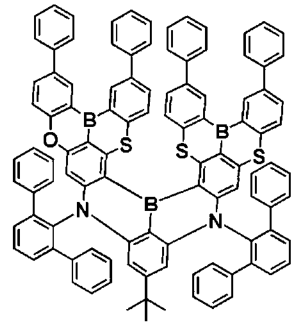

28

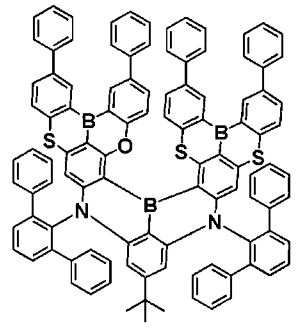

29

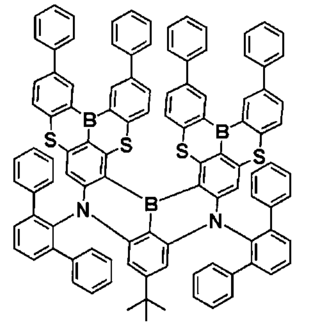

30

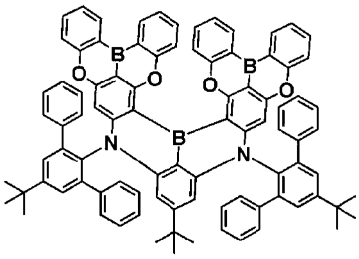

31

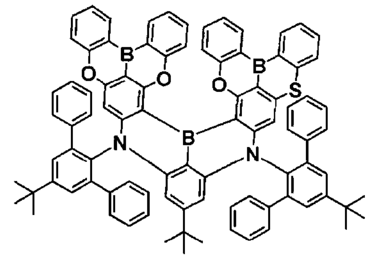

32

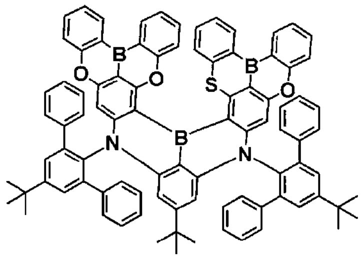

33

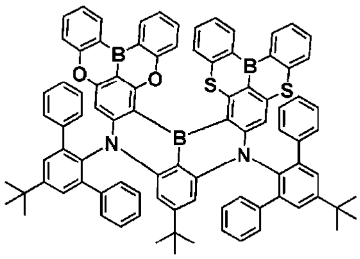

34

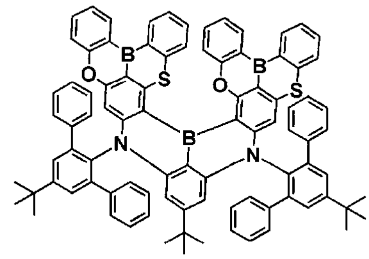

35

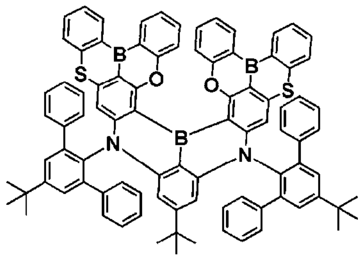

36

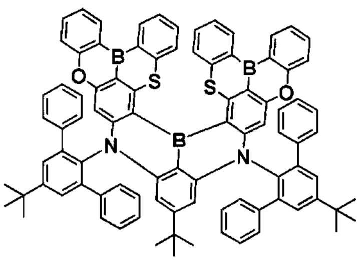

37

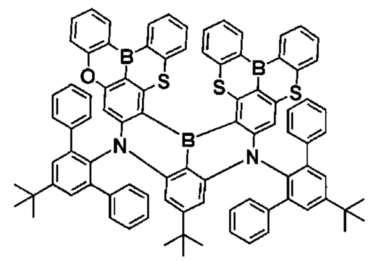

38

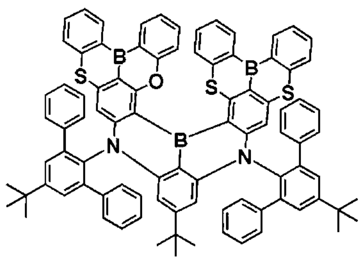

39

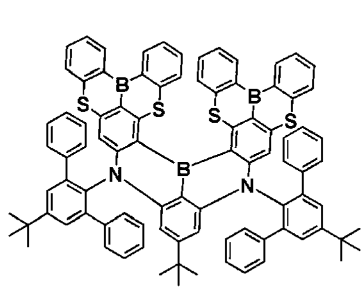

40

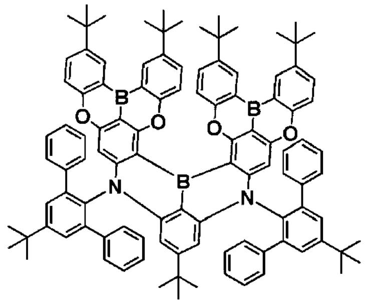

41

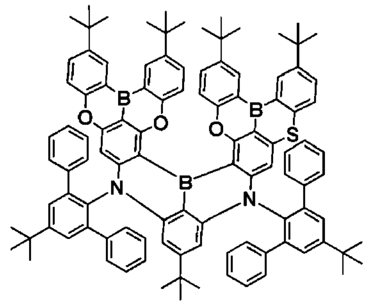

42

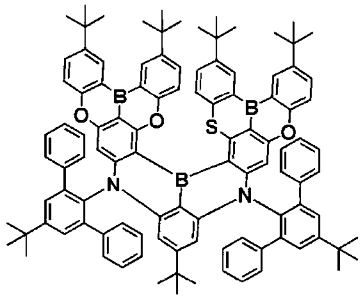

43

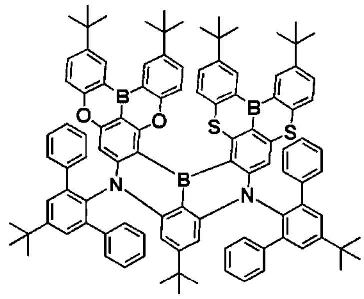

44

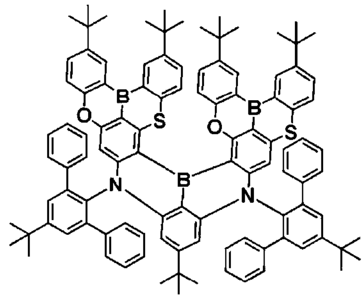

45

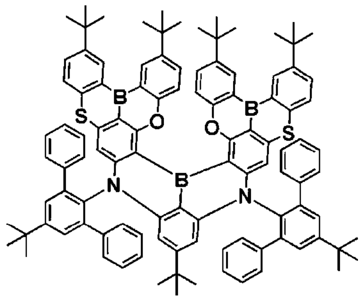

46

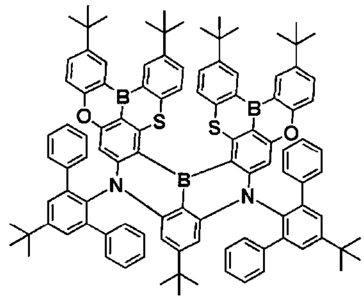

47

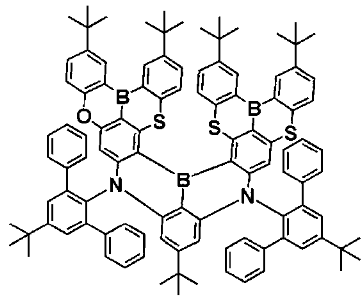

48

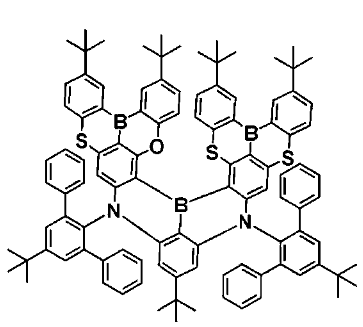

49

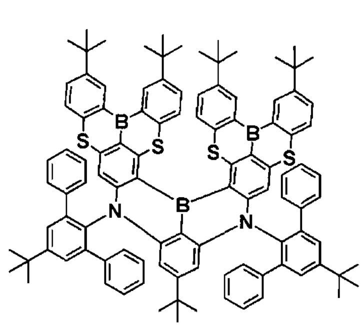

50

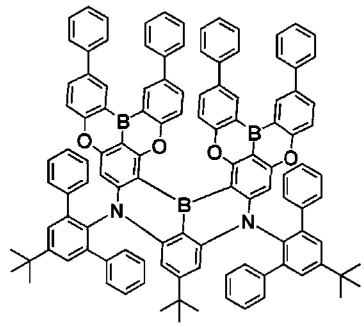

51

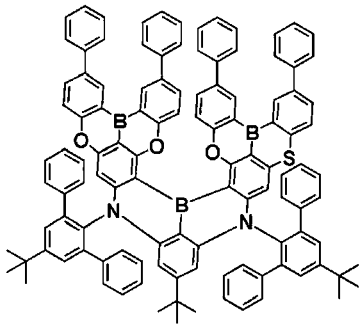
52

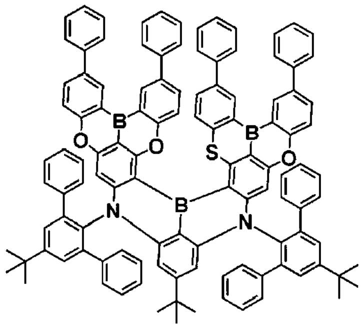
53

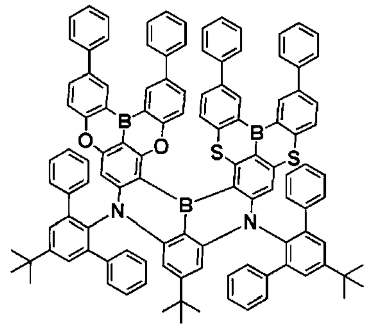
54

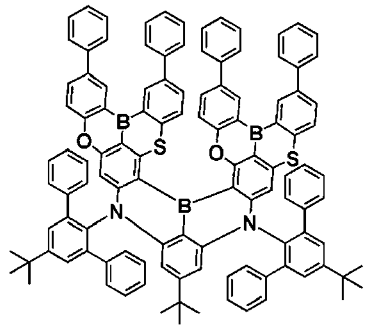
55

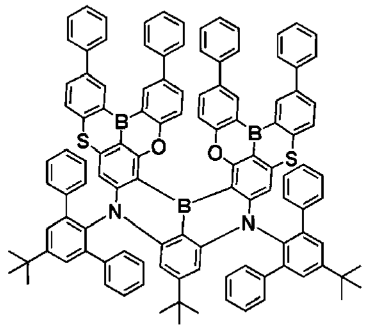
56

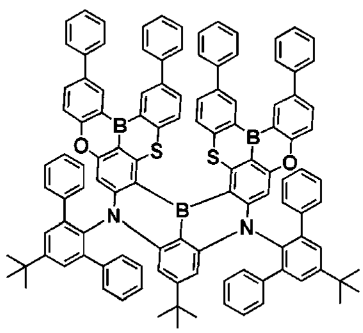
57

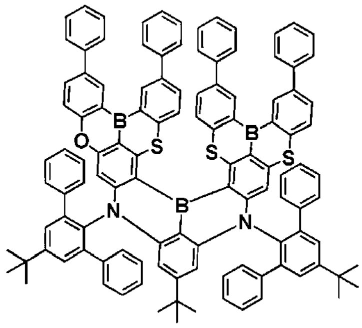
58

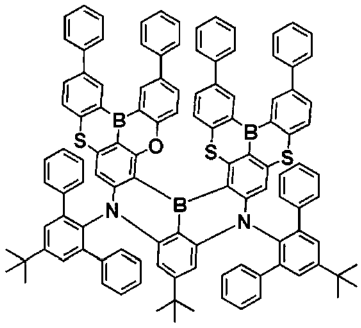
59

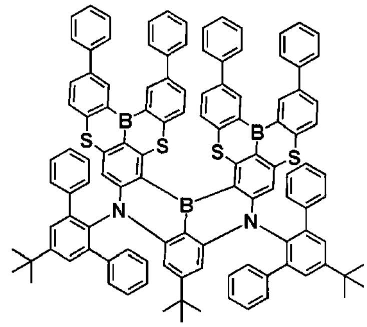
60

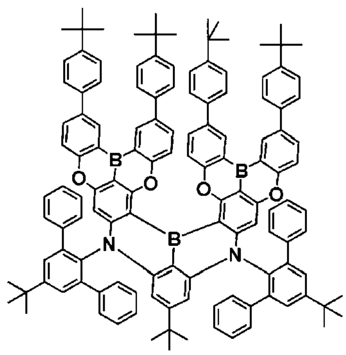
61

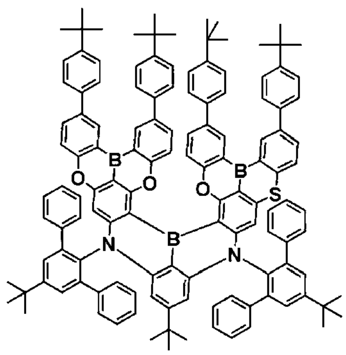
62

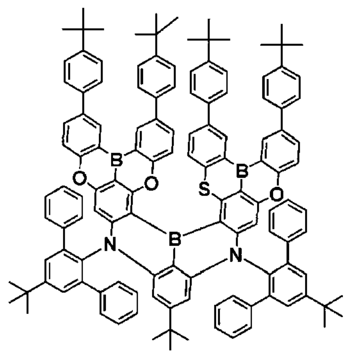
63

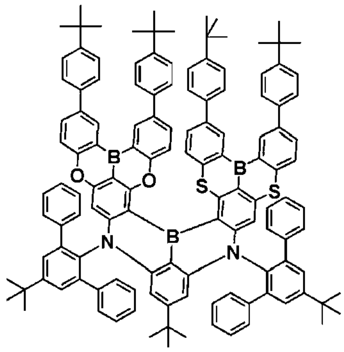

**64**

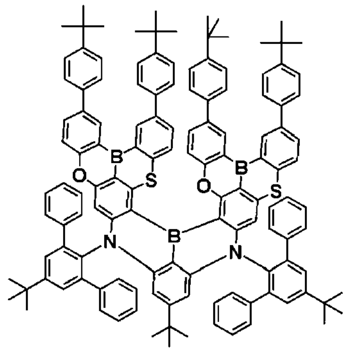

**65**

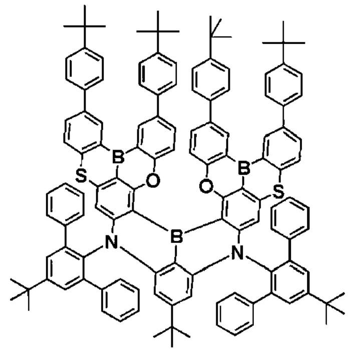

**66**

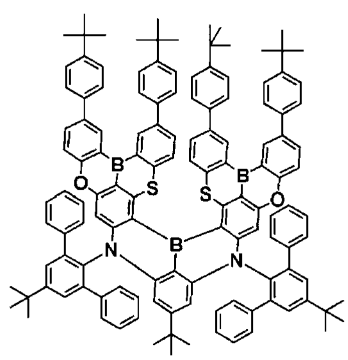

**67**

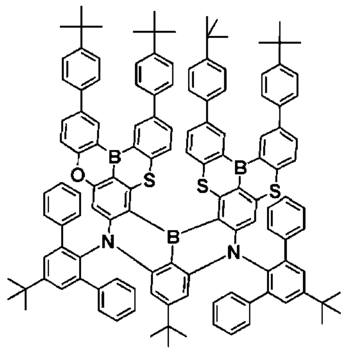

**68**

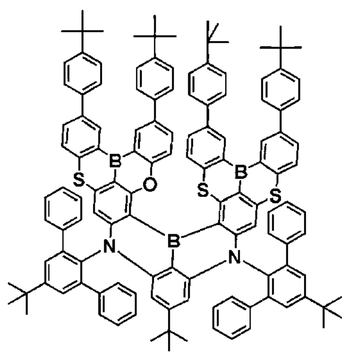

**69**

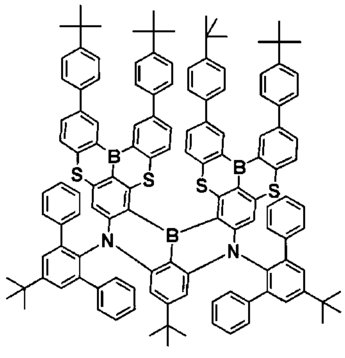

**70**

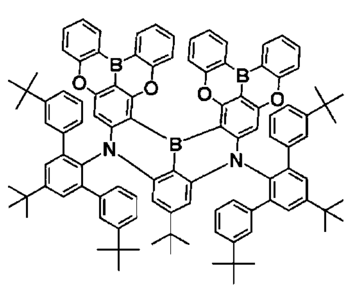

**71**

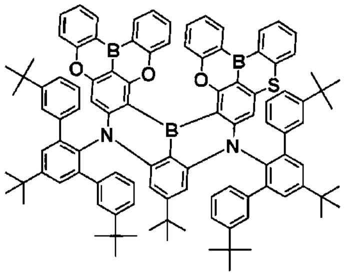

**72**

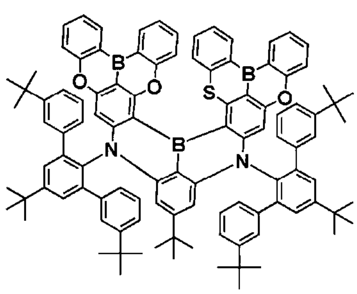

**73**

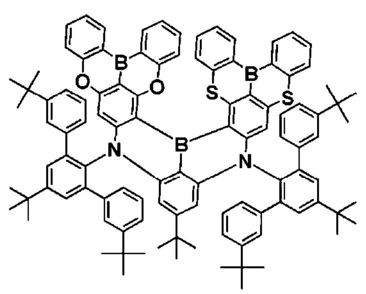

**74**

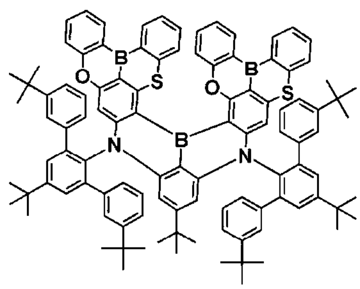

**75**

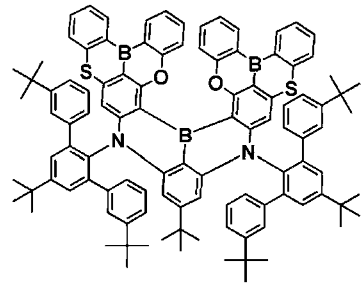

**76**

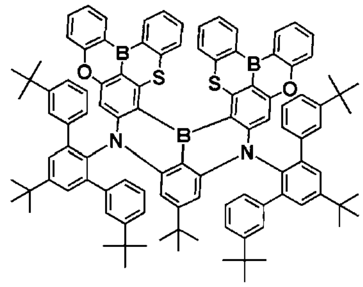

**77**

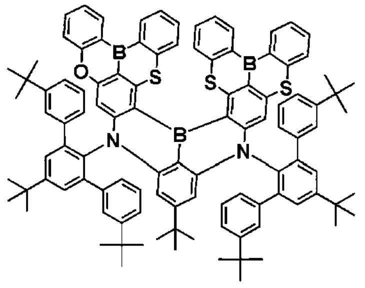

**78**

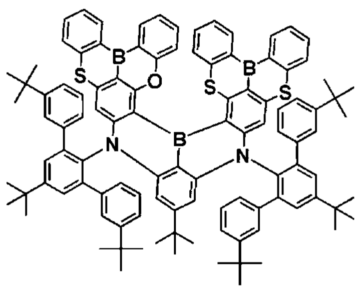

**79**

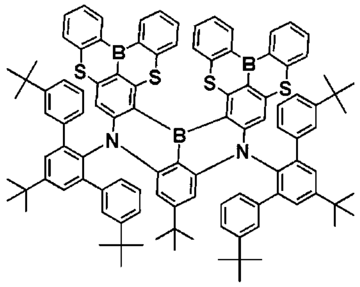

**80**

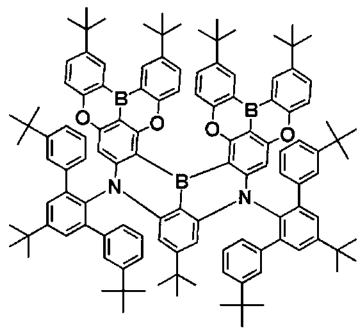

**81**

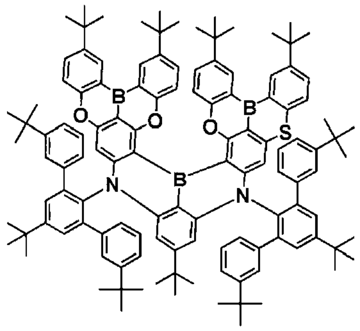

**82**

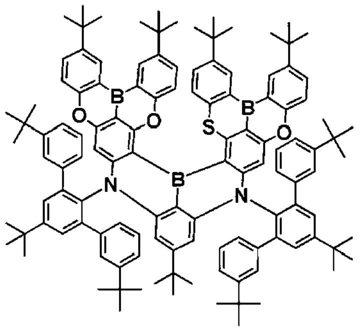

**83**

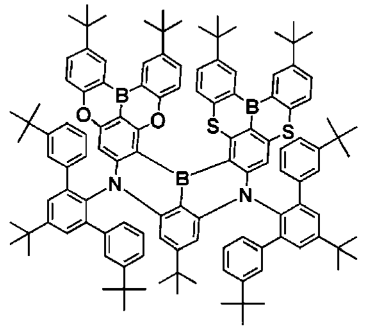

**84**

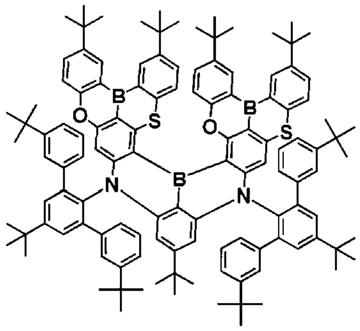

**85**

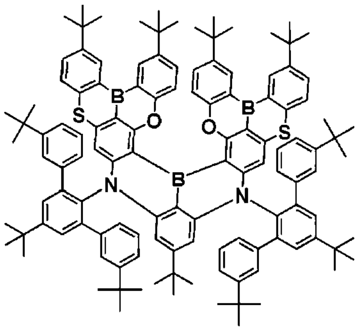

**86**

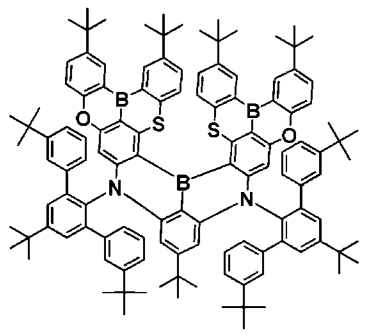

**87**

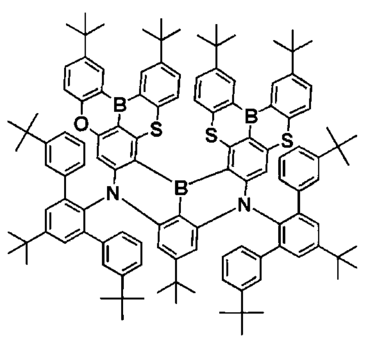

88

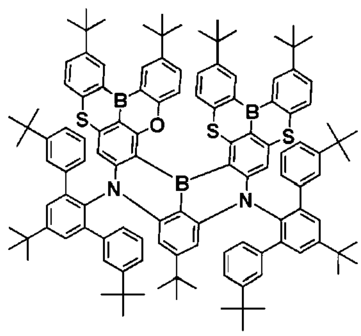

89

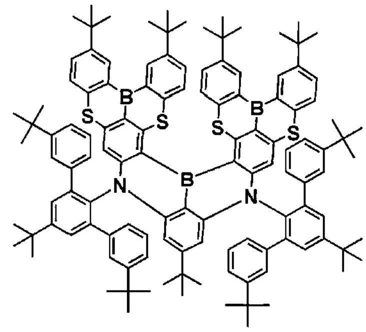

90

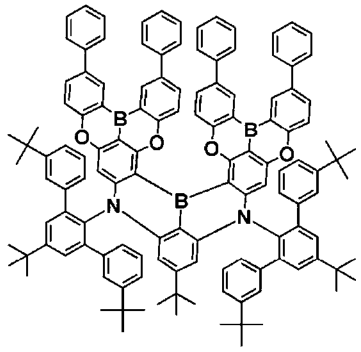

91

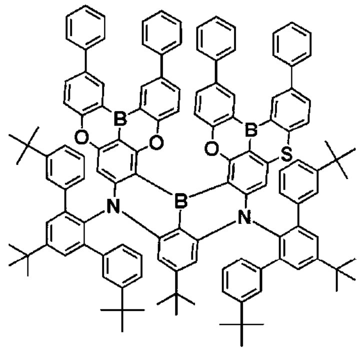

92

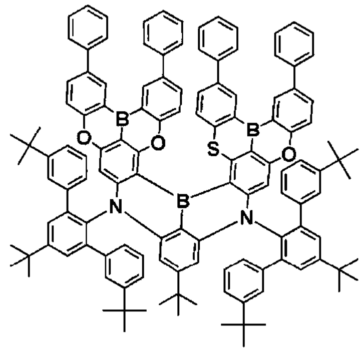

93

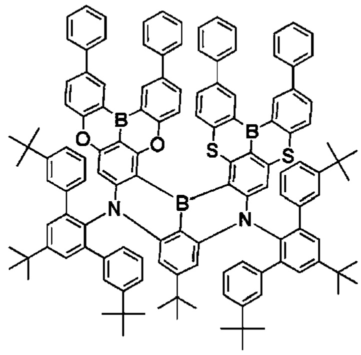

94

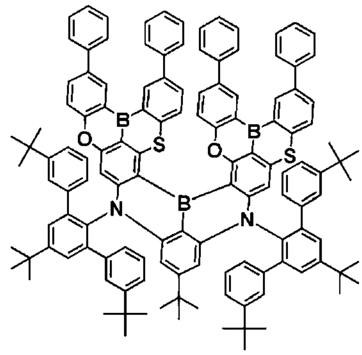

95

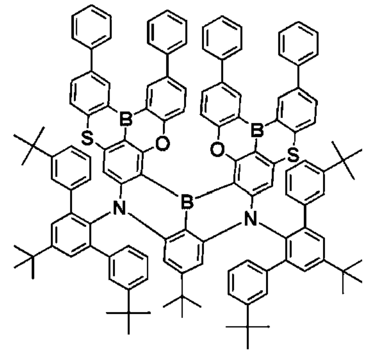

96

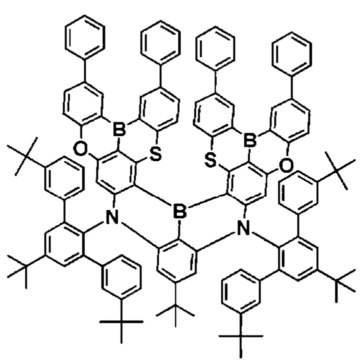

97

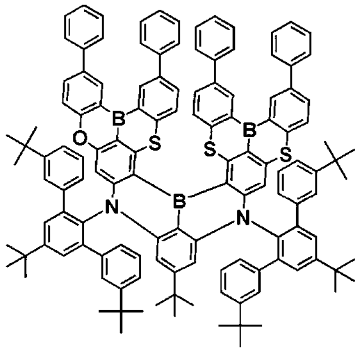

98

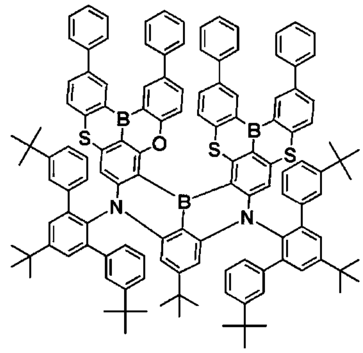

99

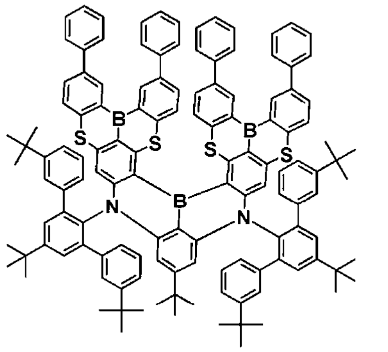

100

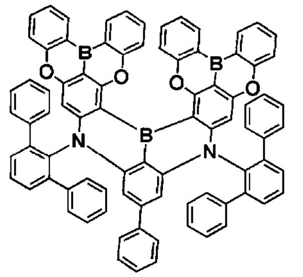

101

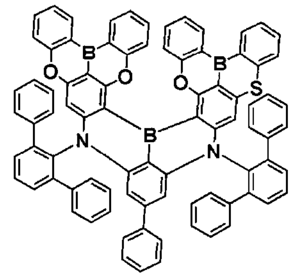

102

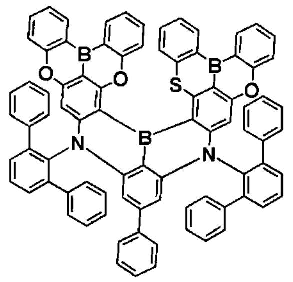

103

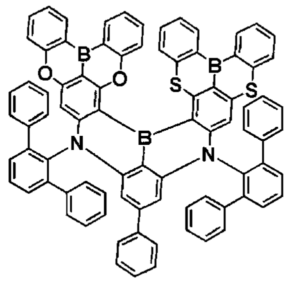

104

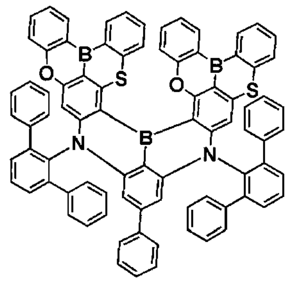

105

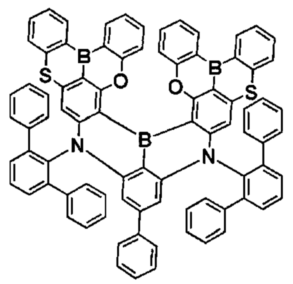

106

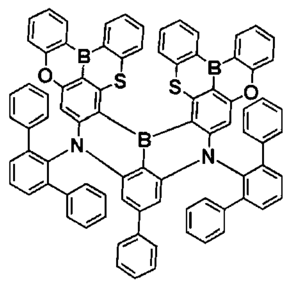

107

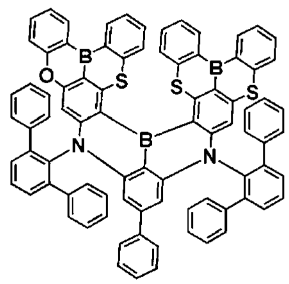

108

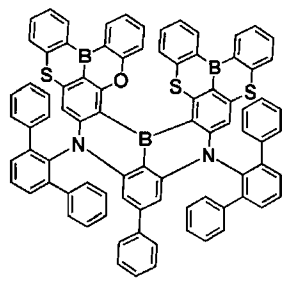

109

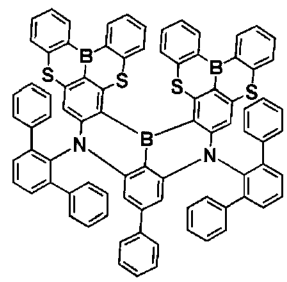

110

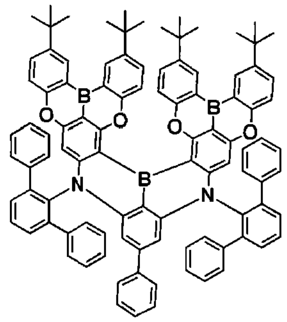

111

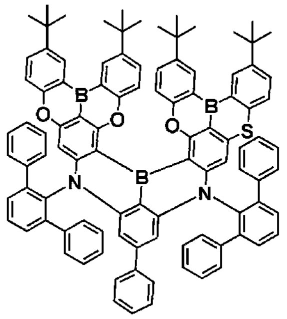

**112**

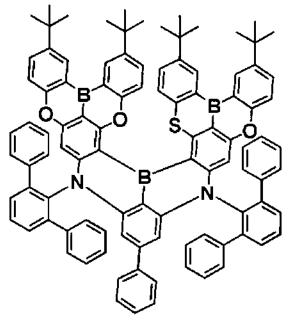

**113**

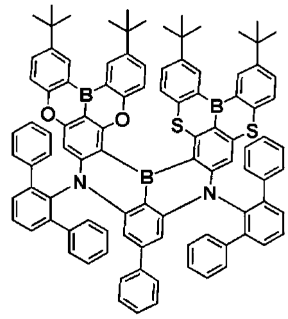

**114**

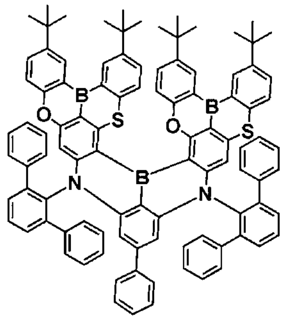

**115**

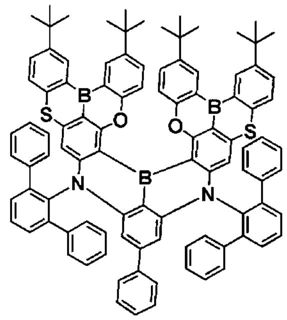

**116**

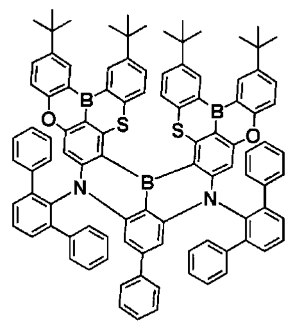

**117**

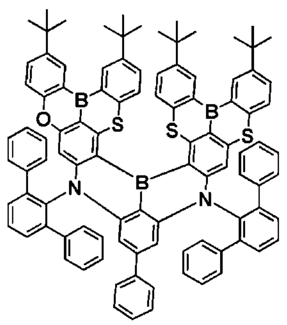

**118**

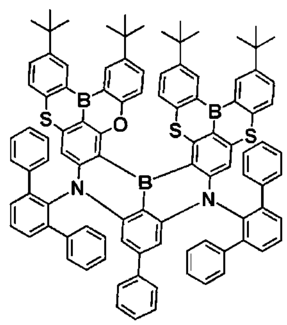

**119**

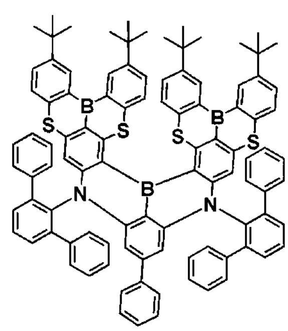

**120**

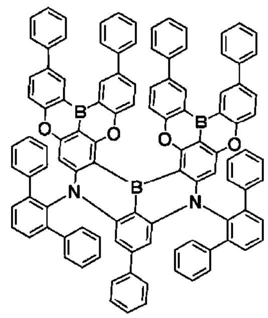

**121**

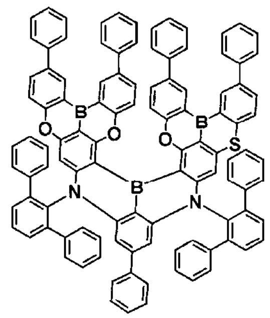

**122**

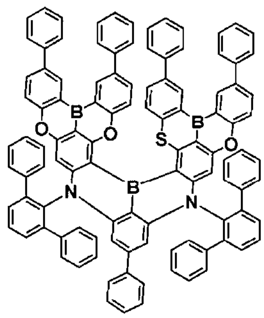

**123**

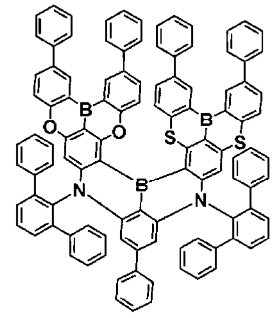

124

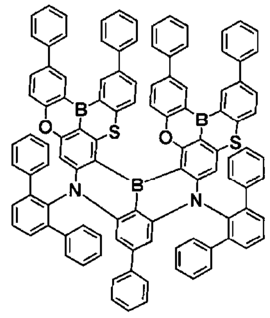

125

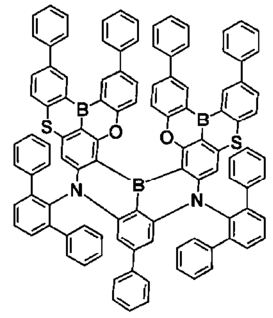

126

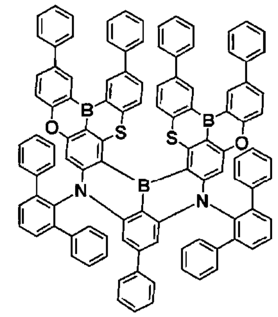

127

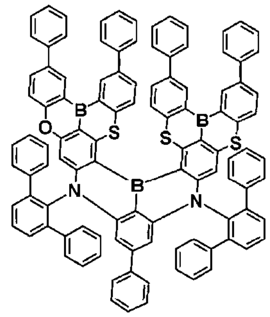

128

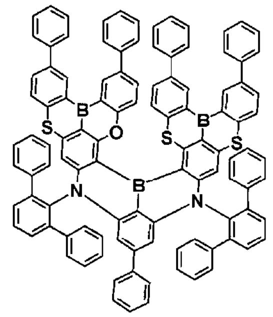

129

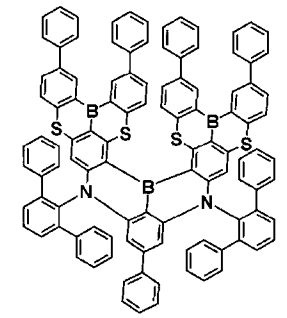

130

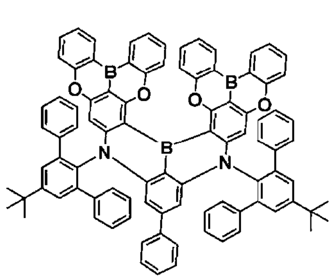

131

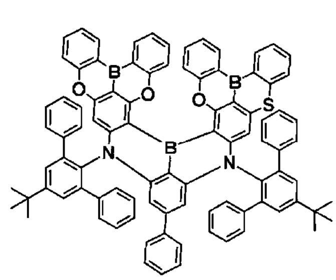

132

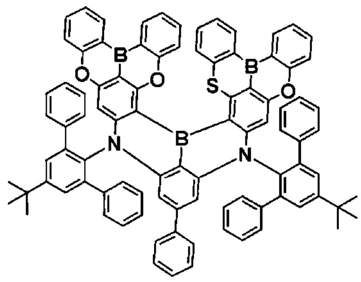

133

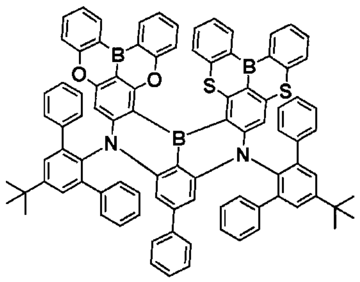

134

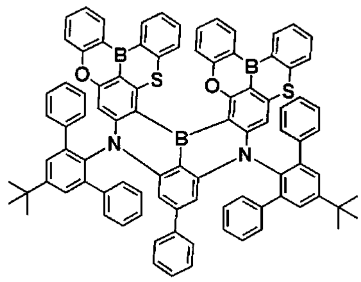

135

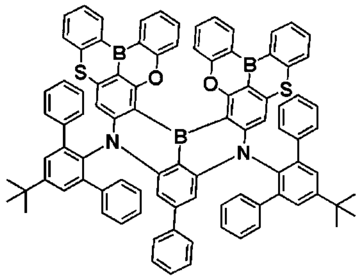

136

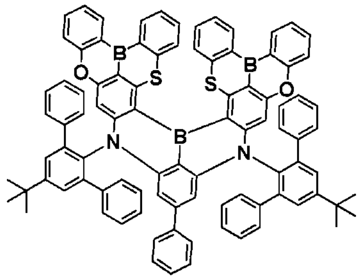

137

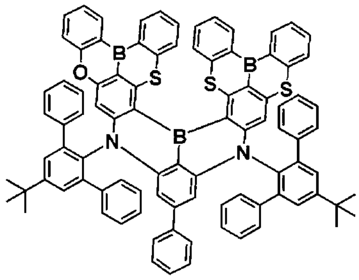

138

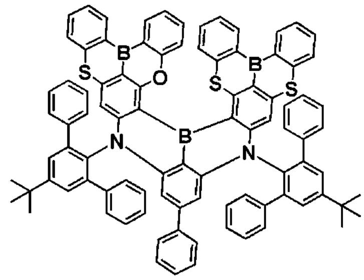

139

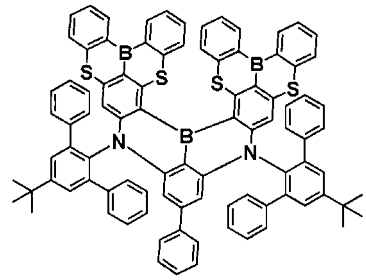

140

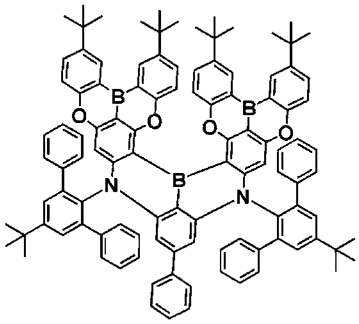

141

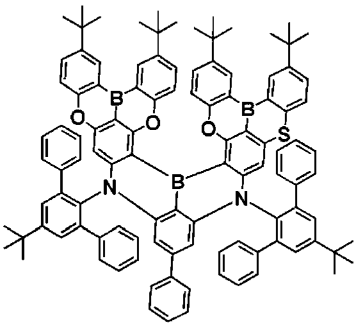

142

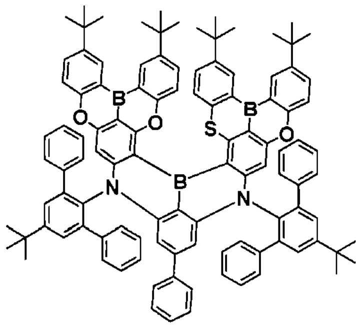

143

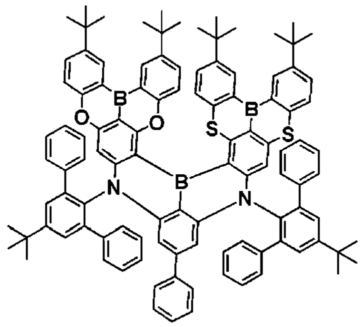

144

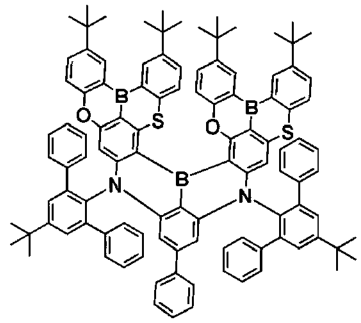

145

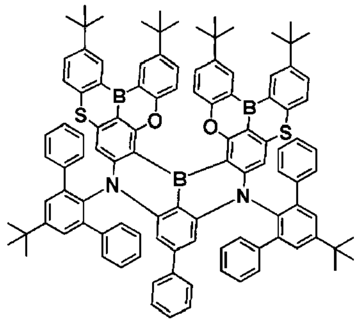

146

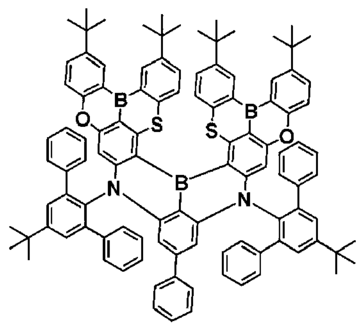

147

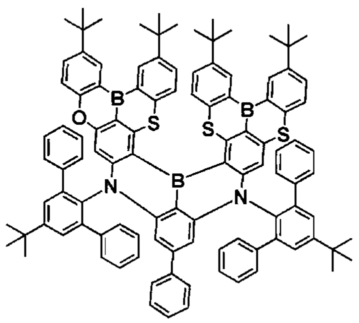

148

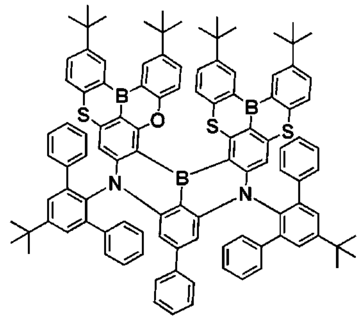

149

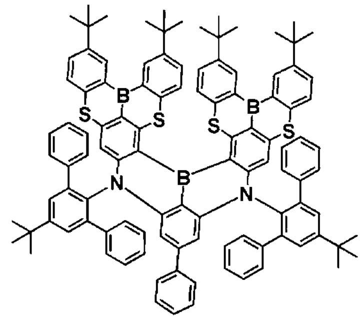

150

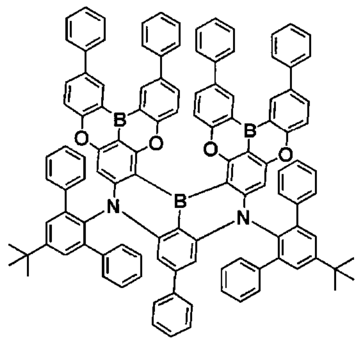

151

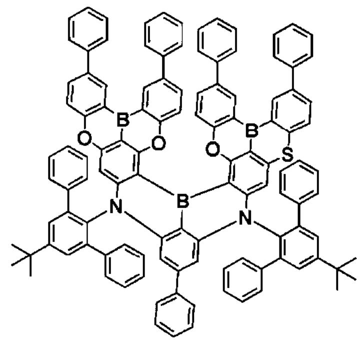

152

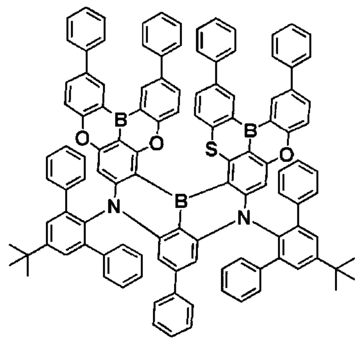

153

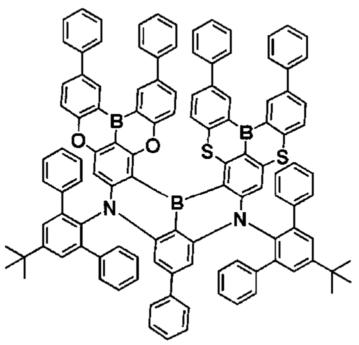

154

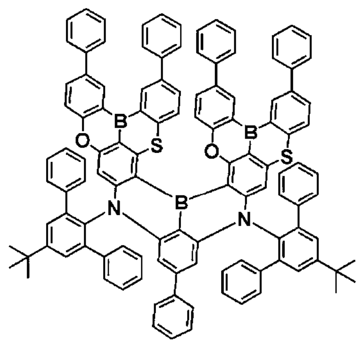

155

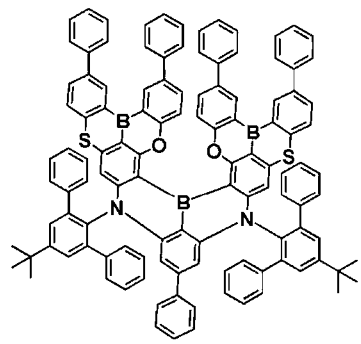

156

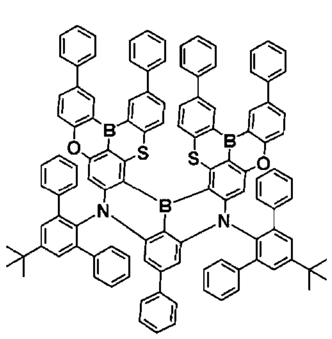

157

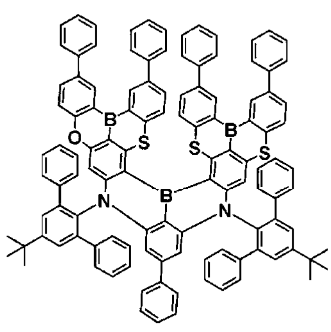

158

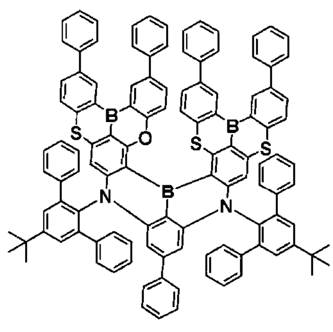

159

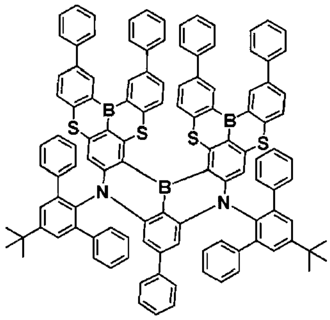

**160**

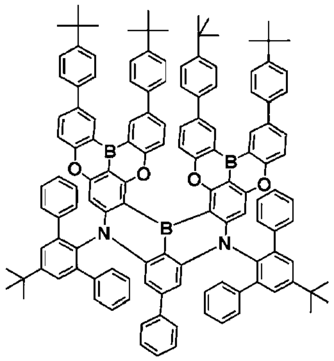

**161**

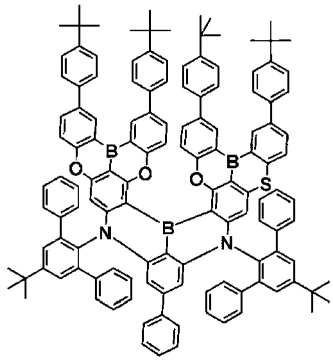

**162**

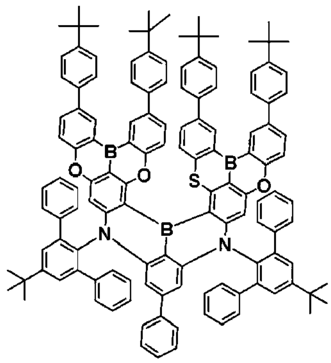

**163**

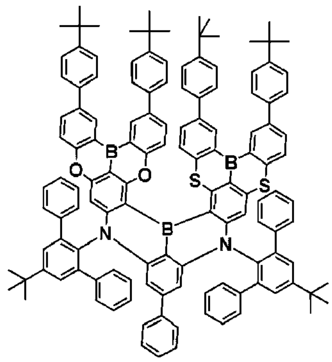

**164**

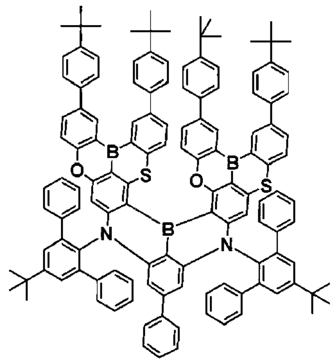

**165**

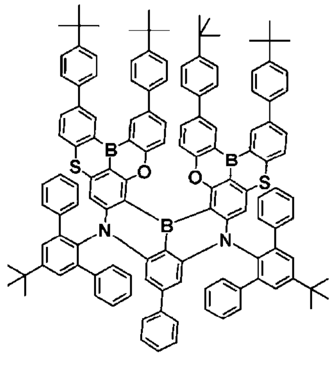

**166**

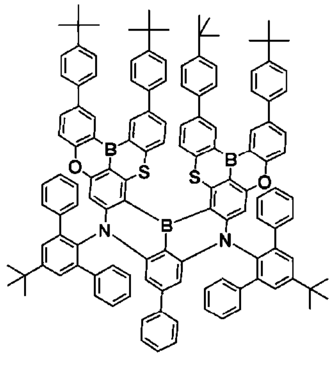

**167**

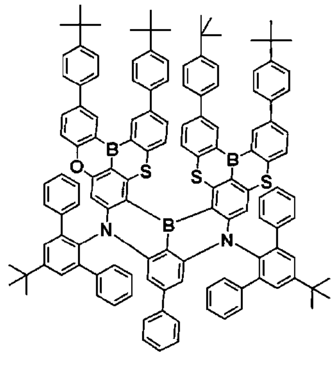

**168**

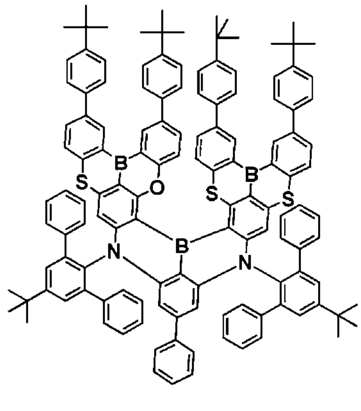

**169**

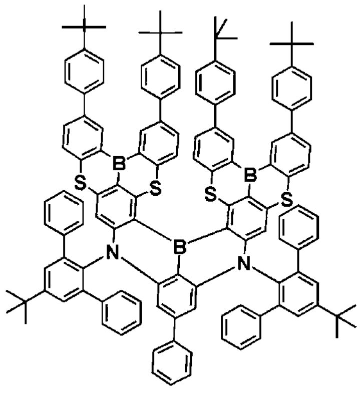

**170**

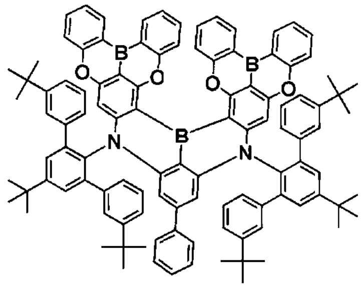

**171**

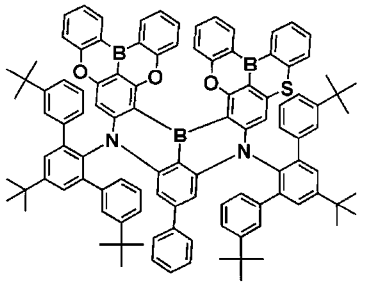

172

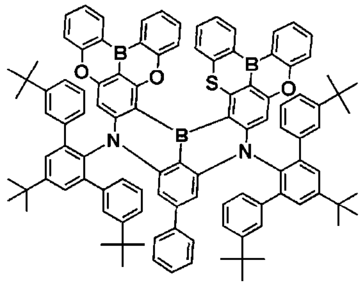

173

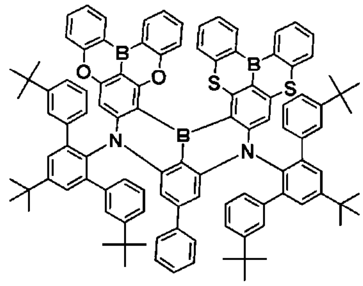

174

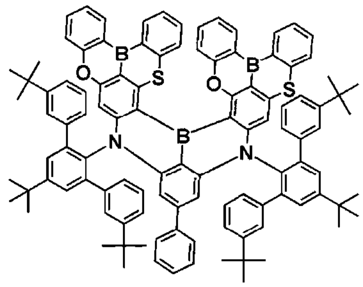

175

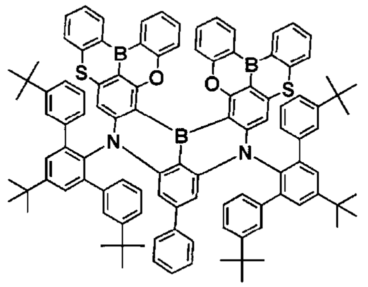

176

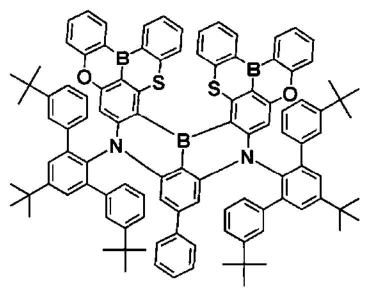

177

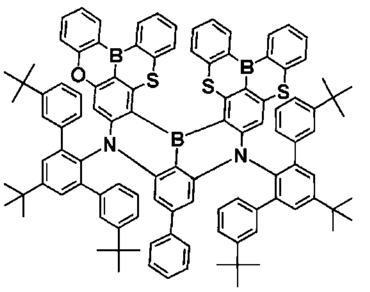

178

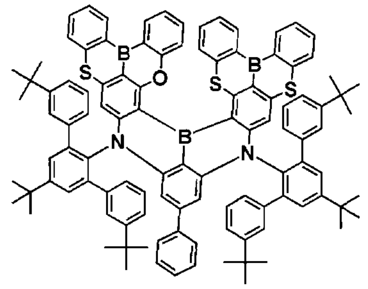

179

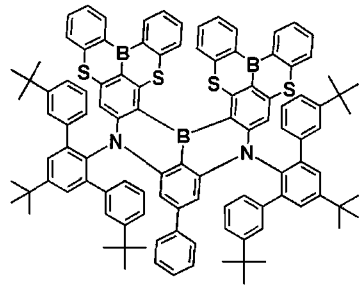

180

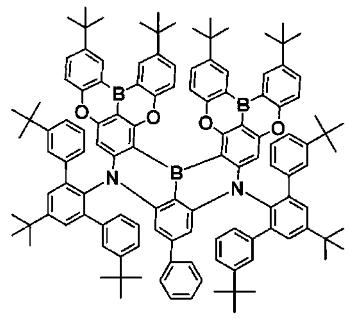

181

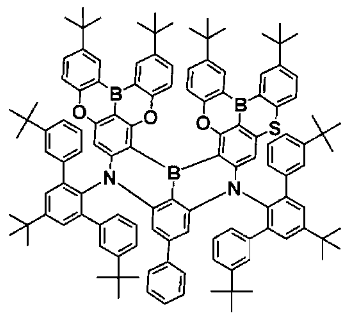

182

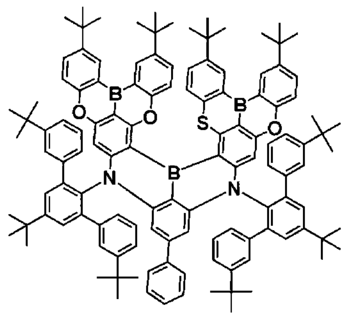

183

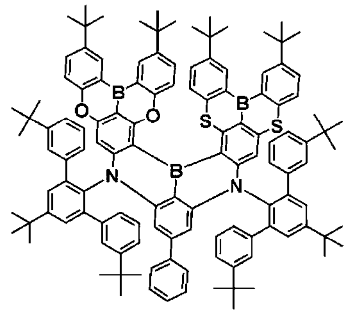

184

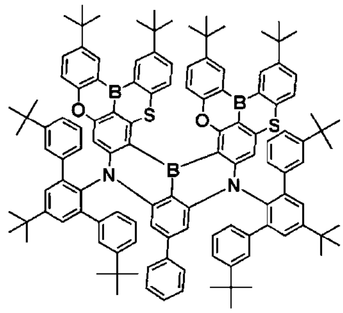

185

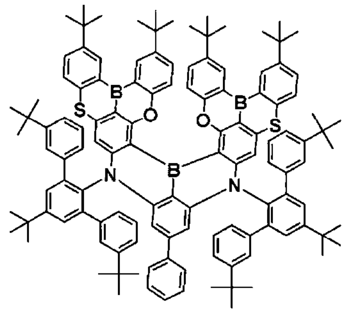

186

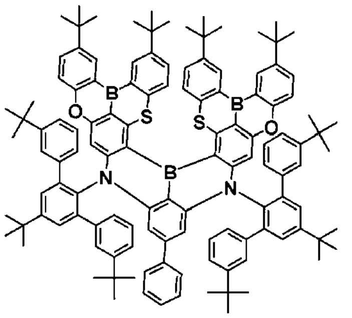

187

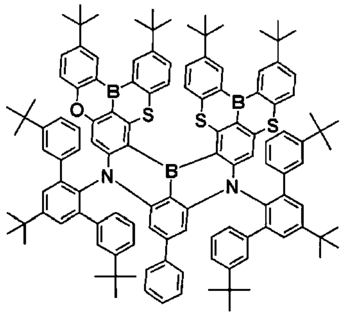

188

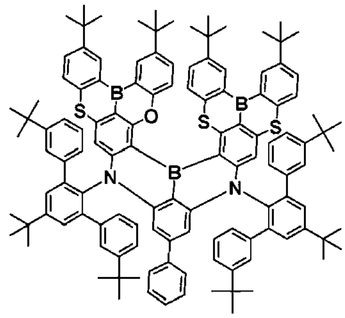

189

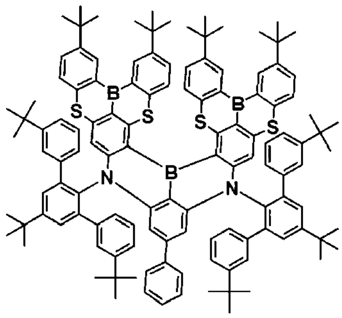

190

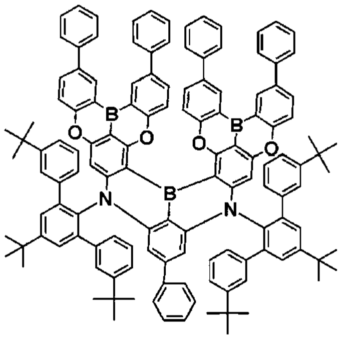

191

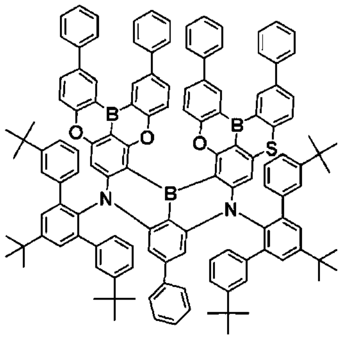

192

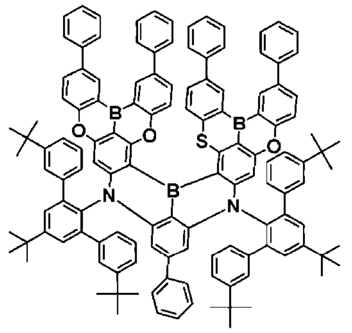

193

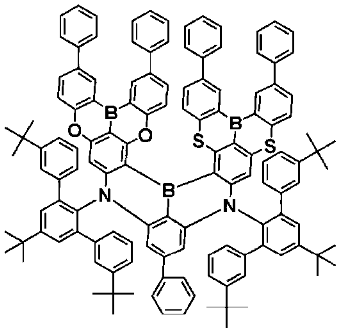

194

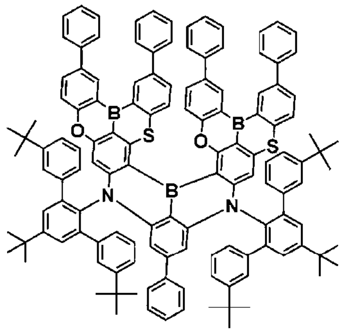

195

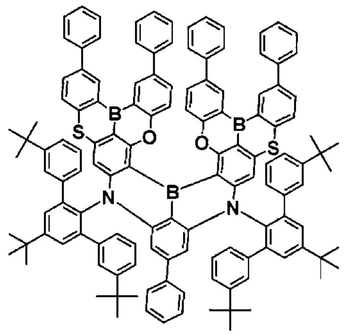

196

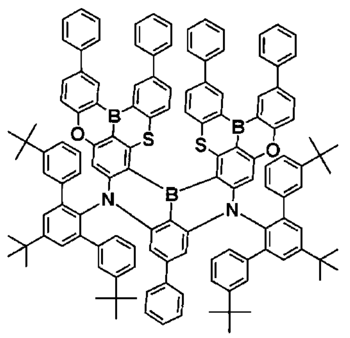

197

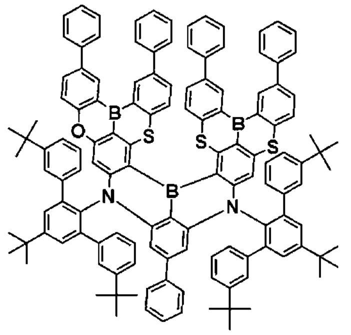

198

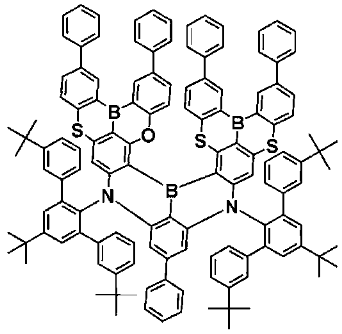

199

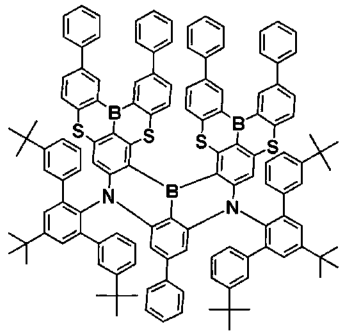

200

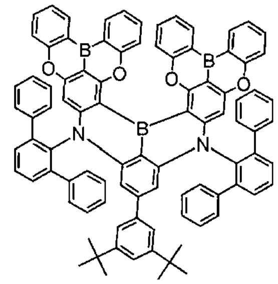

201

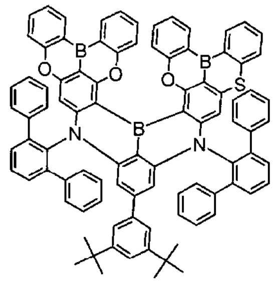

202

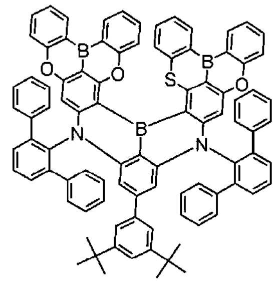

203

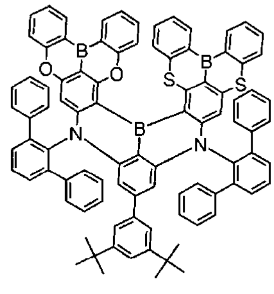

204

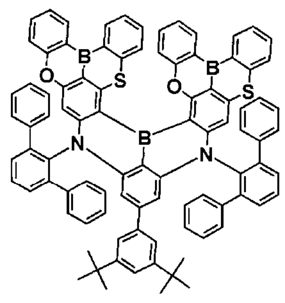

205

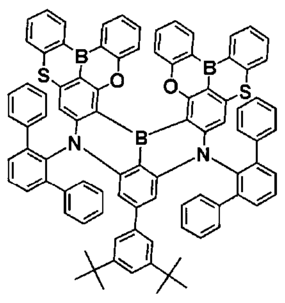

206

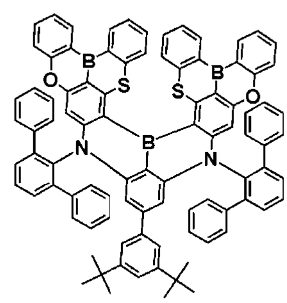

207

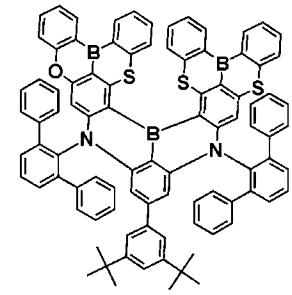

208

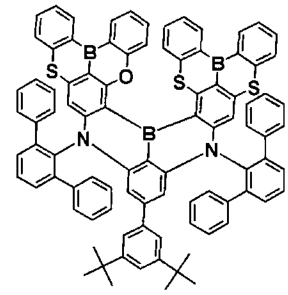

209

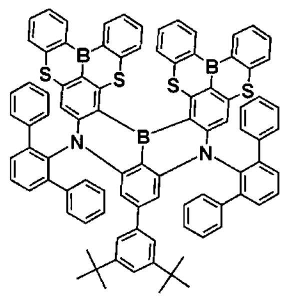

210

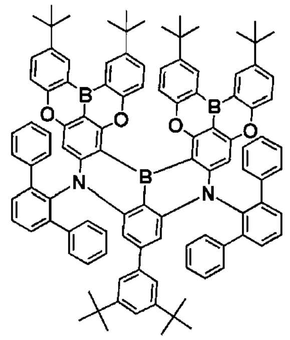

211

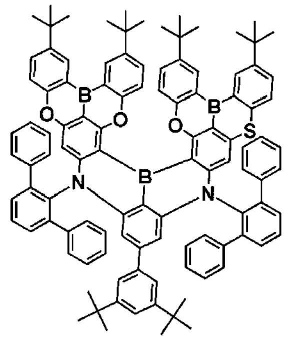

212

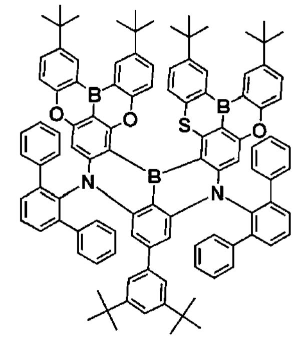

213

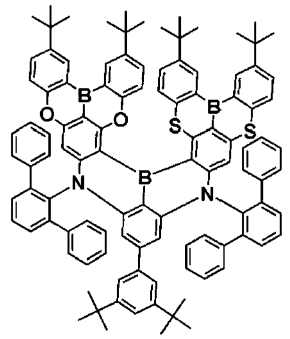

214

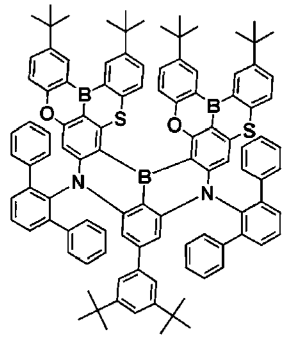

215

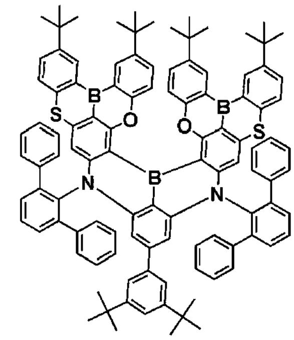

216

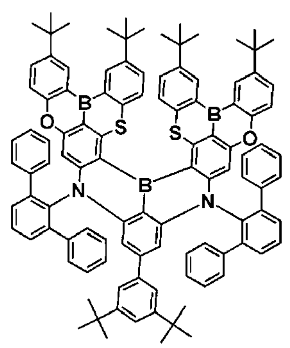

217

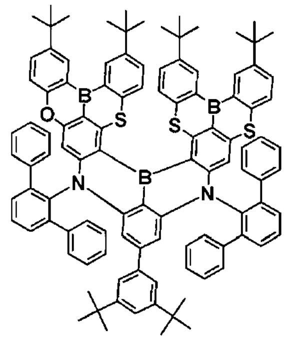

218

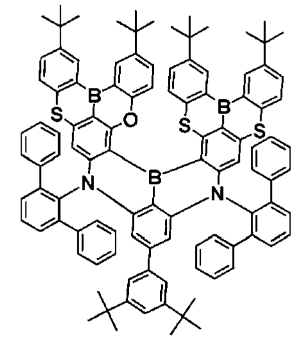

219

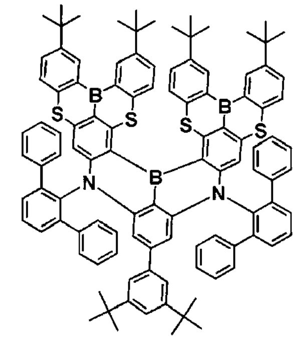

**220**

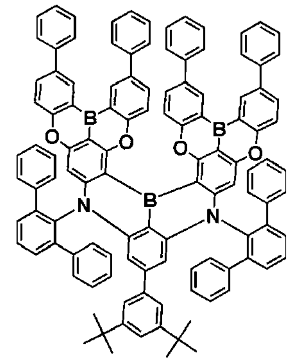

**221**

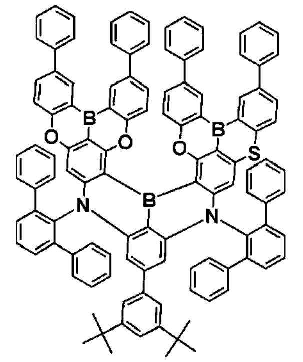

**222**

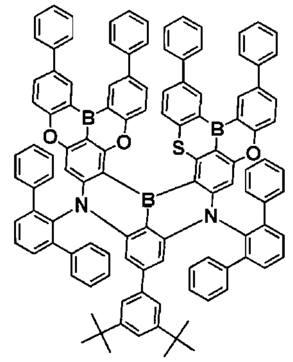

**223**

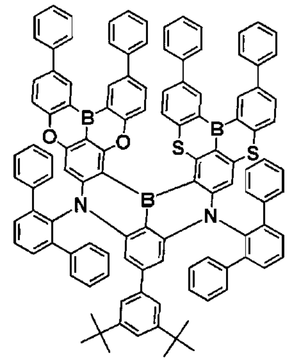

**224**

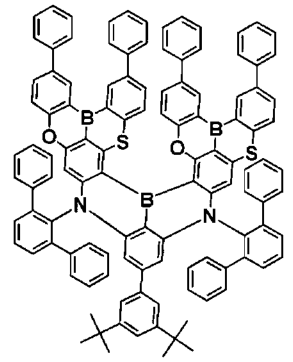

**225**

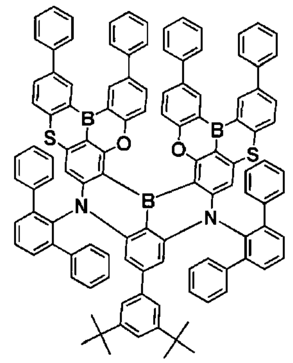

**226**

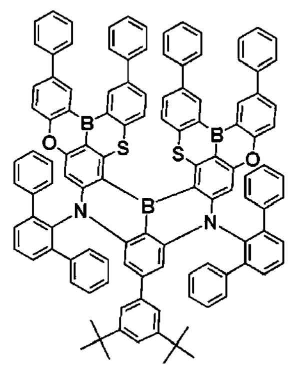

**227**

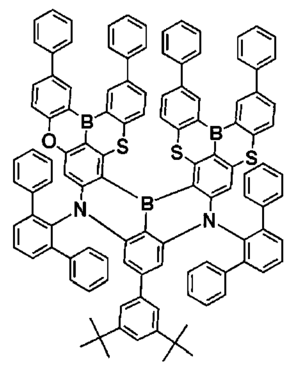

**228**

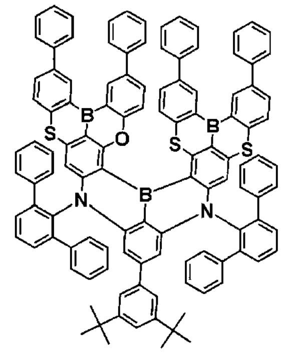

**229**

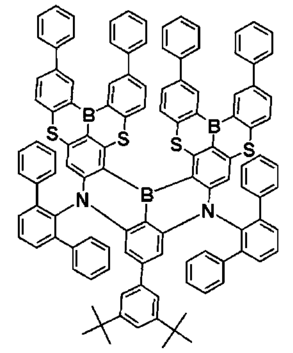

**230**

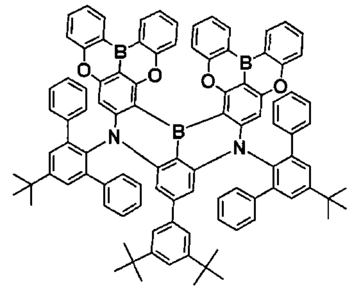

**231**

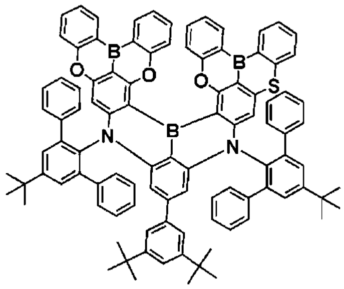

232

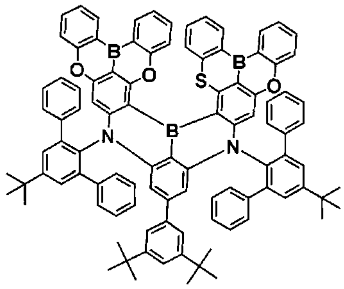

233

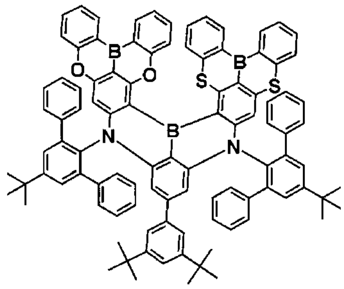

234

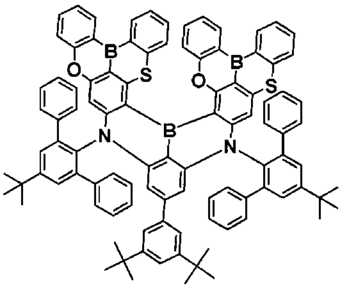

235

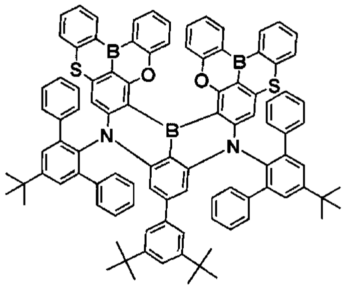

236

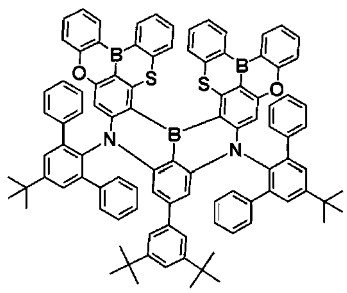

237

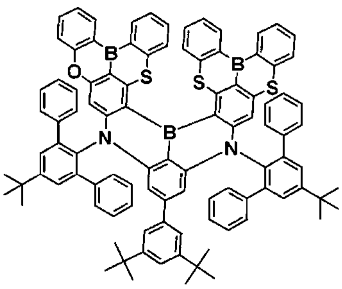

238

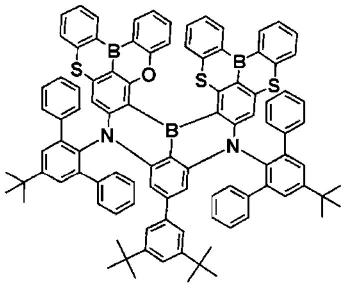

239

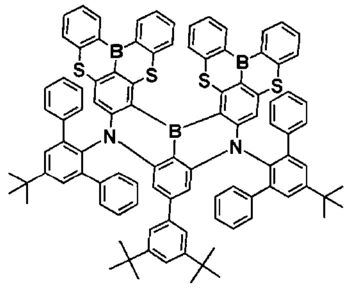

240

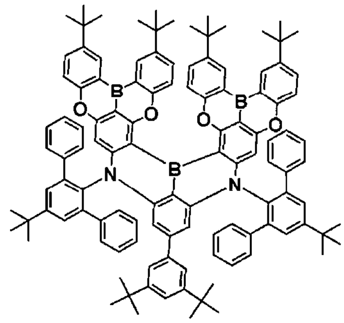

241

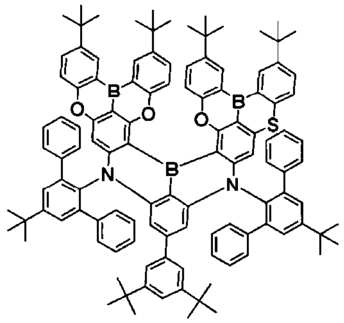

242

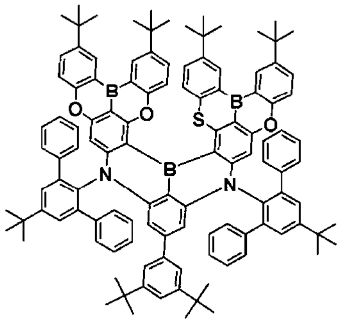

243

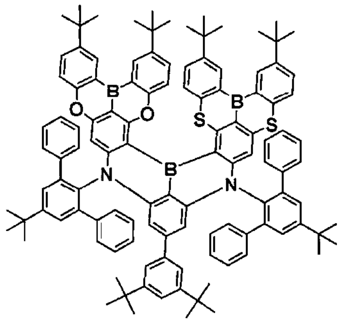

244

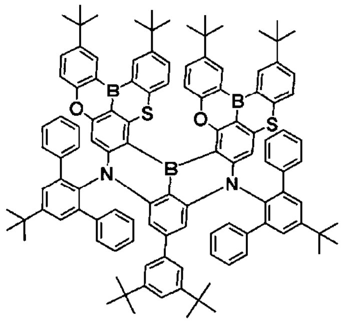

245

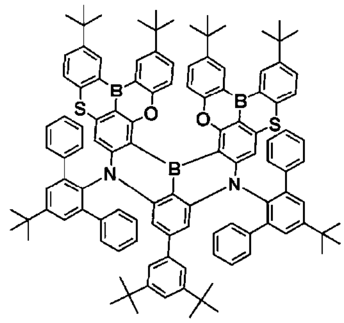

246

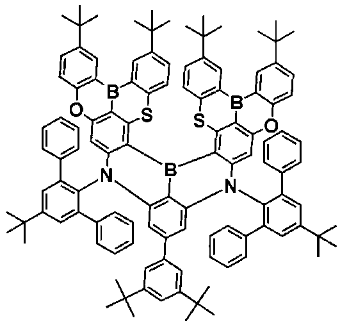

247

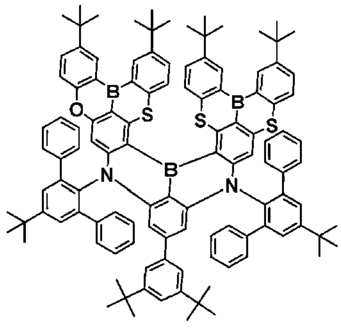

248

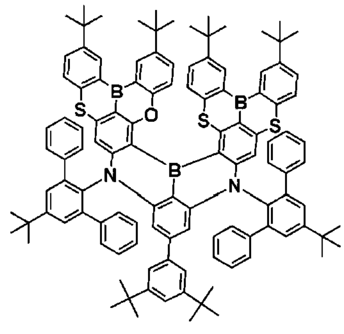

249

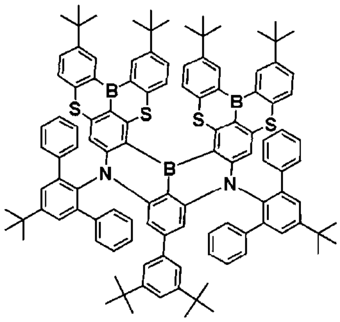

250

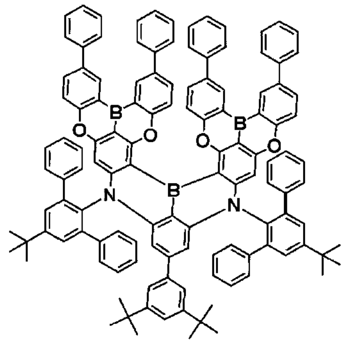

251

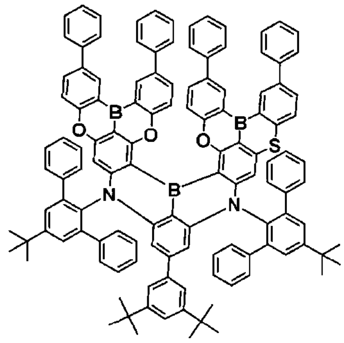

252

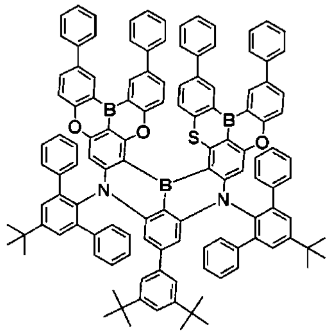

253

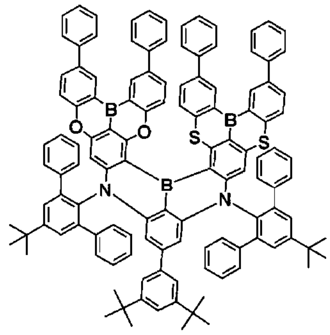

254

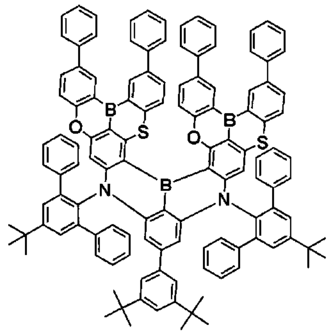

255

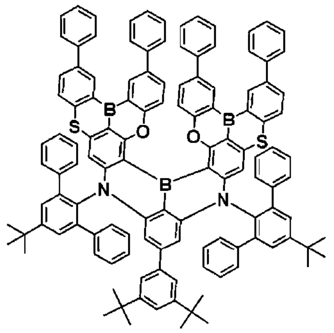

256

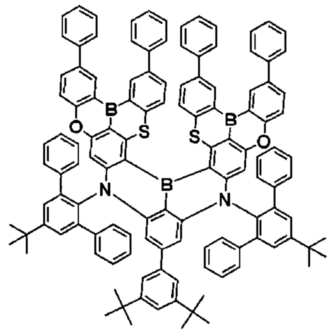

257

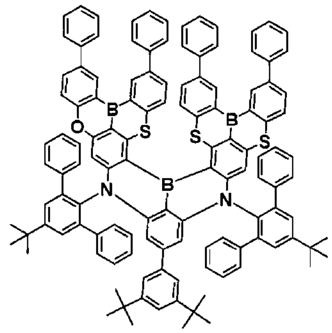

258

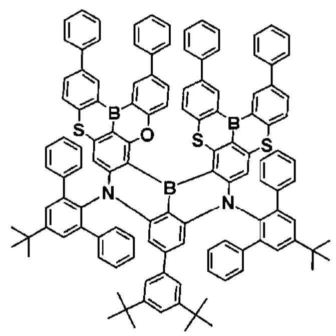

259

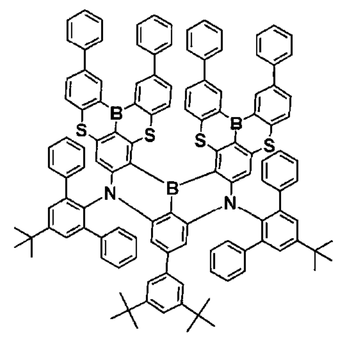

260

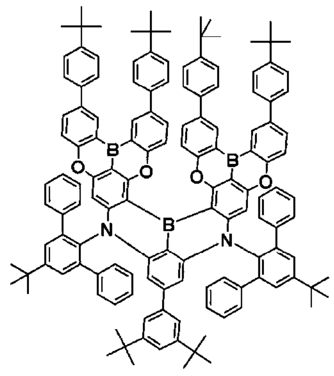

261

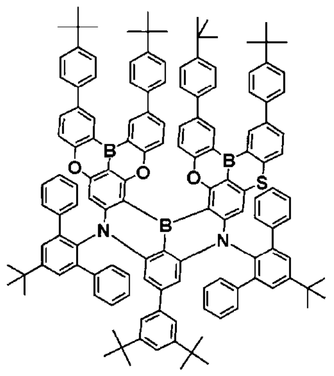

262

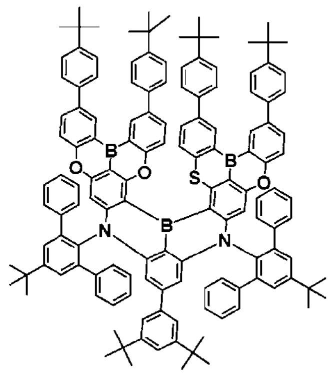

263

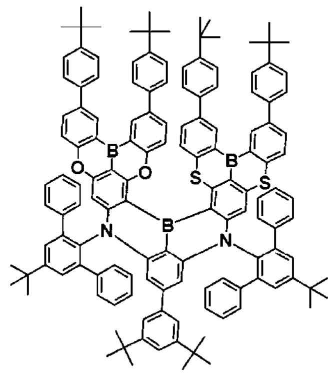

264

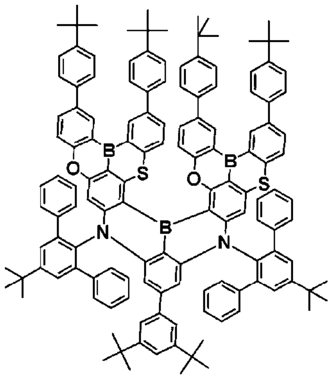

265

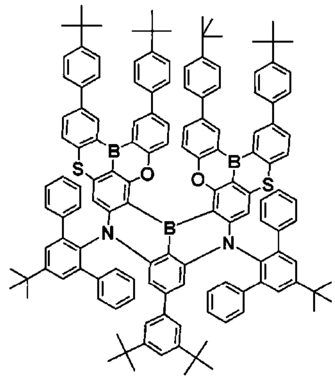

266

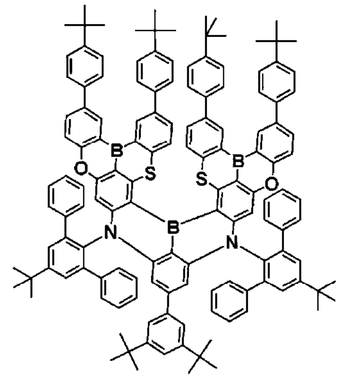

267

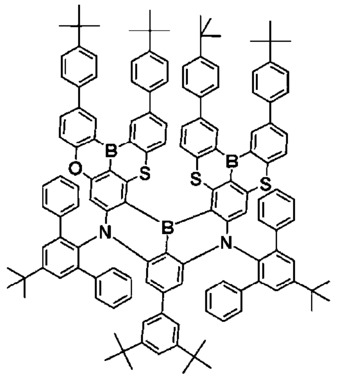

268

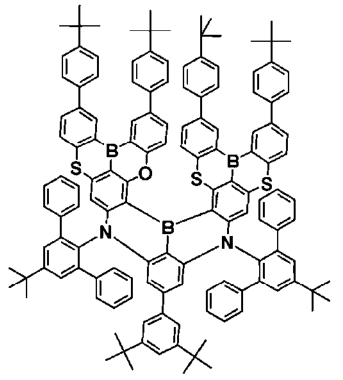

269

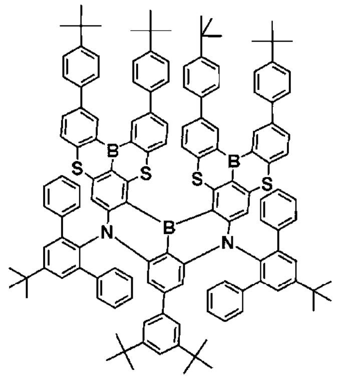

270

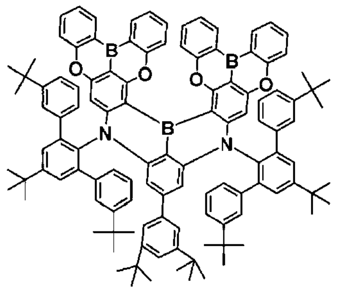

271

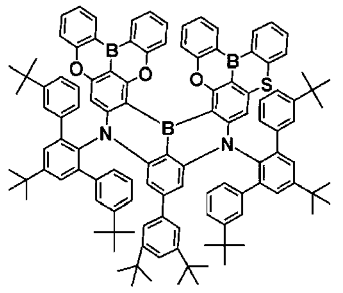

272

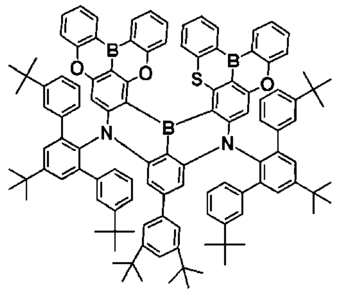

273

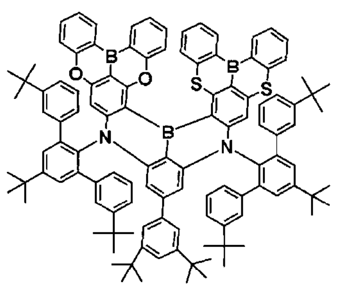

274

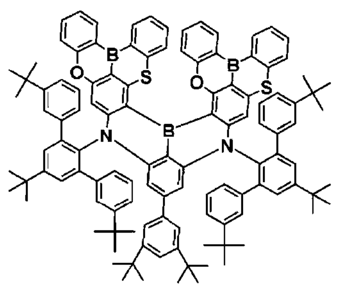

275

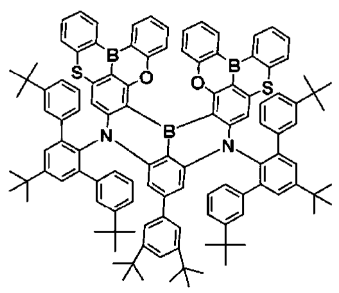

276

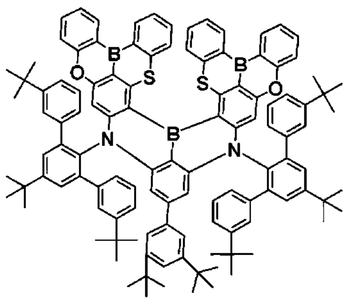

277

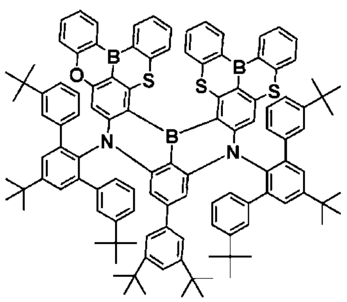

278

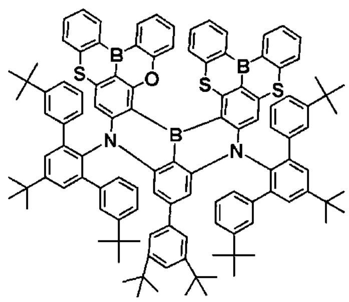

279

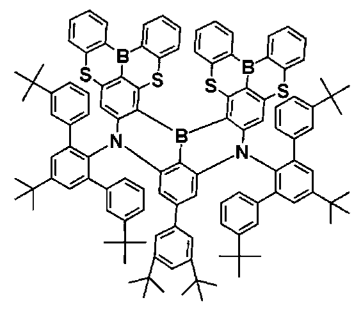

**280**

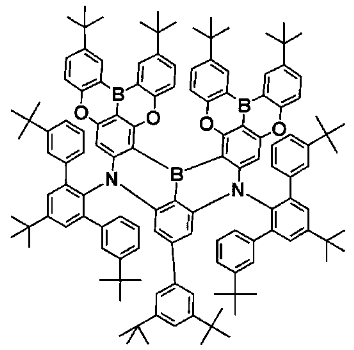

**281**

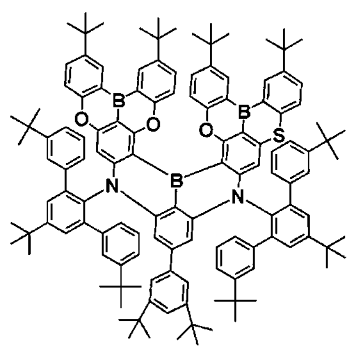

**282**

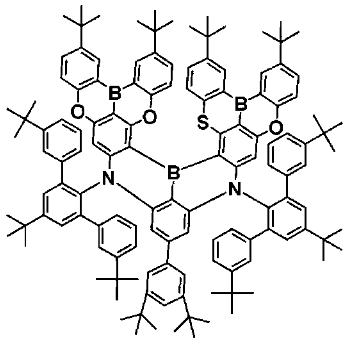

**283**

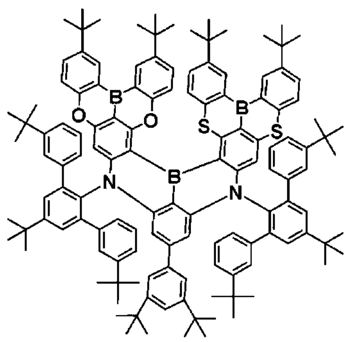

**284**

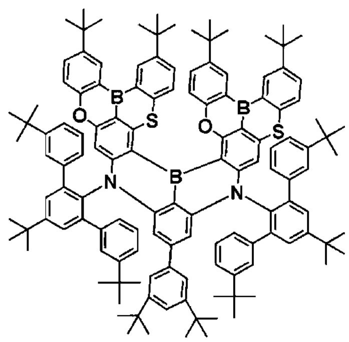

**285**

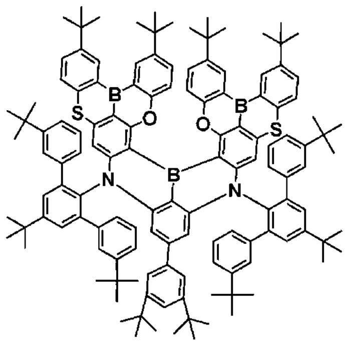

**286**

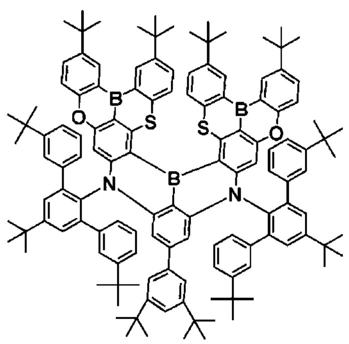

**287**

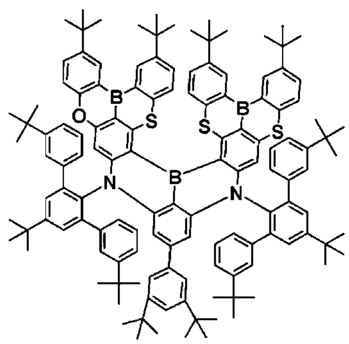

**288**

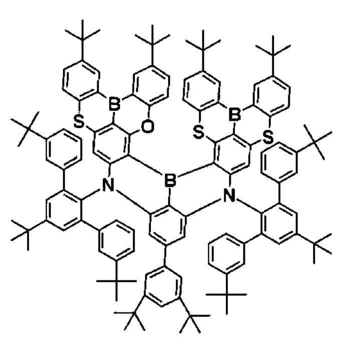

**289**

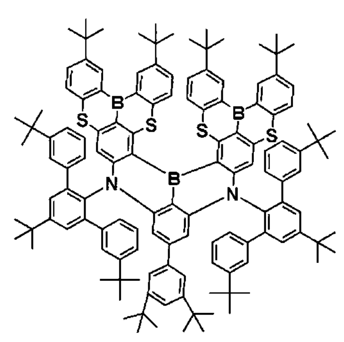

**290**

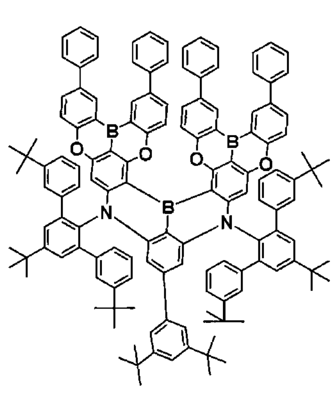

**291**

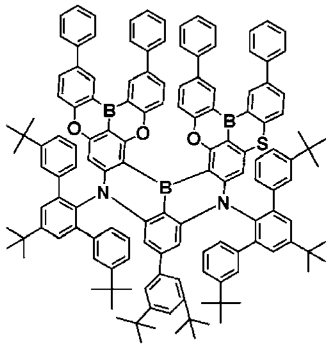

**292**

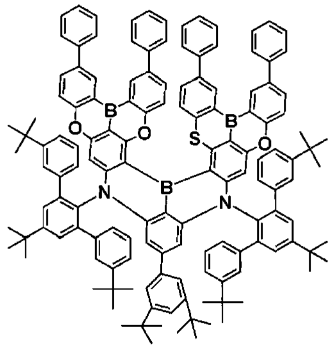

**293**

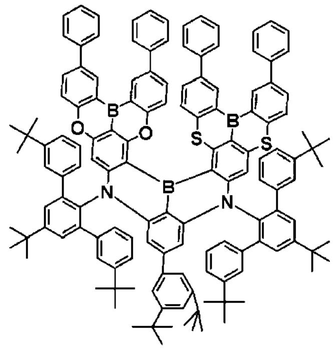

**294**

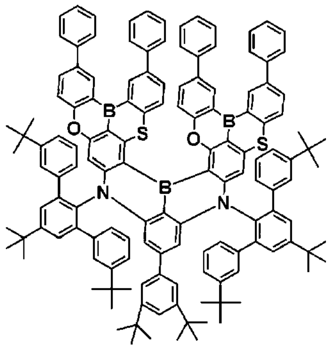

**295**

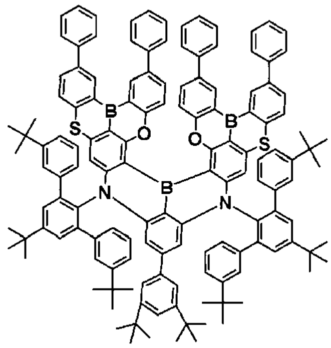

**296**

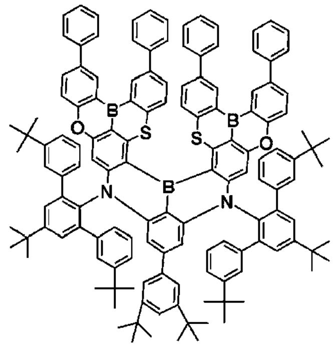

**297**

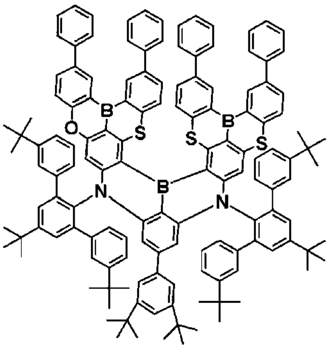

**298**

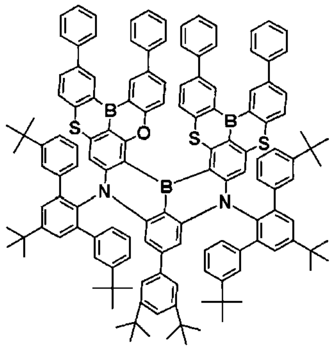

**299**

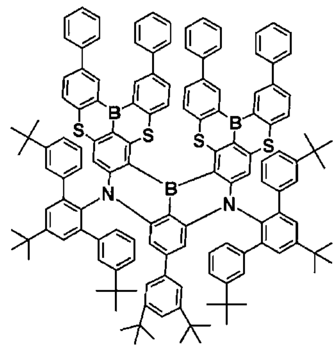

**300**

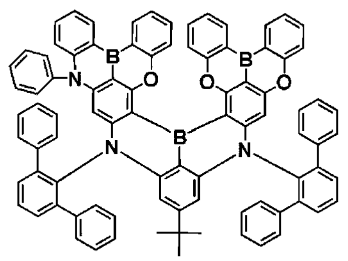

**301**

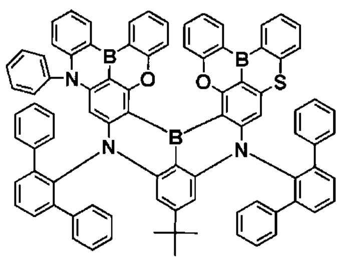

**302**

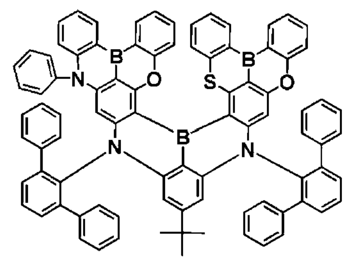

**303**

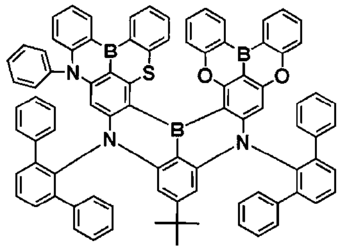

304

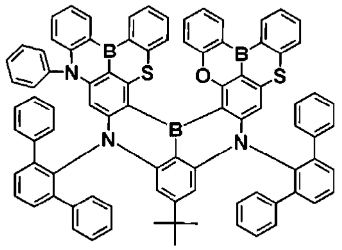

305

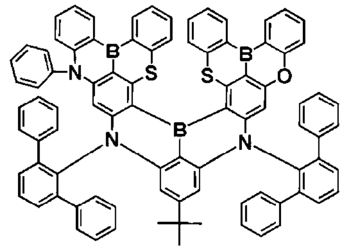

306

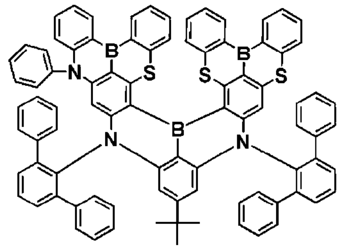

307

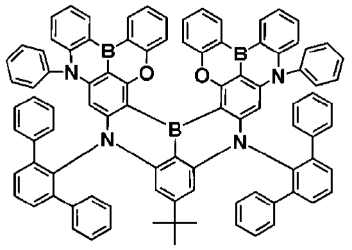

308

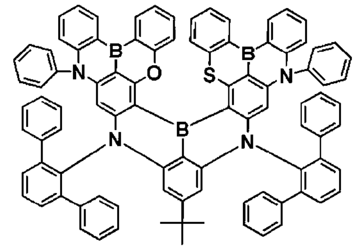

309

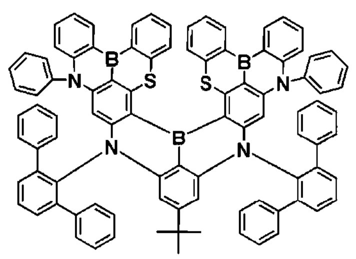

310

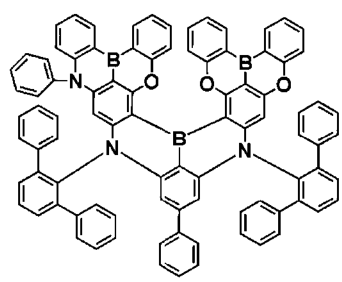

311

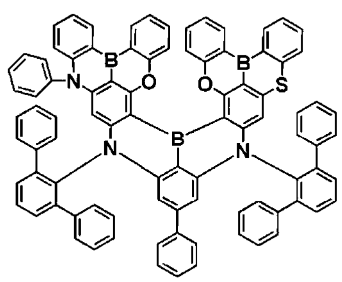

312

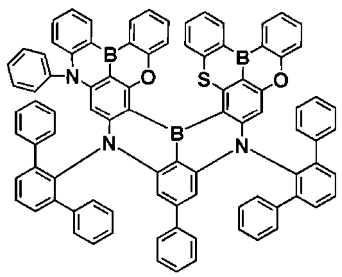

313

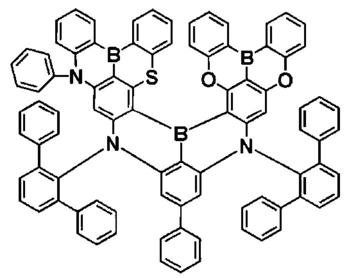

314

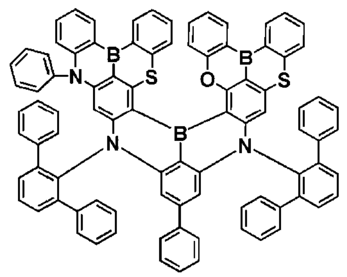

315

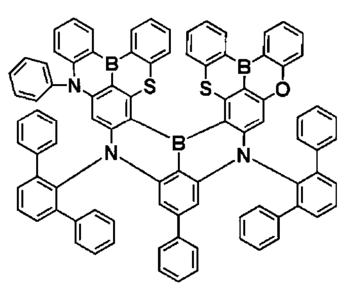

316

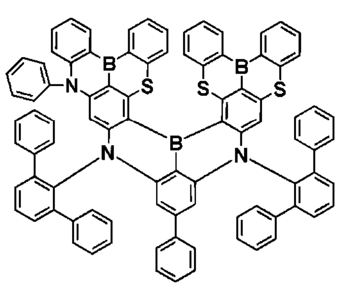

317

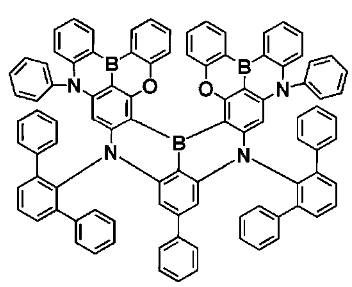

318

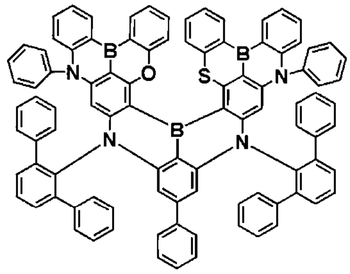

319

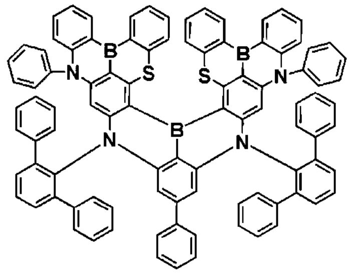

320

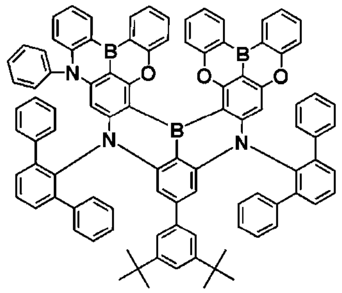

321

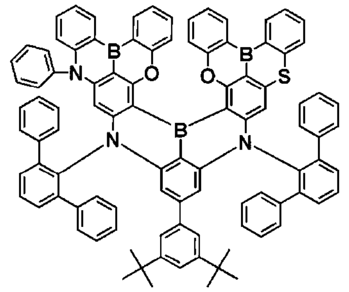

322

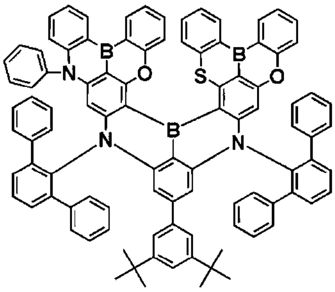

323

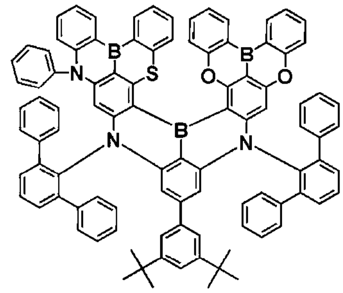

324

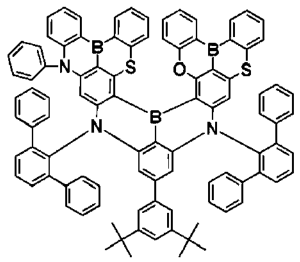

325

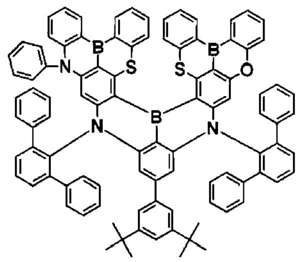

326

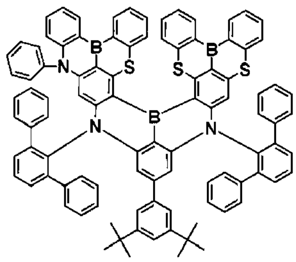

327

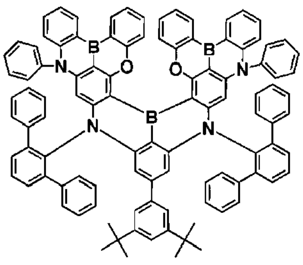

328

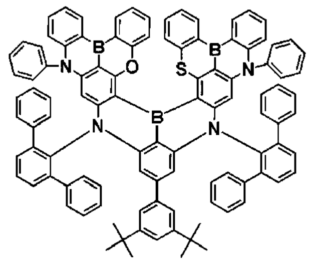

329

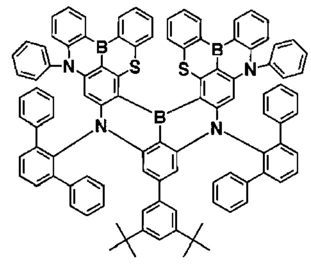

330

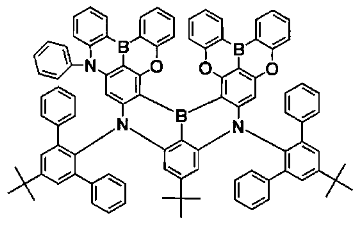

331

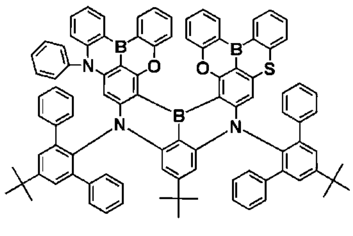

332

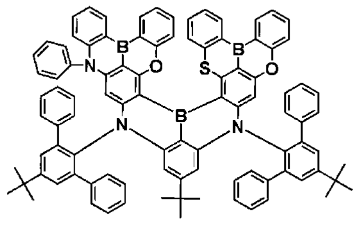

333

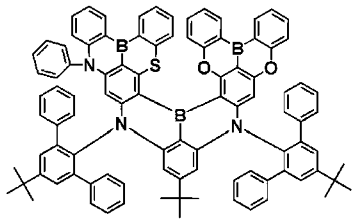

334

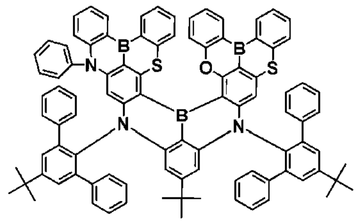

335

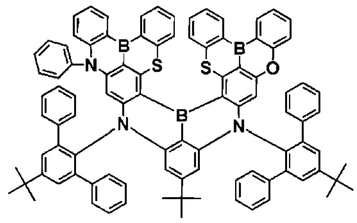

336

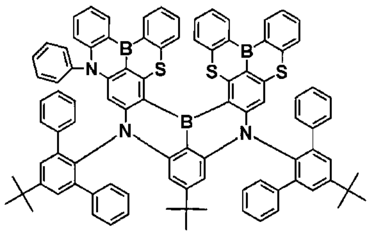

337

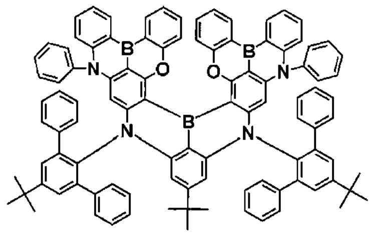

338

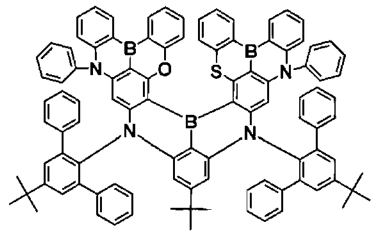

339

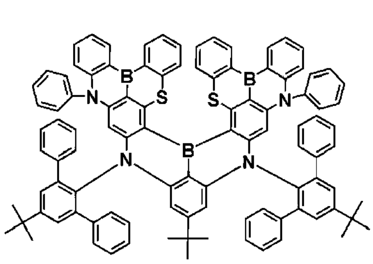

340

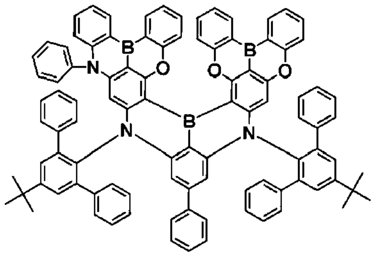

341

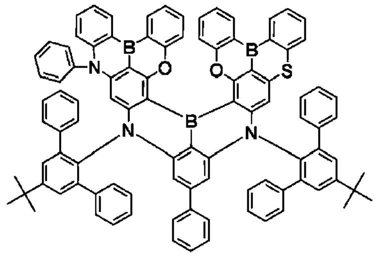

342

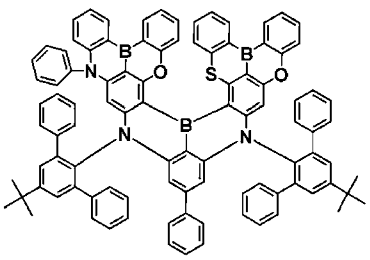

343

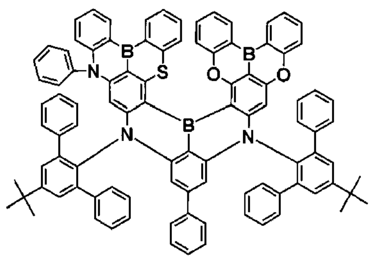

344

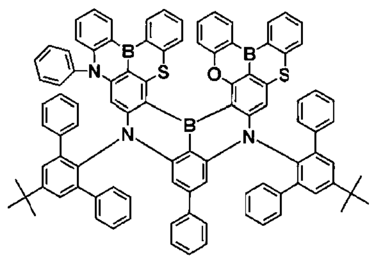

345

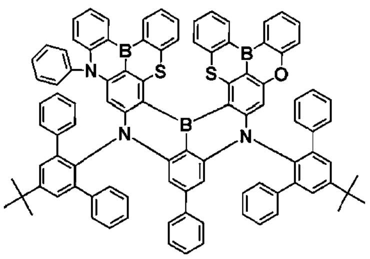

346

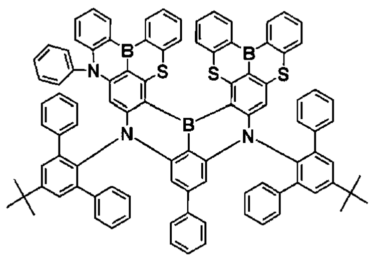

347

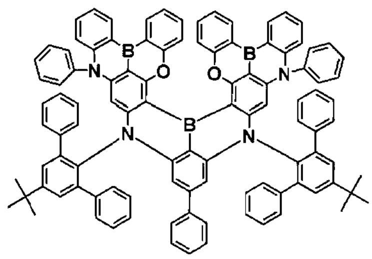

348

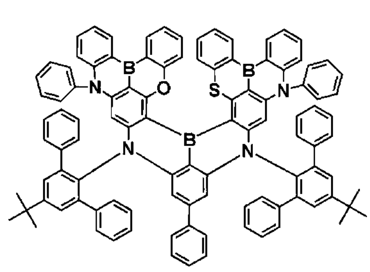

349

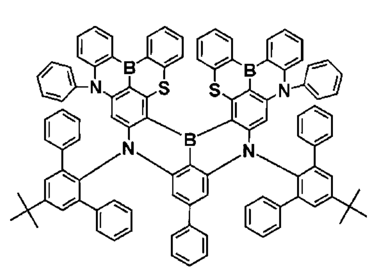

350

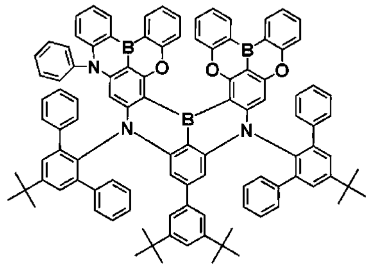

351

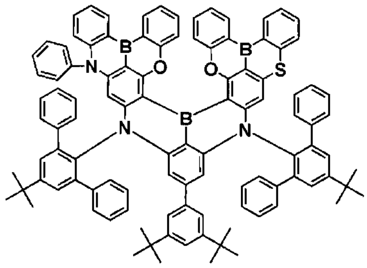

352

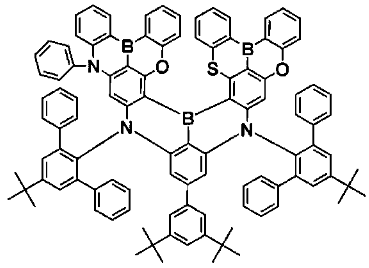

353

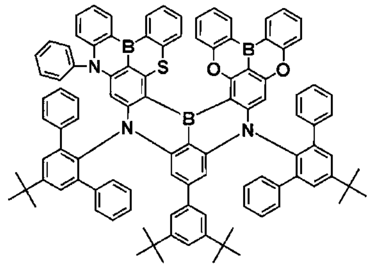

354

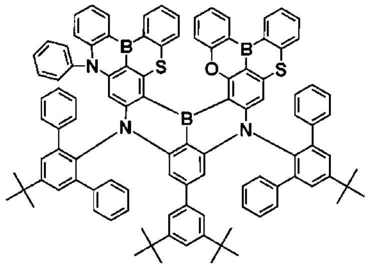

355

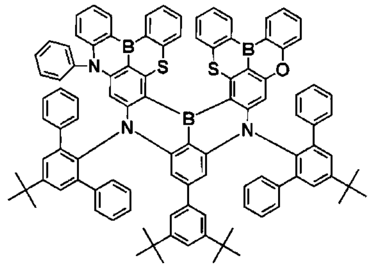

356

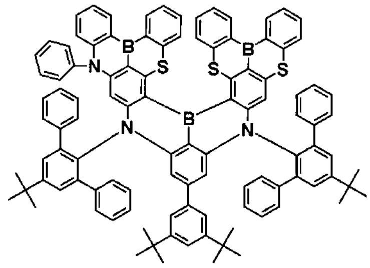

357

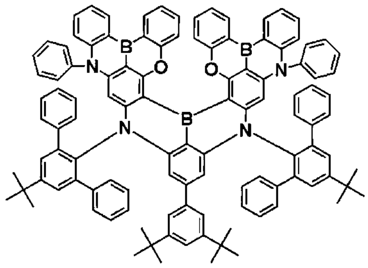

358

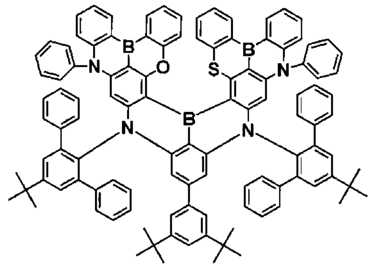

359

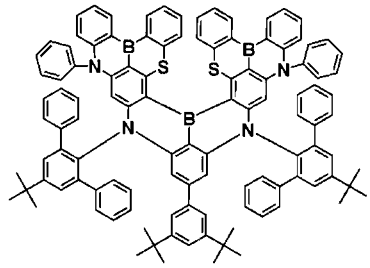

360

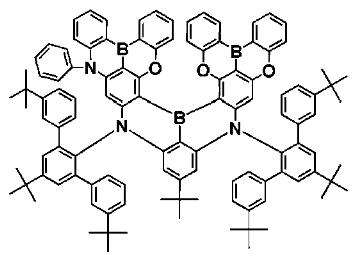

361

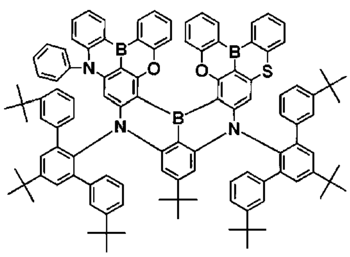

362

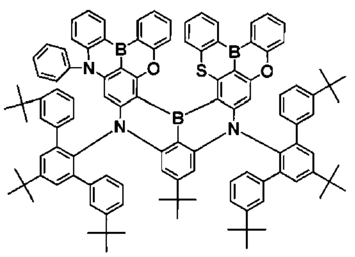

363

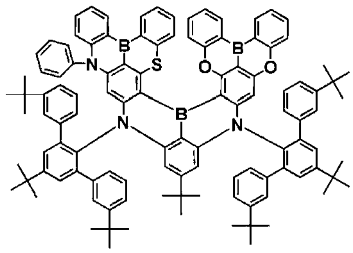

364

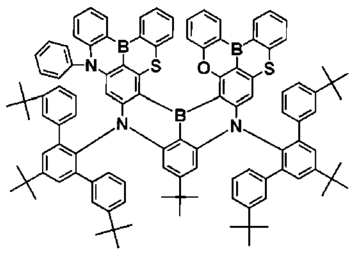

365

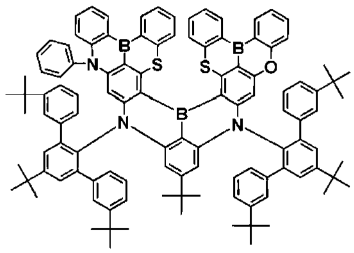

366

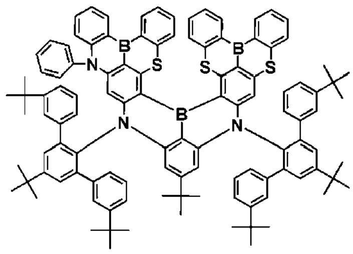

367

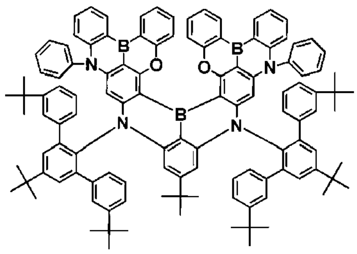

368

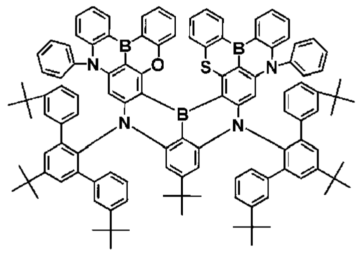

369

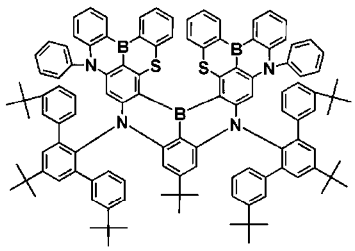

370

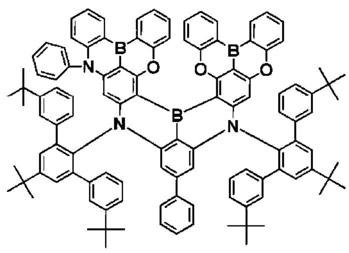

371

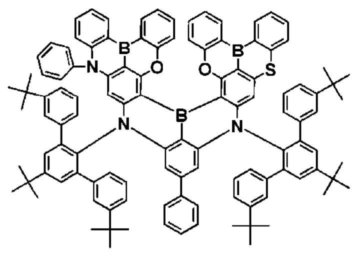

372

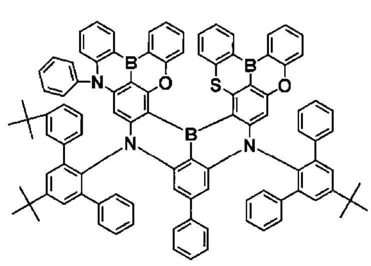

373

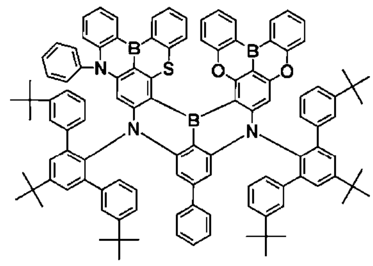

374

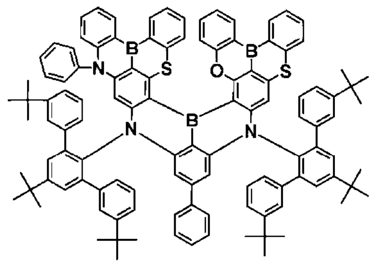

375

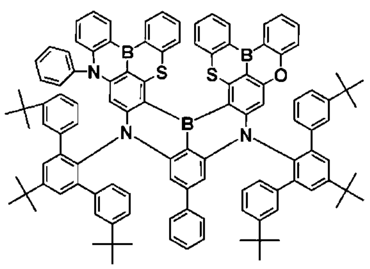

376

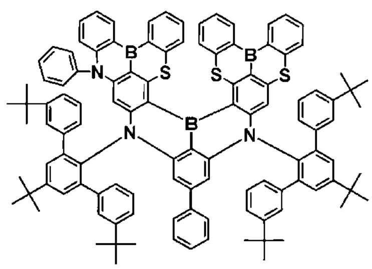

377

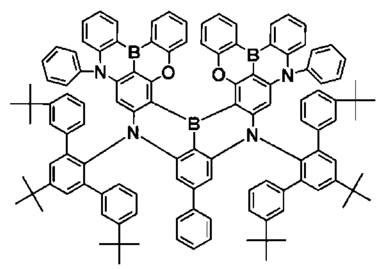

378

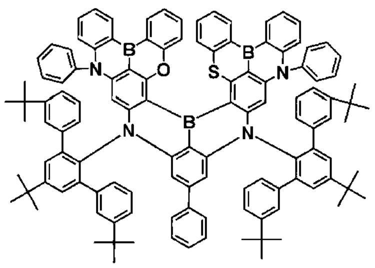

379

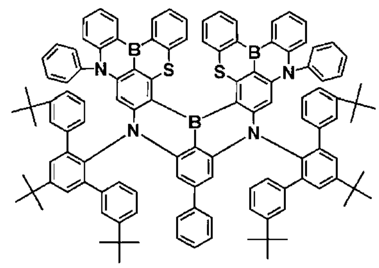

380

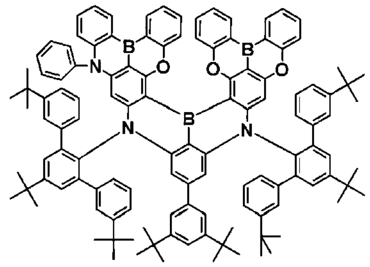

381

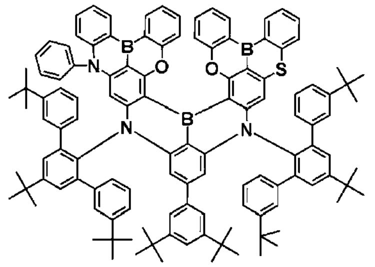

382

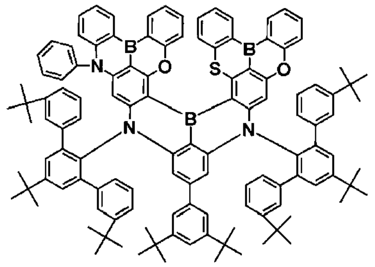

383

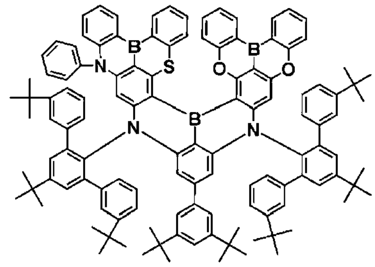

384

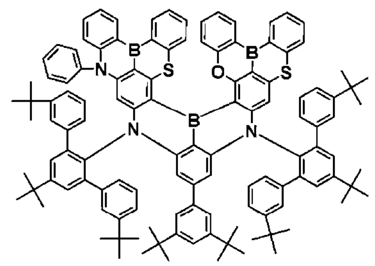

385

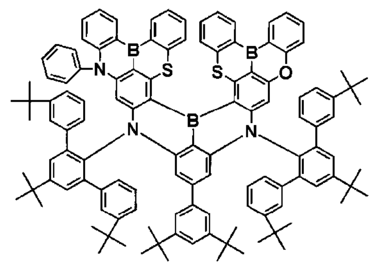

386

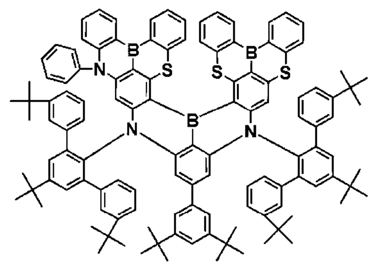

387

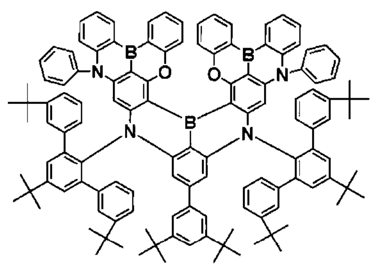

388

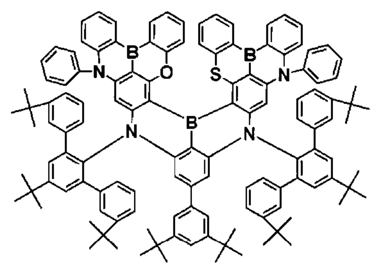

389

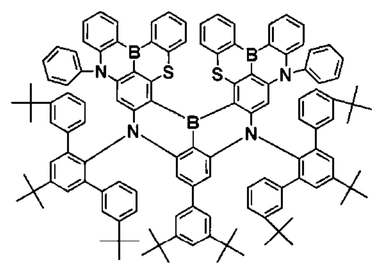

390

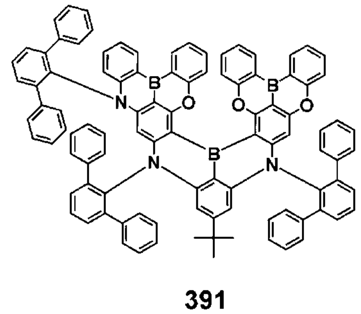

391

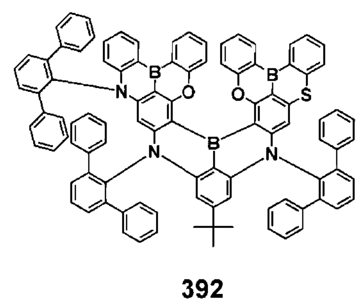

392

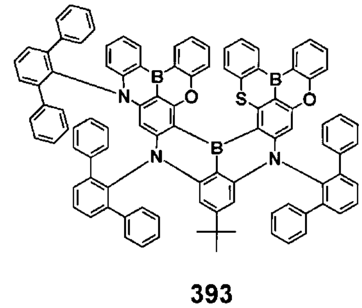

393

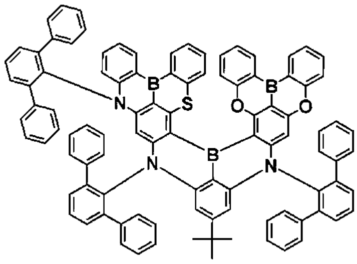
394

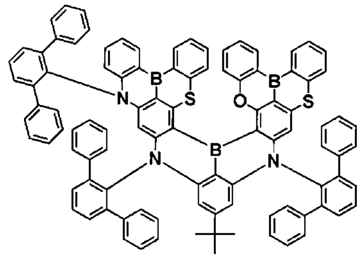
395

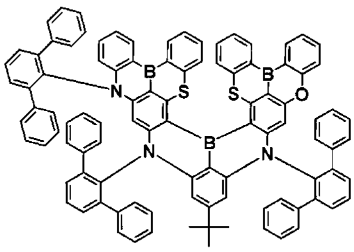
396

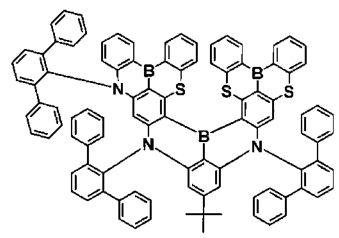
397

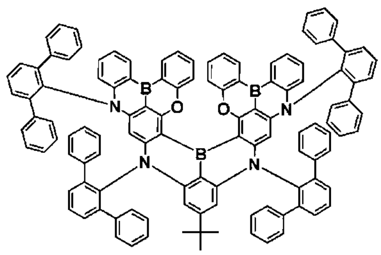
398

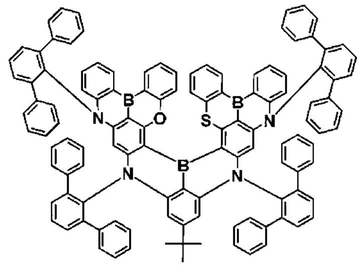
399

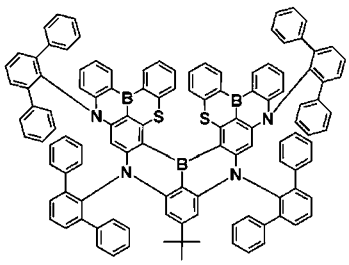
400

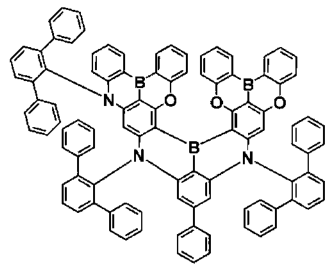
401

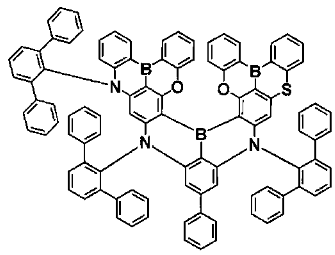
402

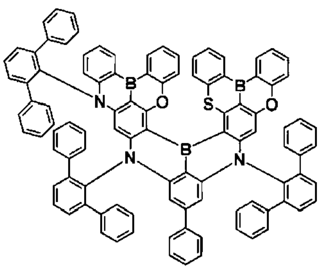
403

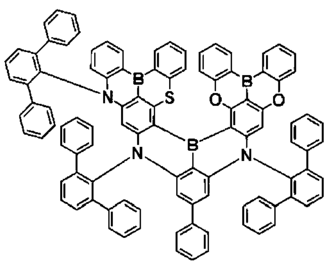
404

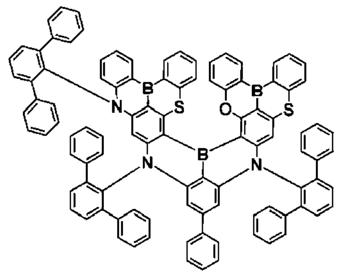
405

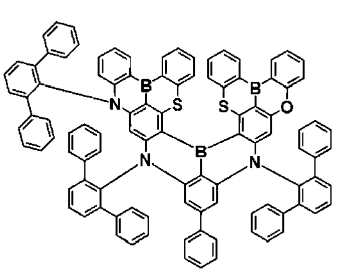
406

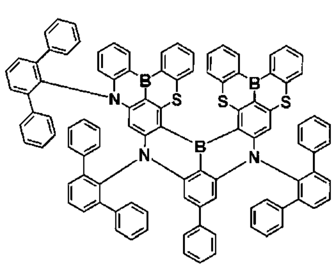
407

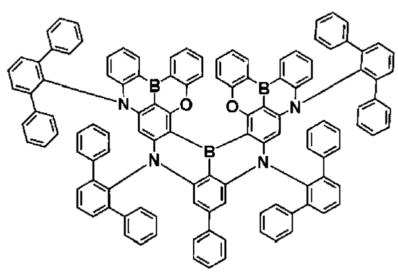
408

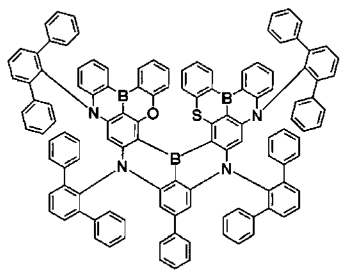

409

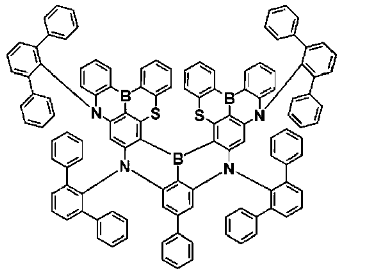

410

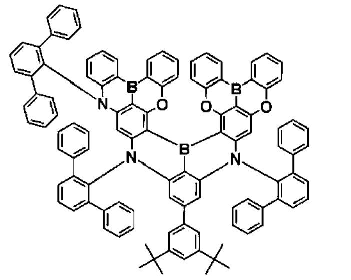

411

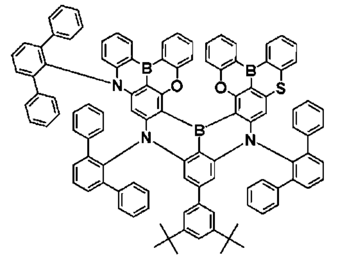

412

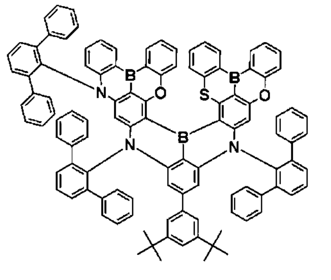

413

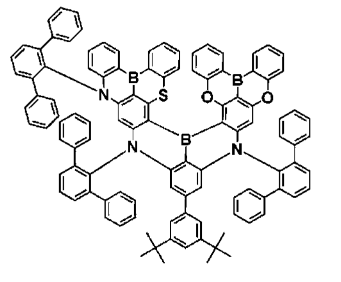

414

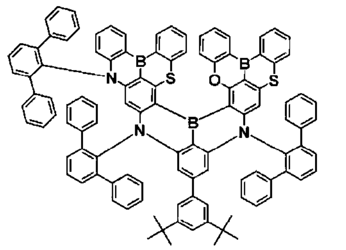

415

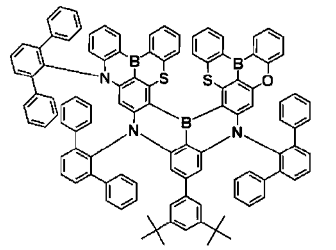

416

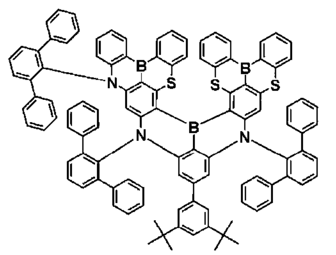

417

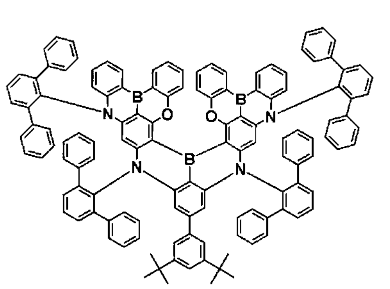

418

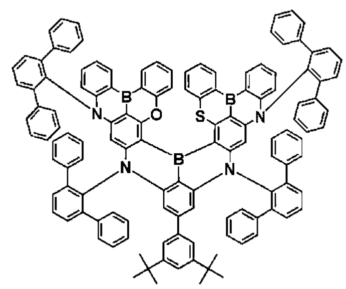

419

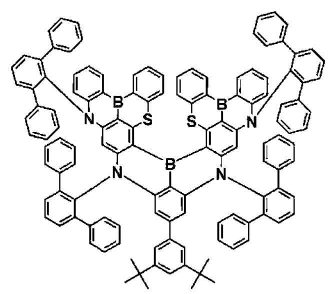

420

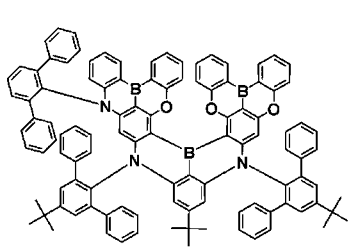

421

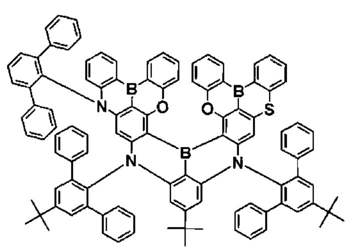

422

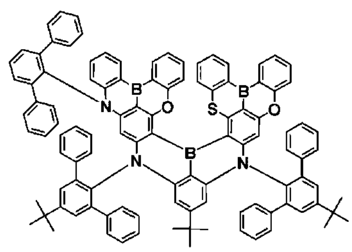

423

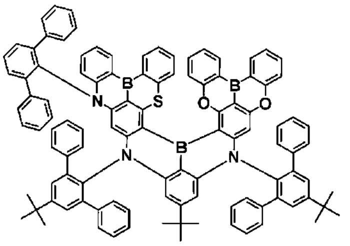

424

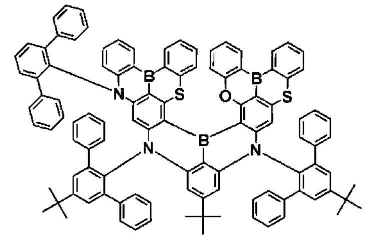

425

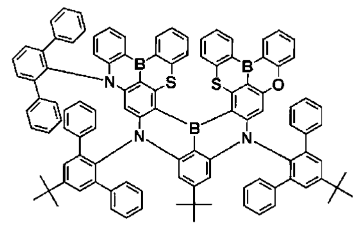

426

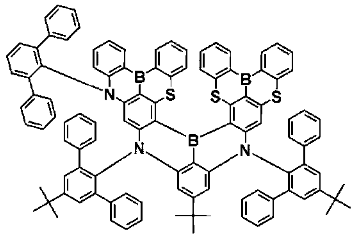

427

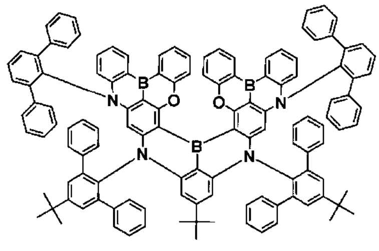

428

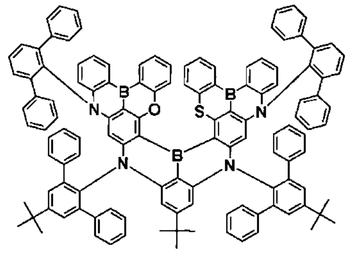

429

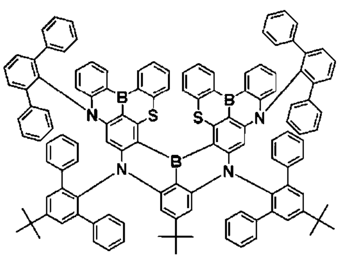

430

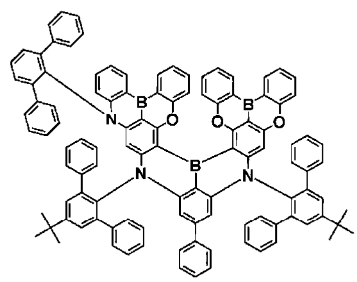

431

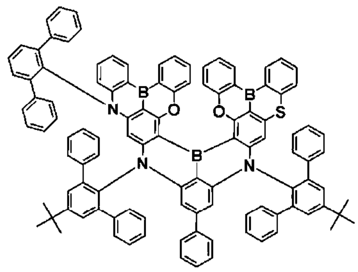

432

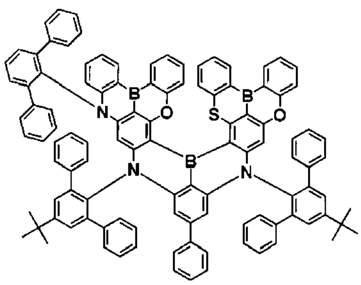

433

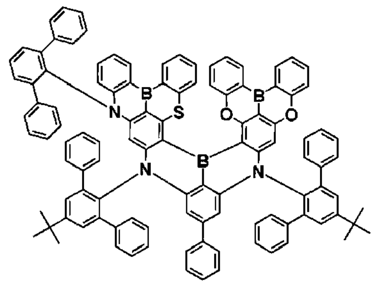

434

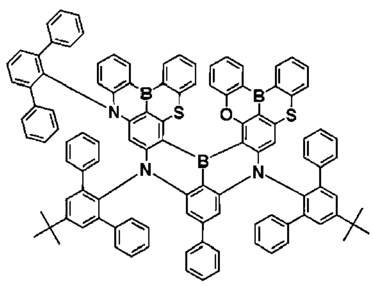

435

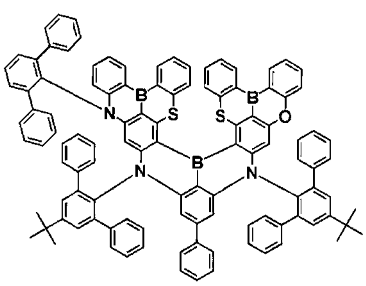

436

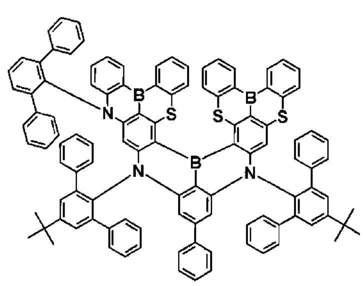

437

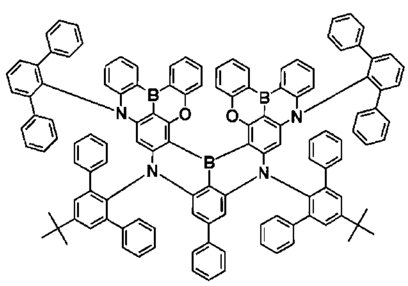

438

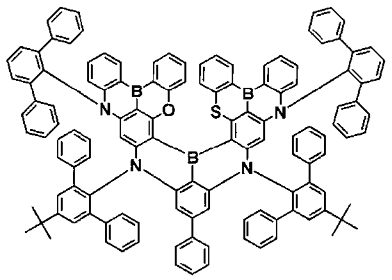

**439**

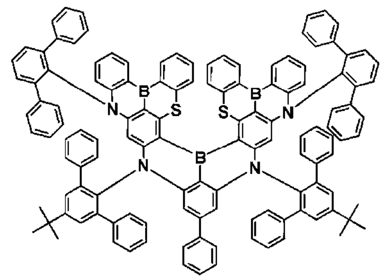

**440**

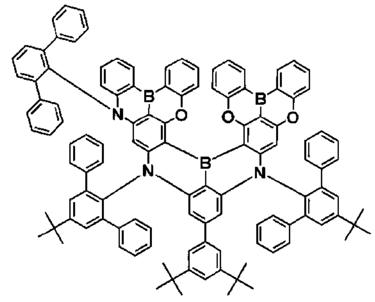

**441**

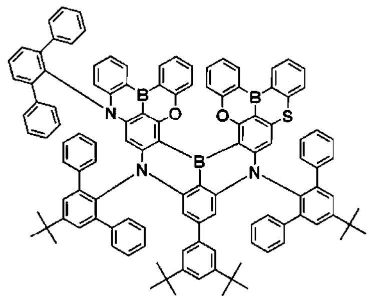

**442**

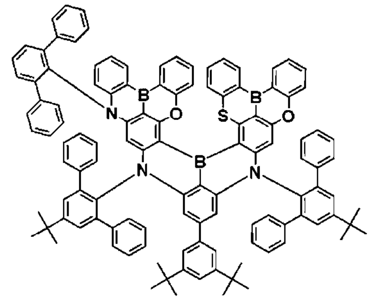

**443**

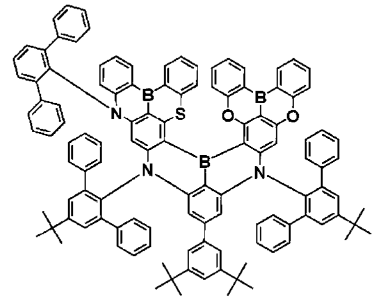

**444**

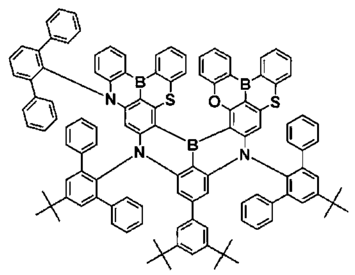

**445**

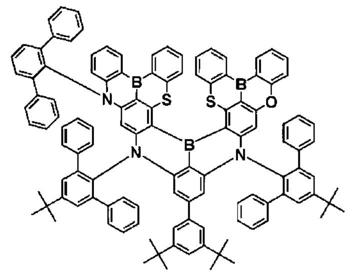

**446**

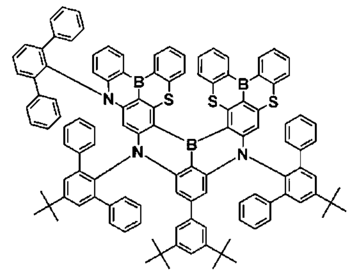

**447**

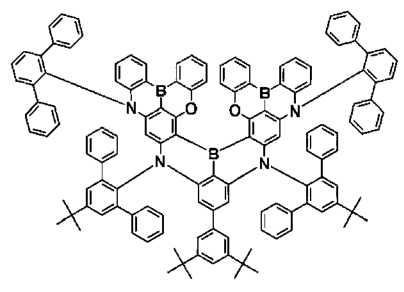

**448**

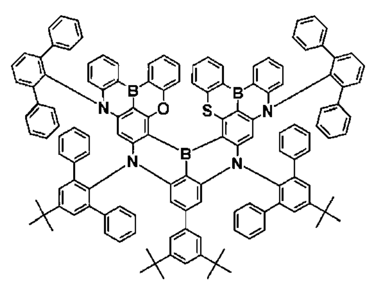

**449**

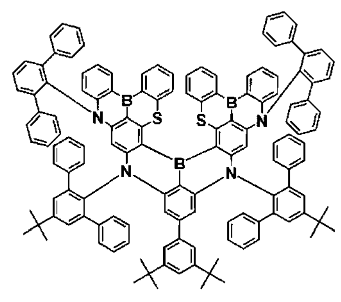

**450**

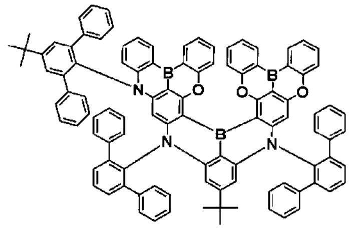

**451**

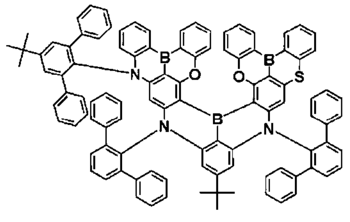

**452**

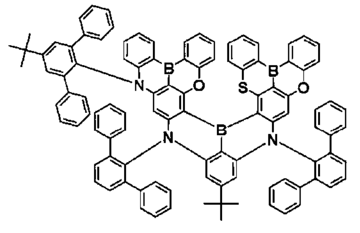

**453**

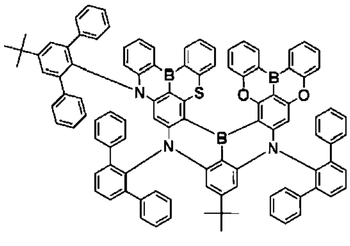

454

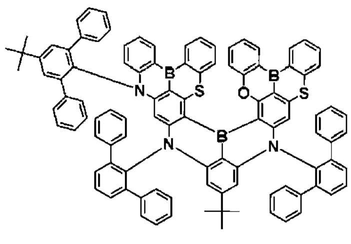

455

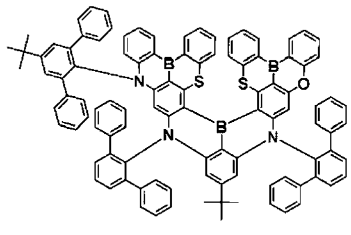

456

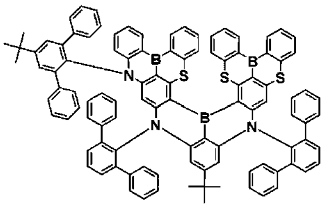

457

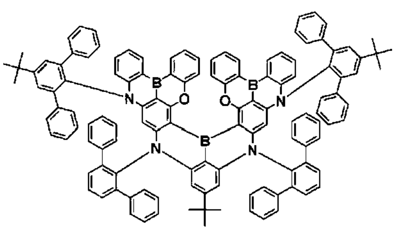

458

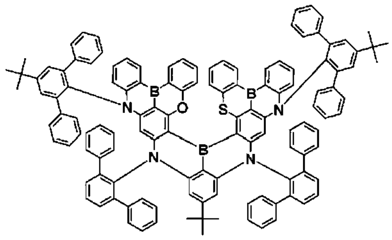

459

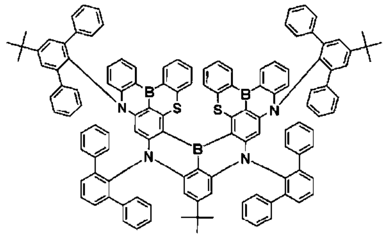

460

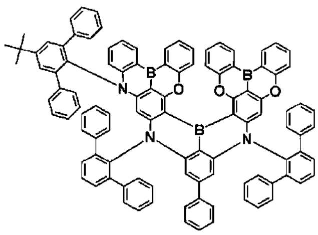

461

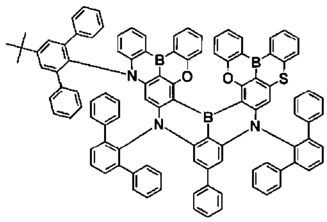

462

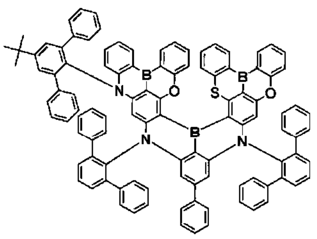

463

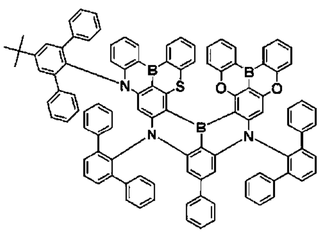

464

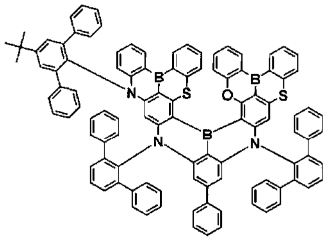

465

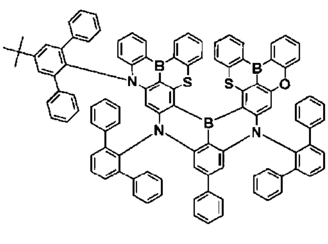

466

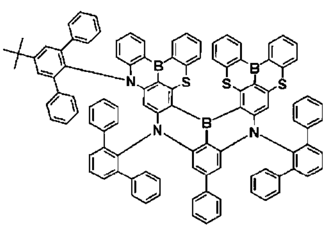

467

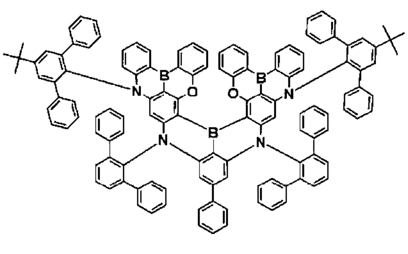

468

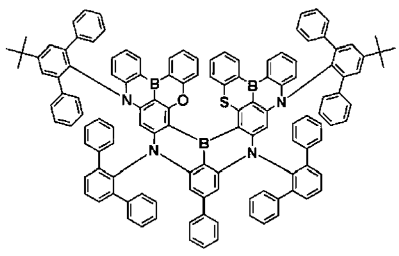
469
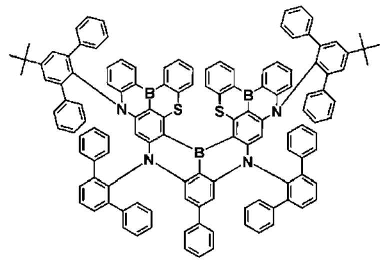
470
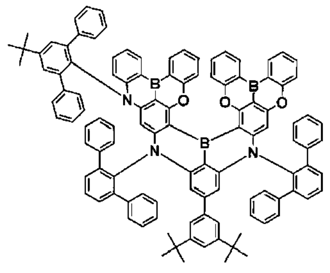
471

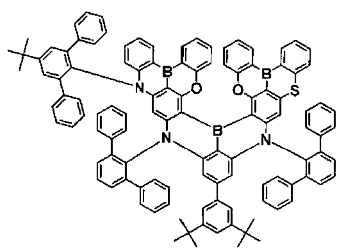
472
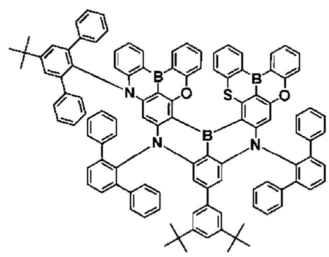
473
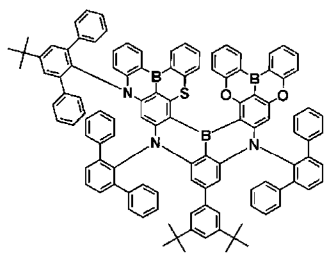
474

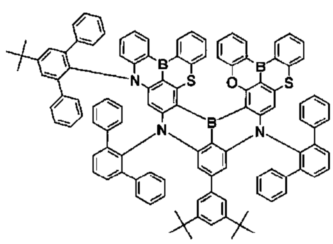
475
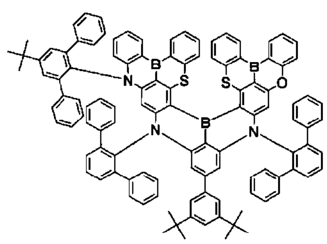
476
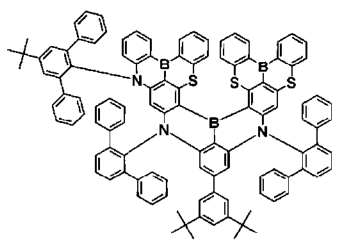
477

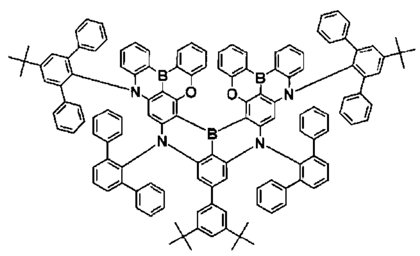
478
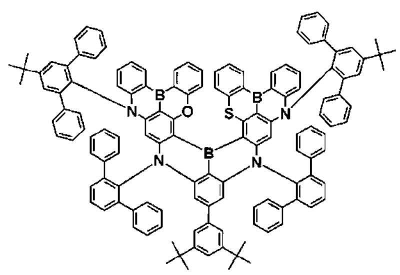
479
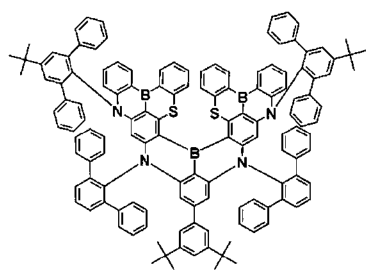
480

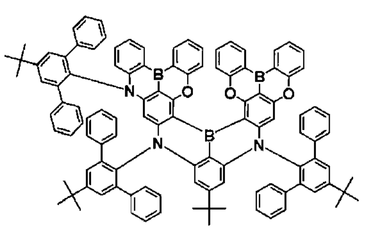
481
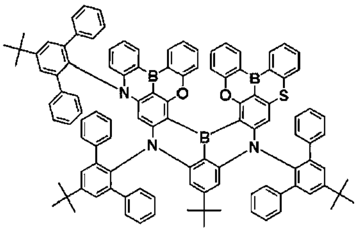
482
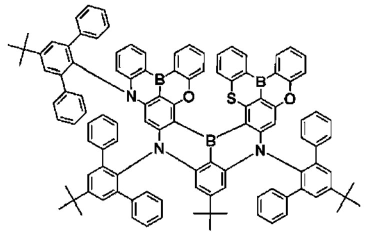
483

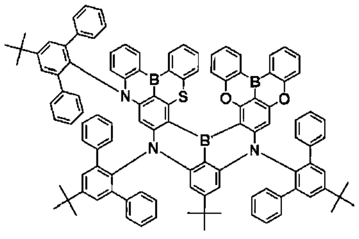

484

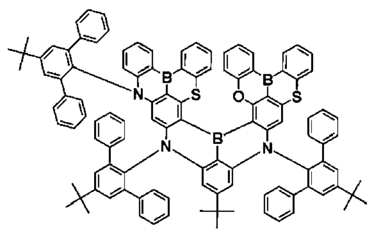

485

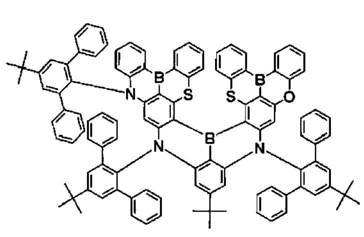

486

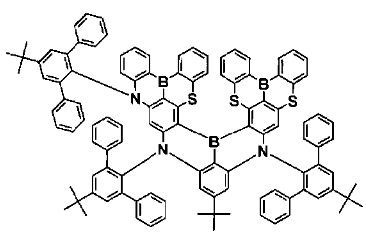

487

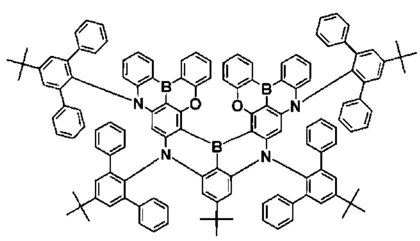

488

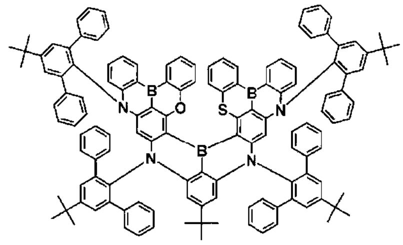

489

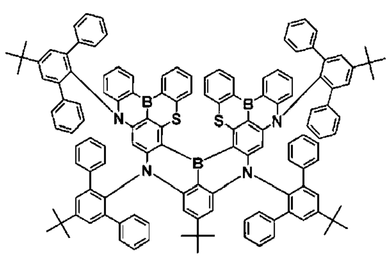

490

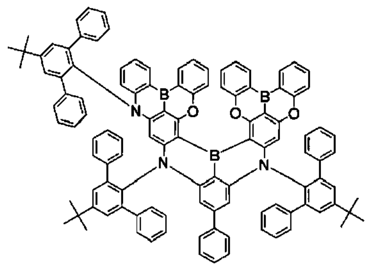

491

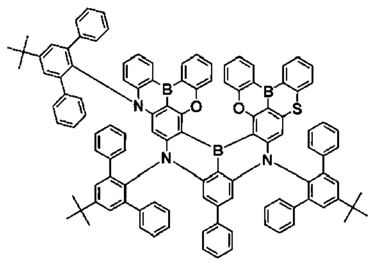

492

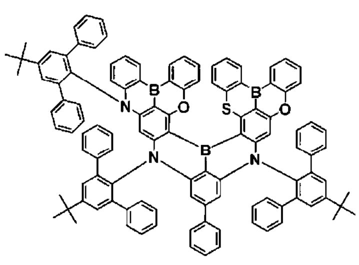

493

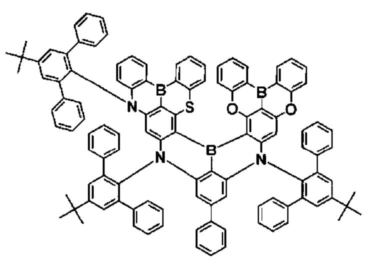

494

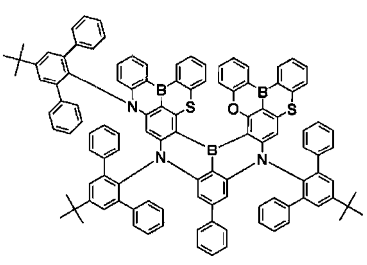

495

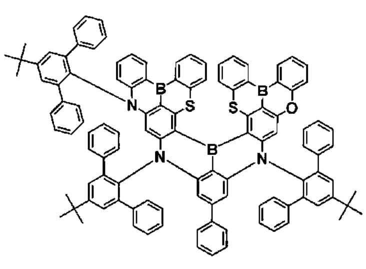

496

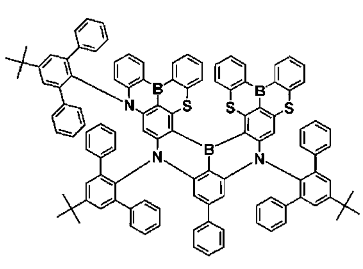

497

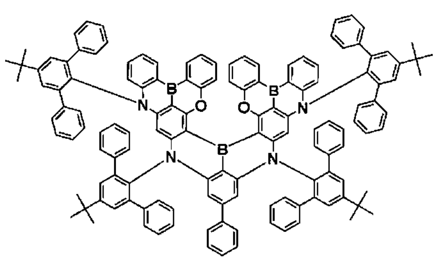

498

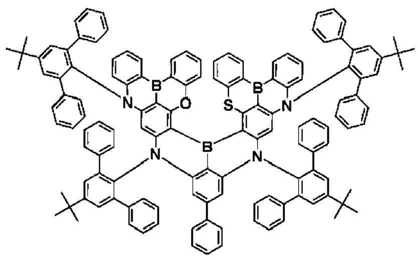

499

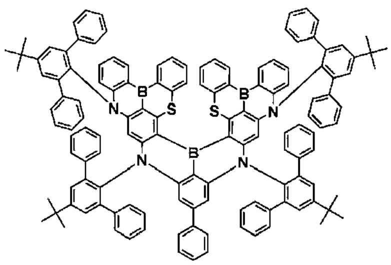

500

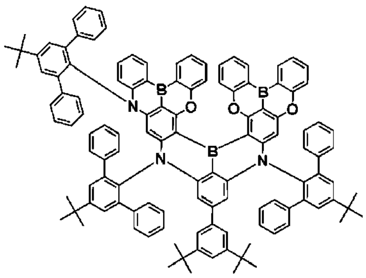

501

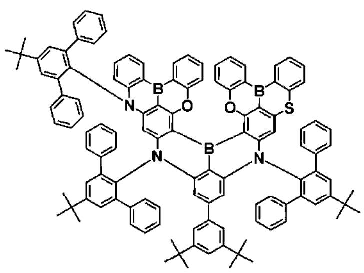

502

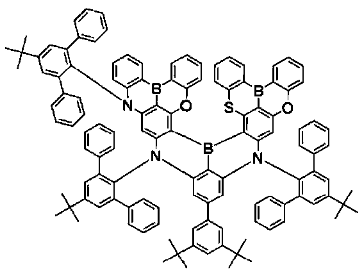

503

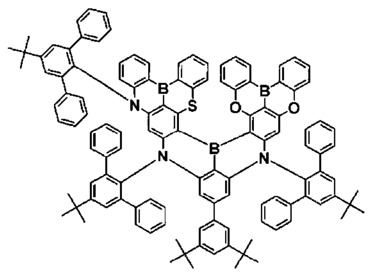

504

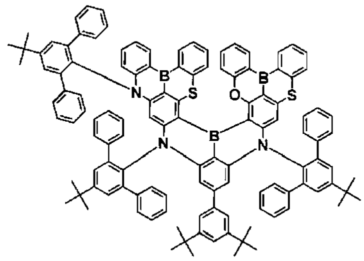

505

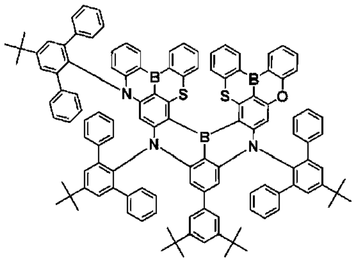

506

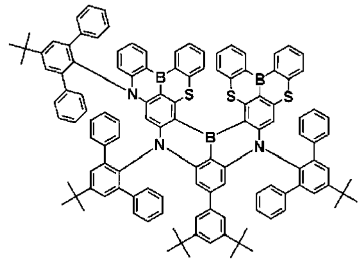

507

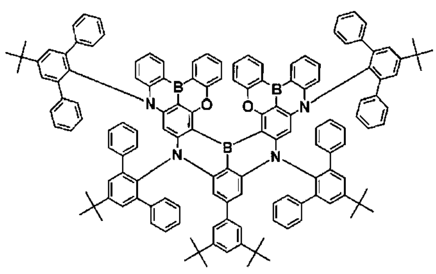

508

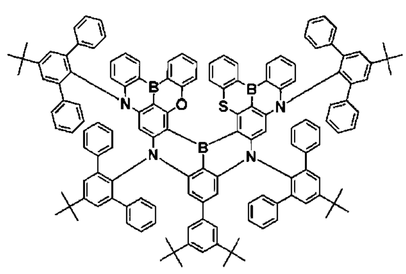

509

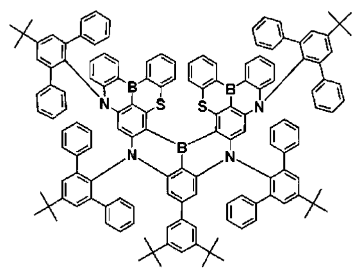

510

.

11. An organic light-emitting device comprising:

a first electrode;
a second electrode; and
an organic layer arranged between the first electrode and the second electrode,
wherein the organic layer comprises an emission layer, and
wherein the organic layer further comprises at least one of the heterocyclic compounds of any of claims 1-10.

12. The organic light-emitting device of claim 11, wherein
the emission layer comprises the at least one heterocyclic compound.

**13.** The organic light-emitting device of claim 12, wherein the emission layer comprises a host and an emitter, and the emitter comprises the at least one heterocyclic compound;
preferably wherein the emission layer emits a blue light with a maximum emission wavelength of 400 nanometers to 490 nanometers.

**14.** The organic light-emitting device of claim 13, wherein an amount of the host in the emission layer is greater than an amount of the at least one heterocyclic compound in the emission layer, based on weight; and/or
wherein the emission layer further comprises a sensitizer, preferably wherein the sensitizer comprises a phosphorescent dopant.

**15.** An electronic apparatus, comprising the organic light-emitting device of any of claims 11-14.

**Amended claims in accordance with Rule 137(2) EPC.**

**1.** A heterocyclic compound represented by Formula 1:

Formula 1

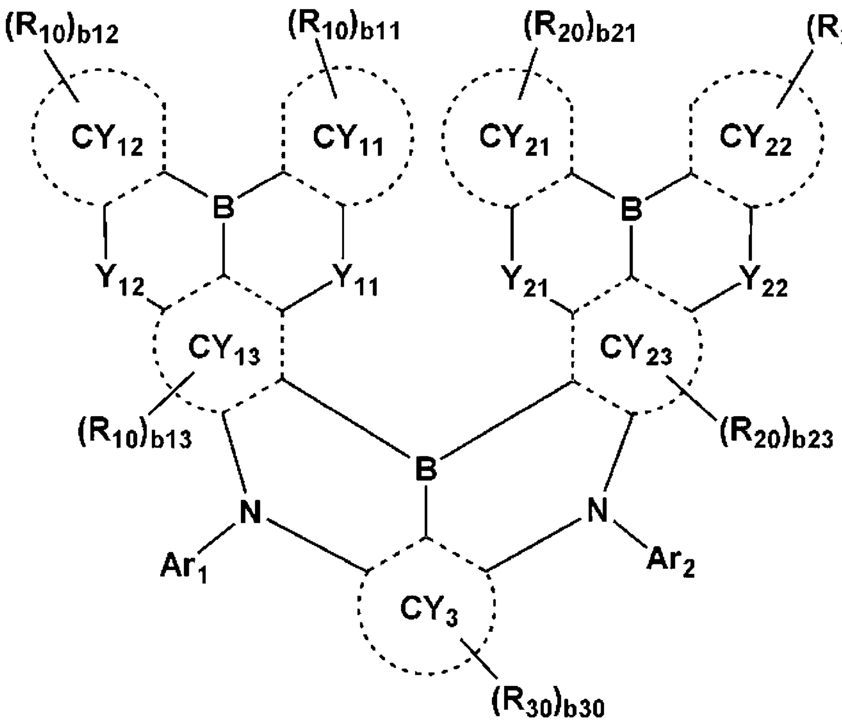

wherein, in Formula 1,
$Y_{11}$ and $Y_{12}$ are each independently a single bond, O, S, Se, $N(Ar_3)$, $N(R_1)$, $C(R_1)(R_2)$, $Si(R_1)(R_2)$, $Ge(R_1)(R_2)$, $B(R_1)$, $P(R_1)$, $P(=O)(R_1)$, $S(=O)_2$, or C(=O),
$Y_{21}$ and $Y_{22}$ are each independently a single bond, O, S, Se, $N(Ar_4)$, $N(R_3)$, $C(R_3)(R_4)$, $Si(R_3)(R_4)$, $Ge(R_3)(R_4)$, $B(R_3)$, $P(R_3)$, $P(=O)(R_3)$, $S(=O)_2$, or C(=O),
**characterized in that** $Ar_1$ to $Ar_4$ are each independently a group represented by Formula 2,

Formula 2

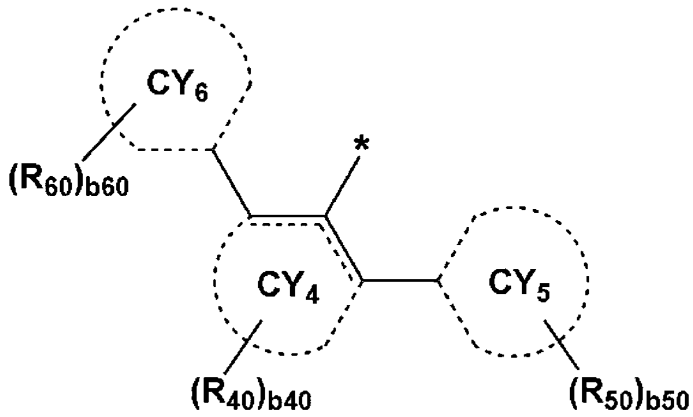

wherein, in Formulae 1 and 2,

$CY_{11}$ to $CY_{13}$, $CY_{21}$ to $CY_{23}$, and $CY_3$ to $CY_6$ are each independently a $C_5$-$C_{30}$ carbocyclic group or a $C_1$-$C_{30}$ heterocyclic group,

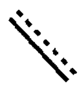

indicates a single bond or a double bond,

* indicates a binding site to a neighboring atom,

$R_1$ to $R_4$, $R_{10}$, $R_{20}$, $R_{30}$, $R_{40}$, $R_{50}$ and $R_{60}$ are each independently hydrogen, deuterium, -F, -Cl, -Br, -I, $-SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_1)(Q_2)(Q_3)$, $-Ge(Q_1)(Q_2)(Q_3)$, $-C(=O)(Q_1)$, $-S(=O)(Q_1)$, $-S(=O)_2(Q_1)$, $-B(Q_1)(Q_2)$, $-P(Q_1)(Q_2)$, $-P(=O)(Q_1)(Q_2)$, or $-P(=S)(Q_1)(Q_2)$,

b11 to b13, b21 to b23, b30, b40, b50, and b60 are each independently 1, 2, 3, 4, 5, 6, 7, 8, 9, 10, 11, 12, 13, or 14,

two or more of adjacent $R_1$ to $R_4$, $R_{10}$, $R_{20}$, $R_{30}$, $R_{40}$, $R_{50}$, and $R_{60}$ are optionally bonded to each other to form a substituted or unsubstituted $C_5$-$C_{30}$ carbocyclic group or a substituted or unsubstituted $C_1$-$C_{30}$ heterocyclic group,

substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group are:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a

nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, $C_1$-$C_{60}$ alkylthio group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, $C_1$-$C_{60}$ alkylthio group, or a $C_1$-$C_{60}$ alkoxy group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{11})(Q_{12})(Q_{13})$, $-Ge(Q_{11})(Q_{12})(Q_{13})$, $-C(=O)(Q_{11})$, $-S(=O)(Q_{11})$, $-S(=O)_2(Q_{11})$, $-B(Q_{11})(Q_{12})$, $-P(Q_{11})(Q_{12})$, $-P(=O)(Q_{11})(Q_{12})$, $-P(=S)(Q_{11})(Q_{12})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, -F, -Cl, -Br, -I, $-SF_5$, $-CD_3$, $-CD_2H$, $-CDH_2$, $-CF_3$, $-CF_2H$, $- CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{21})(Q_{22})(Q_{23})$, $- Ge(Q_{21})(Q_{22})(Q_{23})$, $-C(=O)(Q_{21})$, $-S(=O)(Q_{21})$, $-S(=O)_2(Q_{21})$, $-B(Q_{21})(Q_{22})$, $-P(Q_{21})(Q_{22})$, $-P(=O)(Q_{21})(Q_{22})$, $-P(=S)(Q_{21})(Q_{22})$, or a combination thereof;

$-N(Q_{31})(Q_{32})$, $-Si(Q_{31})(Q_{32})(Q_{33})$, $-Ge(Q_{31})(Q_{32})(Q_{33})$, $-C(=O)(Q_{31})$, $-S(=O)(Q_{31})$, $-S(=O)_2(Q_{31})$, $-B(Q_{31})(Q_{32})$, $-P(Q_{31})(Q_{32})$, $-P(=O)(Q_{31})(Q_{32})$, or $-P(=S)(Q_{31})(Q_{32})$; or

a combination thereof, and

$Q_1$ to $Q_3$, $Q_{11}$ to $Q_{13}$, $Q_{21}$ to $Q_{23}$ and $Q_{31}$ to $Q_{33}$ are each independently:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group; or

a $C_1$-$C_{60}$ alkyl group, a $C_2$-$C_{60}$ alkenyl group, a $C_2$-$C_{60}$ alkynyl group, a $C_1$-$C_{60}$ alkoxy group, $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with deuterium, a $C_1$-$C_{60}$ alkyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, or a combination thereof.

**2.** The heterocyclic compound of claim 1, wherein

$Y_{11}$ and $Y_{21}$ are each independently O, S, or Se, and

$Y_{12}$ and $Y_{22}$ are each independently O, S, Se, $N(Ar_3)$, $N(R_1)$, $C(R_1)(R_2)$, or $Si(R_1)(R_2)$.

**3.** The heterocyclic compound of claims 1 or 2, wherein $CY_{11}$ to $CY_{13}$, $CY_{21}$ to $CY_{23}$, and $CY_3$ to $CY_6$ are each independently a benzene group, a naphthalene group, a phenanthrene group, a fluorene group, a pyridine group, a pyrimidine group, a quinoline group, an isoquinoline group, a phthalazine group, a naphthyridine group, a quinoxaline group, a quinazoline group, a carbazole group, a dibenzofuran group, a dibenzothiophene group, a dibenzosilole group, a dibenzoborole group, a dibenzophosphole group, a dibenzoselenophene group, a dibenzogermole group, a dibenzothiophene 5-oxide group, a 9H-fluoren-9-one group, or a dibenzothiophene 5,5-dioxide group.

**4.** The heterocyclic compound of any of claims 1-3, wherein

the group represented by Formula 2 is a group represented by Formula 2A:

Formula 2A

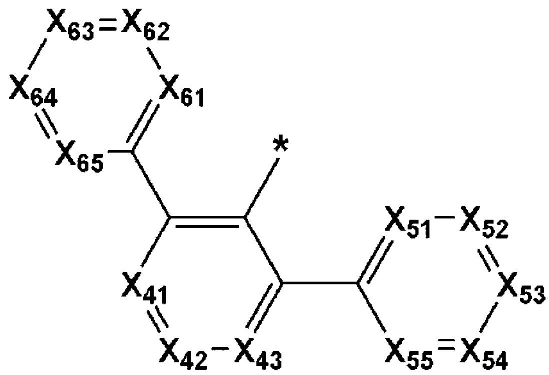

wherein, in Formula 2A,
$X_{41}$ is $C(R_{41})$ or N, $X_{42}$ is $C(R_{42})$ or N, and $X_{43}$ is $C(R_{43})$ or N,
$X_{51}$ is $C(R_{51})$ or N, $X_{52}$ is $C(R_{52})$ or N, $X_{53}$ is $C(R_{53})$ or N, $X_{54}$ is $C(R_{54})$ or N, $X_{55}$ is $C(R_{55})$ or N,
$X_{61}$ is $C(R_{61})$ or N, $X_{62}$ is $C(R_{62})$ or N, $X_{63}$ is $C(R_{63})$ or N, $X_{64}$ is $C(R_{64})$ or N, $X_{65}$ is $C(R_{55})$ or N,
$R_{41}$ to $R_{43}$ are each independently as described in connection with $R_{40}$ in claim 1,
$R_{51}$ to $R_{55}$ are each independently as described in connection with $R_{50}$ in claim 1,
$R_{61}$ to $R_{65}$ are each independently as described in connection with $R_{60}$ in claim 1, and
* indicates a binding site to a neighboring atom;
preferably wherein the group represented by Formula 2 is a group represented by Formula 2A-1:

Formula 2A-1

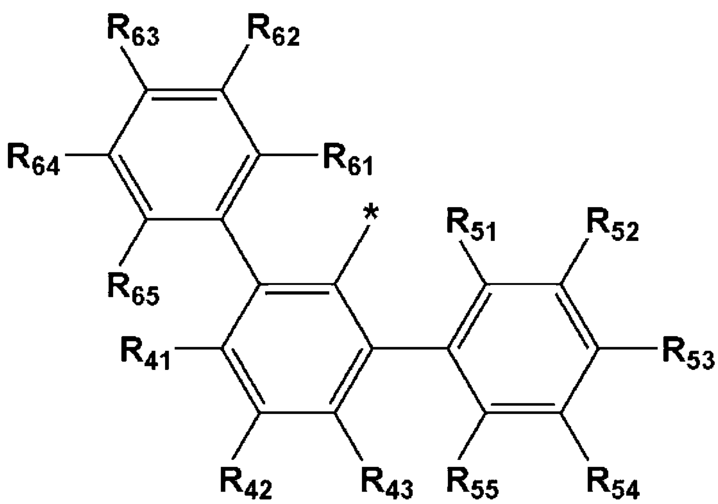

wherein, in Formula 2A-1,
$R_{41}$ to $R_{43}$ are each independently as described in connection with $R_{40}$ in claim 1,

$R_{51}$ to $R_{55}$ are each independently as described in connection with $R_{50}$ in claim 1,
$R_{61}$ to $R_{65}$ are each independently as described in connection with $R_{60}$ in claim 1, and
* indicates a binding site to a neighboring atom.

**5.** The heterocyclic compound of any of claims 1-4, wherein
$R_1$ to $R_4$, $R_{10}$, $R_{20}$, $R_{30}$, $R_{40}$, $R_{50}$, and $R_{60}$ are each independently:

hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, $C_1$-$C_{20}$ alkylthio group, or a $C_1$-$C_{20}$ alkoxy group;

a $C_1$-$C_{20}$ alkyl group, $C_1$-$C_{20}$ alkylthio group, or a $C_1$-$C_{20}$ alkoxy group, each substituted with deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (a norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, - Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorine-containing $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an

isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

- $N(Q_1)(Q_2)$, $-Si(Q_1)(Q_2)(Q_3)$, $-Ge(Q_1)(Q_2)(Q_3)$, $-C(=O)(Q_1)$, $-S(=O)(Q_1)$, $-S(=O)_2(Q_1)$, $-B(Q_1)(Q_2)$, $-P(Q_1)(Q_2)$, $-P(=O)(Q_1)(Q_2)$, or $-P(=S)(Q_1)(Q_2)$.

**6.** The heterocyclic compound of any of claims 1-5, wherein at least one of $R_{30}$ in the number of b30 is -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

**7.** The heterocyclic compound of any of claims 1-6, wherein

the heterocyclic compound is a compound represented by Formula 11:

Formula 11

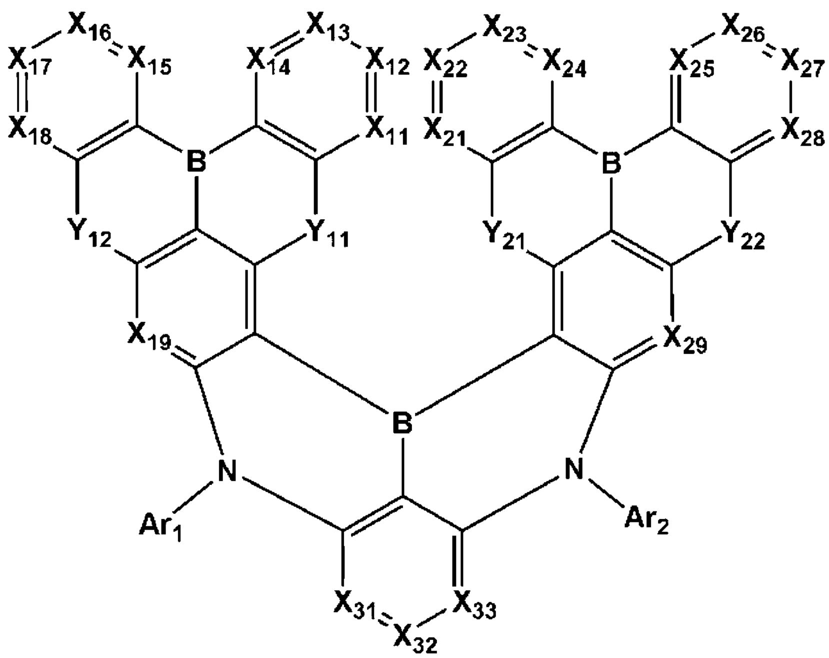

wherein, in Formula 11,
$Y_{11}$, $Y_{12}$, $Y_{21}$, $Y_{22}$, $Ar_1$, and $Ar_2$ are as in claim 1,
$X_{11}$ is $C(R_{11})$ or N, $X_{12}$ is $C(R_{12})$ or N, $X_{13}$ is $C(R_{13})$ or N, $X_{14}$ is $C(R_{14})$ or N, $X_{15}$ is $C(R_{15})$ or N, $X_{16}$ is $C(R_{16})$ or N, $X_{17}$ is $C(R_{17})$ or N, $X_{18}$ is $C(R_{18})$ or N, $X_{19}$ is $C(R_{19})$ or N,
$X_{21}$ is $C(R_{21})$ or N, $X_{22}$ is $C(R_{22})$ or N, $X_{23}$ is $C(R_{23})$ or N, $X_{24}$ is $C(R_{24})$ or N, $X_{25}$ is $C(R_{25})$ or N, $X_{26}$ is $C(R_{26})$ or N, $X_{27}$ is $C(R_{27})$ or N, $X_{28}$ is $C(R_{28})$ or N, $X_{29}$ is $C(R_{29})$ or N,
$X_{31}$ is $C(R_{31})$ or N, $X_{32}$ is $C(R_{32})$ or N, $X_{33}$ is $C(R_{33})$ or N,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1;
preferably wherein
$R_{32}$ is -F, -Cl, -Br, -I, $-SF_5$, a cyano group, a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed

polycyclic group, or a substituted or unsubstituted monovalent non-aromatic condensed heteropolycyclic group, and
$R_{31}$ and $R_{33}$ are each independently hydrogen or deuterium.

**8.** The heterocyclic compound of any of claims 1-7, wherein

the heterocyclic compound is a compound represented by Formula 21:

Formula 21

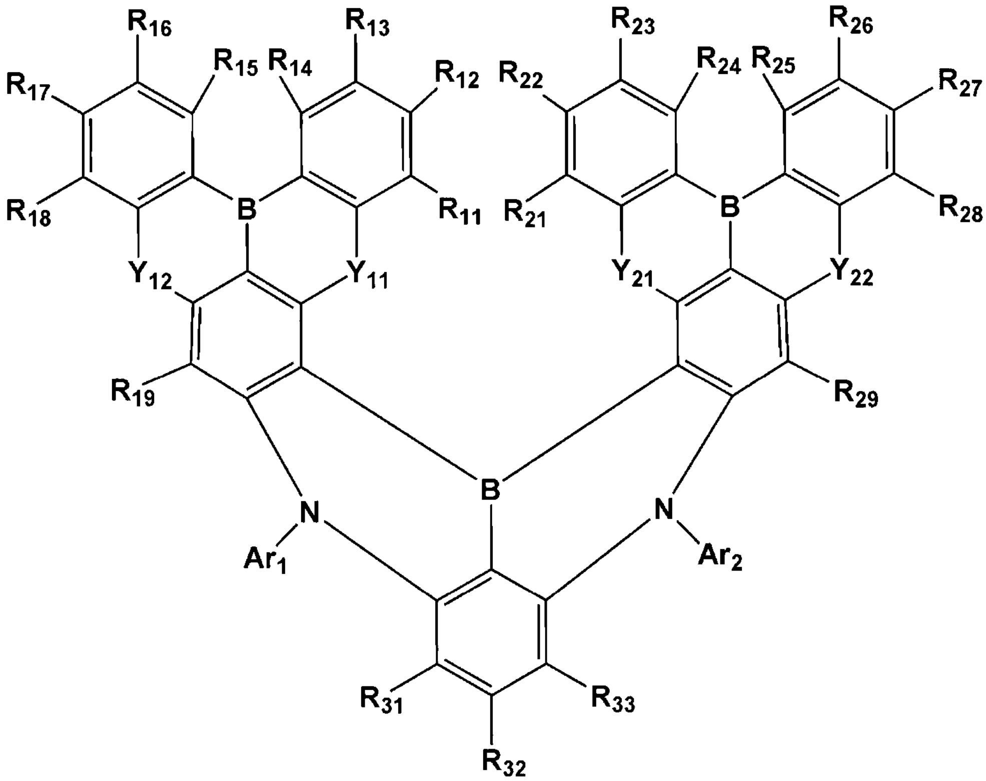

wherein, in Formula 21,
$Y_{11}$, $Y_{12}$, $Y_{21}$, $Y_{22}$, $Ar_1$, and $Ar_2$ are as in claim 1,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1.

**9.** The heterocyclic compound of any of claims 1-8, wherein

the heterocyclic compound is a compound represented by Formula 31:

Formula 31

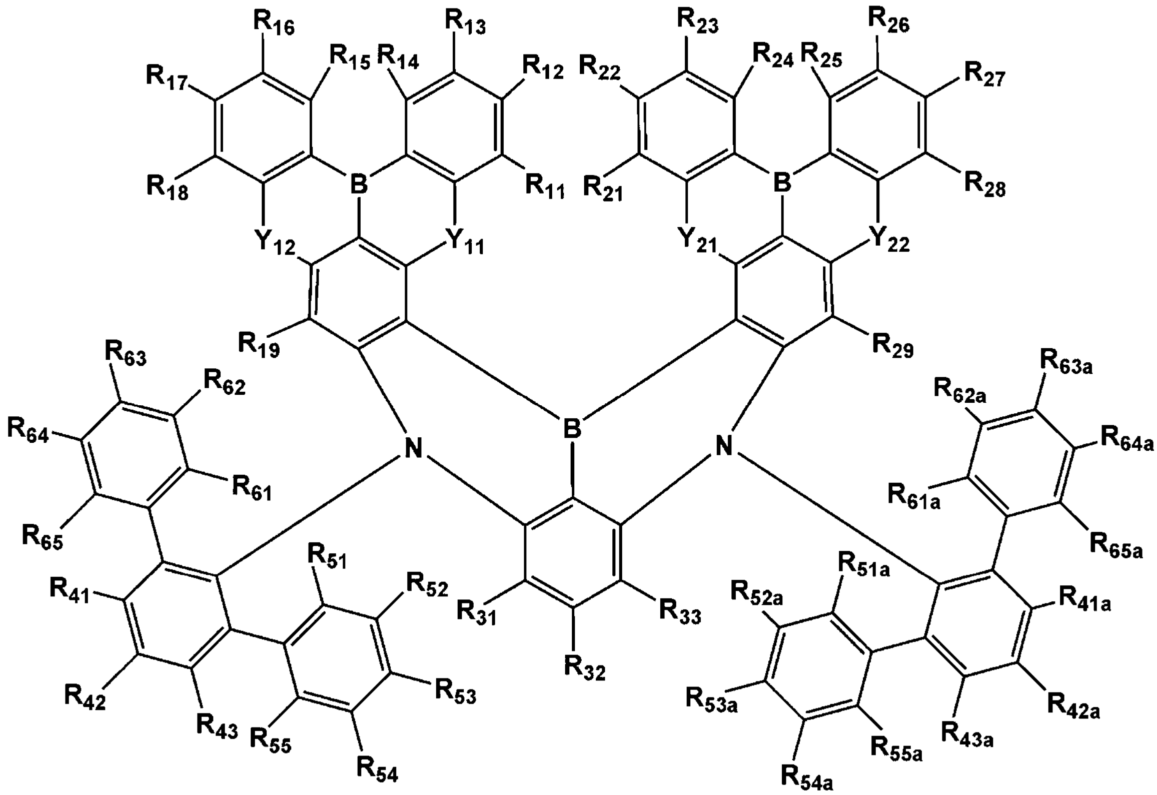

wherein, in Formula 31,
$Y_{11}$, $Y_{12}$, $Y_{21}$, and $Y_{22}$ are as in claim 1,
$R_{11}$ to $R_{19}$ are each independently as described in connection with $R_{10}$ in claim 1,
$R_{21}$ to $R_{29}$ are each independently as described in connection with $R_{20}$ in claim 1, and
$R_{31}$ to $R_{33}$ are each independently as described in connection with $R_{30}$ in claim 1,
$R_{41}$ to $R_{43}$ and $R_{41a}$ to $R_{43a}$ are each independently as described in connection with $R_{40}$ in claim 1,
$R_{51}$ to $R_{55}$ and $R_{51a}$ to $R_{55a}$ are each independently as described in connection with $R_{50}$ in claim 1, and
$R_{61}$ to $R_{65}$ and $R_{61a}$ to $R_{65a}$ are each independently as described in connection with $R_{60}$ in claim 1.

**10.** The heterocyclic compound of claim 1, wherein
the heterocyclic compound is any one of compounds 1 to 510:

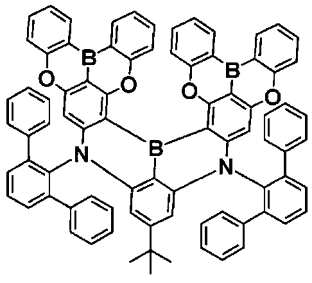

1

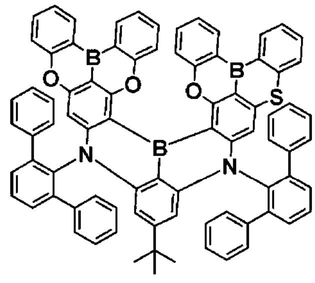

2

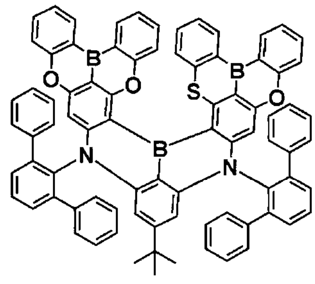

3

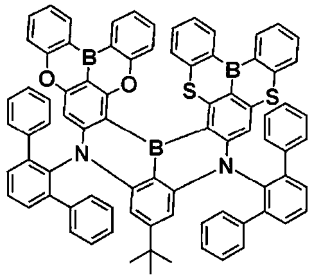

4

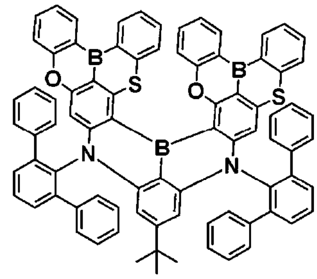

5

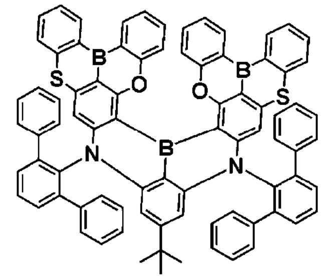

6

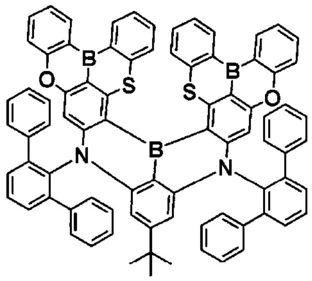

7

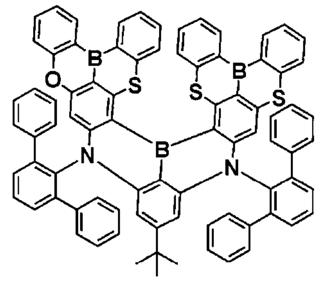

8

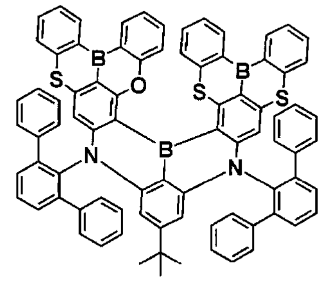

9

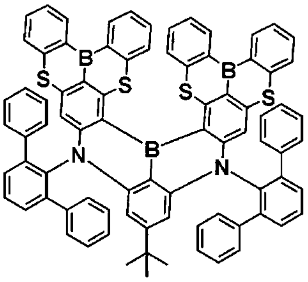

10

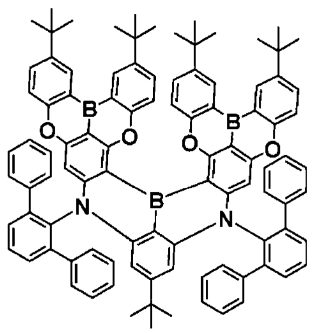

11

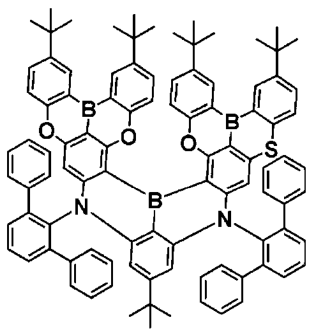

12

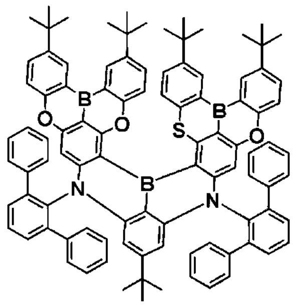

13

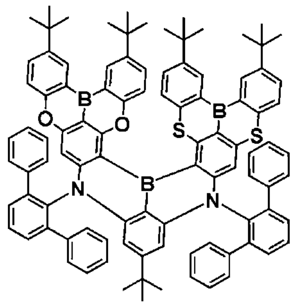

14

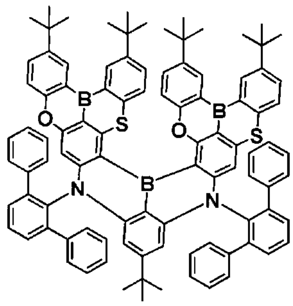

15

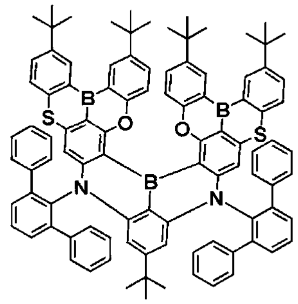

16

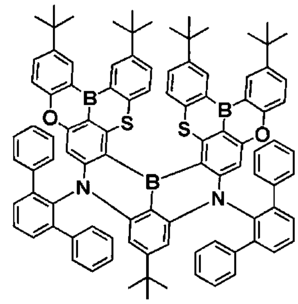

17

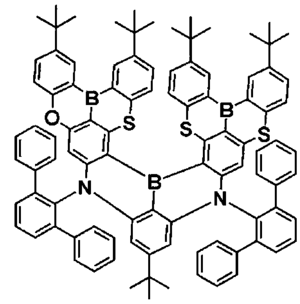

18

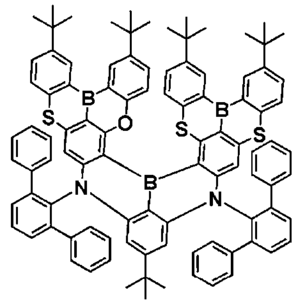

19

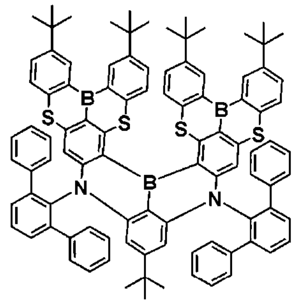

20

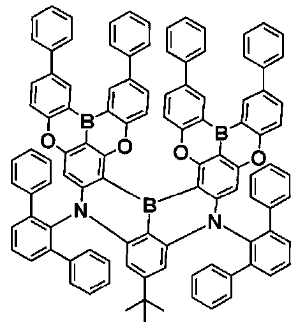

21

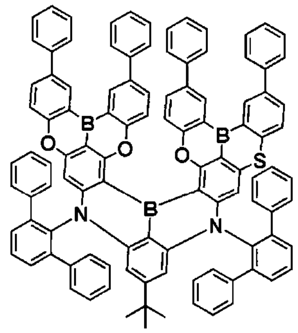

22

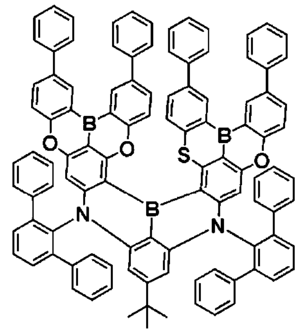

23

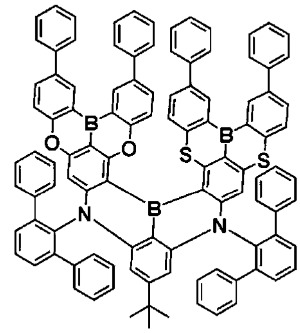

24

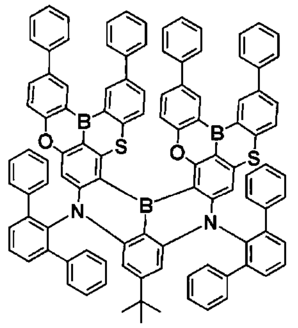

25

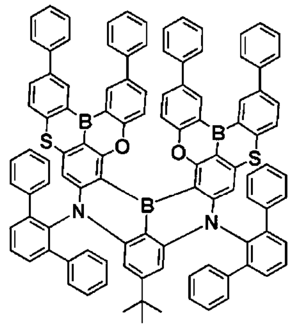

26

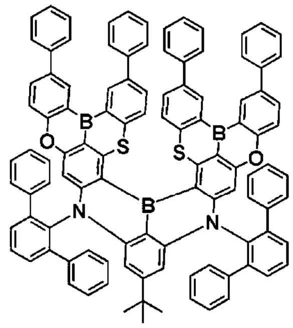

27

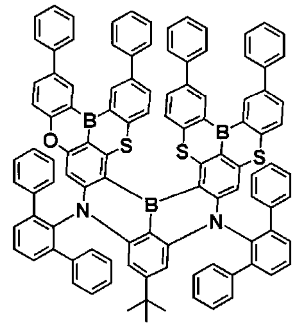

28

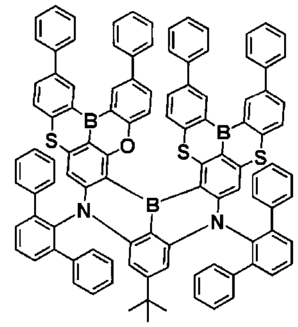

29

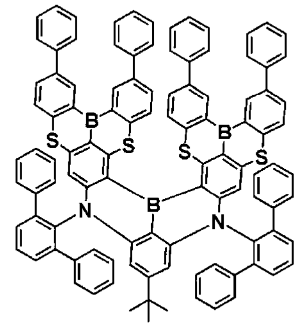

30

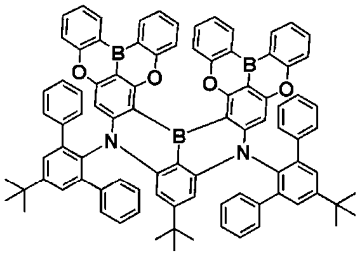

31

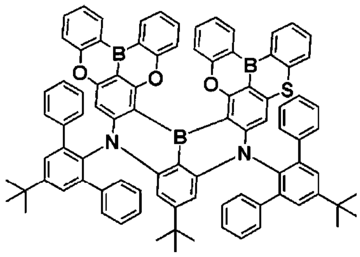

32

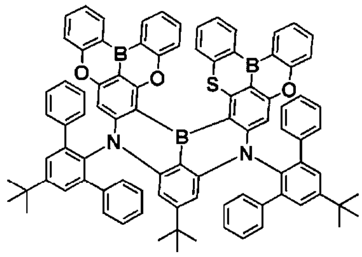

33

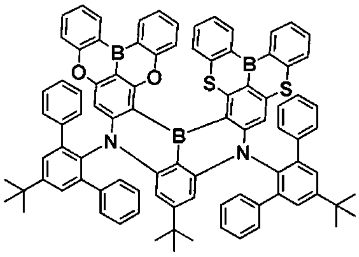

34

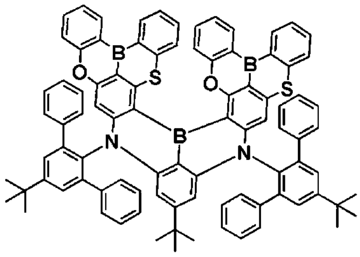

35

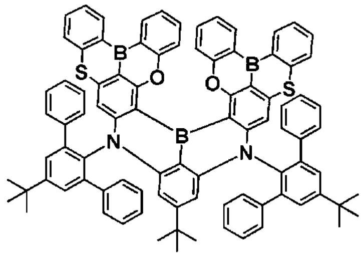

36

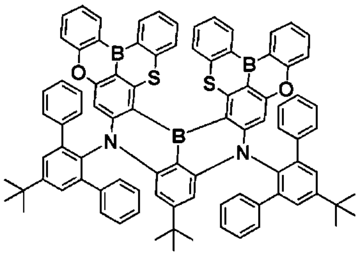

37

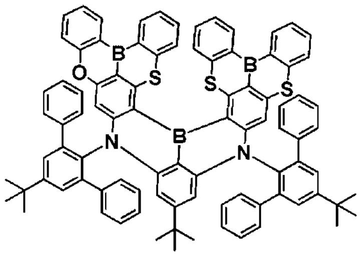

38

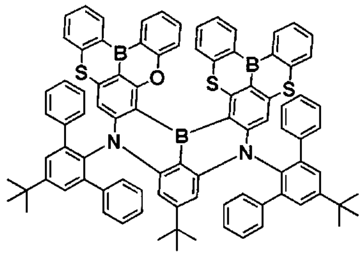

39

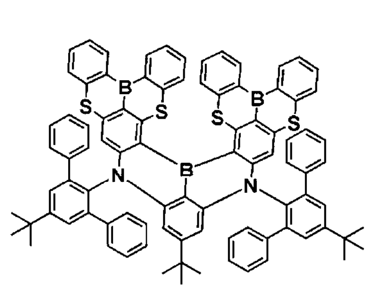

40

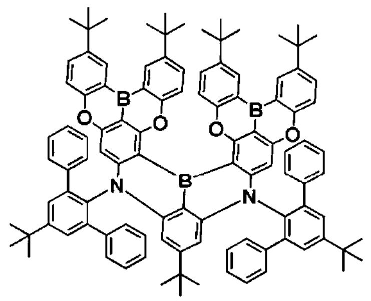

41

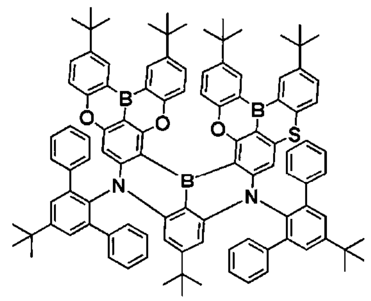

42

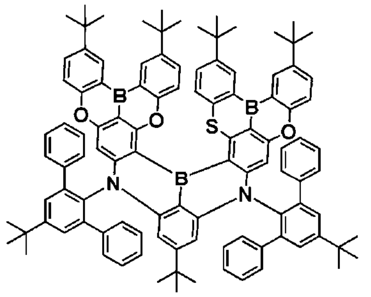

43

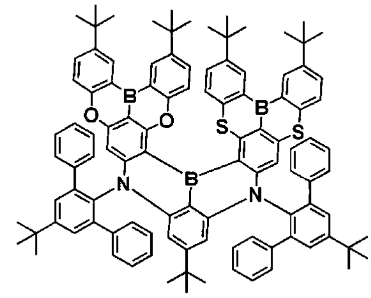

44

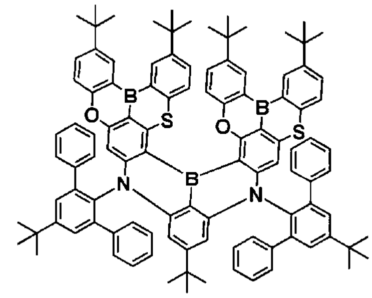

45

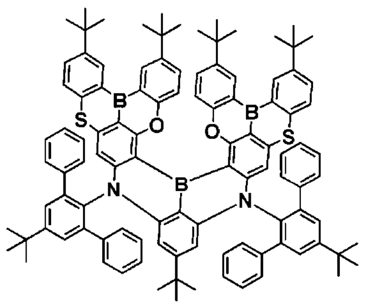

46

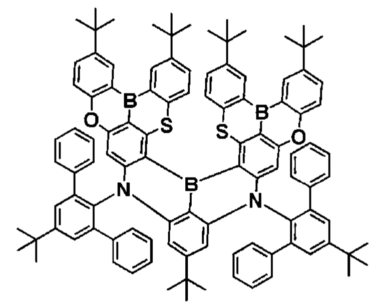

47

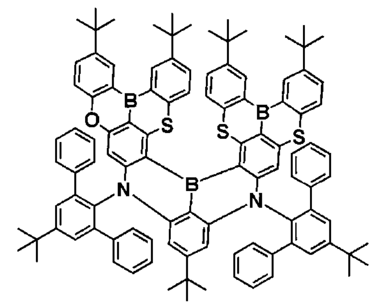

48

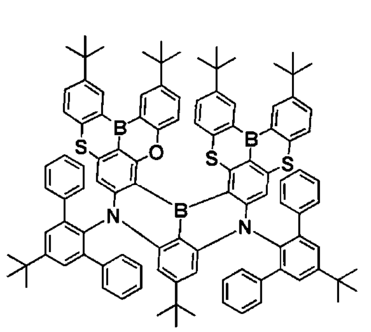

49

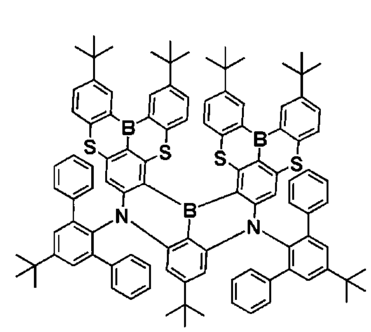

50

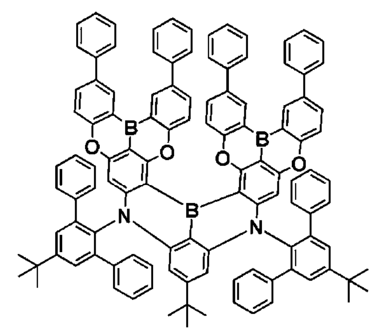

51

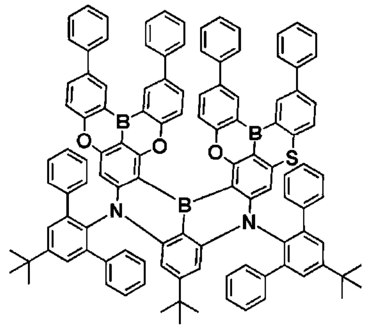

52

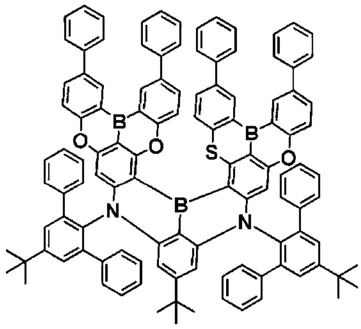

53

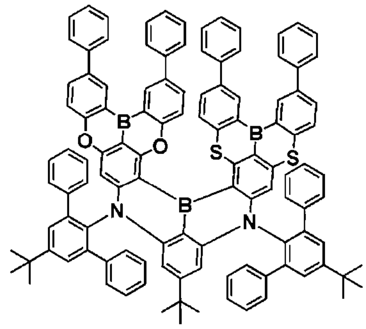

54

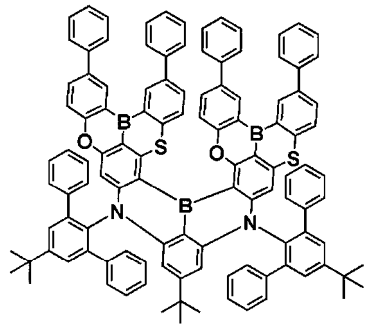

55

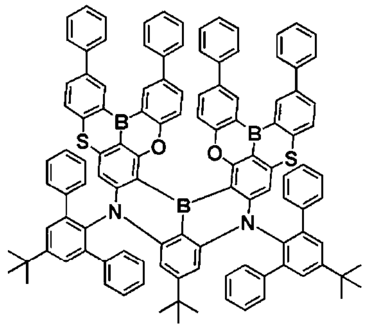

56

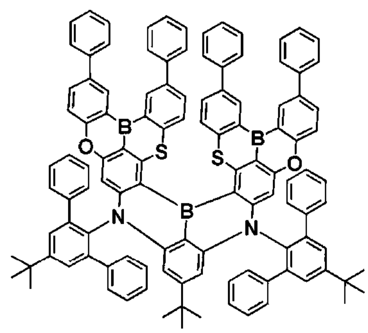

57

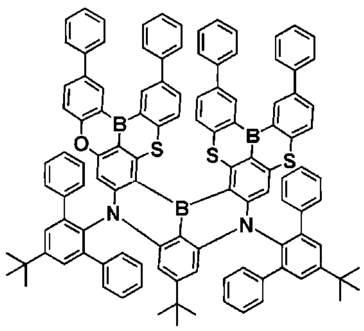

58

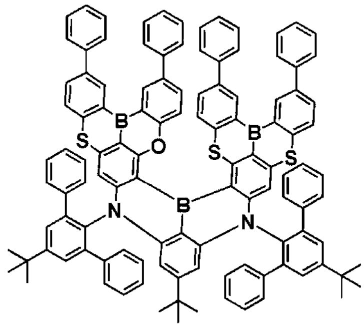

59

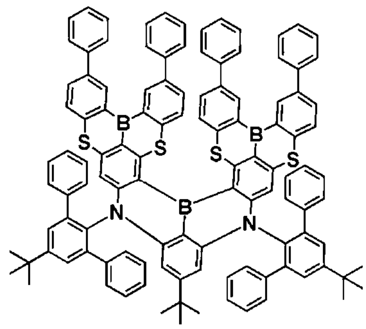

60

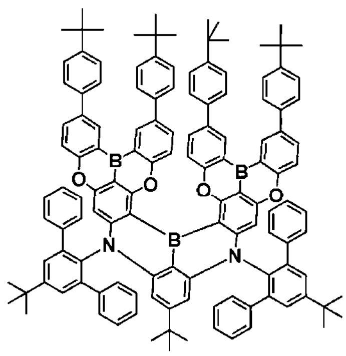

61

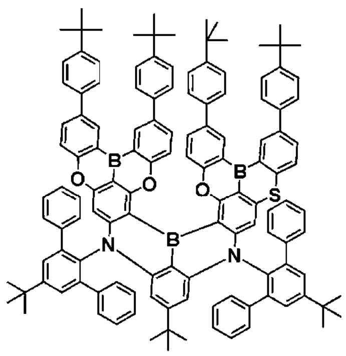

62

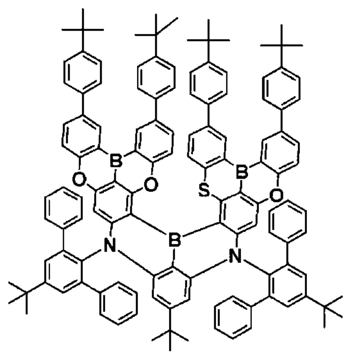

63

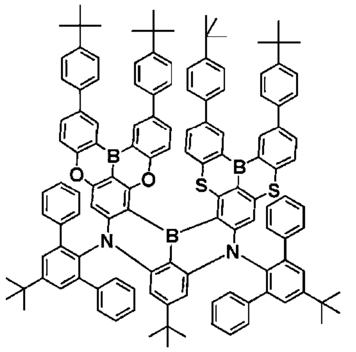

64

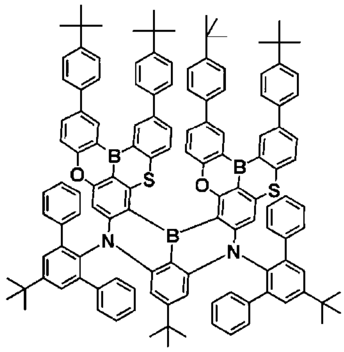

65

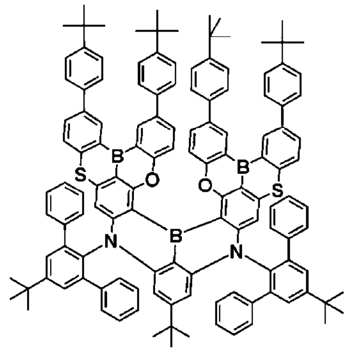

66

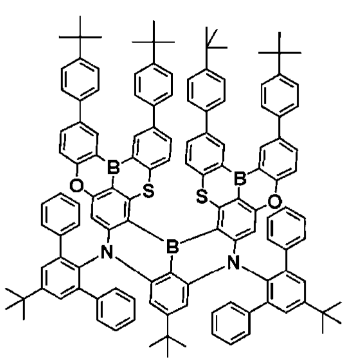

67

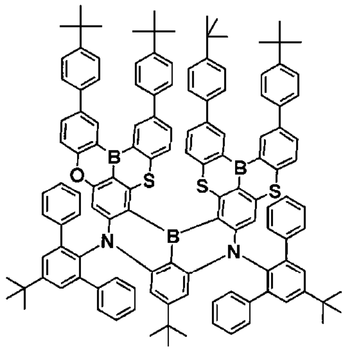

68

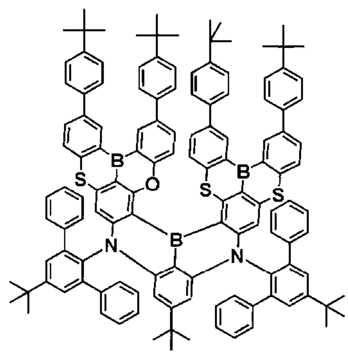

69

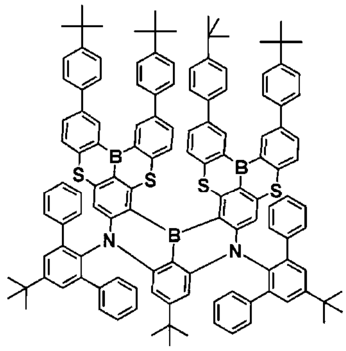

70

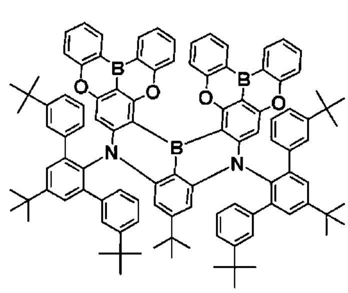

71

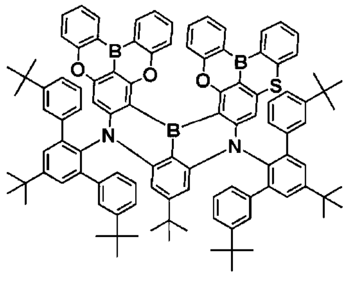

72

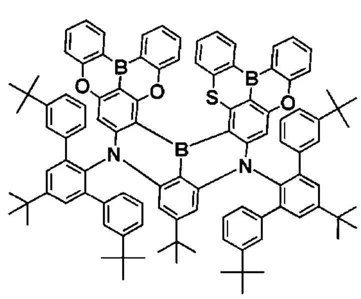

73

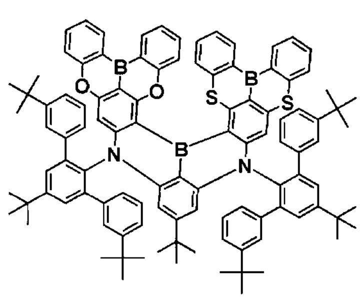

74

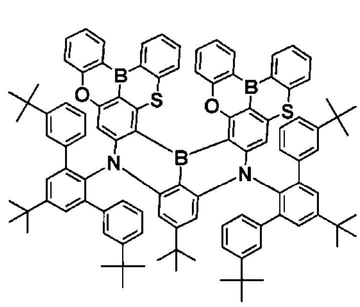

75

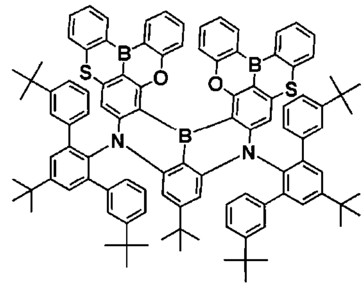
76

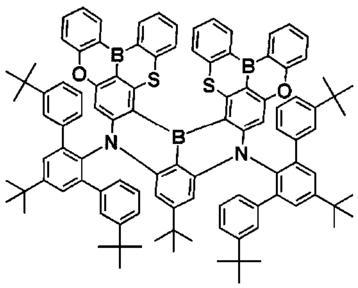
77

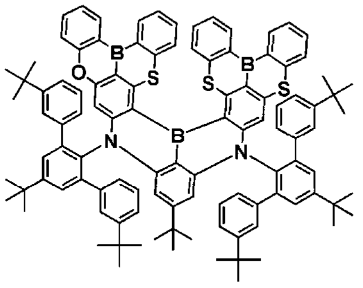
78

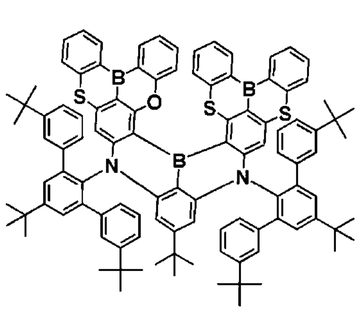
79

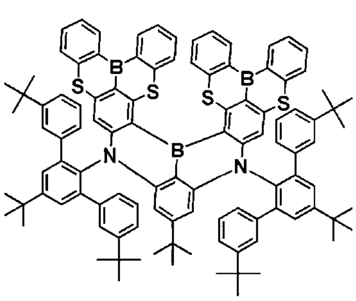
80

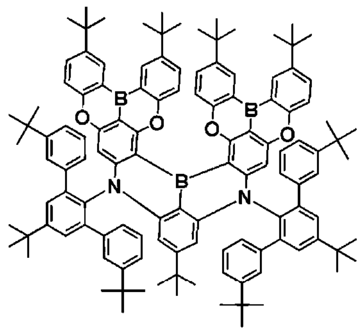
81

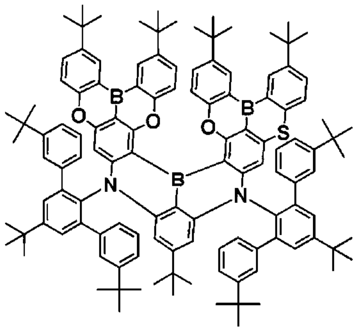
82

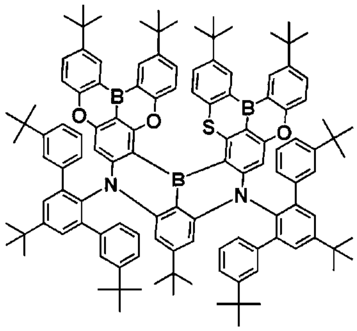
83

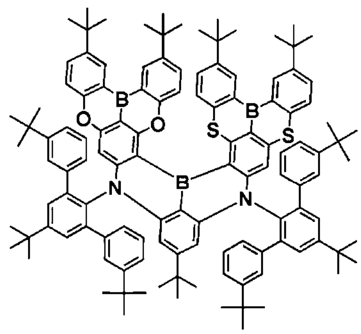
84

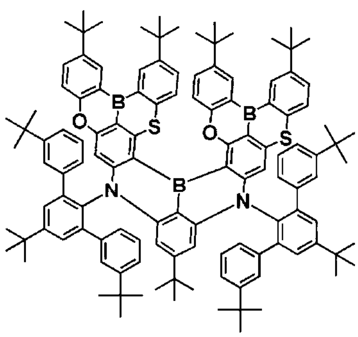
85

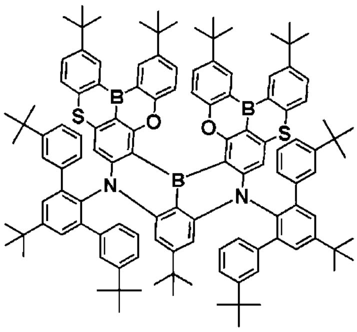
86

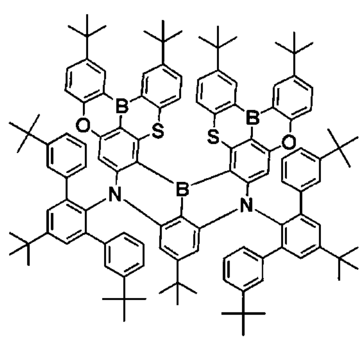
87

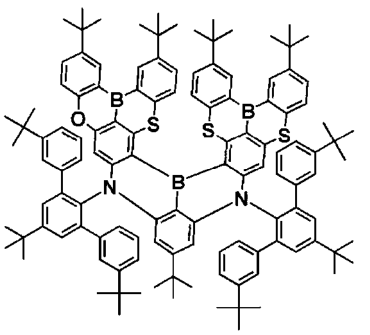

88

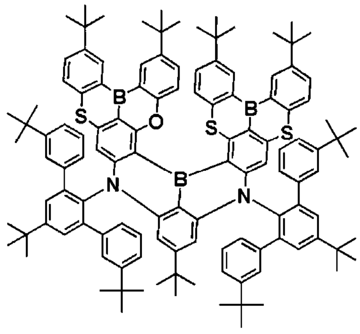

89

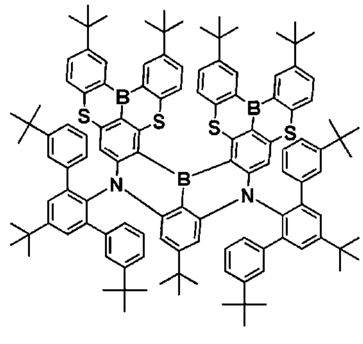

90

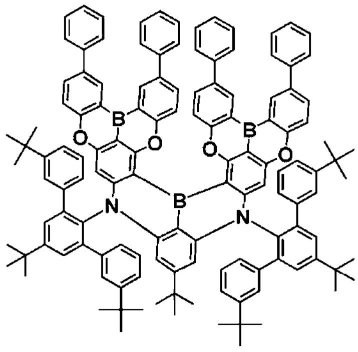

91

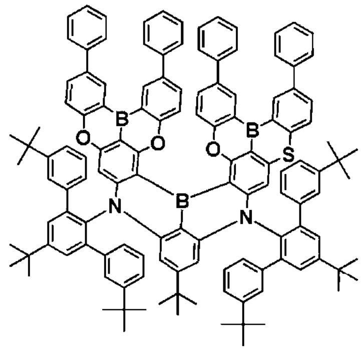

92

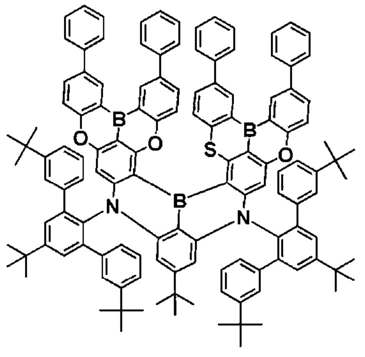

93

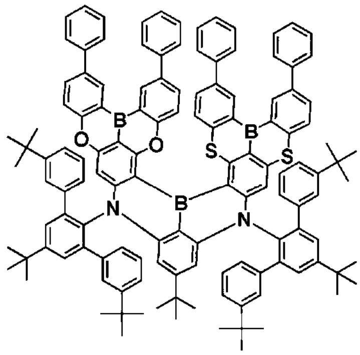

94

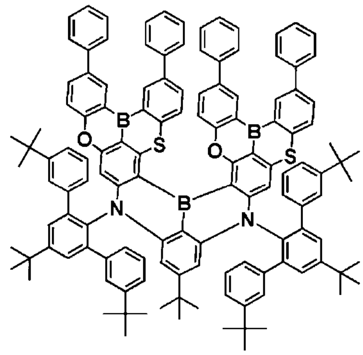

95

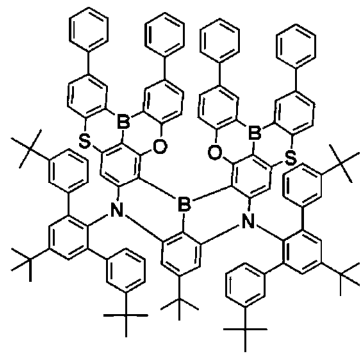

96

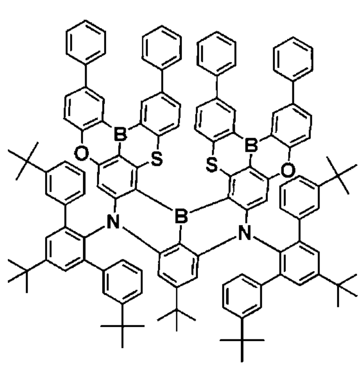

97

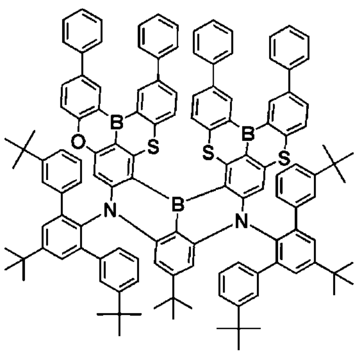

98

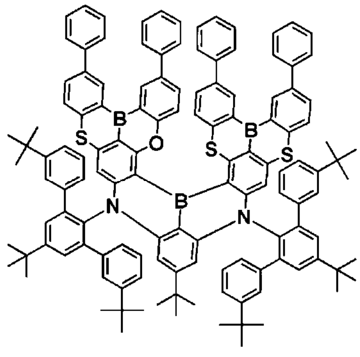

99

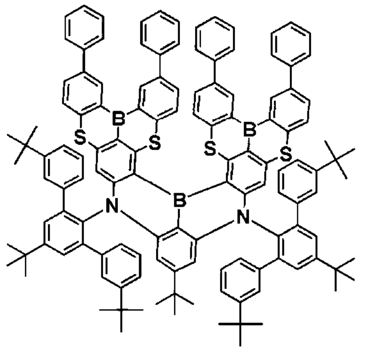

**100**

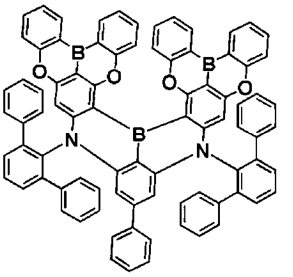

**101**

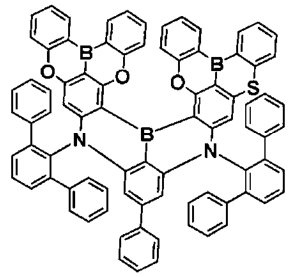

**102**

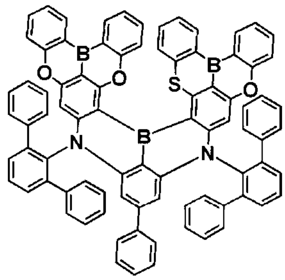

**103**

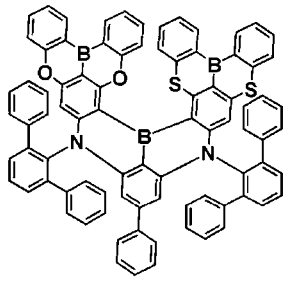

**104**

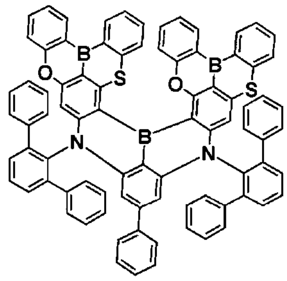

**105**

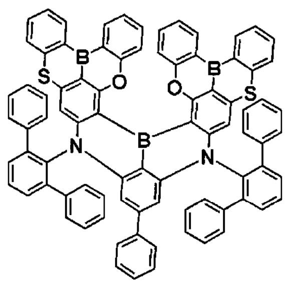

**106**

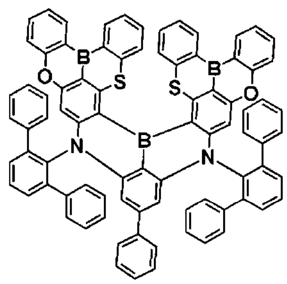

**107**

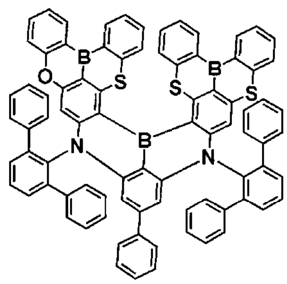

**108**

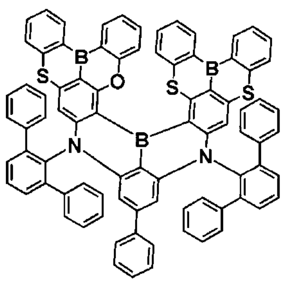

**109**

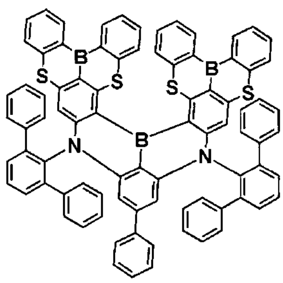

**110**

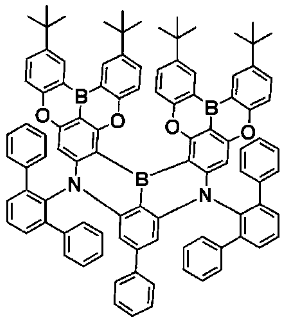

**111**

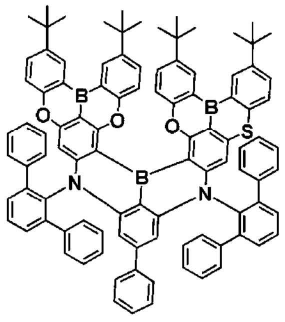

**112**

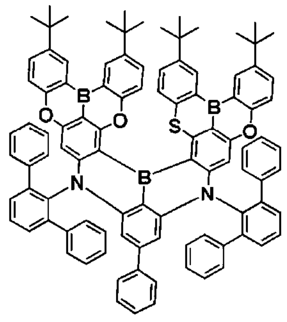

**113**

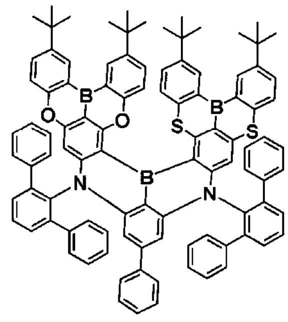

**114**

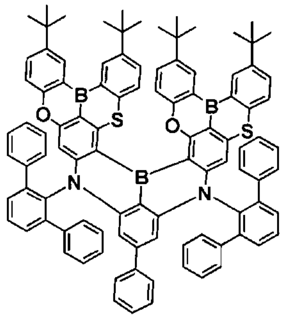

**115**

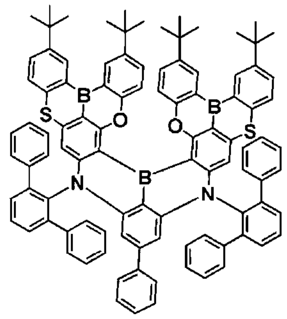

**116**

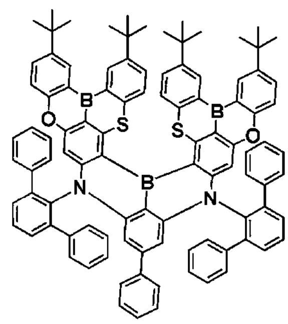

**117**

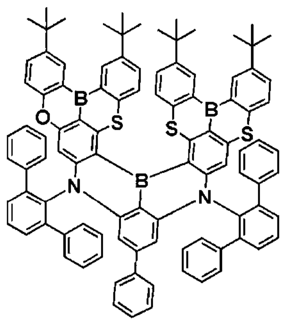

**118**

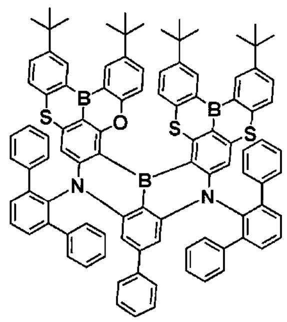

**119**

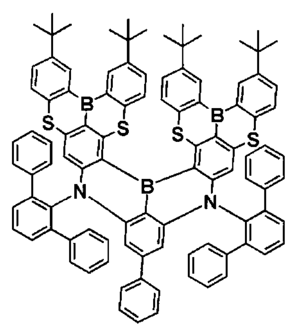

**120**

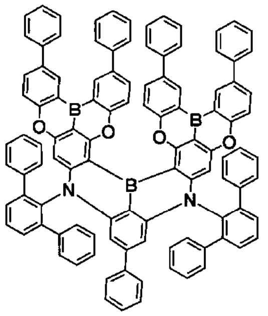

**121**

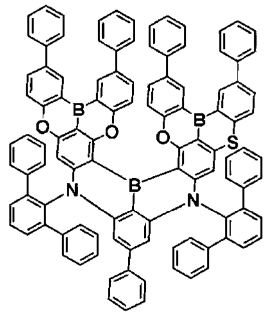

**122**

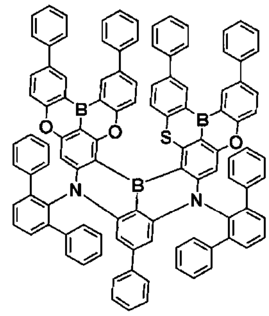

**123**

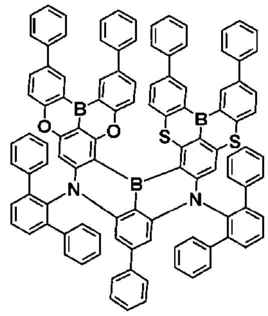

**124**

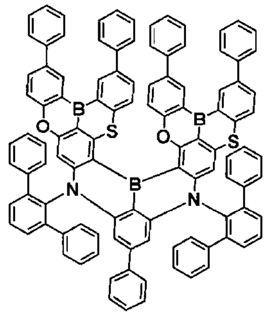

**125**

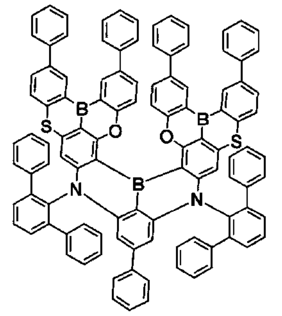

**126**

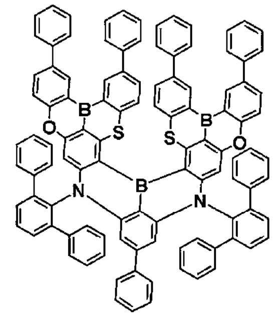

**127**

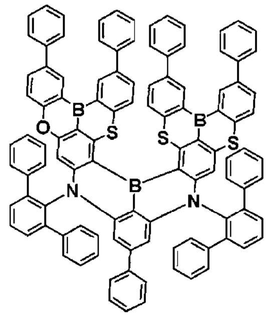

**128**

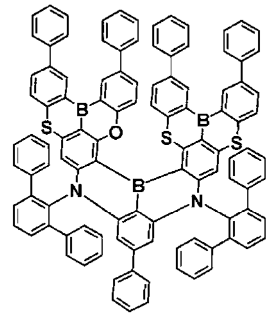

**129**

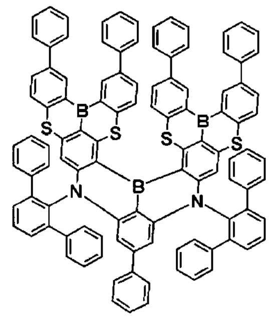

**130**

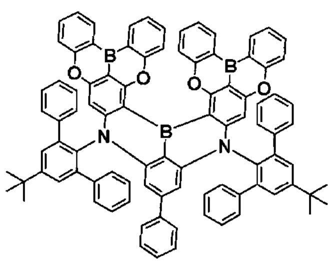

**131**

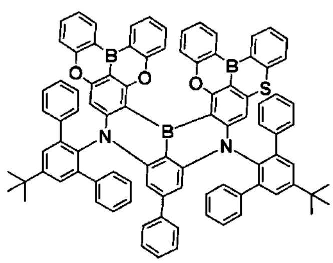

**132**

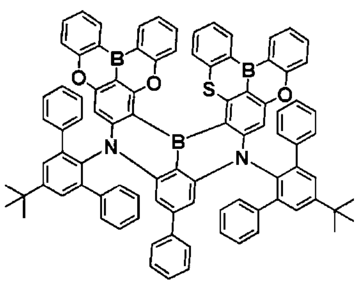

**133**

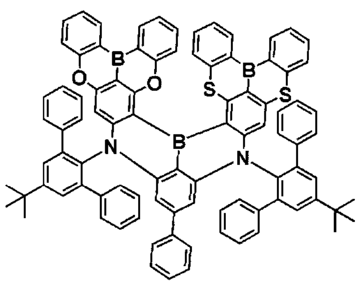

**134**

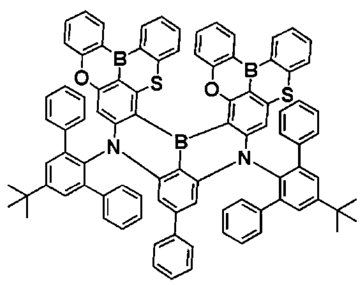

**135**

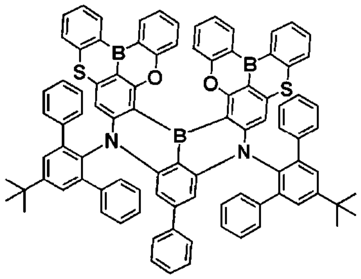

**136**

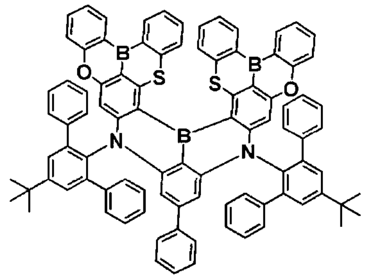

**137**

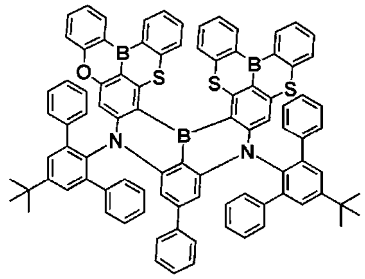

**138**

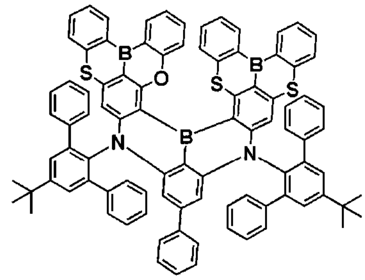

**139**

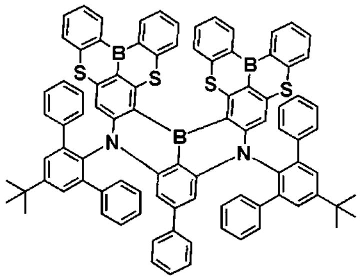

**140**

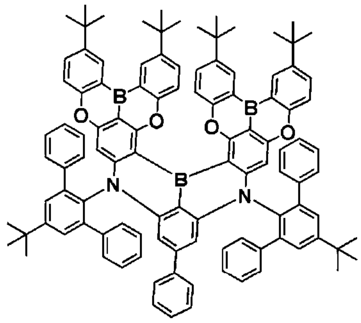

**141**

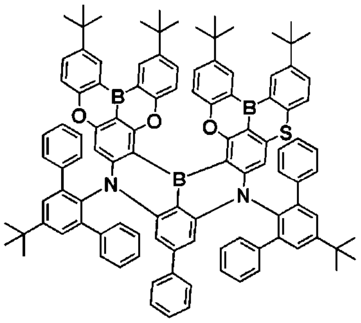

**142**

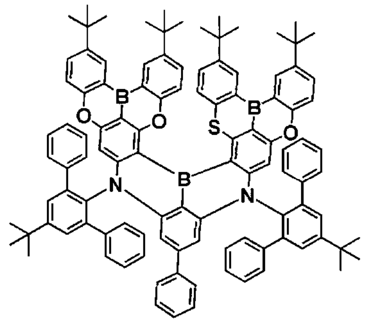

**143**

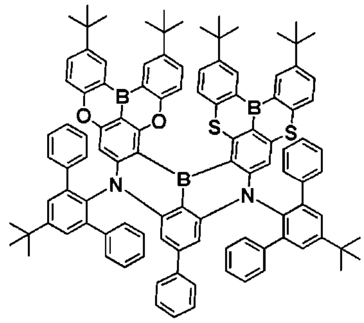

**144**

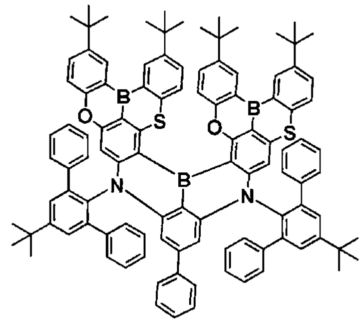

**145**

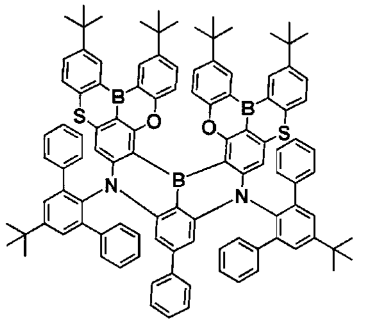

**146**

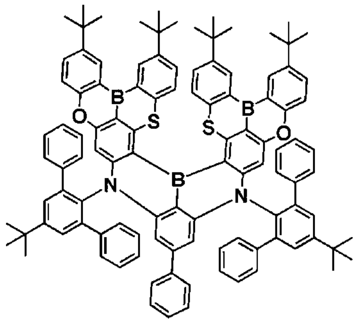

**147**

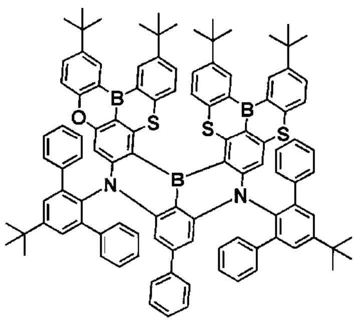

**148**

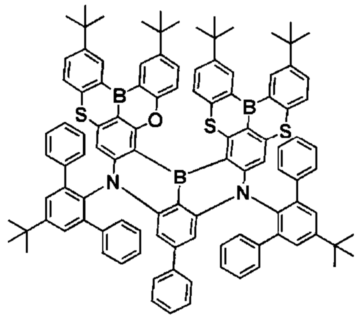

**149**

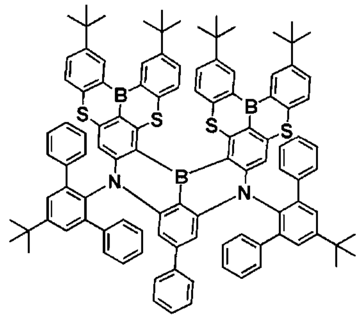

**150**

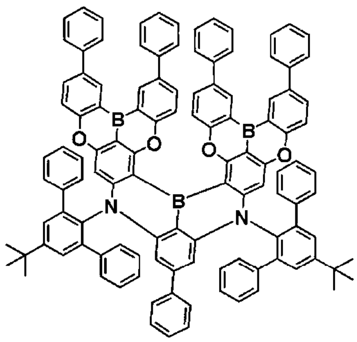

**151**

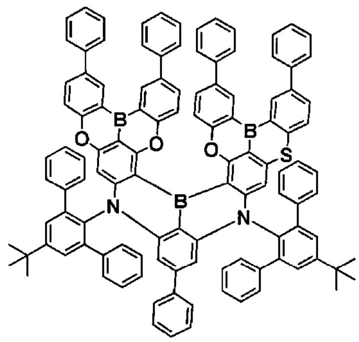

**152**

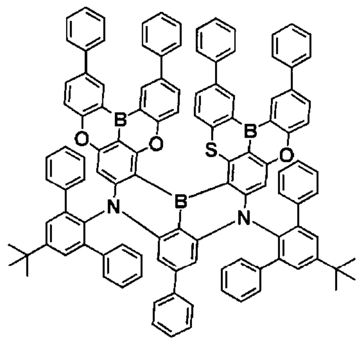

**153**

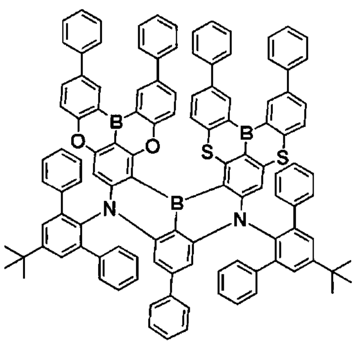

**154**

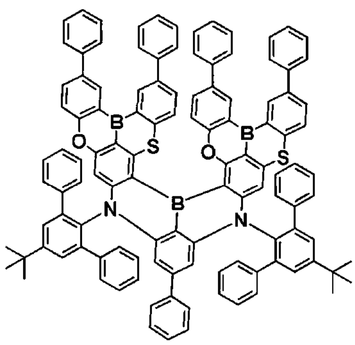

**155**

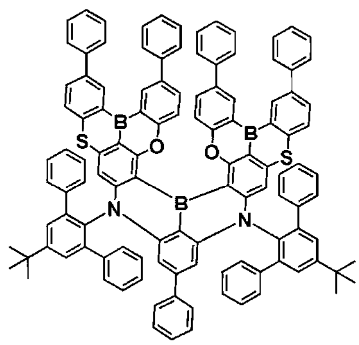

**156**

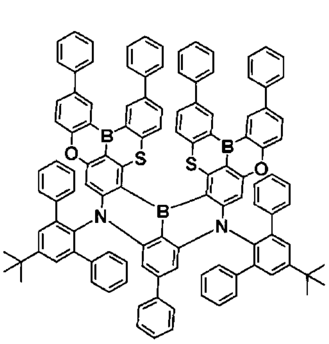

**157**

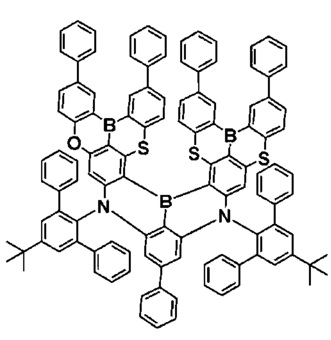

**158**

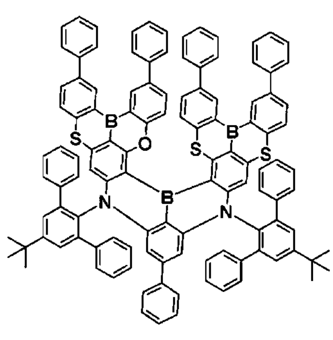

**159**

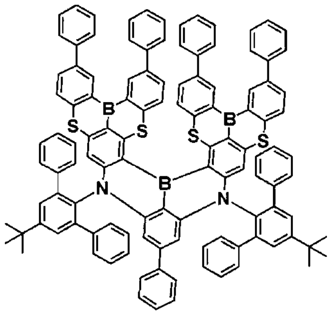

160

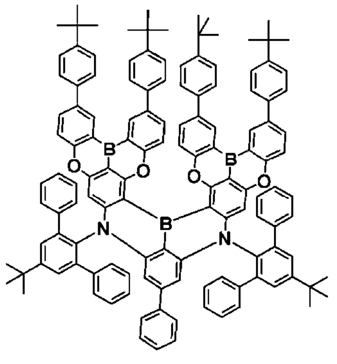

161

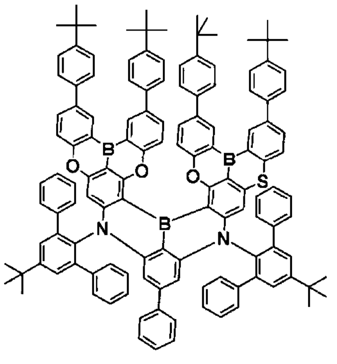

162

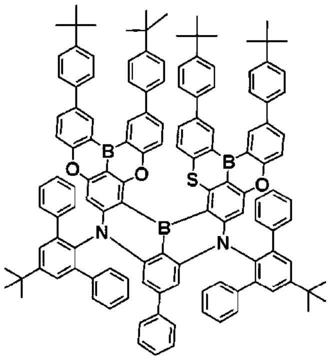

163

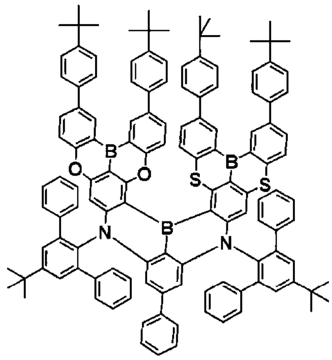

164

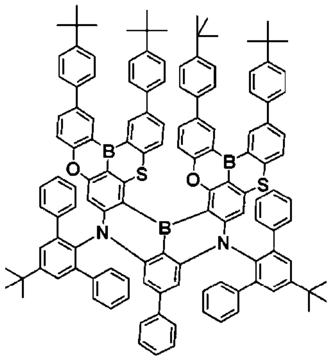

165

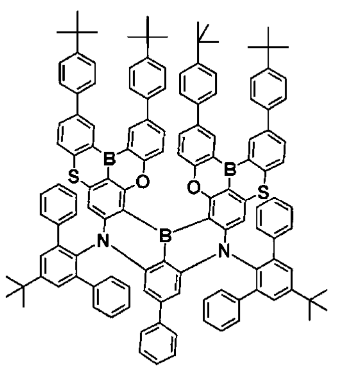

166

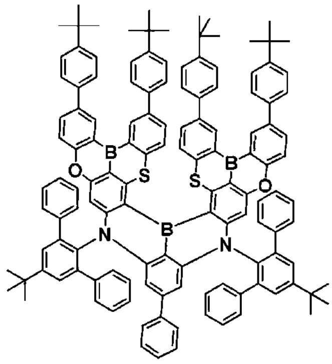

167

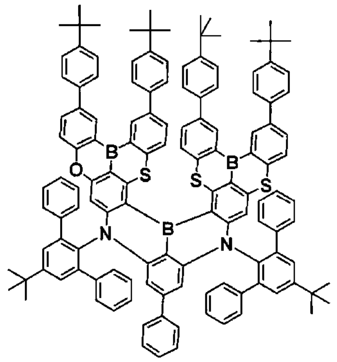

168

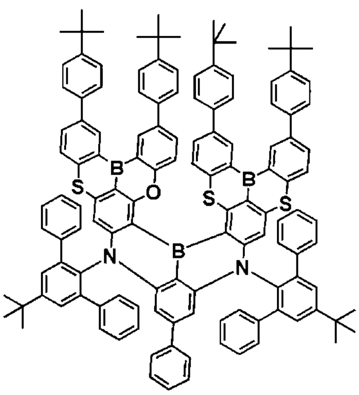

169

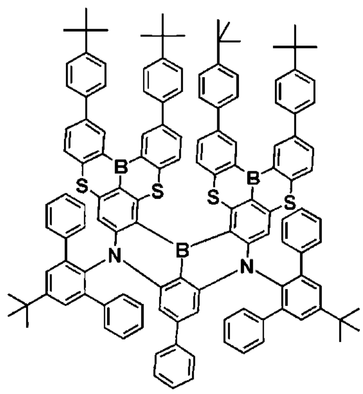

170

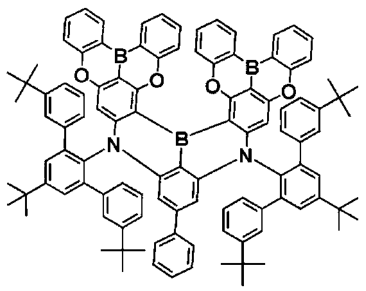

171

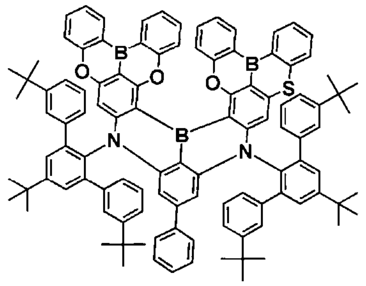

172

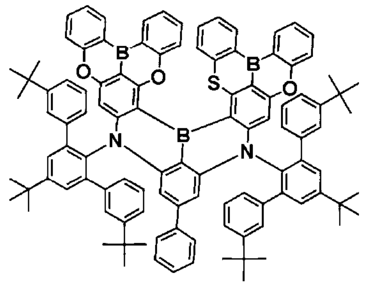

173

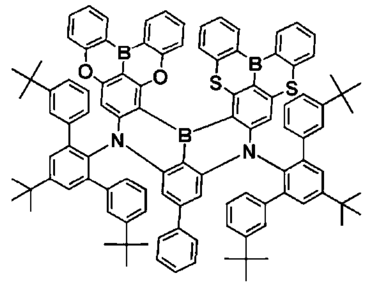

174

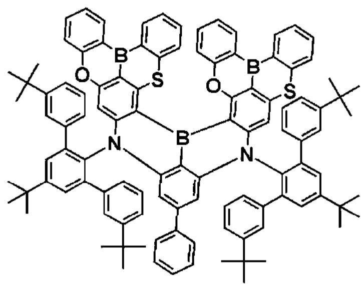

175

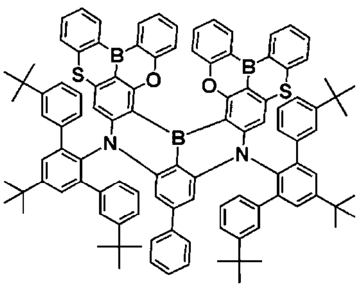

176

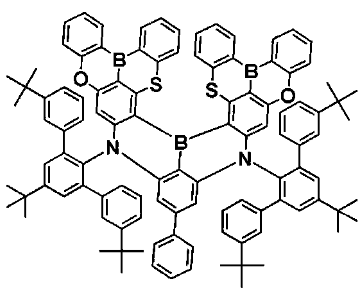

177

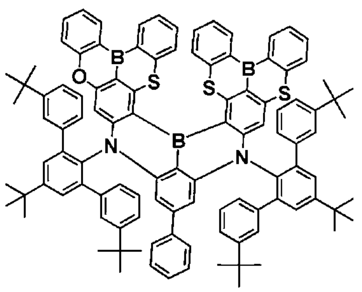

178

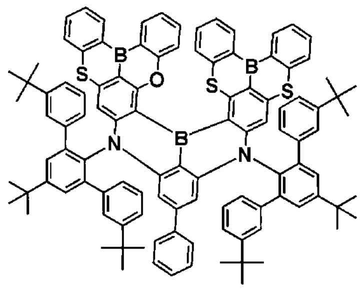

179

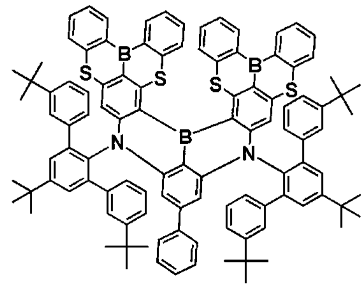

180

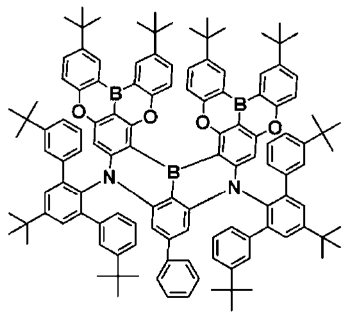

181

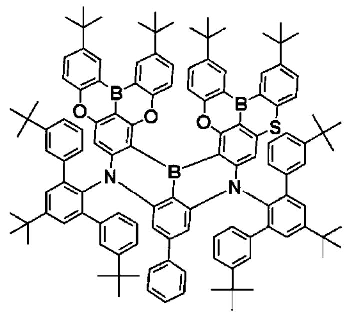

182

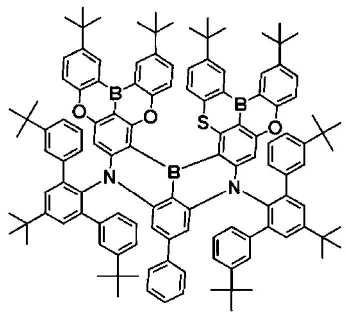

183

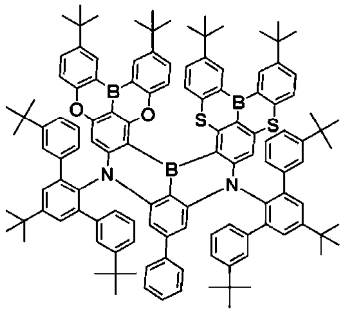

184

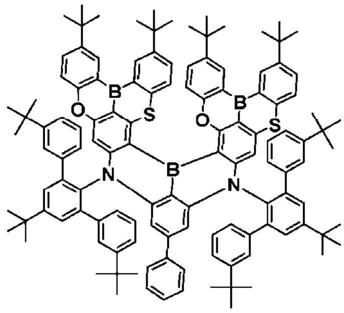

185

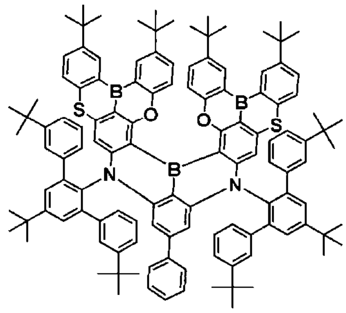

186

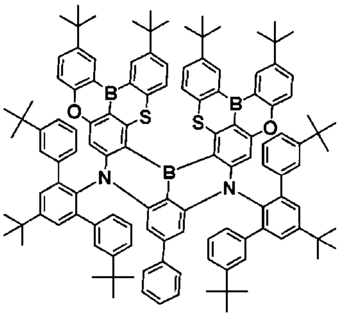

187

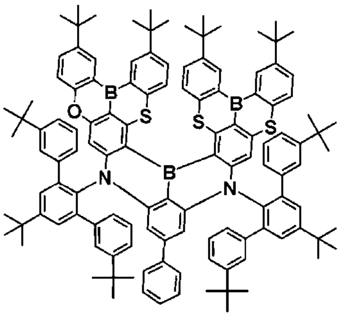

188

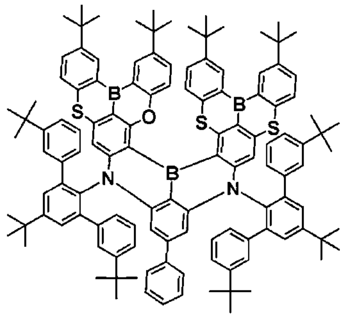

189

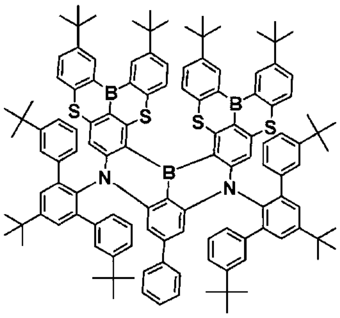

190

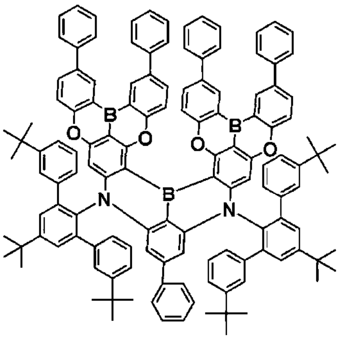

191

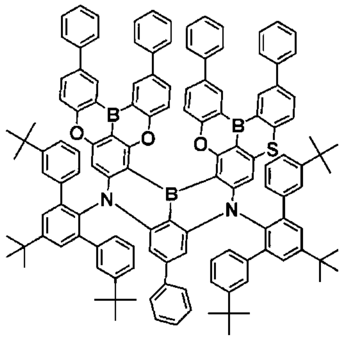

192

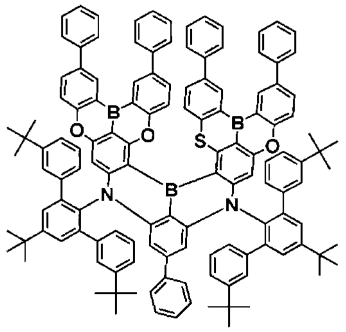

193

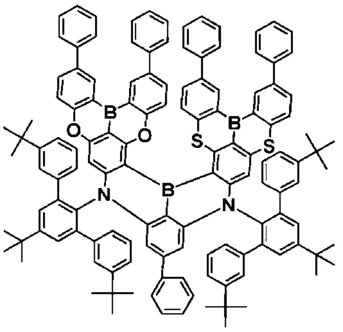

194

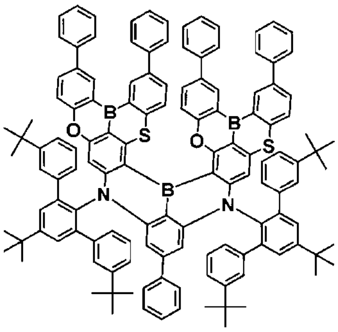

195

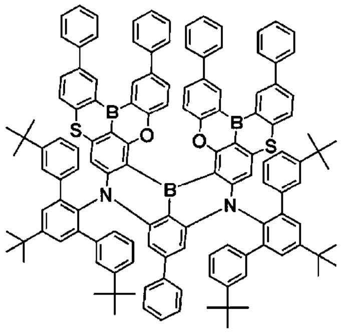

196

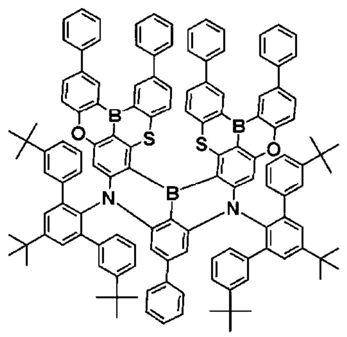

197

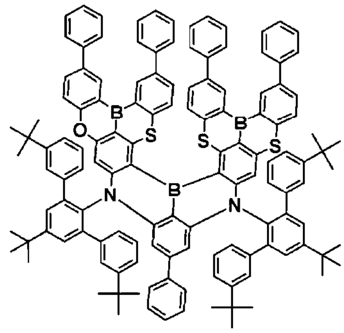

198

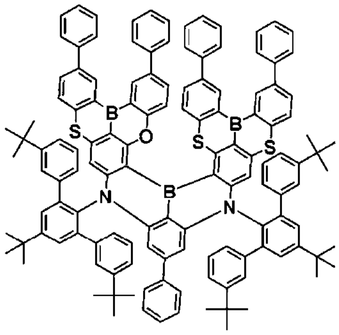

199

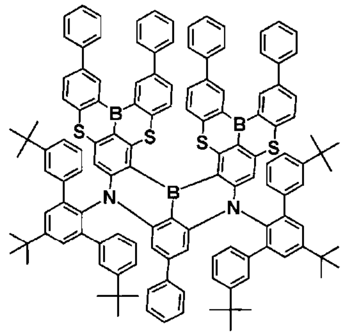

200

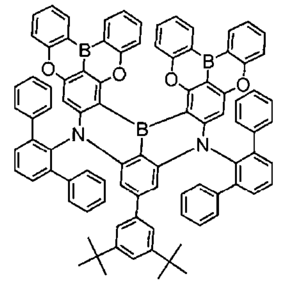

201

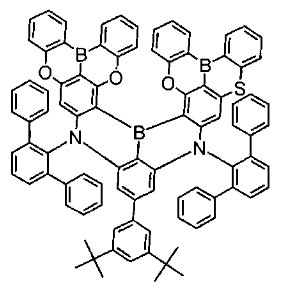

202

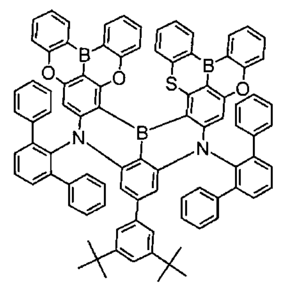

203

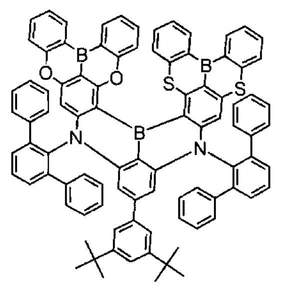

204

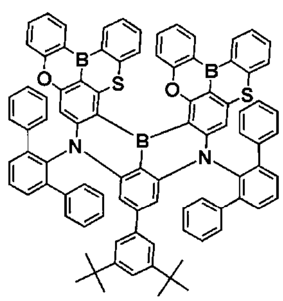

205

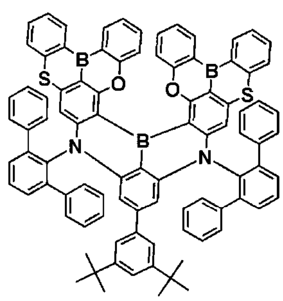

206

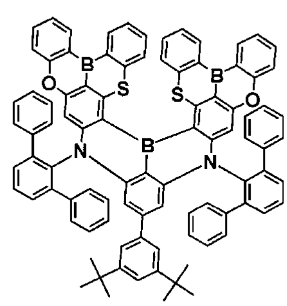

207

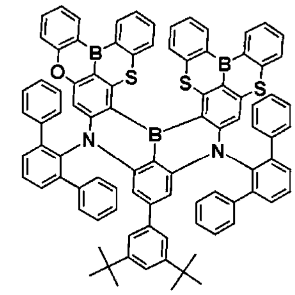

208

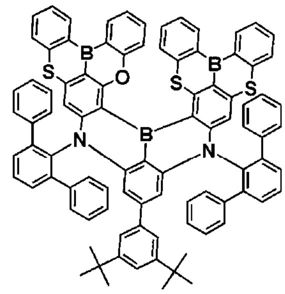

209

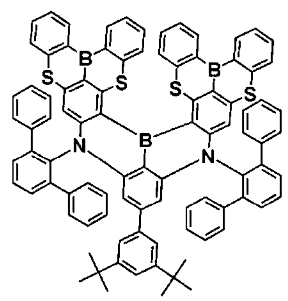

210

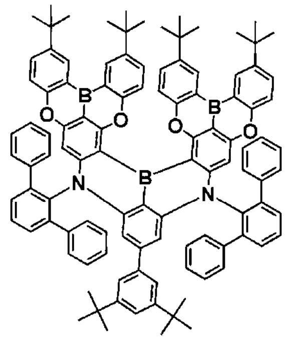

211

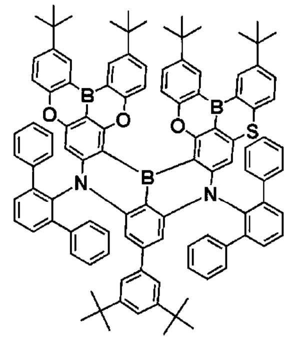

212

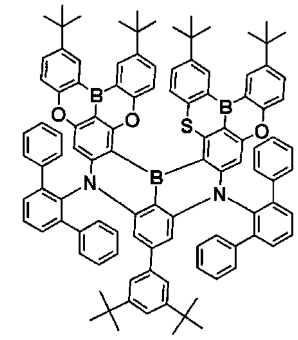

213

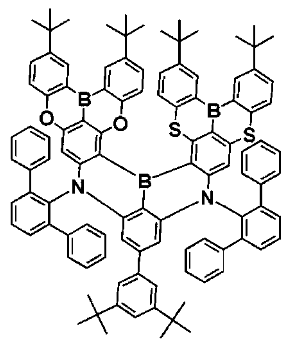

214

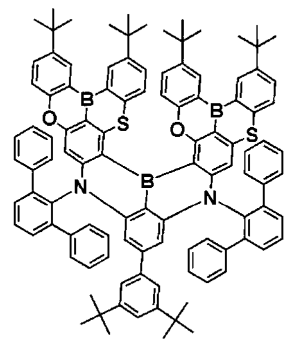

215

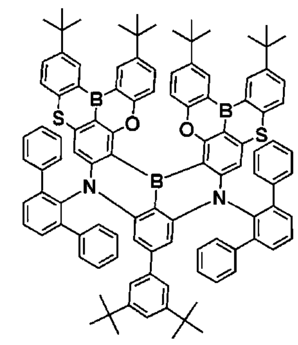

216

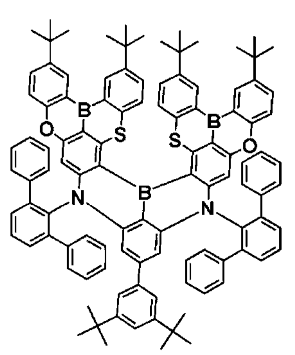

217

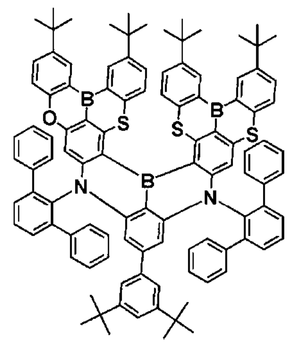

218

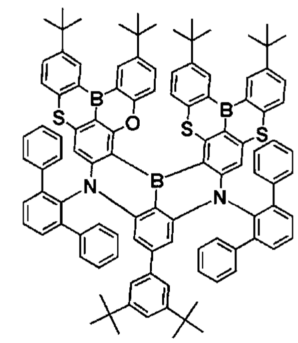

219

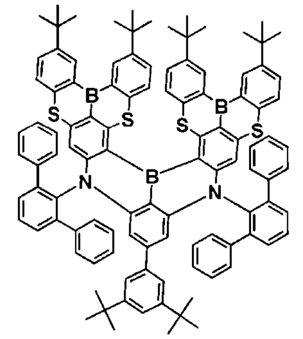

**220**

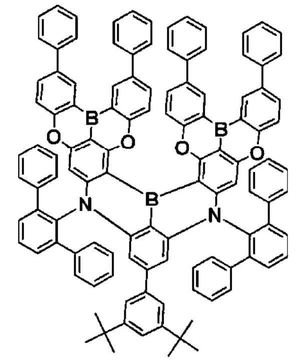

**221**

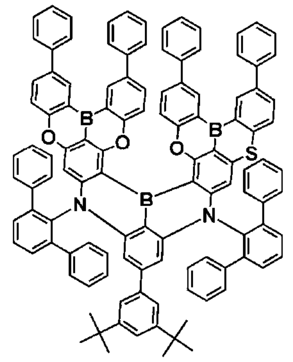

**222**

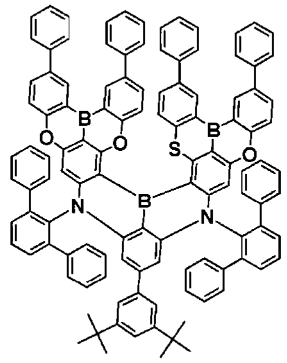

**223**

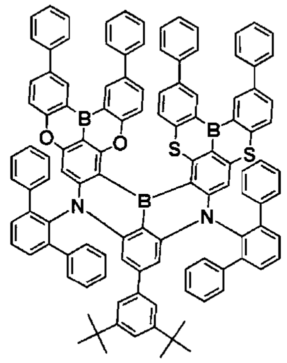

**224**

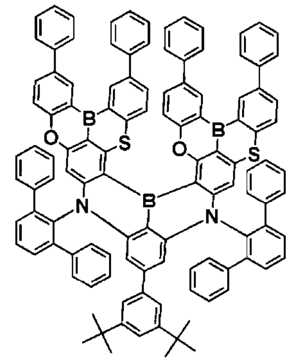

**225**

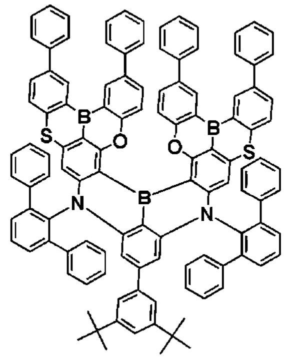

**226**

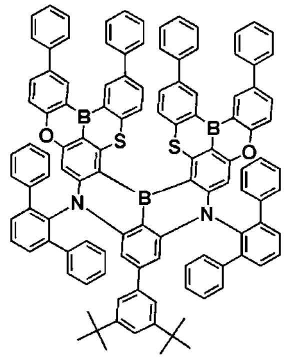

**227**

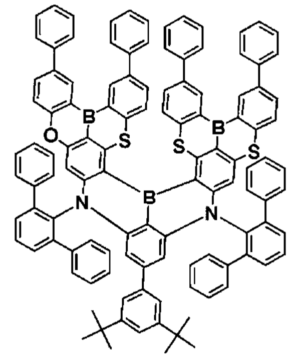

**228**

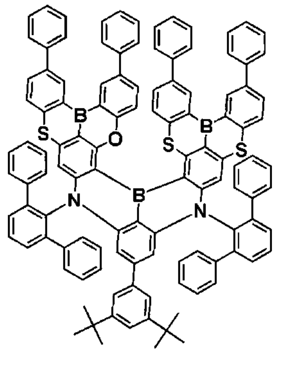

**229**

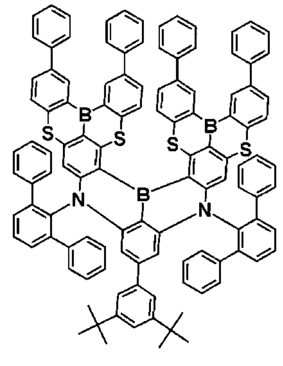

**230**

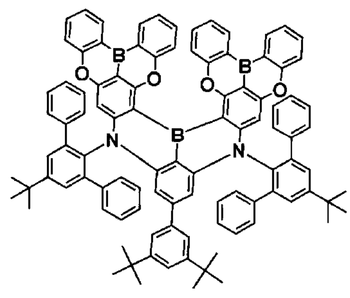

**231**

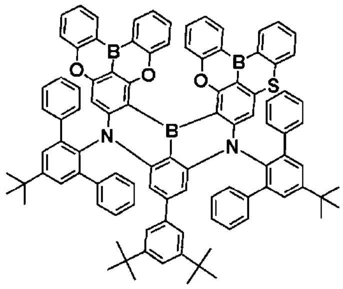

232

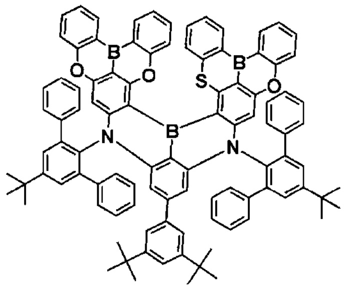

233

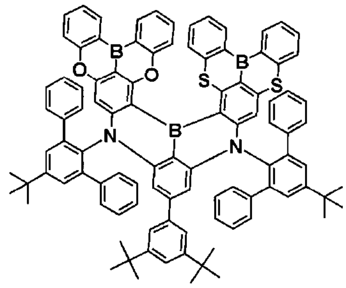

234

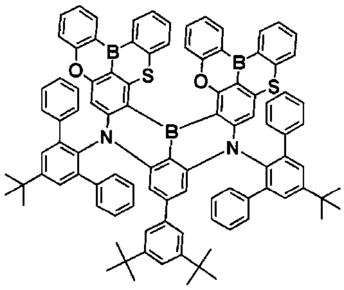

235

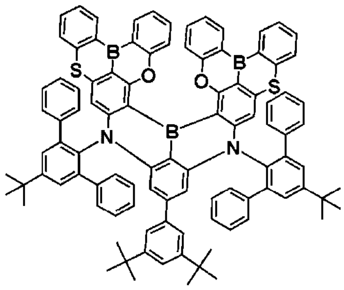

236

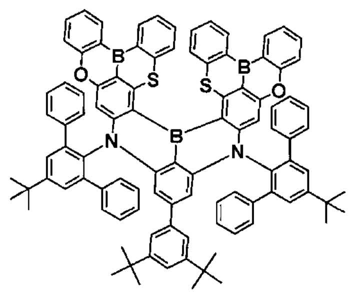

237

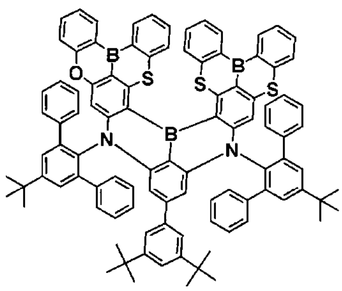

238

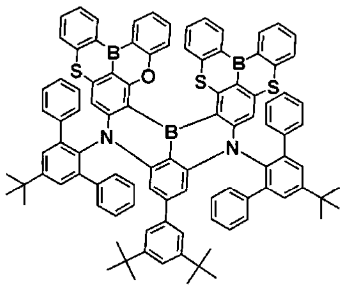

239

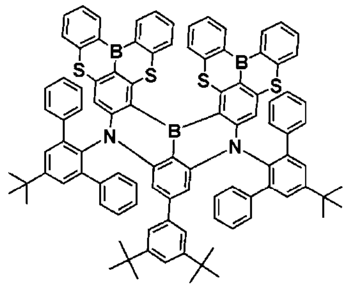

240

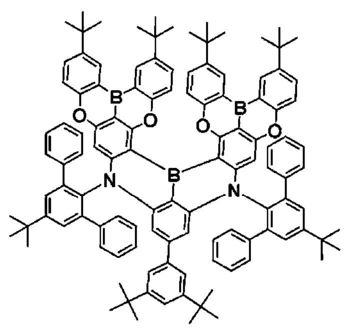

241

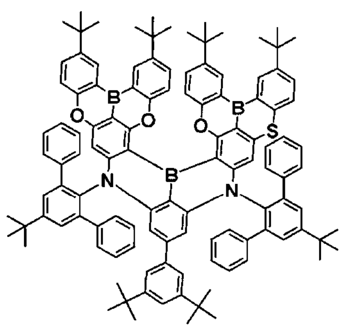

242

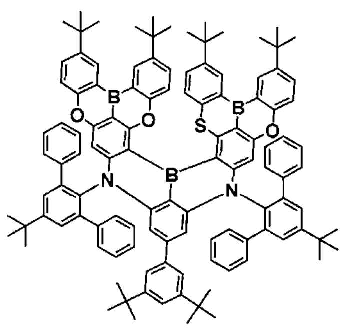

243

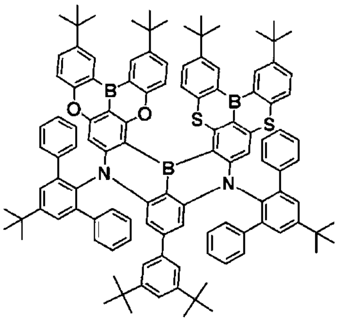

244

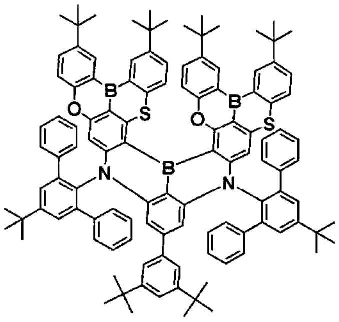

245

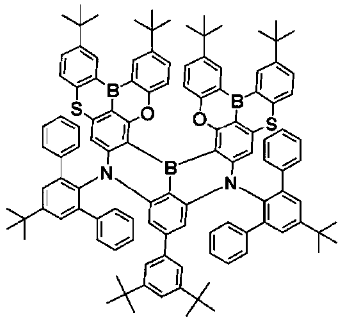

246

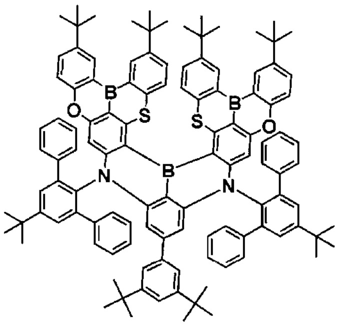

247

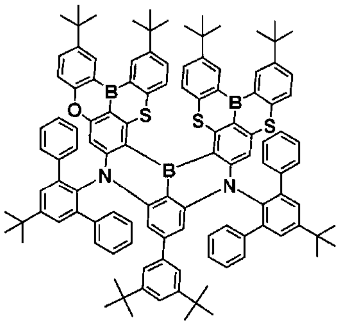

248

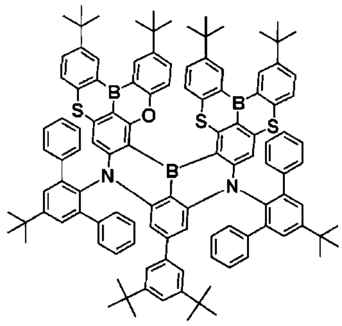

249

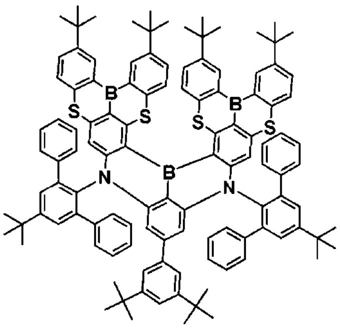

250

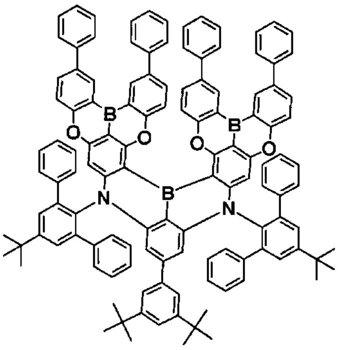

251

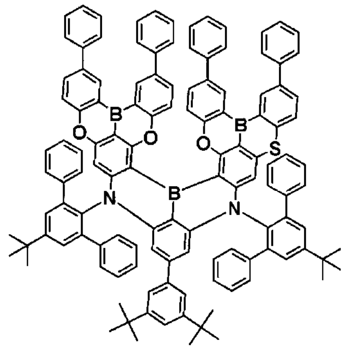

252

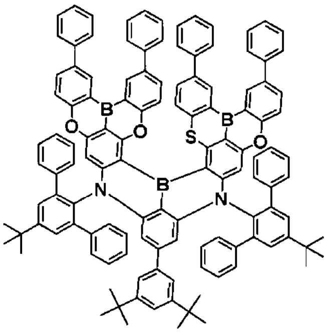

253

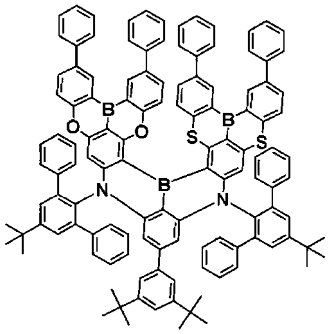

254

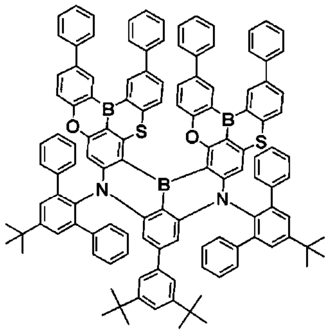

255

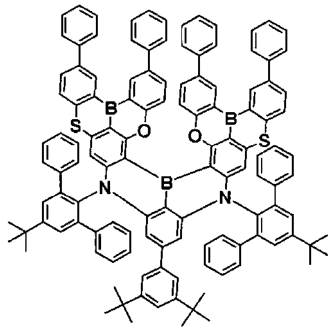

256

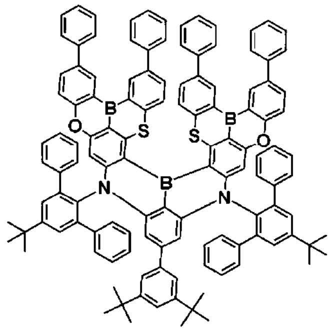

257

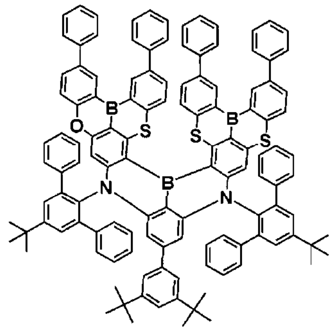

258

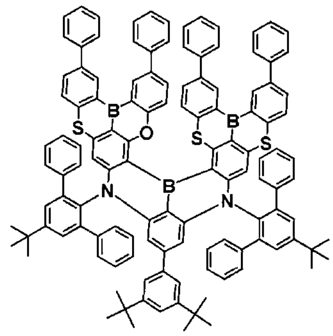

259

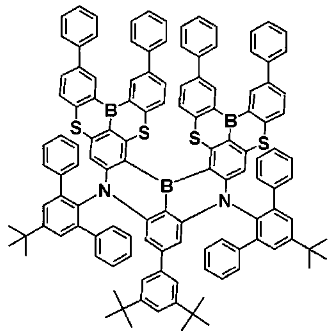

260

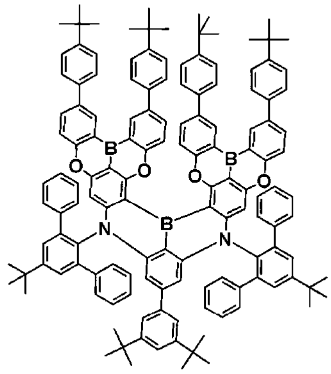

261

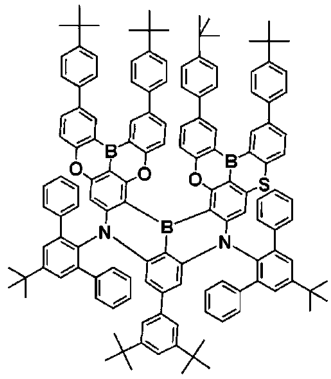

262

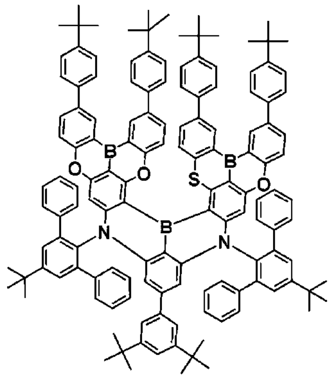

263

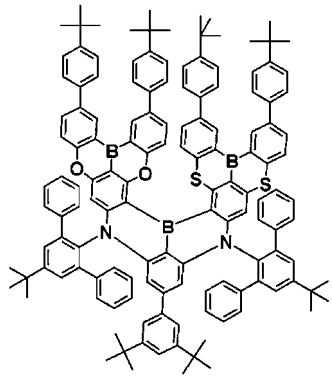

264

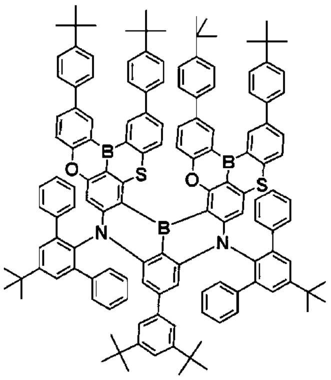

265

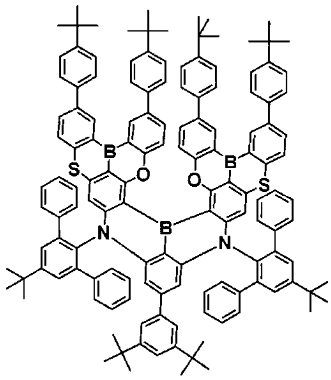

266

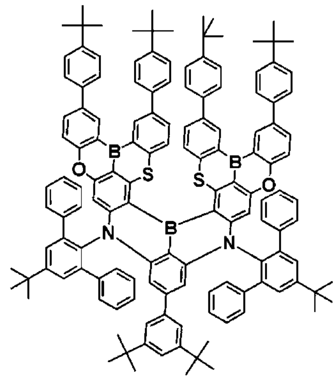

267

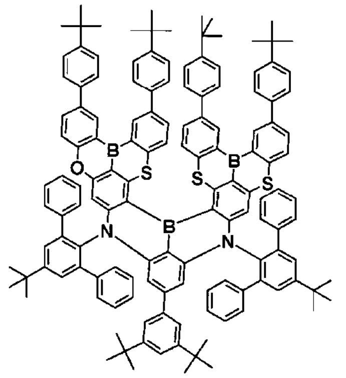

268

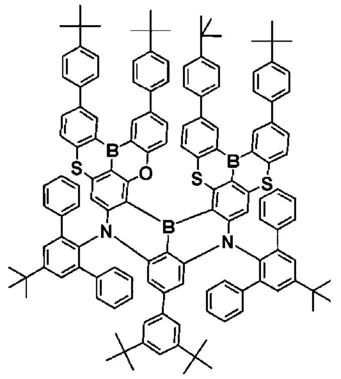

269

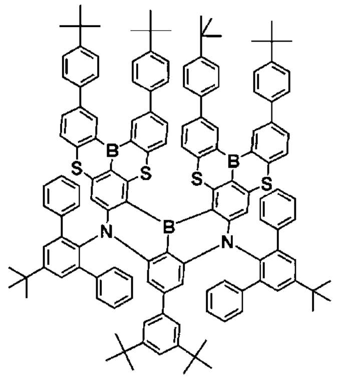

270

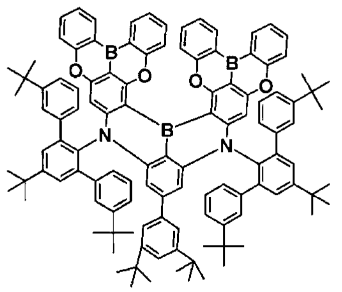

271

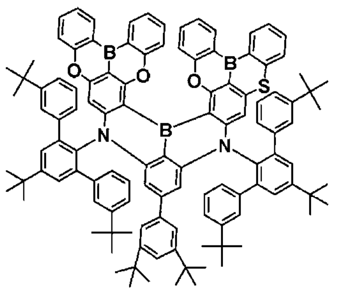

272

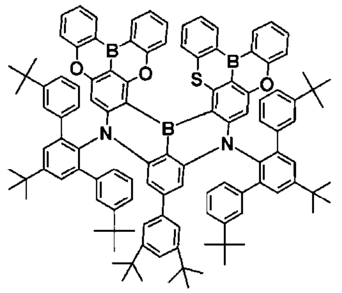

273

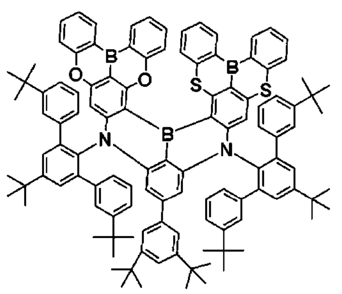

274

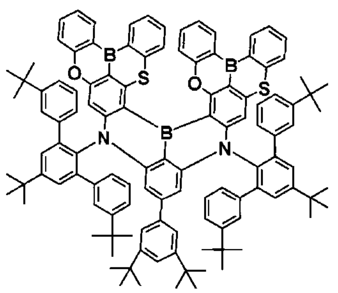

275

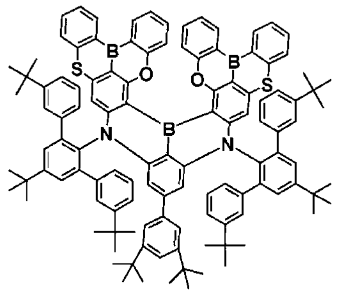

276

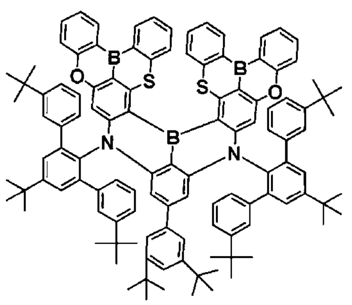

277

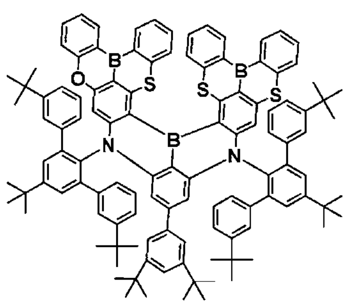

278

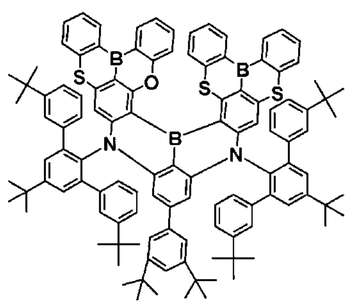

279

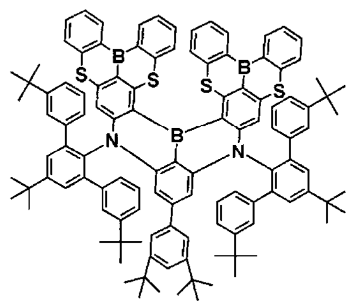

**280**

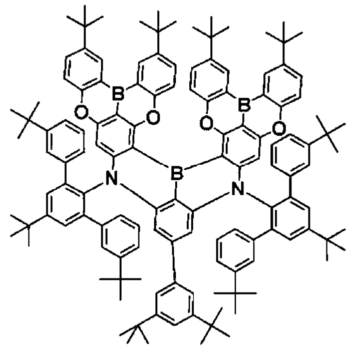

**281**

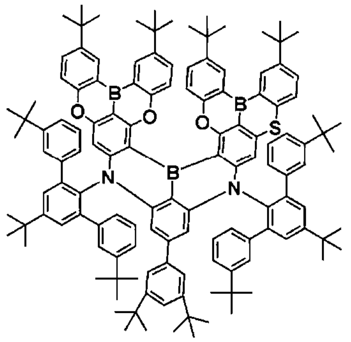

**282**

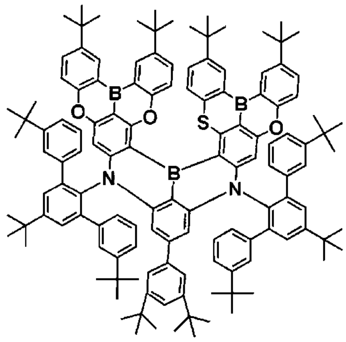

**283**

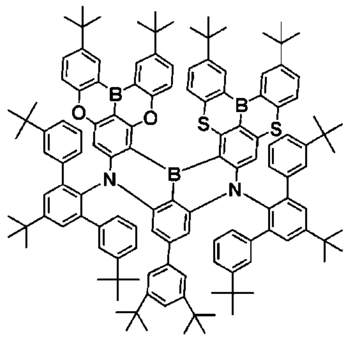

**284**

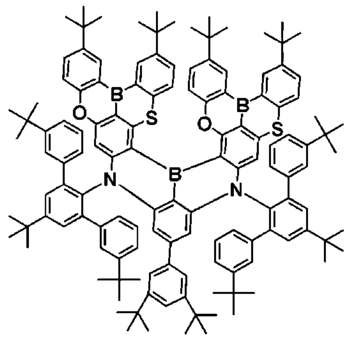

**285**

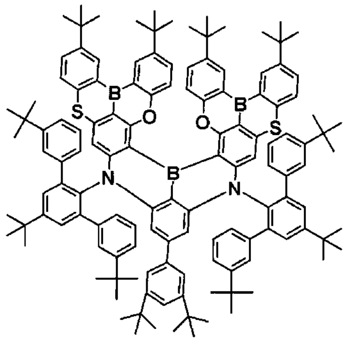

**286**

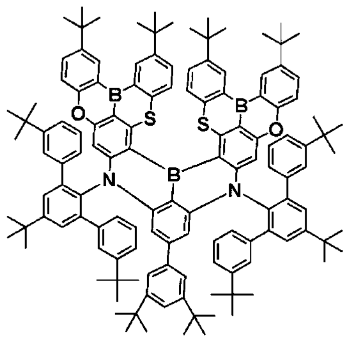

**287**

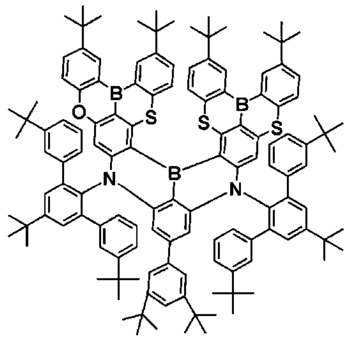

**288**

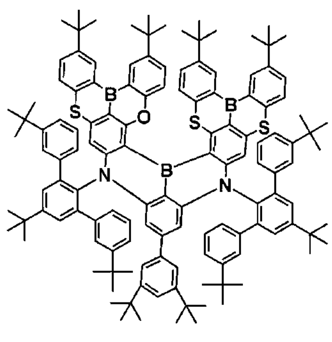

**289**

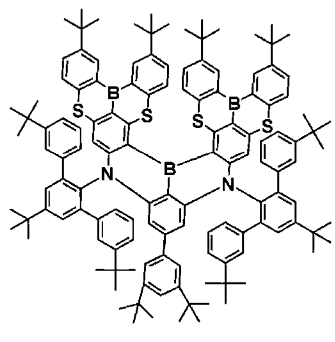

**290**

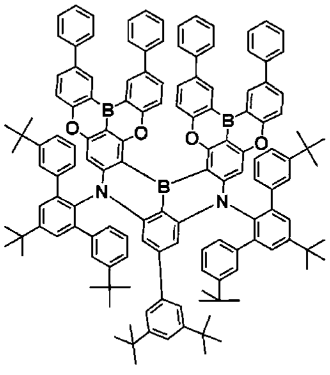

**291**

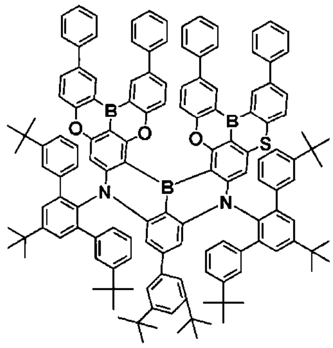

292

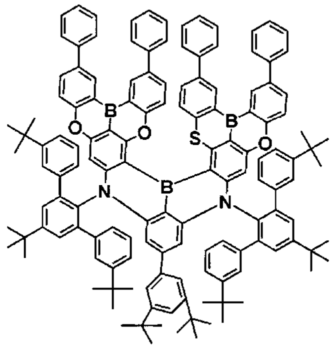

293

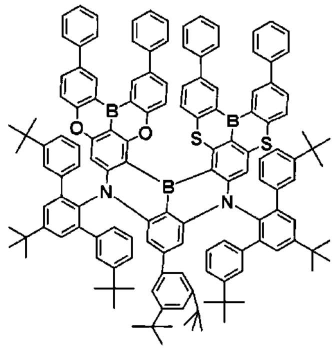

294

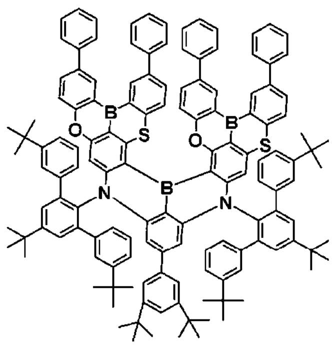

295

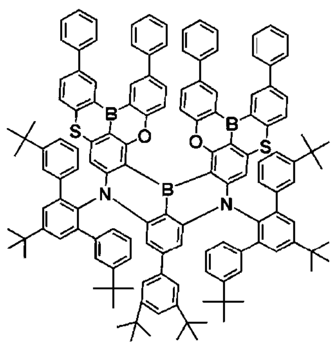

296

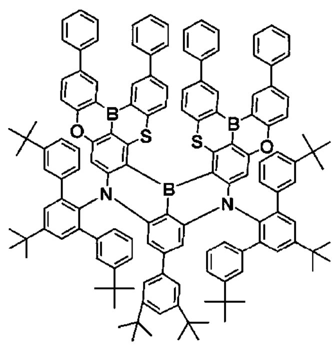

297

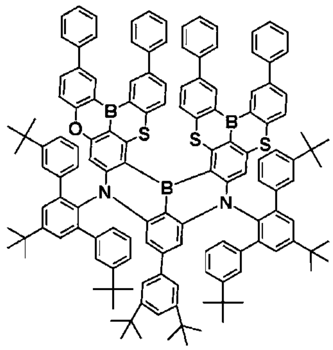

298

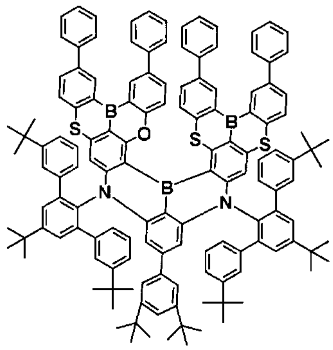

299

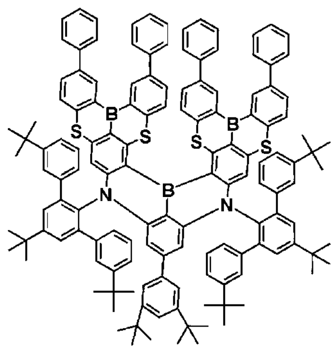

300

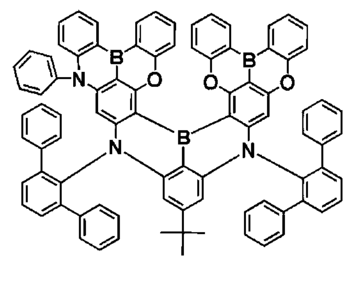

301

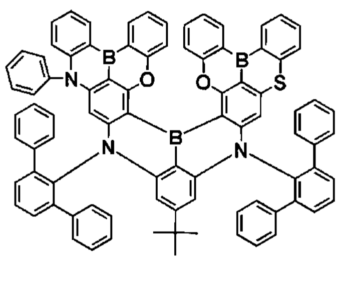

302

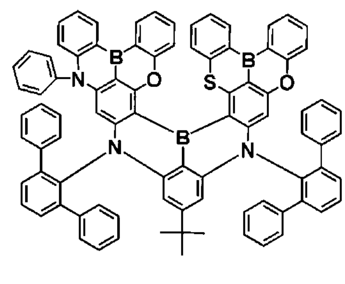

303

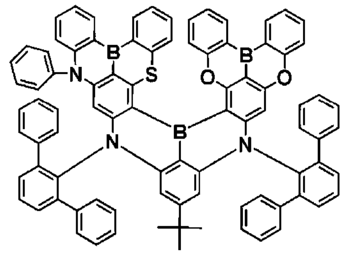

304

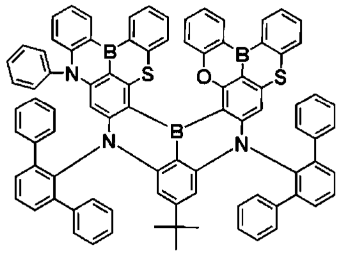

305

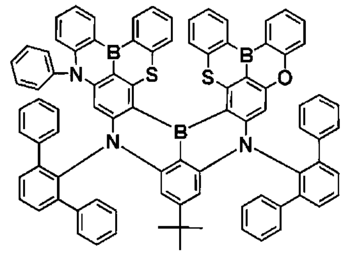

306

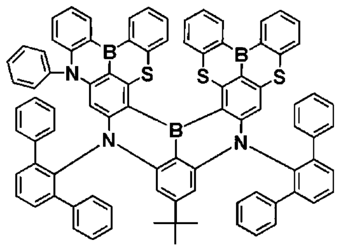

307

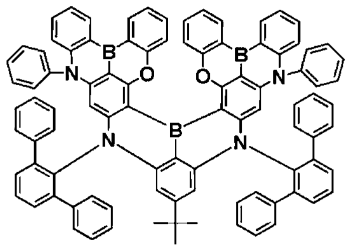

308

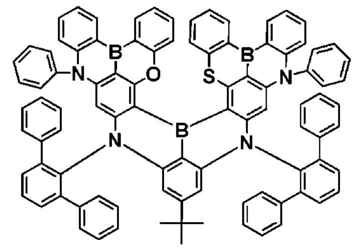

309

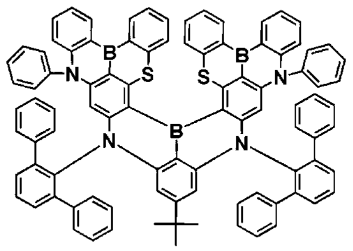

310

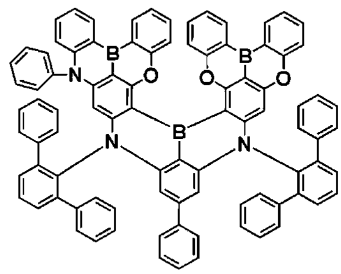

311

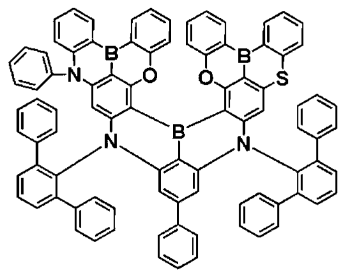

312

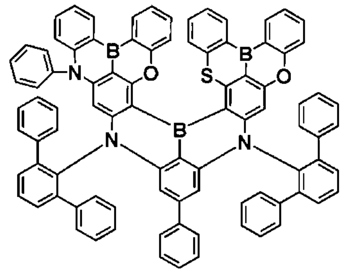

313

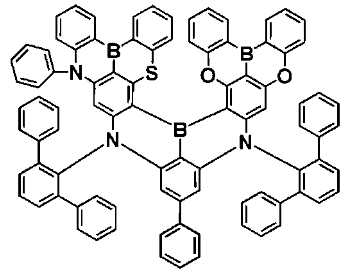

314

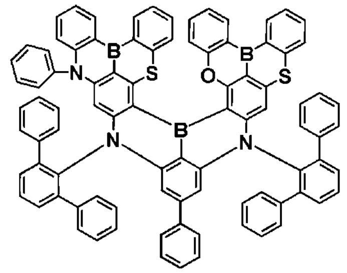

315

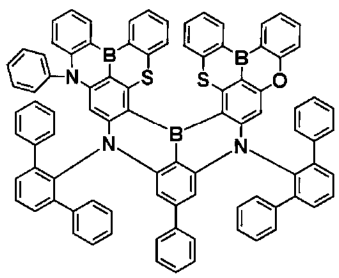

316

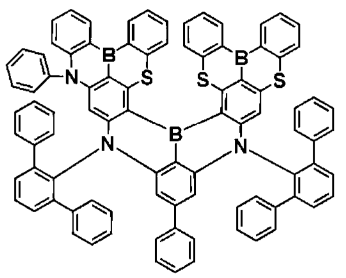

317

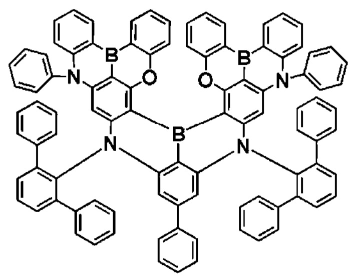

318

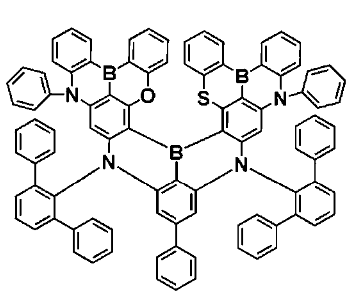
319

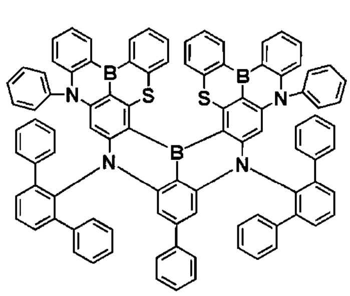
320

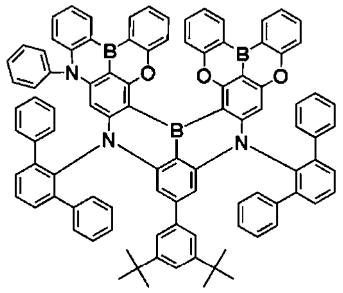
321

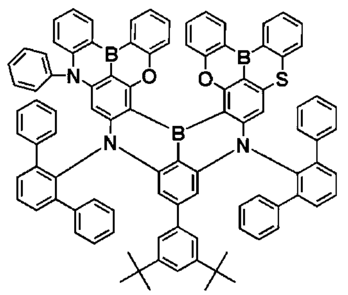
322

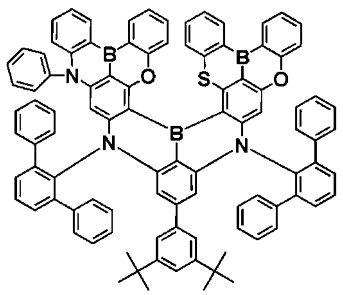
323

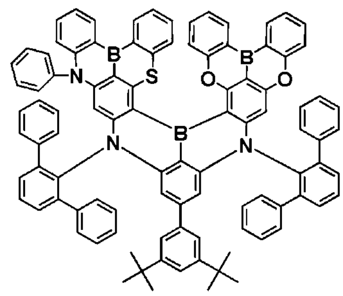
324

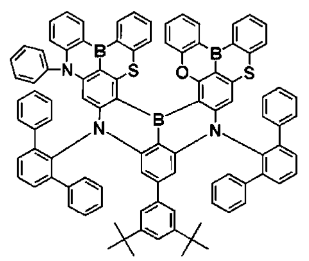
325

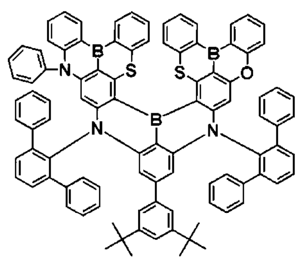
326

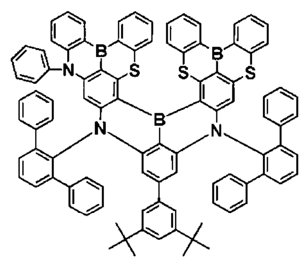
327

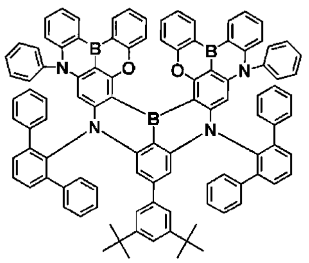
328

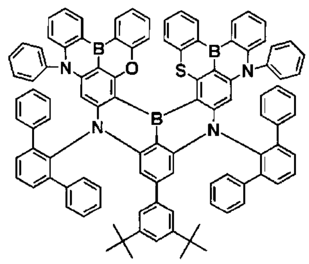
329

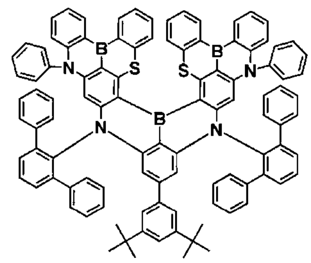
330

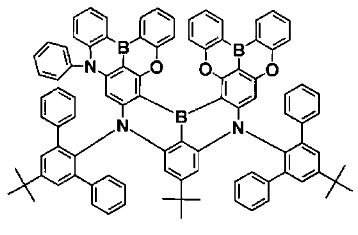
331

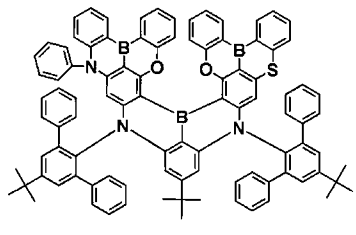
332

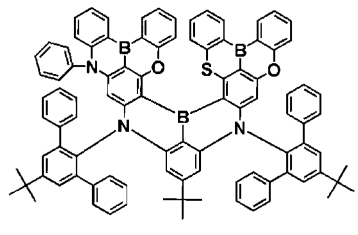
333

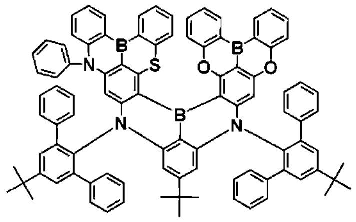

334

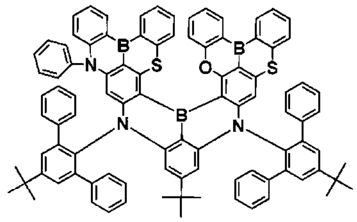

335

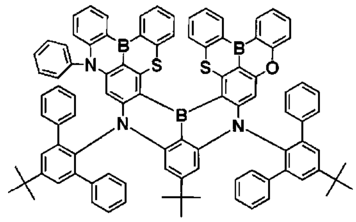

336

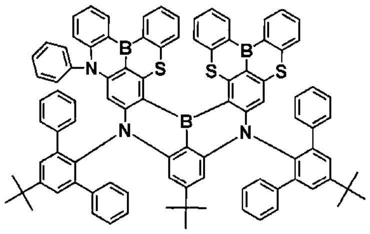

337

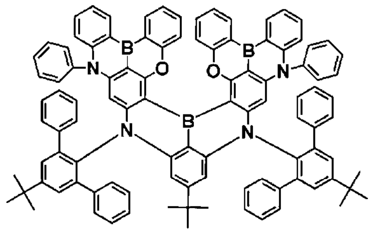

338

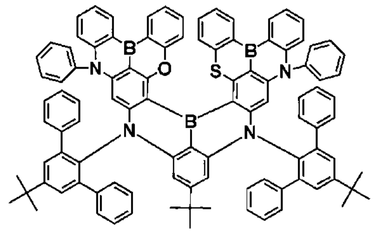

339

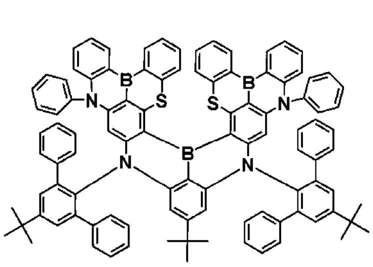

340

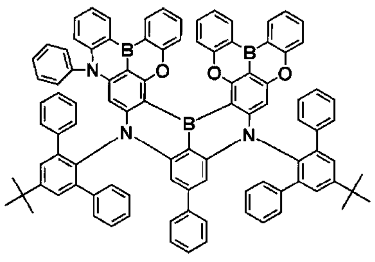

341

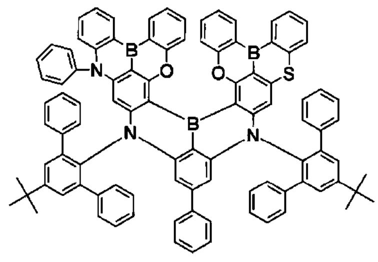

342

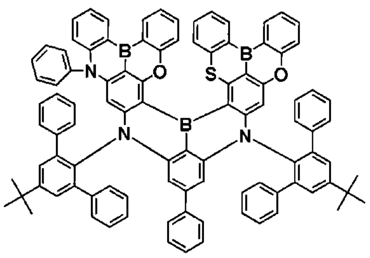

343

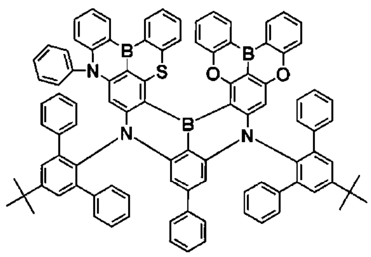

344

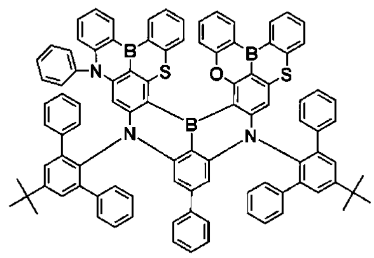

345

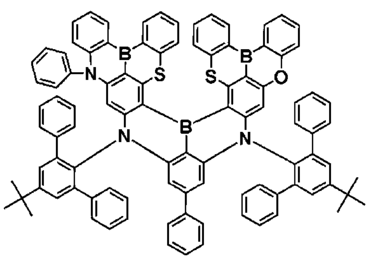

346

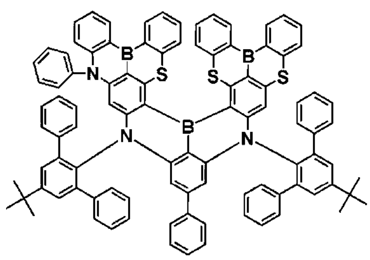

347

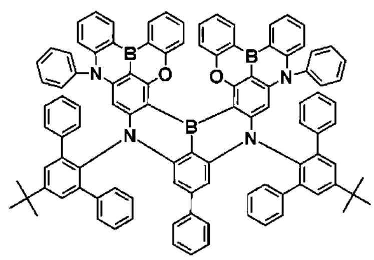

348

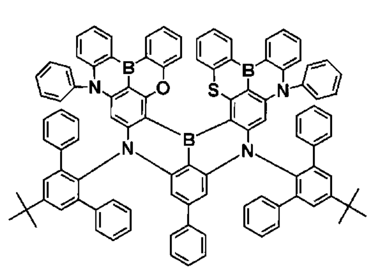

**349**

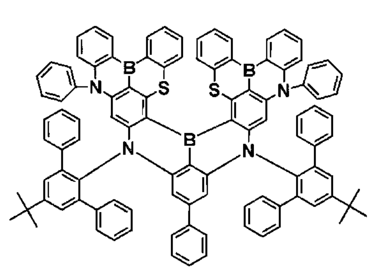

**350**

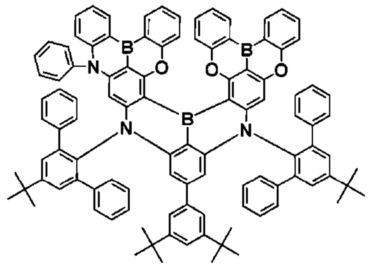

**351**

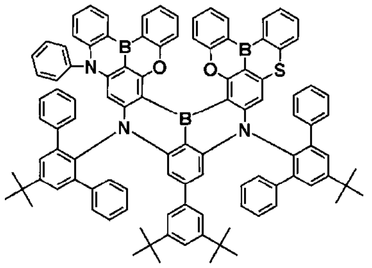

**352**

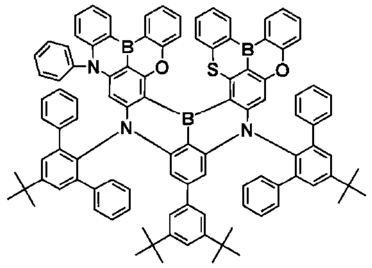

**353**

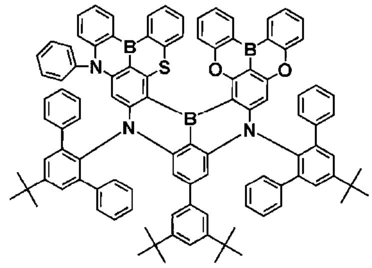

**354**

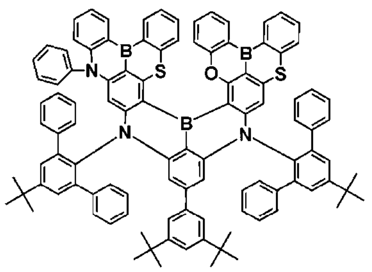

**355**

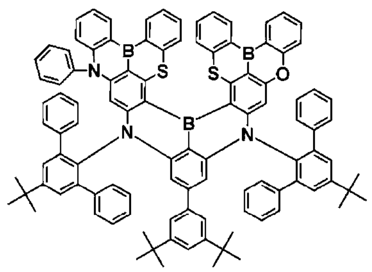

**356**

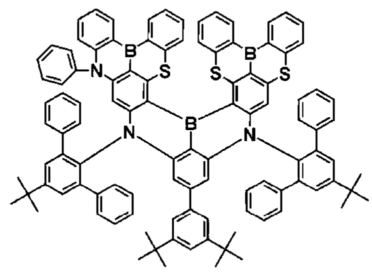

**357**

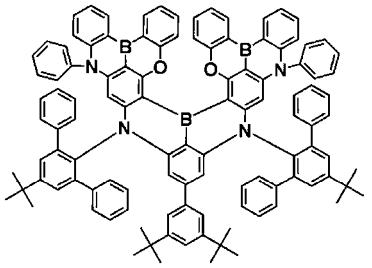

**358**

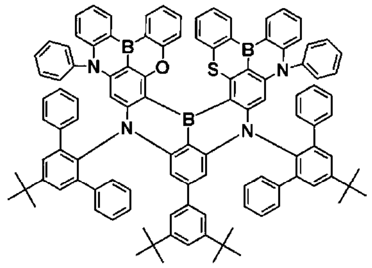

**359**

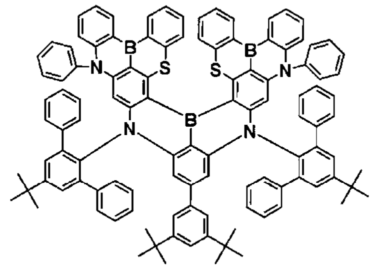

**360**

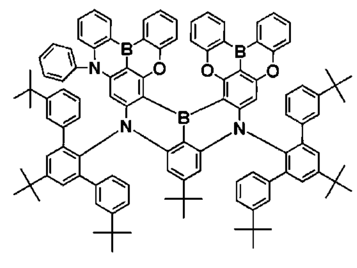

**361**

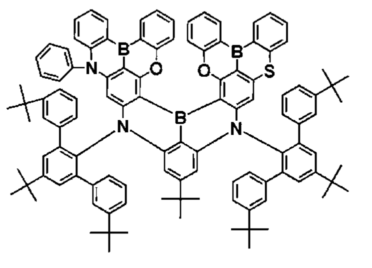

**362**

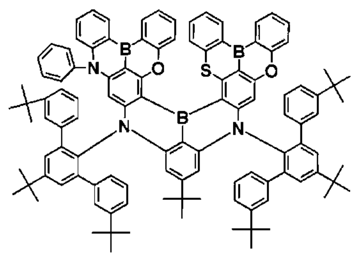

**363**

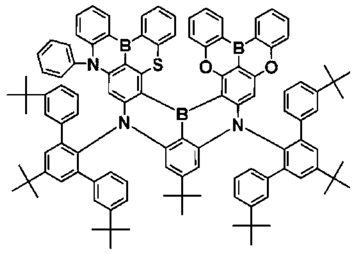

364

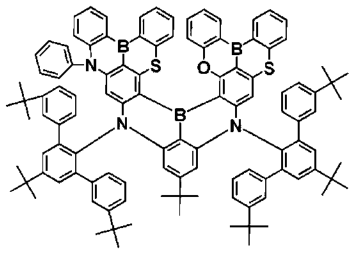

365

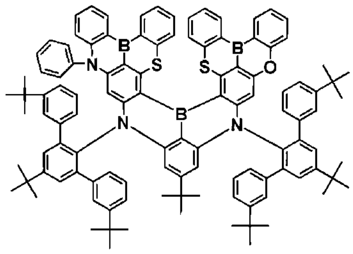

366

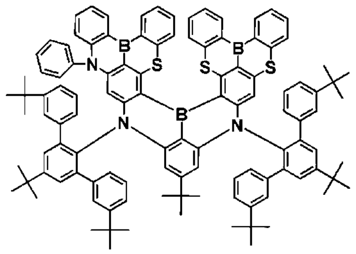

367

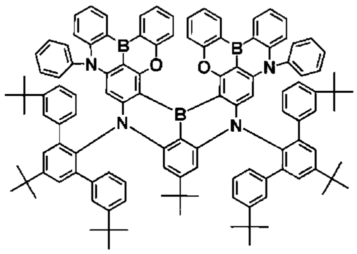

368

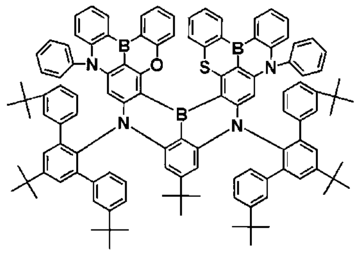

369

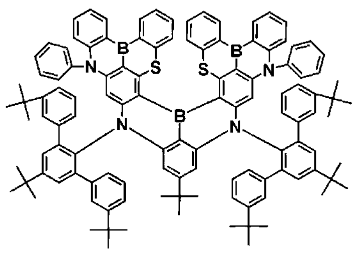

370

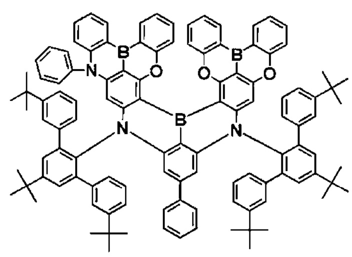

371

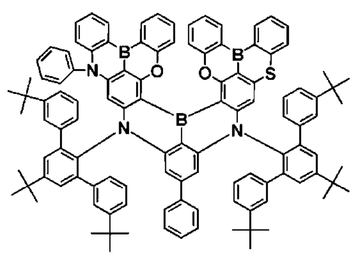

372

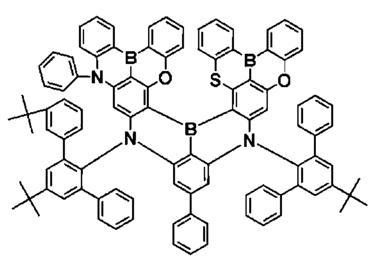

373

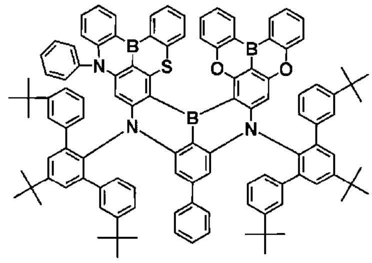

374

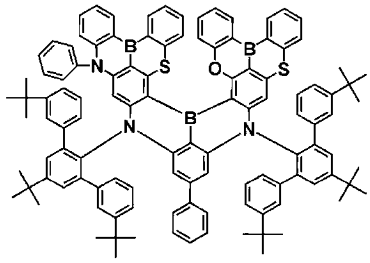

375

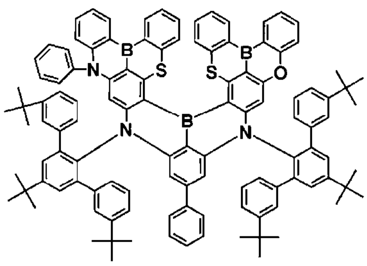

376

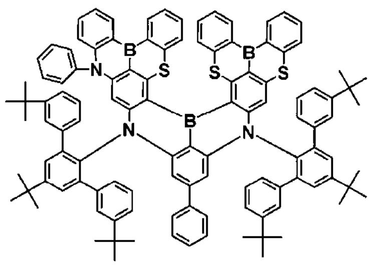

377

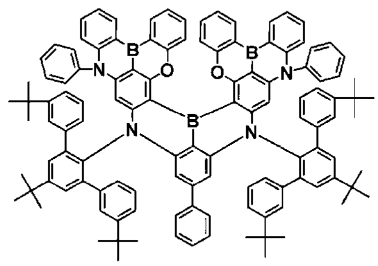

378

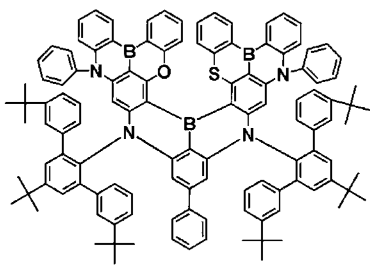

379

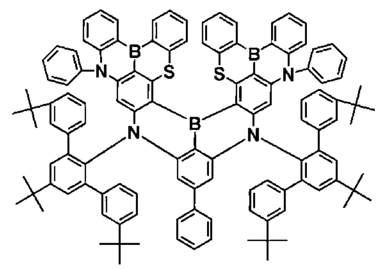

380

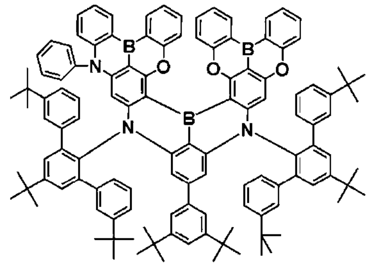

381

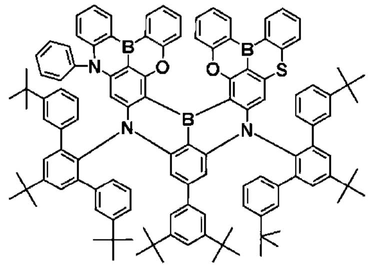

382

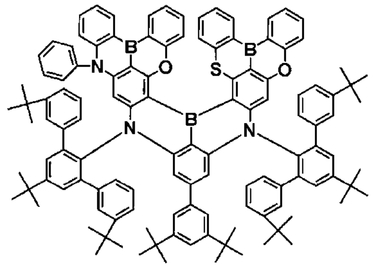

383

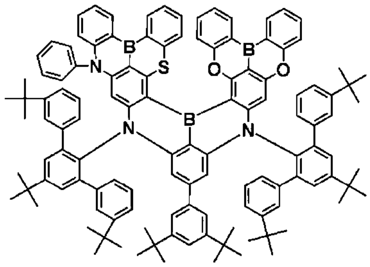

384

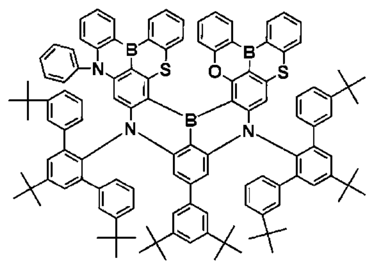

385

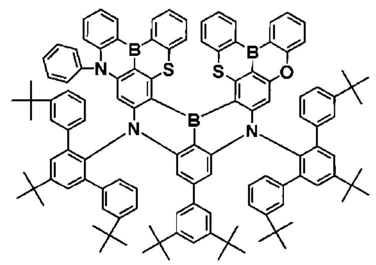

386

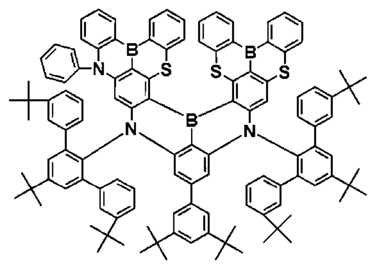

387

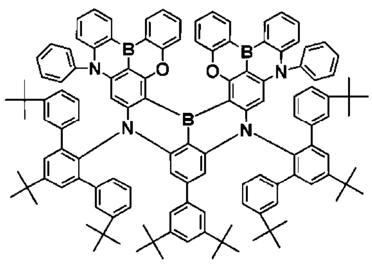

388

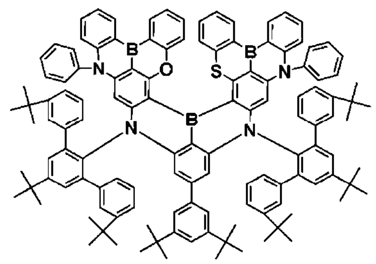

389

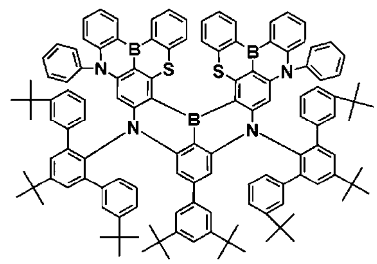

390

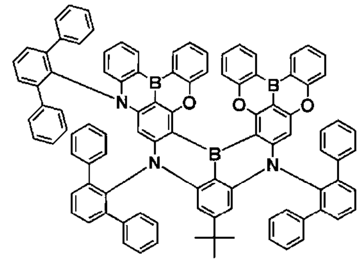

391

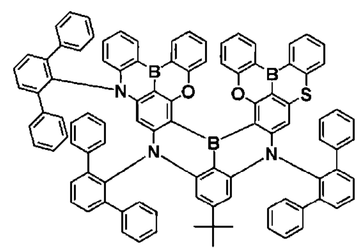

392

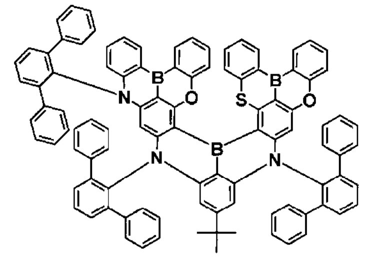

393

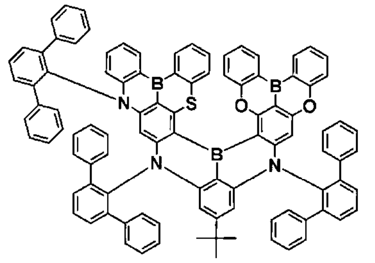

394

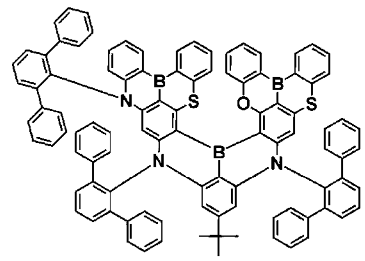

395

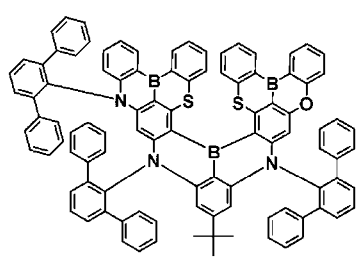

396

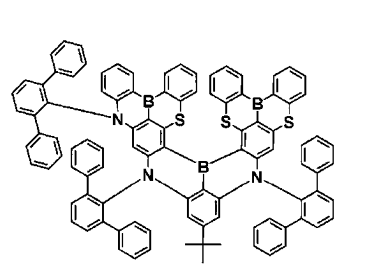

397

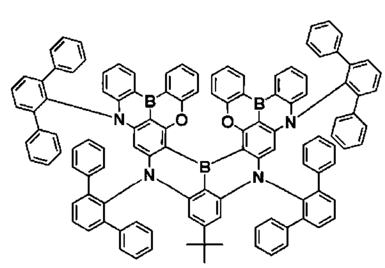

398

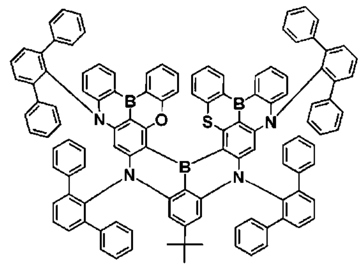

399

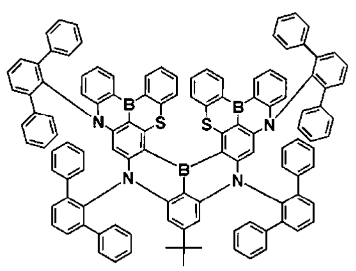

400

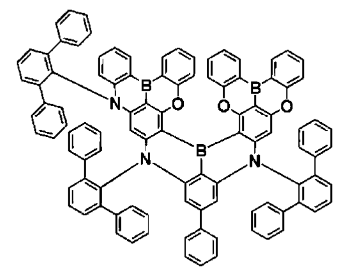

401

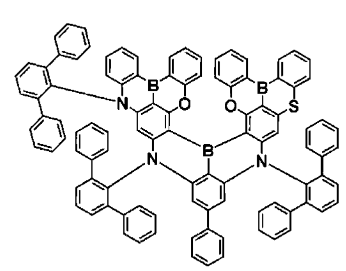

402

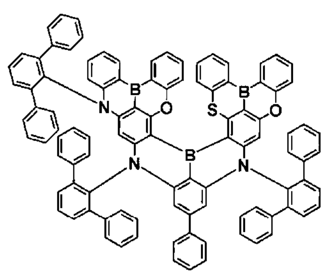

403

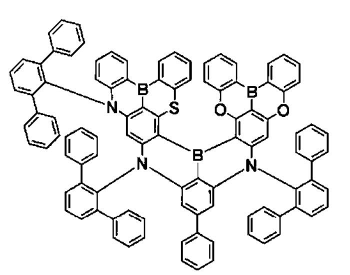

404

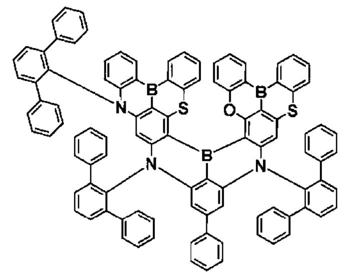

405

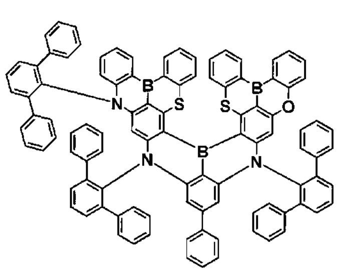

406

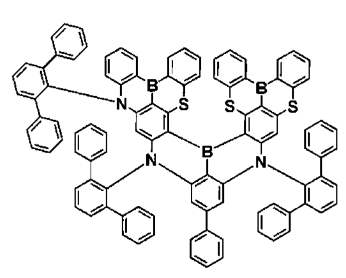

407

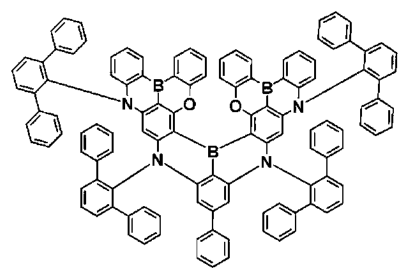

408

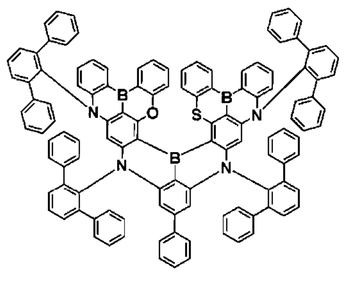

**409**

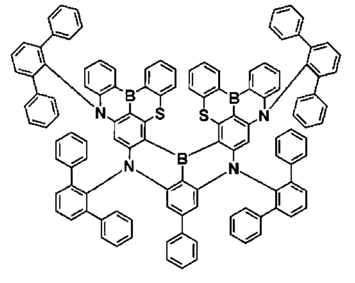

**410**

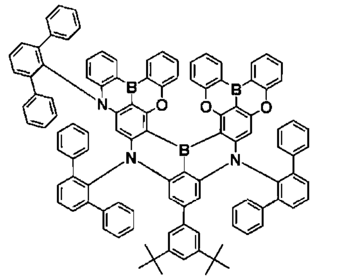

**411**

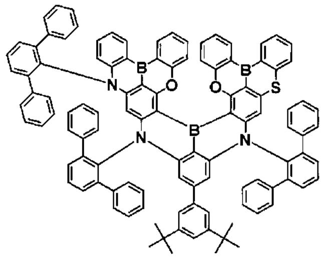

**412**

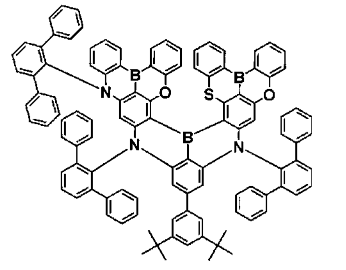

**413**

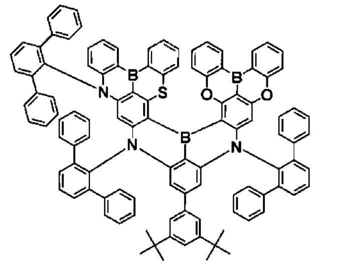

**414**

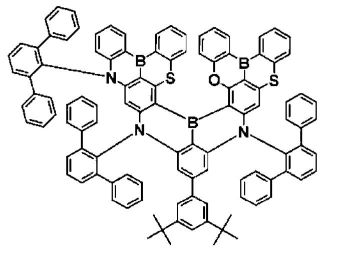

**415**

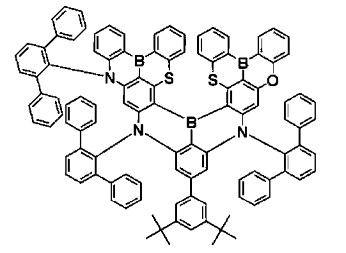

**416**

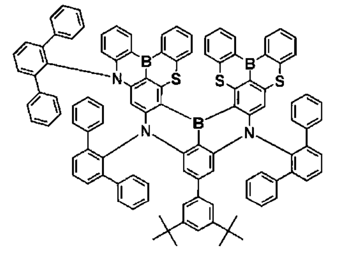

**417**

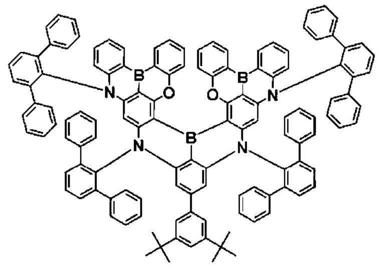

**418**

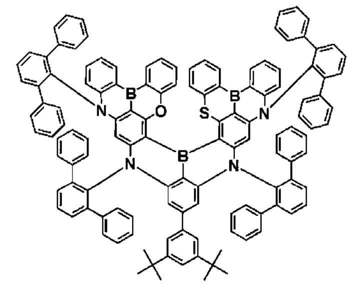

**419**

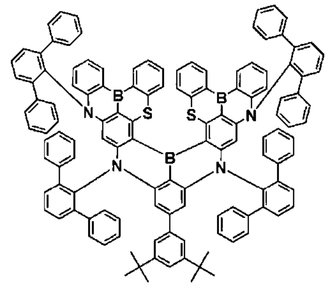

**420**

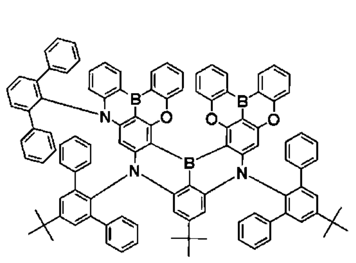

**421**

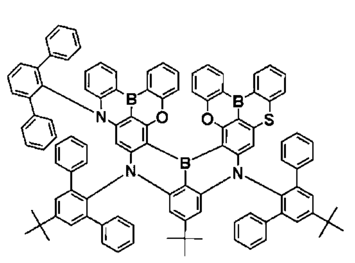

**422**

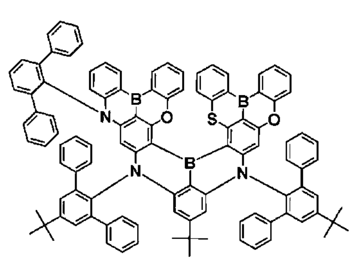

**423**

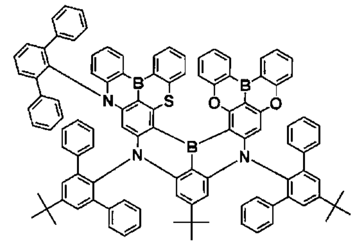

424

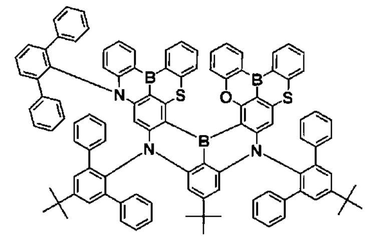

425

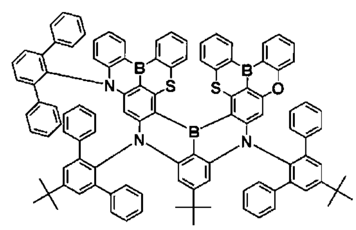

426

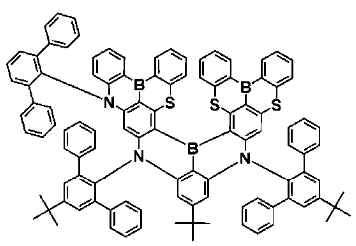

427

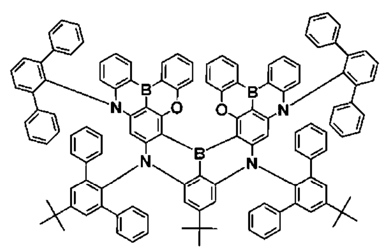

428

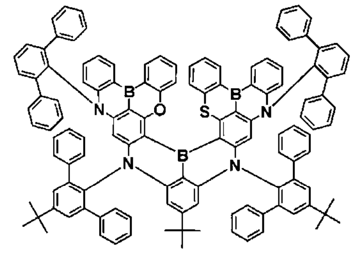

429

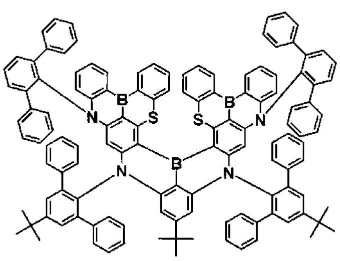

430

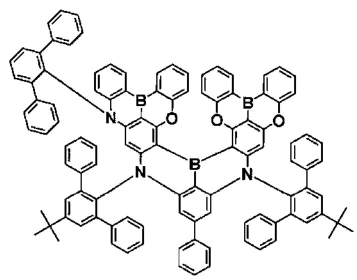

431

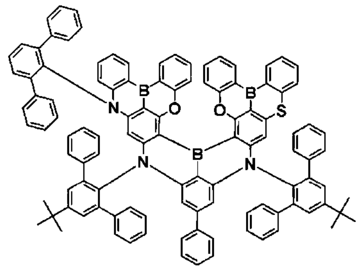

432

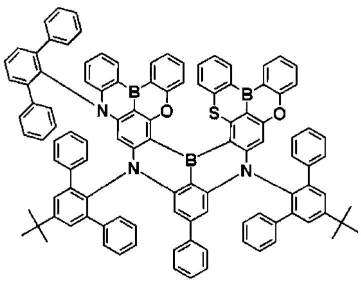

433

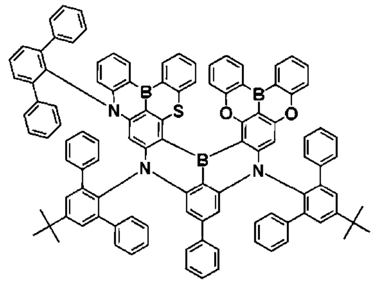

434

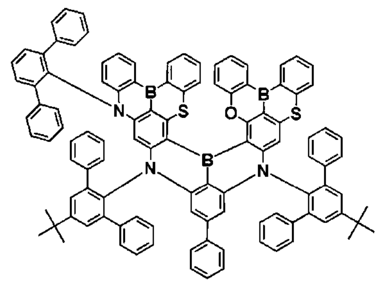

435

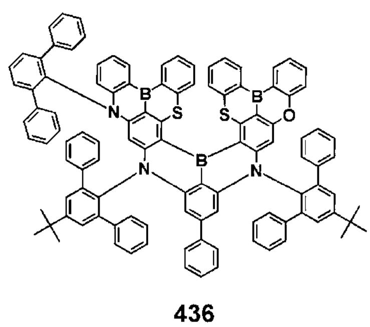

436

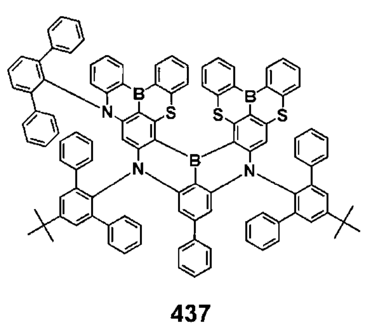

437

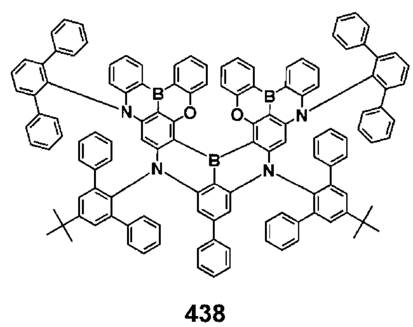

438

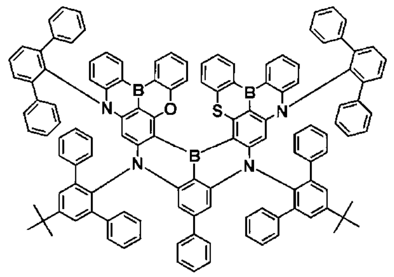

439

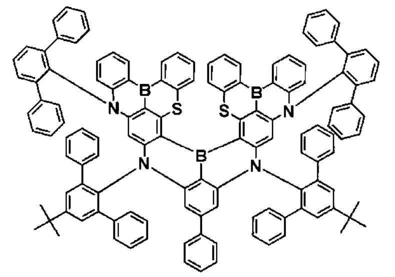

440

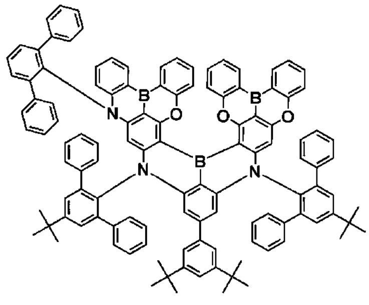

441

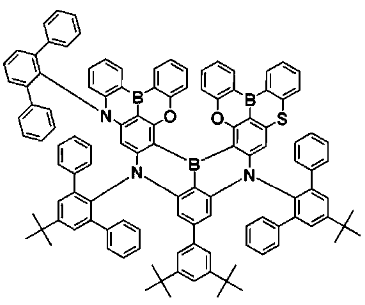

442

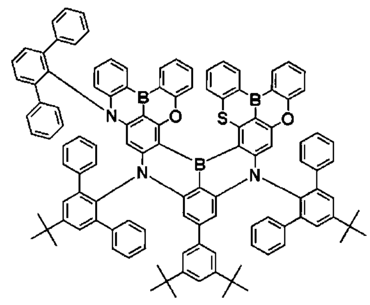

443

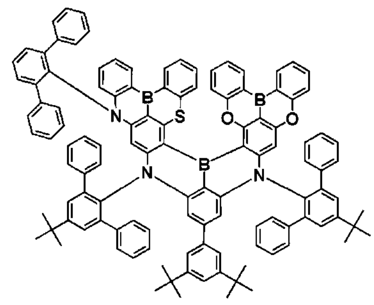

444

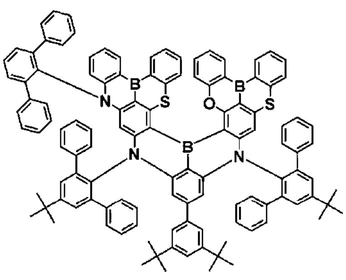

445

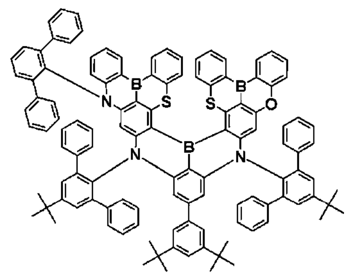

446

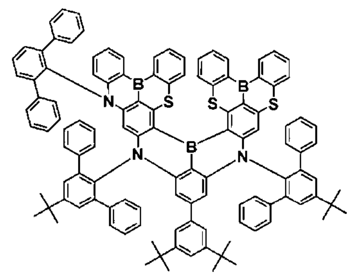

447

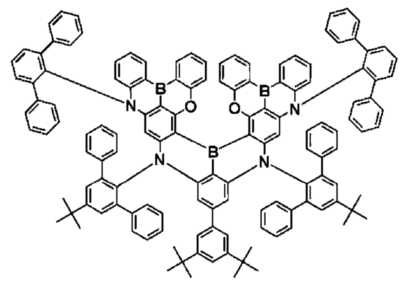

448

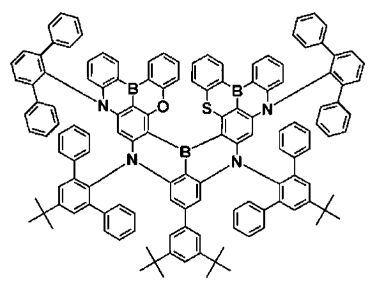

449

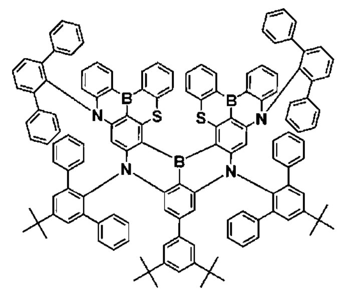

450

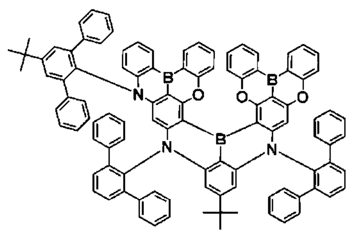

451

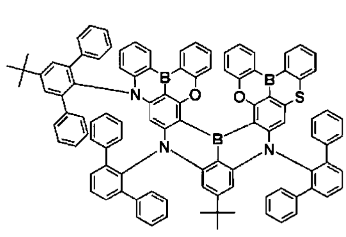

452

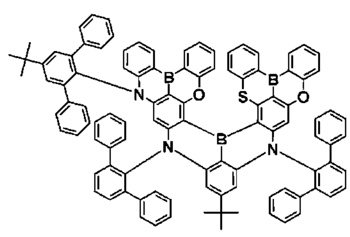

453

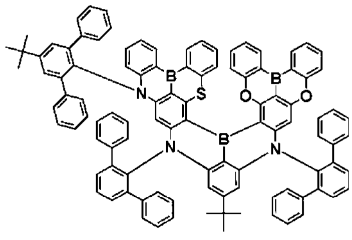

454

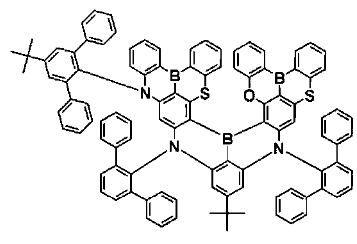

455

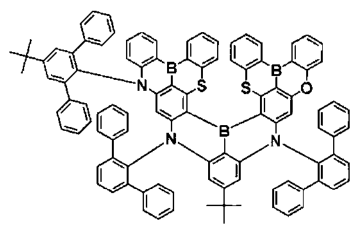

456

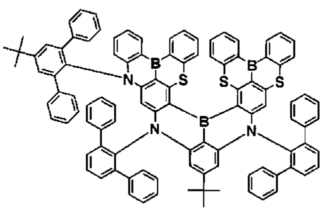

457

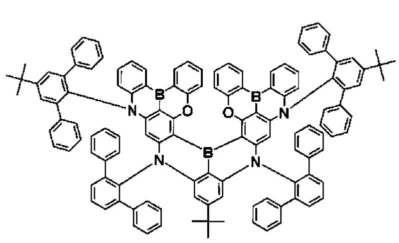

458

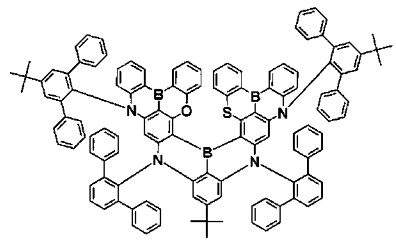

459

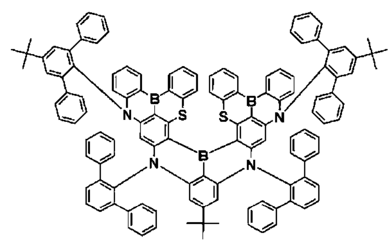

460

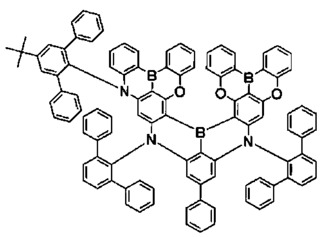

461

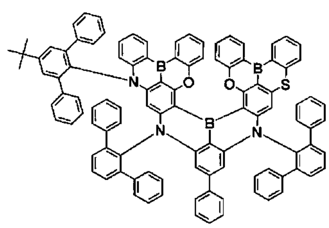

462

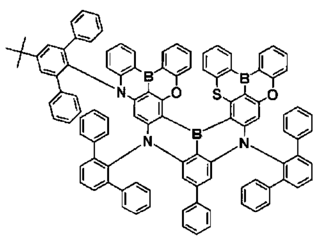

463

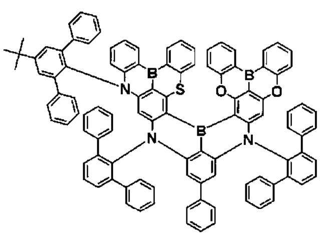

464

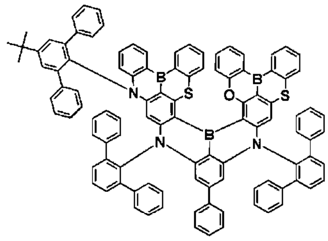

465

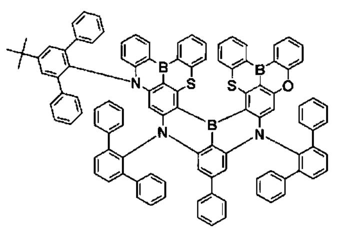

466

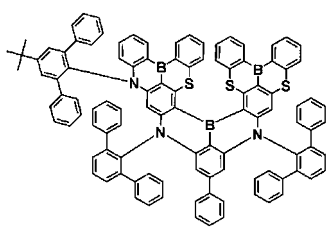

467

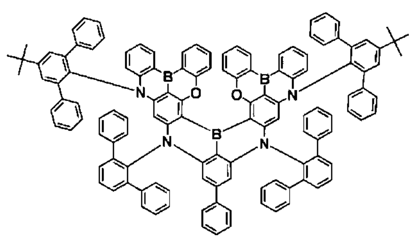

468

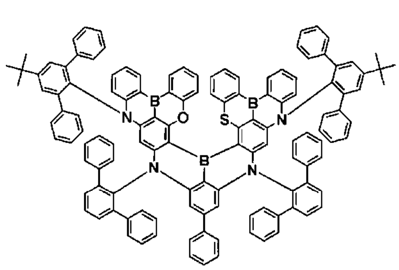

469

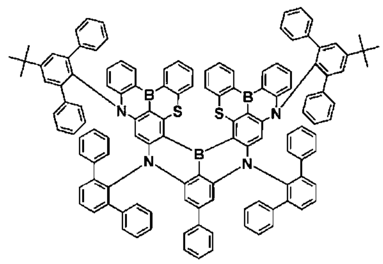

470

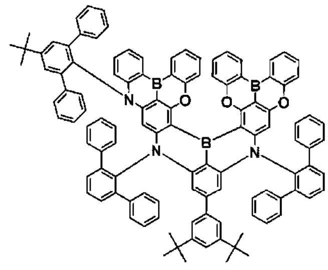

471

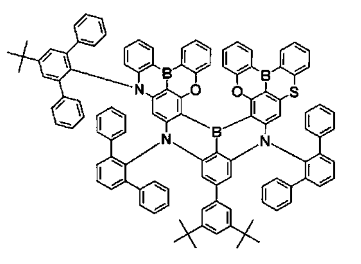

472

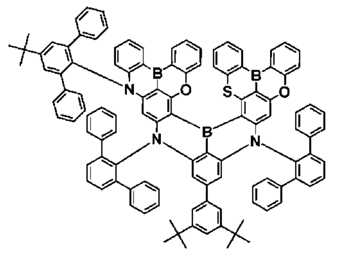

473

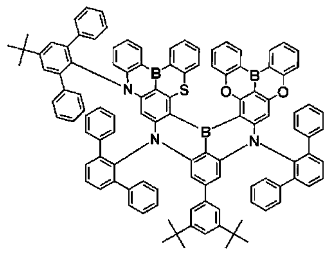

474

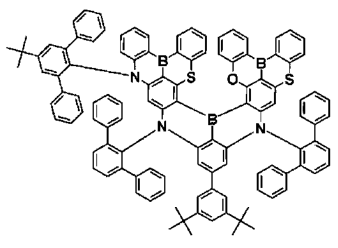

475

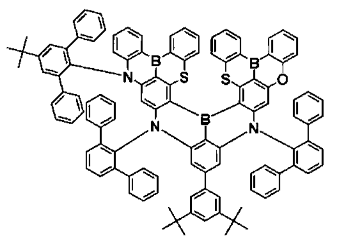

476

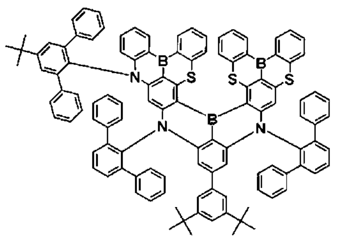

477

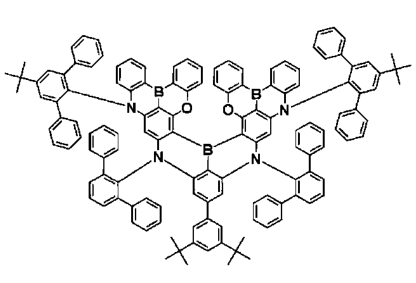

478

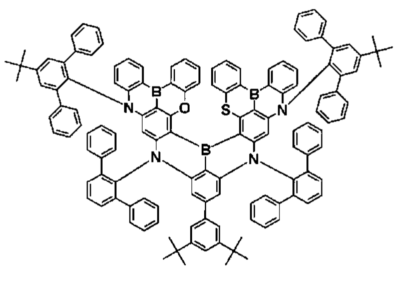

479

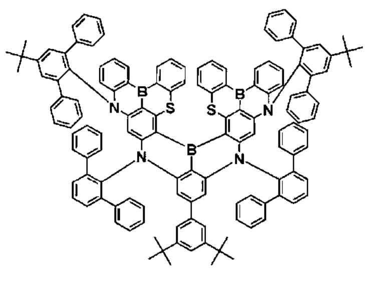

480

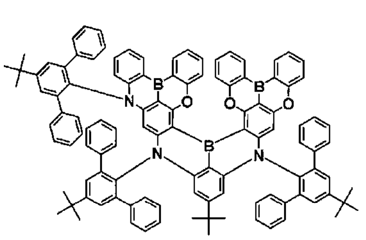

481

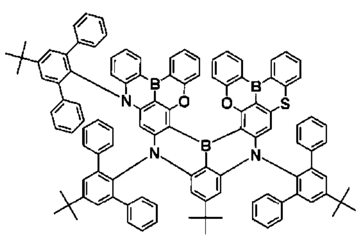

482

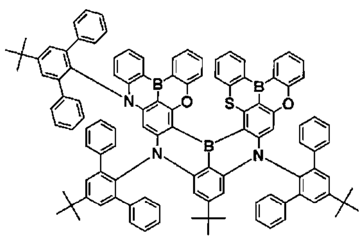

483

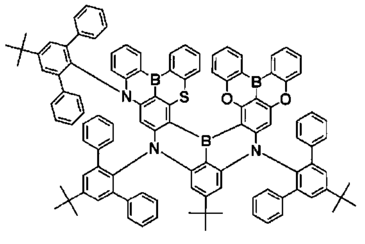

484

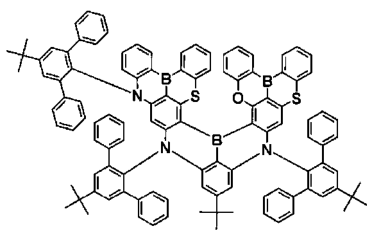

485

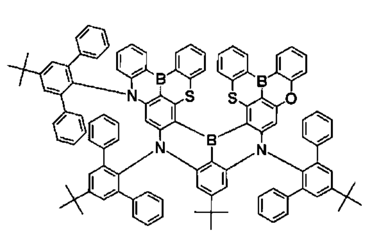

486

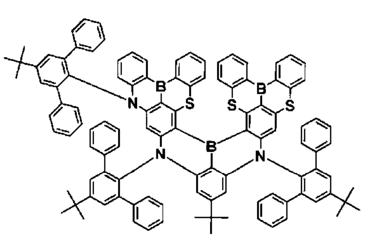

487

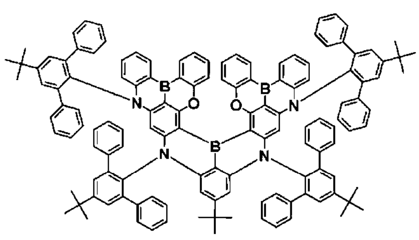

488

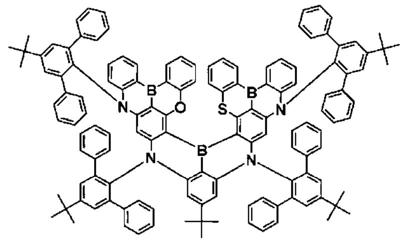

489

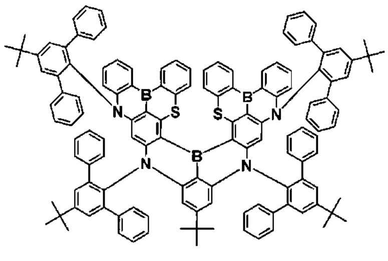

490

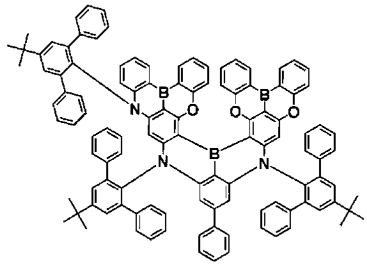

491

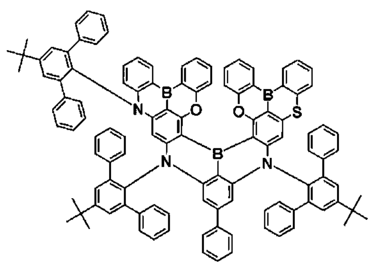

492

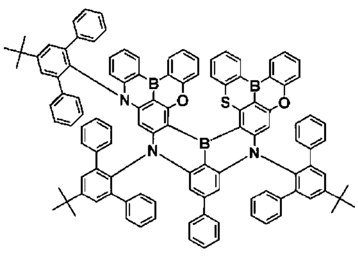

493

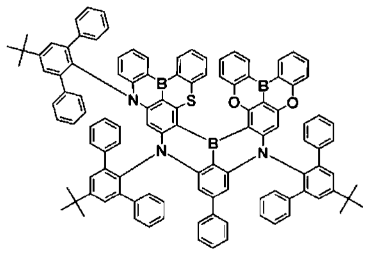

494

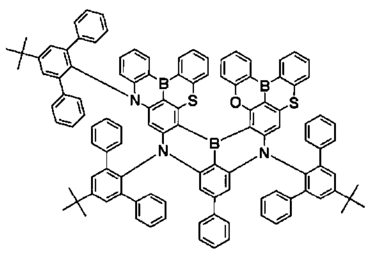

495

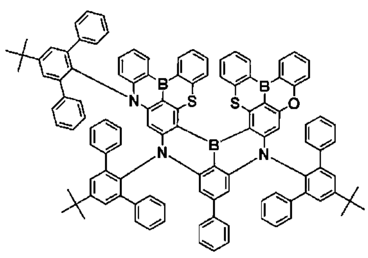

496

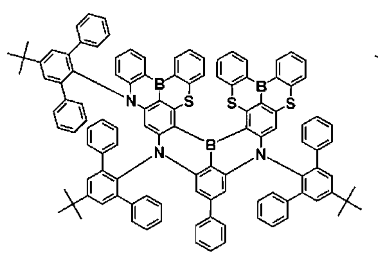

497

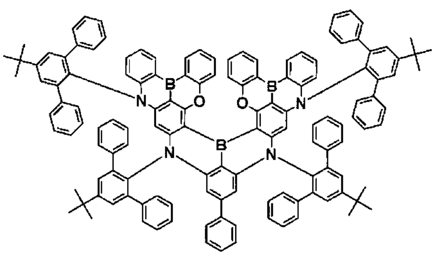

498

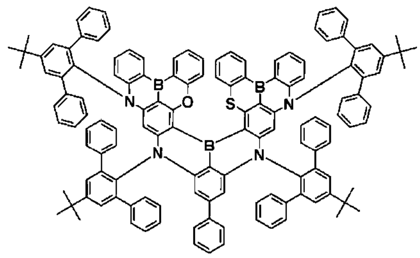

499

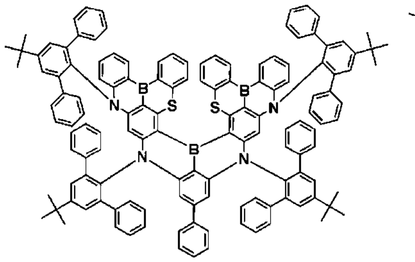

500

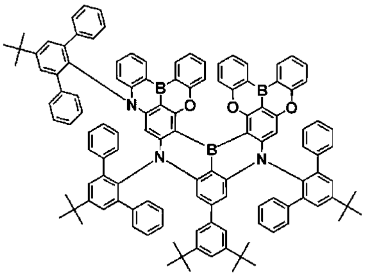

501

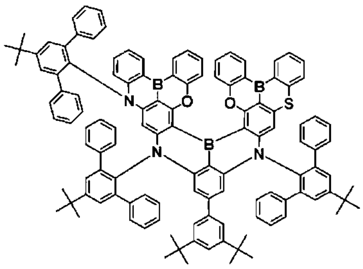

502

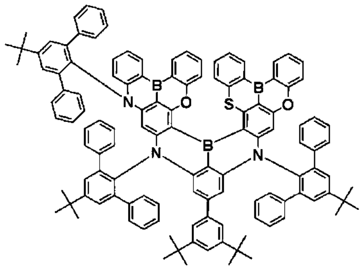

503

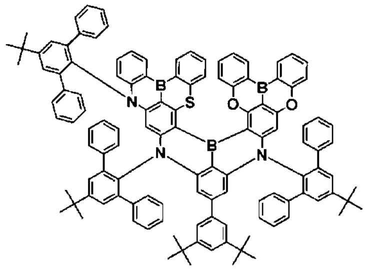

504

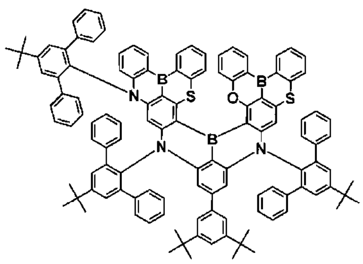

505

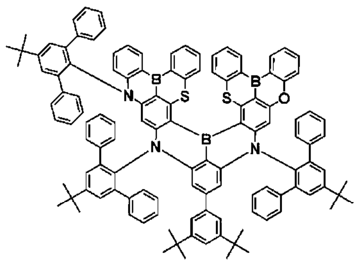

506

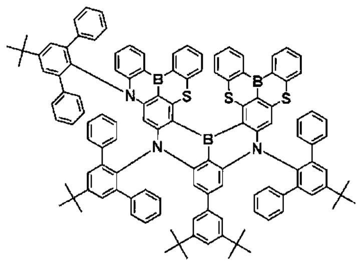

507

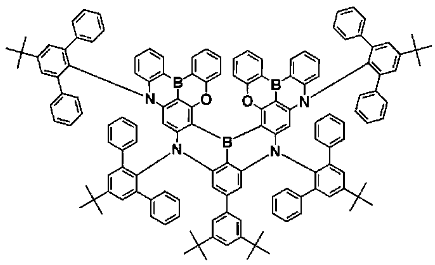

508

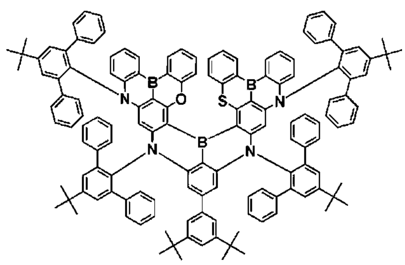

509

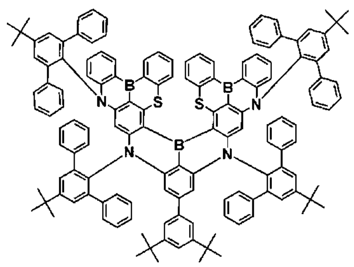

510

.

**11.** An organic light-emitting device (10) comprising:

a first electrode (11);
a second electrode (19); and
an organic layer (15) arranged between the first electrode and the second electrode,
wherein the organic layer comprises an emission layer, and
wherein the organic layer further comprises at least one of the heterocyclic compounds of any of claims 1-10.

**12.** The organic light-emitting device of claim 11, wherein the emission layer comprises the at least one heterocyclic compound.

**13.** The organic light-emitting device of claim 12, wherein the emission layer comprises a host and an emitter, and the emitter comprises the at least one heterocyclic compound;
preferably wherein the emission layer emits a blue light with a maximum emission wavelength of 400 nanometers to 490 nanometers.

**14.** The organic light-emitting device of claim 13, wherein an amount of the host in the emission layer is greater than an amount of the at least one heterocyclic compound in the emission layer, based on weight; and/or
wherein the emission layer further comprises a sensitizer, preferably wherein the sensitizer comprises a phosphorescent dopant.

**15.** An electronic apparatus, comprising the organic light-emitting device of any of claims 11-14.

FIG. 1

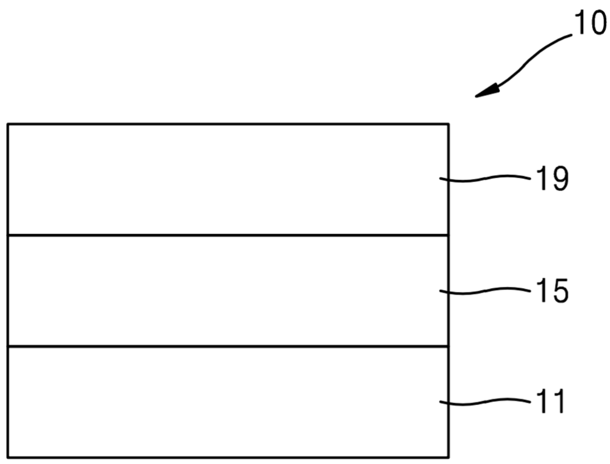

FIG. 2

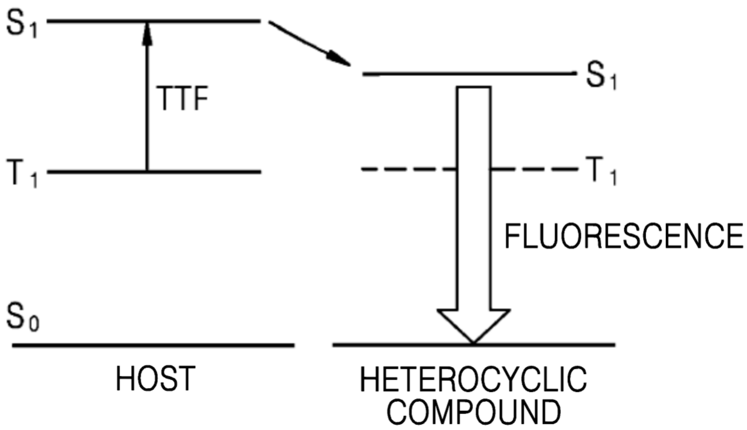

FIG. 3

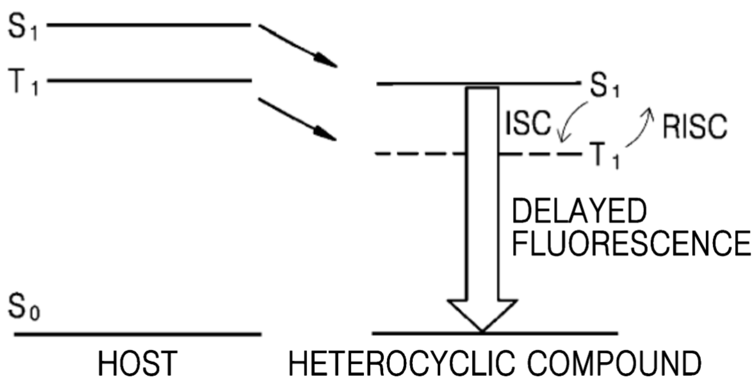
S1
T1
S1
ISC
RISC
T1
DELAYED
FLUORESCENCE
S0
HOST
HETEROCYCLIC COMPOUND

FIG. 4

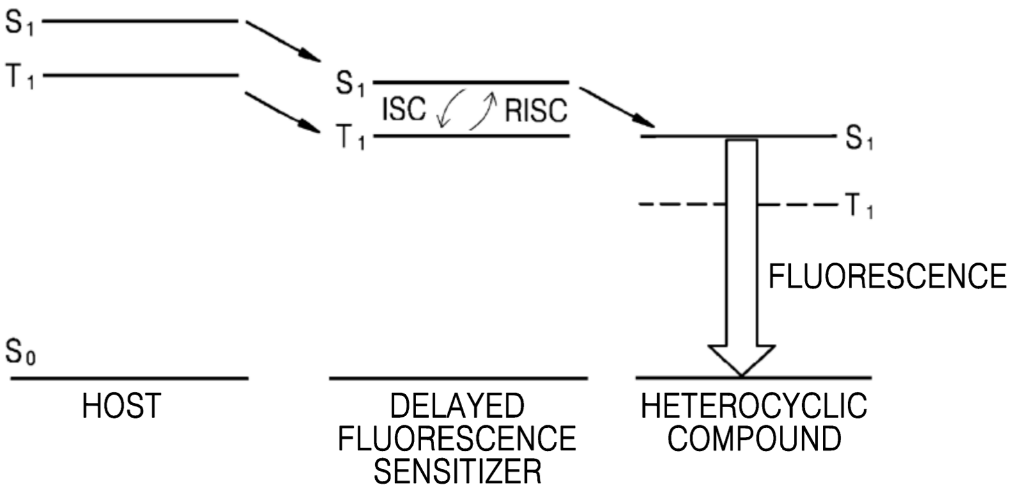
S1
T1
S1
ISC
RISC
T1
S1
T1
FLUORESCENCE
S0
HOST
DELAYED FLUORESCENCE SENSITIZER
HETEROCYCLIC COMPOUND

FIG. 5

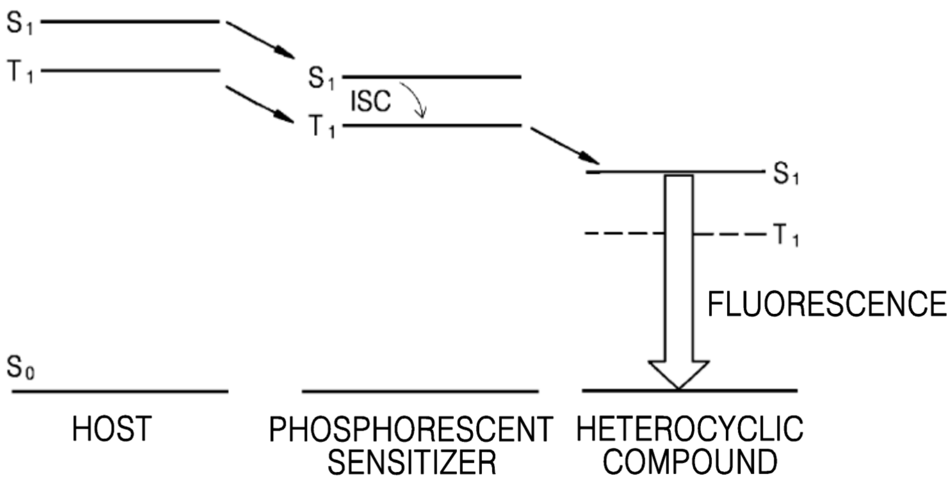
S1
T1
S1
ISC
T1
S1
T1
FLUORESCENCE
S0
HOST
PHOSPHORESCENT SENSITIZER
HETEROCYCLIC COMPOUND

FIG. 6

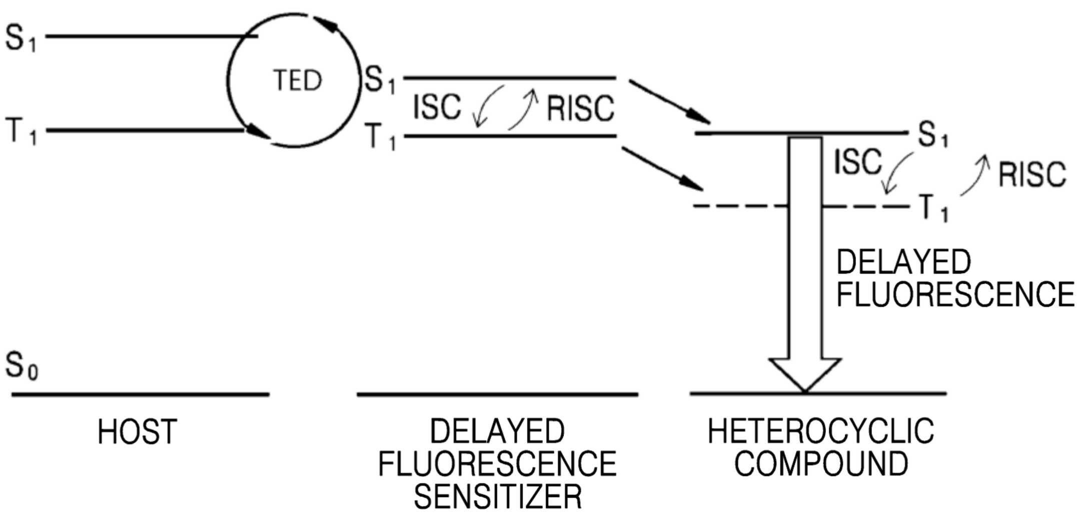
S1
T1
TED
S1
T1
ISC
RISC
S1
T1
ISC
RISC
DELAYED FLUORESCENCE
S0
HOST
DELAYED FLUORESCENCE SENSITIZER
HETEROCYCLIC COMPOUND

Europäisches Patentamt
European Patent Office
Office européen des brevets

# EUROPEAN SEARCH REPORT

Application Number
EP 25 21 2276

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/276708 A1 (HATAKEYAMA TAKUJI [JP] ET AL) 31 August 2023 (2023-08-31)<br>* abstract *<br>* claim 6 *<br>* compounds v-19-27, v-131-3 *<br>----- | 1-15 | INV.<br>H10K50/11<br>H10K85/30<br>H10K85/60 |

TECHNICAL FIELDS SEARCHED (IPC)

H10K

The present search report has been drawn up for all claims

2

| Place of search | Date of completion of the search | Examiner |
|---|---|---|
| Munich | 3 February 2026 | Pfattner, Raphael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 21 2276

This annex lists the patent family members relating to the patent documents cited in the above-mentioned European search report. The members are as contained in the European Patent Office EDP file on The European Patent Office is in no way liable for these particulars which are merely given for the purpose of information.

03-02-2026

| Patent document cited in search report | Publication date | Patent family member(s) | Publication date |
|---|---|---|---|
| US 2023276708 A1 | 31-08-2023 | CN 116096835 A | 09-05-2023 |
| | | JP WO2022034916 A1 | 17-02-2022 |
| | | KR 20230049656 A | 13-04-2023 |
| | | US 2023276708 A1 | 31-08-2023 |
| | | WO 2022034916 A1 | 17-02-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Nat. Commun.*, 2024, vol. 15, 2361